(19) Europäisches Patentamt
European Patent Office
Office européen des brevets

(11) EP 3 605 636 B1

(12) EUROPEAN PATENT SPECIFICATION

(45) Date of publication and mention of the grant of the patent:
**01.05.2024 Bulletin 2024/18**

(21) Application number: **18776402.2**

(22) Date of filing: **26.03.2018**

(51) International Patent Classification (IPC):
***H10K 85/30*** $^{(2023.01)}$ ***H10K 85/60*** $^{(2023.01)}$
*H10K 50/11* $^{(2023.01)}$ *H10K 101/20* $^{(2023.01)}$

(52) Cooperative Patent Classification (CPC):
**H10K 85/657; H10K 85/6572; H10K 85/6574; H10K 85/658;** H10K 50/11; H10K 2101/20

(86) International application number:
**PCT/JP2018/012157**

(87) International publication number:
**WO 2018/181188 (04.10.2018 Gazette 2018/40)**

(54) **ORGANIC ELECTROLUMINESCENCE ELEMENT AND ELECTRONIC DEVICE**
ORGANISCHES ELEKTROLUMINESZENZELEMENT UND ELEKTRONISCHE VORRICHTUNG
ÉLÉMENT ÉLECTROLUMINESCENT ORGANIQUE ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2017 JP 2017072026**

(43) Date of publication of application:
**05.02.2020 Bulletin 2020/06**

(73) Proprietor: **Idemitsu Kosan Co., Ltd.**
**Chiyoda-ku**
**Tokyo 100-8321 (JP)**

(72) Inventors:
- **OGIWARA, Toshinari**
  **Sodegaura-shi**
  **Chiba 299-0293 (JP)**
- **YOSHIZAKI, Kei**
  **Sodegaura-shi**
  **Chiba 299-0293 (JP)**
- **SAITO, Masatoshi**
  **Sodegaura-shi**
  **Chiba 299-0293 (JP)**
- **KAWAMURA, Yuichiro**
  **Sodegaura-shi**
  **Chiba 299-0293 (JP)**

(74) Representative: **Gille Hrabal Partnerschaftsgesellschaft mbB**
**Patentanwälte**
**Brucknerstraße 20**
**40593 Düsseldorf (DE)**

(56) References cited:
**WO-A1-2015/098975**
**WO-A1-2015/102118**
**WO-A1-2017/018326**
**JP-A- 2016 115 940**
**US-A1- 2016 172 601**

- **TAKUJI HATAKEYAMA ET AL: "Ultrapure Blue Thermally Activated Delayed Fluorescence Molecules: Efficient HOMO-LUMO Separation by the Multiple Resonance Effect", ADVANCED MATERIALS, vol. 28, no. 14, 11 February 2016 (2016-02-11), pages 2777-2781, XP055315917, ISSN: 0935-9648, DOI: 10.1002/adma.201505491**
- **HATAKEYAMA TAKUJI et al.: "Ultrapure Blue Thermally Activated Delayed Fluorescence Molecules: Efficient HOMO-LUMO Separation by the Multiple Resonance Effect", ADVANCED MATERIALS, vol. 28, no. 14, 13 April 2016 (2016-04-13), pages 2777-2781, XP055315917, DOI: doi:10.1002/adma.201505491**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 605 636 B1

**Description**

TECHNICAL FIELD

The present invention relates to an organic electroluminescence device and an electronic device.

BACKGROUND ART

When a voltage is applied to an organic electroluminescence device (hereinafter, occasionally referred to as "organic EL device"), holes and electrons are injected into an emitting layer from an anode and a cathode, respectively. The injected electrons and holes are recombined in an emitting layer to form excitons. According to the electron spin statistics theory, singlet excitons are generated at a ratio of 25% and triplet excitons are generated at a ratio of 75%.

A fluorescent organic EL device, which uses emission caused by singlet excitons, has been applied to a full-color display of a mobile phone, TV and the like, but is inferred to exhibit an internal quantum efficiency of 25% at the maximum. A fluorescent EL device is required to use triplet excitons in addition to singlet excitons to promote a further efficient emission from the organic EL device.

In view of the above, a highly efficient fluorescent organic EL device using delayed fluorescence has been studied.

For instance, a TADF (Thermally Activated Delayed Fluorescence) mechanism has been studied. The TADF mechanism uses such a phenomenon that inverse intersystem crossing from triplet excitons to singlet excitons thermally occurs when a material having a small energy difference ($\Delta ST$) between singlet energy level and triplet energy level is used. Delayed fluorescence (thermally activated delayed fluorescence) is explained in "Yuki Hando-tai no Debaisu Bussei (Device Physics of Organic Semiconductors)" (edited by ADACHI, Chihaya, published by Kodansha, issued on April 1, 2012, on pages 261-262).

Polycyclic aromatic compounds and the like are known as materials for the organic EL device (Patent Literatures 1 to 3). A technique for using such polycyclic aromatic compounds in an organic EL device using the TADF mechanism has been developed (non-Patent Literature 1).

Patent Literature 4 discloses an OLED comprising an emissive layer having a first compound and second compound, where the first compound is a TADF compound.

Patent Literature 5 discloses an organic electroluminescent element having at least one light-emitting layer containing a $\pi$-conjugated boron compound.

Non-Patent Literature 2 discloses a compound designated as DABNA-1, as the emitter in an OLED.

CITATION LIST

PATENT LITERATURE(S)

Patent Literature 1: International Publication No. WO2016/152544
Patent Literature 2: International Publication No. WO2016/152418
Patent Literature 3: International Publication No. WO2015/102118
Patent Literature 4: US patent application No. US2016/172601 A1
Patent Literature 5: International Publication No. WO2017/018326 A1

NON-PATENT LITERATURE

Non-Patent Literature 1: Ultrapure Blue Thermally Activated Delayed Fluorescence Molecules: Efficient HOMO-LUMO Separation by the Multiple Resonance Effect, Adv. Mater. 2016, 28, 2777-2781.
Non-Patent Literature 2: TAKUJI HATAKEYAMA ET AL: "Ultrapure Blue Thermally Activated Delayed Fluorescence Molecules: Efficient HOMO-LUMO Separation by the Multiple Resonance Effect", ADVANCED MATERIALS, vol. 28, no. 14, 11 February 2016 (2016-02-11), pages 2777-2781.

SUMMARY OF THE INVENTION

PROBLEMS TO BE SOLVED BY THE INVENTION

However, the luminous efficiency of the organic EL device is disadvantageously decreased in a high-current-density area at or around 10 $mA/cm^2$ (i.e. a practical area).

An object of the invention is to provide an organic electroluminescence device capable of emitting light with high efficiency and an electronic device including the organic electroluminescence device.

MEANS FOR SOLVING THE PROBLEMS

An organic electroluminescence device according to an aspect of the invention includes: an anode; an emitting layer; and a cathode, in which the emitting layer contains a first compound and a second compound, the first compound is a thermally activated delayed fluorescent compound, the first compound is a compound represented by a formula (11D) below, the second compound is represented by a formula (2) below, and a singlet energy $S_1(M1)$ of the first compound and a singlet energy $S_1(M2)$ of the second compound satisfy a relationship of Numerical Formula 1 below,

$$S_1(M1) > S_1(M2) \quad \text{(Numerical Formula 1)}$$

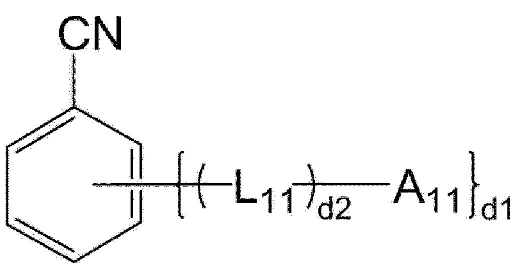

(11D)

wherein in the formula (11D):

d1 is 5, d2 are each independently 0 or 1;
$L_{11}$ are each independently a single bond or a linking group;
$L_{11}$ serving as the substituents are each independently a group derived from a group selected from the group consisting of a substituted or unsubstituted aryl group having 6 to 30 ring carbon atoms, and a substituted or unsubstituted heteroaryl group having 5 to 30 ring atoms;
$A_{11}$ are each independently a hydrogen atom or a substituent; and
$A_{11}$ serving as the substituents are each independently a group selected from the group consisting of a cyano group, a substituted or unsubstituted aryl group having 6 to 30 ring carbon atoms, and a substituted or unsubstituted heteroaryl group having 5 to 30 ring atoms,
with a proviso that at least one of $A_{11}$ is a group represented by the formula (11a)

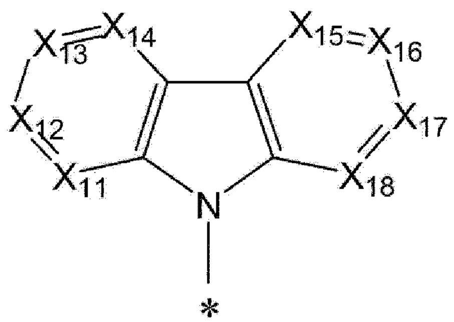

(11a)

wherein in the formula (11a):
$X_{11}$ to $X_{18}$ are each independently a nitrogen atom or CRx (a carbon atom having a substituent Rx);
Rx are each independently a hydrogen atom or a substituent;

Rx serving as the substituent is selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted phosphoryl group, a substituted silyl group, a cyano group, a nitro group, and a carboxyl group;
a plurality of Rx are mutually the same or different;
when a plurality of ones of $X_{11}$ to $X_{18}$ are CRx and Rx are substituents, Rx are bonded to each other to form a ring, or are not bonded to form no ring; and
* represents a bonding position to a carbon atom of the cyclic structure represented by $L_{11}$ or the benzonitrile moiety in the formula (11D),

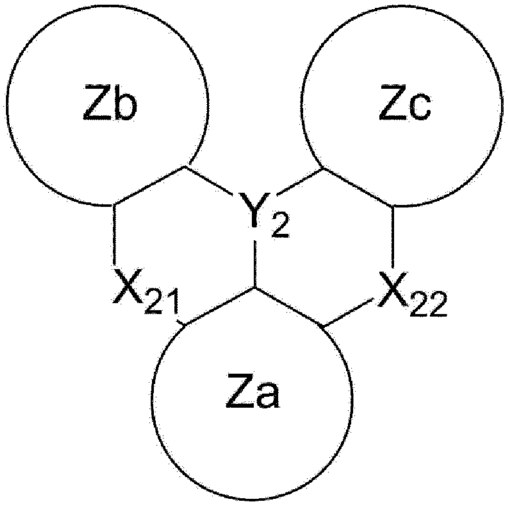

(2)

where, in the formula (2): Za ring, Zb ring and Zc ring are each independently a cyclic structure selected from the group consisting of a substituted or unsubstituted aryl ring having 6 to 30 ring carbon atoms, and a substituted or unsubstituted heteroaryl ring having 5 to 30 ring atoms;

$X_{21}$ and $X_{22}$ are each independently an oxygen atom, NRa, or a sulfur atom;
when $X_{21}$ is NRa, Ra is bonded to Za ring or Zb ring to form a ring or is not bonded to form no ring;
when $X_{22}$ is NRa, Ra is bonded to Za ring or Zc ring to form a ring or is not bonded to form no ring;
Ra is each independently a group selected from the group consisting of a substituted or unsubstituted aryl group having 6 to 30 ring carbon atoms, a substituted or unsubstituted heteroaryl group having 5 to 30 ring atoms, and a substituted or unsubstituted alkyl group having 1 to 30 carbon atoms;
$Y_2$ is any one of a boron atom, a phosphorus arom, SiRb, P=O, or P=S;
Rb is each independently a group selected from the group consisting of a substituted or unsubstituted aryl group having 6 to 30 ring carbon atoms, a substituted or unsubstituted heteroaryl group having 5 to 30 ring atoms, and a substituted or unsubstituted alkyl group having 1 to 30 carbon atoms.

According to another aspect of the invention, an electronic device including the organic electroluminescence device according to the above aspect of the invention is provided.
According to the above aspects of the invention, an organic electroluminescence device capable of emitting light with high efficiency and an electronic device including the organic electroluminescence device can be provided.

BRIEF DESCRIPTION OF DRAWING

Fig. 1 schematically shows an exemplary arrangement of an organic electroluminescence device according to a first exemplary embodiment of the invention.
Fig. 2 schematically shows a device for measuring transient PL.
Fig. 3 shows examples of a transient PL decay curve.

Fig. 4 shows a relationship between energy levels of a first compound and a second compound and an energy transfer between the first compound and the second compound in an exemplary emitting layer of the organic electroluminescence device according to the first exemplary embodiment of the invention.

Fig. 5 shows a relationship between energy levels of a first compound, a second compound, and a third compound and an energy transfer between the first compound, the second compound, and the third compound in an exemplary emitting layer of an organic electroluminescence device according to a second exemplary embodiment of the invention.

DESCRIPTION OF EMBODIMENT(S)

First Exemplary Embodiment

Organic EL Device

Arrangement(s) of Organic EL Device

An arrangement of an organic EL device according to a first exemplary embodiment will be described below.

An organic device in the first exemplary embodiment includes a pair of electrodes and an organic layer between the pair of electrodes. The organic layer includes at least one layer formed of an organic compound. Alternatively, the organic layer includes a plurality of layers formed of an organic compound(s). The organic layer may further include an inorganic compound(s). In the organic EL device in the first exemplary embodiment, at least one layer of the organic layer(s) is an emitting layer. Specifically, for instance, the organic layer may consist of a single emitting layer, or alternatively, may further include other layer(s) usable in a typical organic EL device. Examples of the non-limiting other layer usable in the organic EL device include at least one layer selected from the group consisting of a hole injecting layer, a hole transporting layer, an electron injecting layer, an electron transporting layer and a blocking layer.

Typical device arrangements of the organic EL device include the following arrangements (a) to (f) and the like:

(a) anode/ emitting layer/ cathode;
(b) anode / hole injecting transporting layer / emitting layer / cathode;
(c) anode / emitting layer / electron injecting·transporting layer / cathode;
(d) anode / hole injecting-transporting layer / emitting layer / electron injecting-transporting layer / cathode;
(e) anode / hole injecting-transporting layer / emitting layer / blocking layer / electron injecting-transporting layer / cathode; and
(f) anode / hole injecting-transporting layer / blocking layer / emitting layer / blocking layer / electron injecting-transporting layer / cathode.

The arrangement (d) is suitably used among the above arrangements. However, the arrangement of the invention is not limited to the above arrangements. The "emitting layer" refers to an organic layer having an emitting function. The term "hole injecting transporting layer" means at least one of a hole injecting layer and a hole transporting layer. The term "electron injecting transporting layer" means at least one of an electron injecting layer and an electron transporting layer. Herein, when the hole injecting layer and the hole transporting layer are provided, the hole injecting layer is preferably provided between the hole transporting layer and the anode. When the electron injecting layer and the electron transporting layer are provided, the electron injecting layer is preferably provided between the electron transporting layer and the cathode. The hole injecting layer, the hole transporting layer, the electron transporting layer and the electron injecting layer may each consist of a single layer or a plurality of layers.

Fig. 1 schematically shows an arrangement of an exemplary organic EL device according to the first exemplary embodiment.

An organic EL device 1 includes a light-transmissive substrate 2, an anode 3, a cathode 4, and an organic layer 10 provided between the anode 3 and the cathode 4. The organic layer 10 includes: a hole injecting layer 6, a hole transporting layer 7, an emitting layer 5, an electron transporting layer 8, and an electron injecting layer 9. The organic layer 10 includes the hole injecting layer 6, the hole transporting layer 7, the emitting layer 5, the electron transporting layer 8, and the electron injecting layer 9 which are laminated on the anode 3 in this order.

Emitting Layer

The emitting layer 5 of the organic EL device 1 contains a first compound and a second compound. The emitting layer 5 may contain a metal complex. The emitting layer 5 preferably does not contain a phosphorescent metal complex.

The first compound is also preferably a host material (occasionally referred to as a matrix material).. The second

compound is also preferably a dopant material (occasionally referred to as a guest material, emitter, or luminescent material).

First Compound

The first compound is a thermally activated delayed fluorescent compound represented by a formula (11D) below.

In the organic EL device of the first exemplary embodiment, the first compound is a compound represented by a formula (11D) below.

[Formula 19]

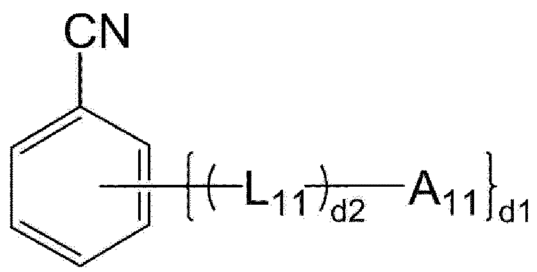

(11D)

In the formula (11D): d1 is 5, d2 are each independently 0 or 1;

$L_{11}$ are each independently a single bond or a linking group;

$L_{11}$ serving as the substituents are each independently a group derived from a group selected from the group consisting of a substituted or unsubstituted aryl group having 6 to 30 ring carbon atoms, and a substituted or unsubstituted heteroaryl group having 5 to 30 ring atoms;

$A_{11}$ are each independently a hydrogen atom or a substituent; and

$A_{11}$ serving as the substituents are each independently a group selected from the group consisting of a cyano group, a substituted or unsubstituted aryl group having 6 to 30 ring carbon atoms, and a substituted or unsubstituted heteroaryl group having 5 to 30 ring atoms,

with a proviso that at least one of $A_{11}$ is a group represented by the formula (11a)

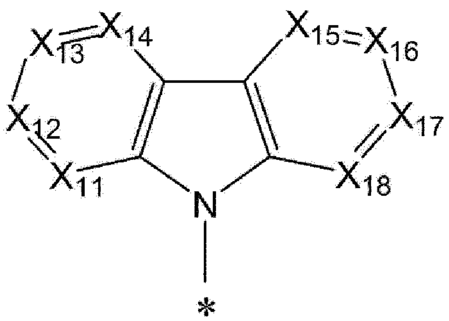

(11a)

wherein in the formula (11a):

$X_{11}$ to $X_{18}$ are each independently a nitrogen atom or CRx (a carbon atom having a substituent Rx);

Rx are each independently a hydrogen atom or a substituent;

Rx serving as the substituent is selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted phosphoryl group, a substituted silyl group, a cyano group, a nitro group, and a carboxyl group;

a plurality of Rx are mutually the same or different;

when a plurality of ones of $X_{11}$ to $X_{18}$ are CRx and Rx are substituents, Rx are bonded to each other to form a ring, or are not bonded to form no ring; and

* represents a bonding position to a carbon atom of the cyclic structure represented by $L_{11}$ or the benzonitrile moiety in the formula (11D).

In the organic EL device of the first exemplary embodiment, the first compound is also preferably a compound represented by a formula (11E) below.

[Formula 20]

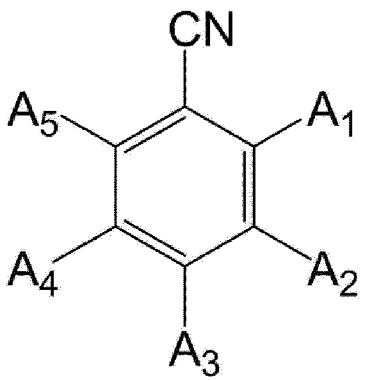

(11E)

In the formula (11E): $A_1$ to $A_5$ are each independently a hydrogen atom or a substituent; and

$A_1$ to $A_5$ serving as the substituents are each independently a group selected from the group consisting of a cyano group, a substituted or unsubstituted aryl group having 6 to 30 ring carbon atoms, and a substituted or unsubstituted heteroaryl group having 5 to 30 ring atoms,

with a proviso that at least one of $A_1$ to $A_5$ is a group represented by the formula (11a).

In the organic EL device of the first exemplary embodiment, at least one of $A_1$, $A_2$, $A_4$, and $A_5$ of the formula (11E) is preferably the group represented by the formula (11a). It is more preferable that all of $A_1$, $A_2$, $A_4$, and $A_5$ of the formula (11E) are groups represented by the formula (11a).

Delayed Fluorescence

Delayed fluorescence (thermally activated delayed fluorescence) is explained in "Yuki Hando-tai no Debaisu Bussei (Device Physics of Organic Semiconductors)" (edited by ADACHI, Chihaya, published by Kodansha, on pages 261-268). This document describes that, when an energy difference $\Delta E_{13}$ between a singlet state and a triplet state of a fluorescent material can be decreased, in spite of a typical low transition probability, inverse energy transfer from the triplet state to the singlet state occurs at a high efficiency to express TADF (Thermally Activated Delayed Fluorescence). Further, Fig. 10.38 in this literature illustrates an occurrence mechanism of the delayed fluorescence. The first compound in the exemplary embodiment is a compound emitting thermally activated delayed fluorescence ("thermally activated delayed fluorescent compound") to be generated by such a mechanism.

Occurrence of delayed fluorescence emission can be determined by transient PL (Photo Luminescence) measurement.

The behavior of delayed fluorescence can be analyzed based on the decay curve obtained by the transient PL measurement. The transient PL measurement is a process where a sample is irradiated with a pulse laser to be excited, and a decay behavior (transient characteristics) of PL emission after the irradiation is stopped is measured. PL emission using a TADF material is divided into an emission component from singlet excitons generated by the first PL excitation and an emission component from singlet excitons generated via triplet excitons. The lifetime of the singlet excitons generated by the initial PL excitation is in a nano-second order and considerably short. Accordingly, the emission from the singlet excitons is rapidly reduced after pulse laser radiation.

On the other hand, since delayed fluorescence provides emission from singlet excitons generated through long-life triplet excitons, emission is gradually reduced. There is thus a large difference in time between emission from the singlet excitons generated by the initial PL excitation and emission from the singlet excitons generated via triplet excitons. Accordingly, a luminous intensity derived from delayed fluorescence is obtainable.

Fig. 2 schematically shows an exemplary device for measuring transient PL.

A transient PL measurement device 100 of the first exemplary embodiment includes: a pulse laser unit 101 capable of emitting light with a predetermined wavelength; a sample chamber 102 configured to house a measurement sample; a spectrometer 103 configured to disperse light emitted from the measurement sample; a streak camera 104 configured to form a two-dimensional image; and a personal computer 105 configured to analyze the two-dimensional image imported thereinto. It should be noted that transient PL may be measured by a device different from one described in the first exemplary embodiment.

The sample to be housed in the sample chamber 102 is prepared by forming a thin film, which is made of a matrix material doped with a doping material at a concentration of 12 mass%, on a quartz substrate.

The thus-obtained thin film sample is housed in the sample chamber 102, and is irradiated with a pulse laser emitted from the pulse laser unit 101 to excite the doping material. The emitted excitation light is taken in a 90-degree direction with respect to the irradiation direction of the excitation light, and is dispersed by the spectrometer 103. A two-dimensional image of the light is formed through the streak camera 104. In the thus-obtained two-dimensional image, an ordinate axis corresponds to time, an abscissa axis corresponds to wavelength, and a bright spot corresponds to luminous intensity. The two-dimensional image is taken at a predetermined time axis, thereby obtaining an emission spectrum with an ordinate axis representing luminous intensity and an abscissa axis representing wavelength. Further, the two-dimensional image is taken at a wavelength axis, thereby obtaining a decay curve (transient PL) with an ordinate axis representing the logarithm of luminous intensity and an abscissa axis representing time.

For instance, using a reference compound H1 below as the matrix material and a reference compound D1 as the doping material, a thin film sample A was prepared as described above and the transitional PL was measured.

[Formula 26]

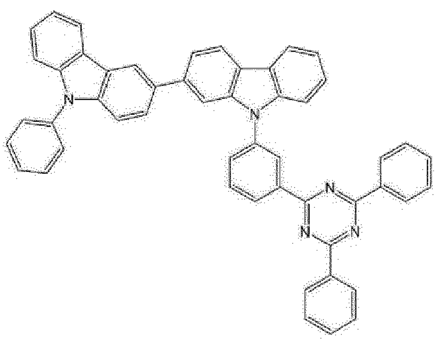

(Reference Compound H1)

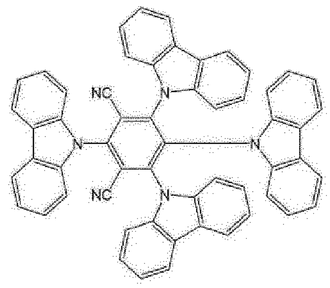

(Reference Compound D1)

The decay curve was analyzed with respect to the above thin film sample A and a thin film sample B. The thin film sample B was prepared as described above, using a reference compound H2 below as the matrix material and the reference compound D1 as the doping material.

Fig. 3 schematically shows decay curves obtained from transient PL obtained by measuring the respective thin film samples A and B.

[Formula 27]

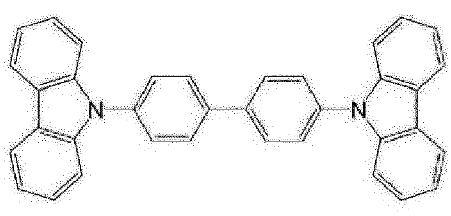

(Referemce Compound H2)

As described above, an emission decay curve with an ordinate axis representing luminous intensity and an

abscissa axis representing time can be obtained by the transient PL measurement. Based on the emission decay curve, a fluorescence intensity ratio between fluorescence in the single state generated by light excitation and the delayed fluorescence in the singlet state generated by the inverse energy transfer through the triplet state can be estimated. In a delayed fluorescent material, a ratio of the intensity of the slowly decaying delayed fluorescence to the intensity of the promptly decaying fluorescence is relatively large.

In the first exemplary embodiment, the luminescence amount of the delayed fluorescence can be obtained using the device shown in Fig. 2. Emission from the first compound includes: Prompt emission observed immediately when the excited state is achieved by exciting the first compound with a pulse beam (i.e., a beam emitted from a pulse laser unit) having an absorbable wavelength; and Delayed emission observed not immediately when but after the excited state is achieved. In the first exemplary embodiment, when the amount of Prompt emission is denoted by $X_P$ and the amount of Delayed emission is denoted by $X_D$, a value of $X_D/X_P$ is preferably 0.05 or more.

The amount of Prompt emission and the amount of Delayed emission can be obtained through the same method as a method described in "Nature 492, 234-238, 2012." The amount of Prompt emission and the amount of Delayed emission may be calculated using a device different from one described in the above Reference Literature.

For instance, a sample usable for measuring the delayed fluorescence may be prepared by co-depositing the first compound and a compound TH-2 below on a quartz substrate at a ratio of the first compound being 12 mass% to form a 100-nm-thick thin film.

[Formula 28]

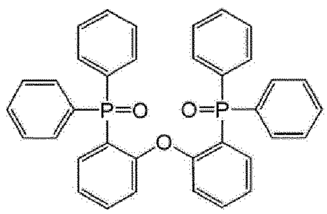

TH-2

Method of Manufacturing First Compound

The first compound can be exemplarily manufactured through a method described in Chemical Communications p.10385-10387 (2013) and NATURE Photonics p.326-332 (2014). Moreover, the first compound can be exemplarily manufactured by a method described in International Publications WO2013/180241, WO2014/092083, WO2014/104346 and the like. Furthermore, the first compound can be exemplarily manufactured with use of a known alternative reaction and a starting material depending on a target object with reference to a reaction described later in Examples.

Specific examples of the first compound of the exemplary embodiment are shown below. The first compound according to the invention is not limited to these specific examples.

[Formula 34]

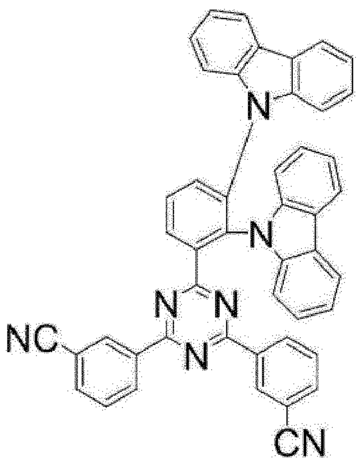

[Formula 45]

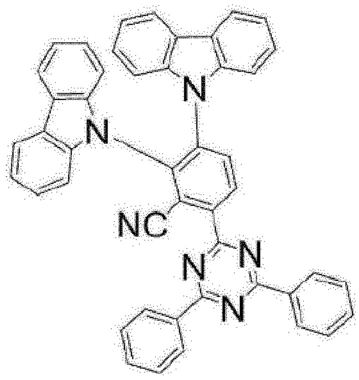

[Formula 46]

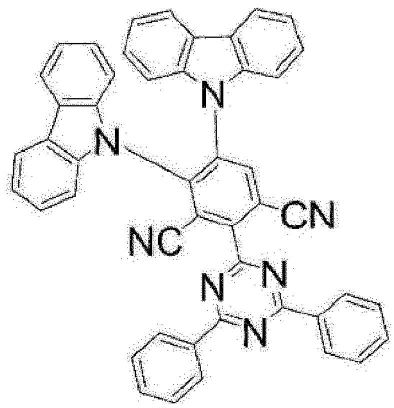

[Formula 48]

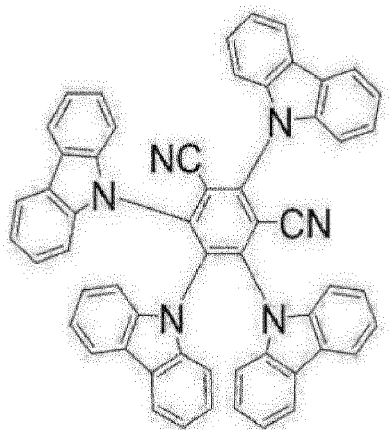

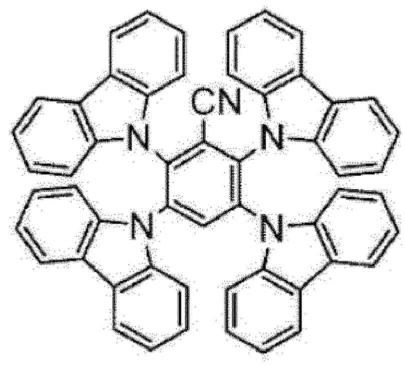

[Formula 49]

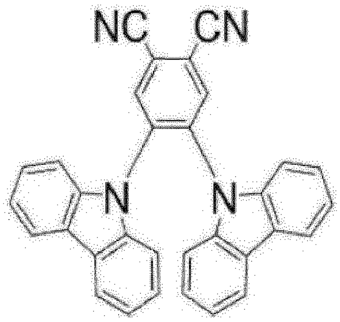

[Formula 50]

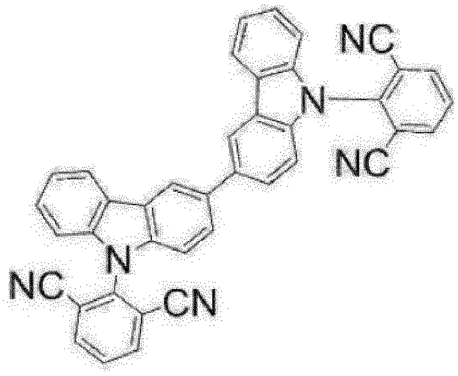

[Formula 65]

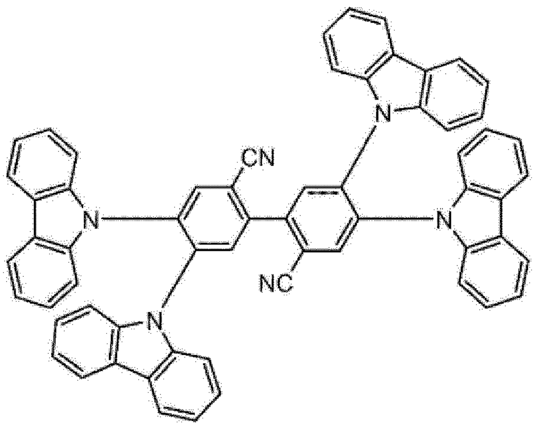

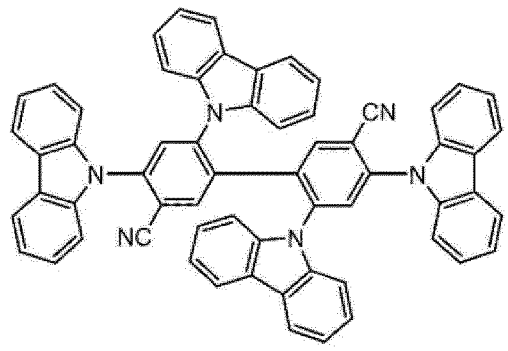

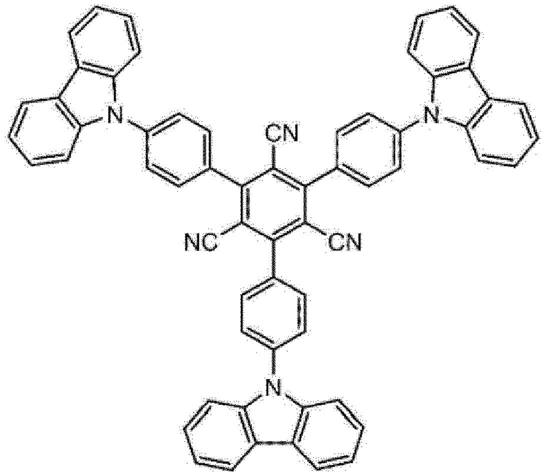

[Formula 66]

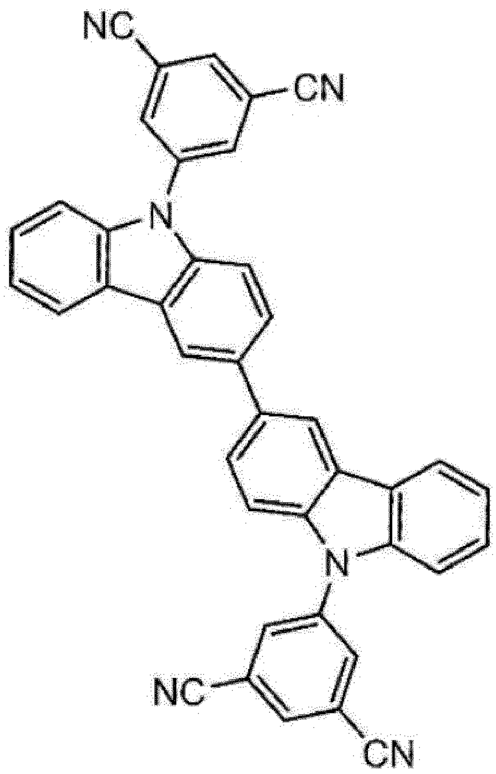

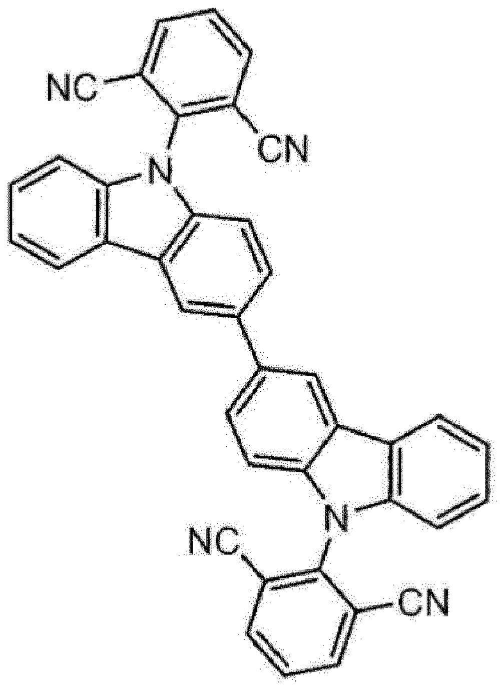

[Formula 67]

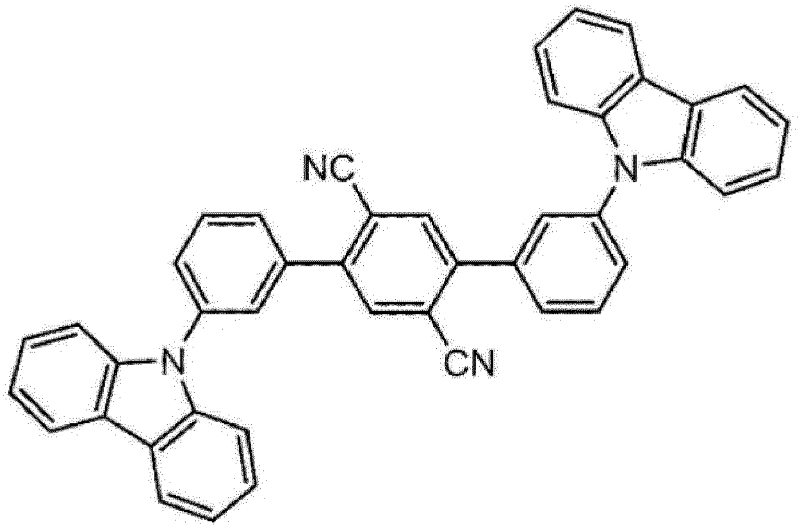

[Formula 68]

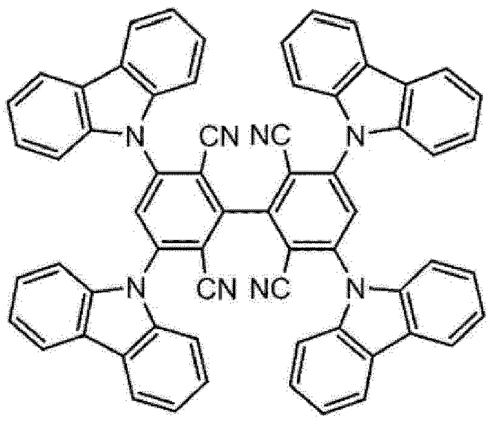

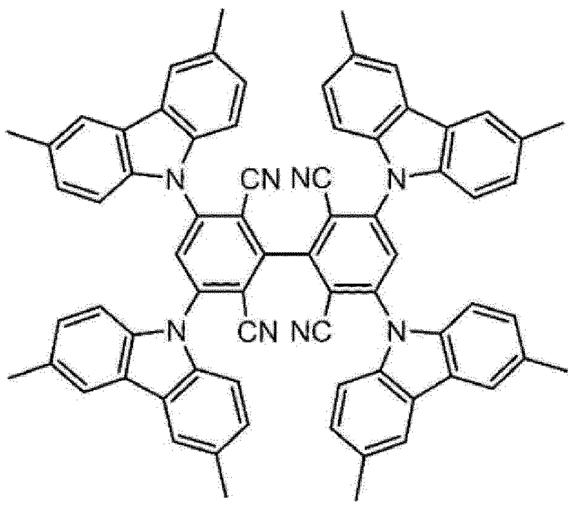

Second Compound

The second compound is represented by a formula (2) below.

In the organic EL device of the first exemplary embodiment, the second compound is sometimes a delayed fluorescent (thermally activated delayed fluorescent) compound.

When the second compound is a delayed fluorescent compound, the delayed fluorescence of the second compound can be determined through a measurement method disclosed in Non-Patent Literature 1. For instance, Non-Patent Literature 1 discloses that a compound BN-1 (an example of the second compound) used in Example exhibits delayed fluorescence through the measurement method described in Non-Patent Literature 1.

[Formula 69]

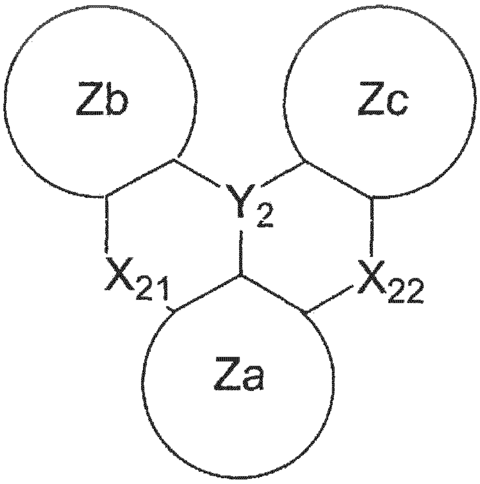

(2)

In the formula (2): Za ring, Zb ring and Zc ring are each independently a cyclic structure selected from the group consisting of a substituted or unsubstituted aryl ring having 6 to 30 ring carbon atoms, and a substituted or unsubstituted heteroaryl ring having 5 to 30 ring atoms;

$X_{21}$ and $X_{22}$ are each independently an oxygen atom, NRa (a nitrogen atom having a substituent Ra), or a sulfur atom;
when $X_{21}$ is NRa, Ra is bonded to Za ring or Zb ring to form a ring or is not bonded to form no ring;
When $X_{22}$ is NRa, Ra is bonded to Za ring or Zc ring to form a ring or is not bonded to form no ring;
Ra is each independently a group selected from the group consisting of a substituted or unsubstituted aryl group having 6 to 30 ring carbon atoms, a substituted or unsubstituted heteroaryl group having 5 to 30 ring atoms, and a substituted or unsubstituted alkyl group having 1 to 30 carbon atoms;
$Y_2$ is any one of a boron atom, a phosphorus atom, SiRb (a silicon atom having a substituent Rb), P=O, and P=S; and
Rb is each independently a group selected from the group consisting of a substituted or unsubstituted aryl group having 6 to 30 ring carbon atoms, a substituted or unsubstituted heteroaryl group having 5 to 30 ring atoms, and a substituted or unsubstituted alkyl group having 1 to 30 carbon atoms.

In the organic EL device according to the first exemplary embodiment, Ra in the formula (2) is preferably a substituted or unsubstituted aryl group having 6 to 30 ring carbon atoms, more preferably a substituted or unsubstituted phenyl group.

In the organic EL device according to the first exemplary embodiment, Za ring, Zb ring, and Zc ring in the formula (2) are preferably each independently a substituted or unsubstituted aryl ring having 6 to 30 ring carbon atoms.

In the organic EL device according to the first exemplary embodiment, when $X_{21}$ in the formula (2) is NRa, Ra is also preferably not bonded to any of Za ring and Zb ring to form no ring.

In the organic EL device according to the first exemplary embodiment, when $X_{22}$ in the formula (2) is NRa, Ra is also preferably not bonded to any of Za ring and Zc ring to form no ring.

In the organic EL device according to the first exemplary embodiment, the compound represented by the formula (2) is also preferably a compound symmetric about an x-y axis below.

[Formula 70]

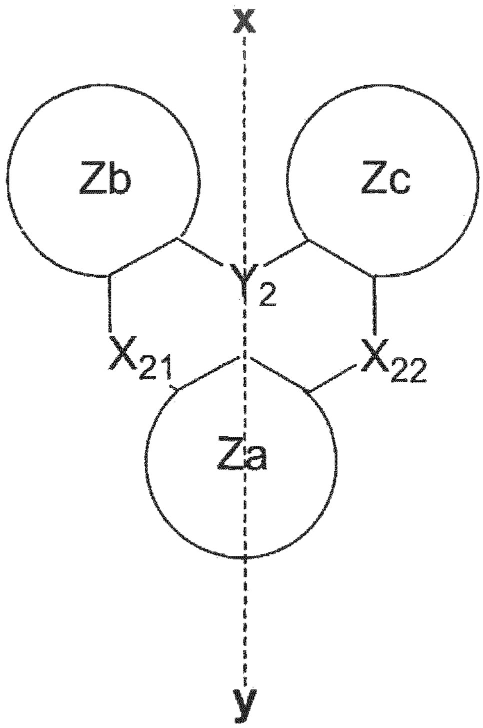

In the organic EL device of the first exemplary embodiment, $Y_2$ in the formula (2) is preferably a boron atom.

In the organic EL device of the first exemplary embodiment, the second compound is also preferably a compound represented by a formula (2A) below.

[Formula 71]

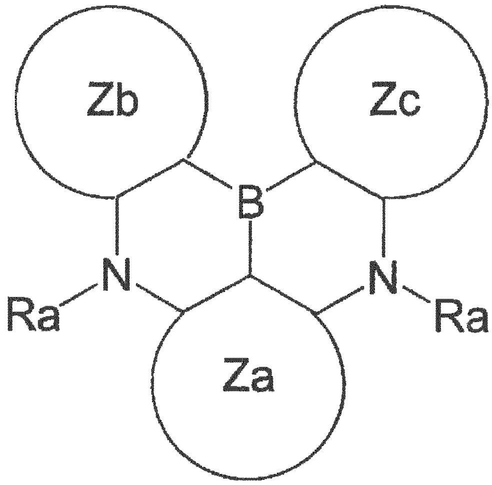

(2A)

In the formula (2A), Za ring, Zb ring, Zc ring, and Ra represent the same as Za ring, Zb ring, Zc ring, and Ra in the formula (2), respectively.

In the organic EL device according to the first exemplary embodiment, Za ring, Zb ring and Zc ring in the formula (2A) are preferably each independently a substituted or unsubstituted aryl ring having 6 to 30 ring carbon atoms.

In the organic EL device according to the first exemplary embodiment, Ra in the formula (2A) is preferably a substituted or unsubstituted aryl group having 6 to 30 ring carbon atoms, more preferably a substituted or unsubstituted phenyl group.

In the organic EL device of the first exemplary embodiment, it is also preferable that Ra in the formula (2A) is

not bonded to any of Za ring and Zb ring to form no ring, and Ra in the formula (2A) is not bonded to any of Za ring and Zc ring to form no ring.

In the organic EL device of the first exemplary embodiment, the second compound is also preferably a compound represented by a formula (20) below.

[Formula 72]

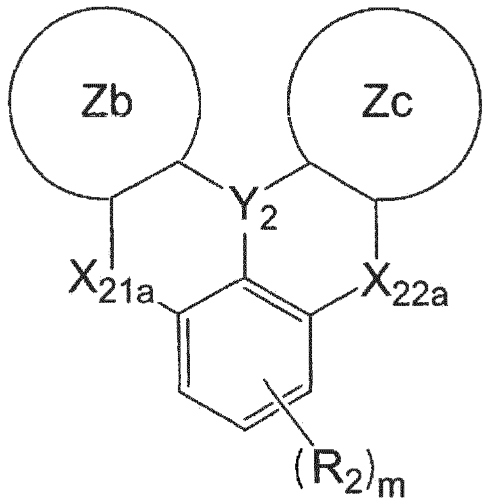

(20)

In the formula (20): $X_{21a}$ and $X_{22a}$, which are mutually the same, are any one of oxygen atoms, NRa (nitrogen atoms each having a substituent Ra), and sulfur atoms;

m is 3;
$R_2$ are each independently a hydrogen atom or a substituent; and
$R_2$ serving as the substituents are each independently a group selected from the group consisting of a substituted or unsubstituted aryl group having 6 to 30 ring carbon atoms, a substituted or unsubstituted heteroaryl group having 5 to 30 ring atoms;
a substituted or unsubstituted alkyl group having 1 to 30 carbon atoms, a substituted or unsubstituted aryloxy group having 6 to 30 ring carbon atoms, a substituted or unsubstituted amino group, and a substituted silyl group.

In the formula (20), Zb ring, Zc ring, $Y_2$, and Ra represent the same as Zb ring, Zc ring, $Y_2$, and Ra in the formula (2), respectively.

In the formula (20), when $R_2$ is a substituted or unsubstituted amino group, the amino group may be a cyclic amino group. The ring of the cyclic amino group may include one or two hetero atoms selected from the group consisting of a nitrogen atom, an oxygen atom, and a sulfur atom. Examples of the cyclic amino group include a piperidinyl group and a morpholinyl group.

In the organic EL device of the first exemplary embodiment, $Y_2$ in the formula (20) is preferably a boron atom.

In the organic EL device according to the first exemplary embodiment, Zb ring and Zc ring in the formula (20) are preferably each independently a substituted or unsubstituted aryl ring having 6 to 30 ring carbon atoms.

In the organic EL device of the first exemplary embodiment, the second compound is also preferably a compound represented by a formula (20A) below.

[Formula 73]

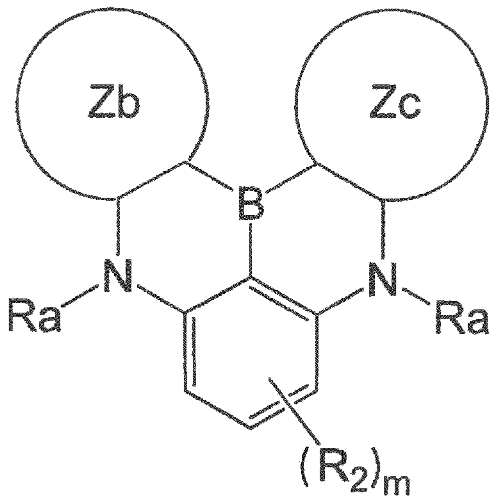

(20A)

In the formula (20A), Zb ring, Zc ring, Ra, $R_2$, and m represent the same as Zb ring, Zc ring, Ra, $R_2$, and m in the formula (20), respectively.

In the organic EL device according to the first exemplary embodiment, Zb ring and Zc ring in the formula (20A) are preferably each independently a substituted or unsubstituted aryl ring having 6 to 30 ring carbon atoms.

In the organic EL device according to the first exemplary embodiment, Ra in the formula (20A) is preferably a substituted or unsubstituted aryl group having 6 to 30 ring carbon atoms, more preferably a substituted or unsubstituted phenyl group.

In the organic EL device of the first exemplary embodiment, it is also preferable that Ra in the formula (20A) is not bonded to any of Za ring in a form of a benzene ring and Zb ring to form no ring, and Ra in the formula (20A) is not bonded to any of Za ring in a form of a benzene ring and Zc ring to form no ring.

In the organic EL device of the first exemplary embodiment, the second compound is also preferably a compound represented by a formula (21) below.

[Formula 74]

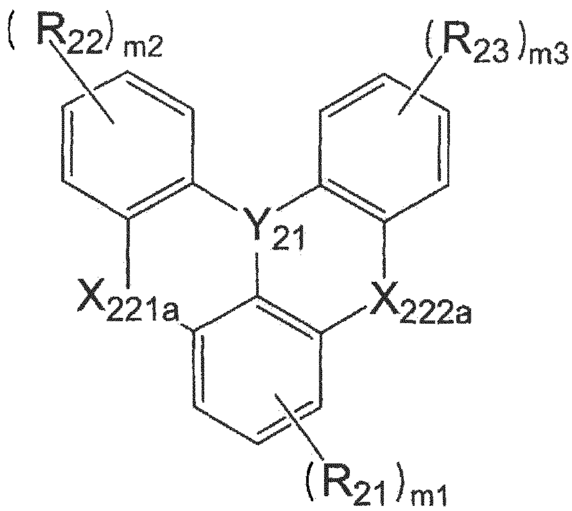

(21)

In the formula (21): $X_{221a}$ and $X_{222a}$, which are mutually the same, are any one of oxygen atoms, NRa (carbon atoms each having a substituent Ra), and sulfur atoms;

m1 is 3, and each of m2 and m3 is 4;

$R_{21}$ to $R_{23}$ are each independently a hydrogen atom or a substituent;

$R_{21}$ to $R_{23}$ serving as the substituents are each independently a group selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted aryloxy group having 6 to 30 ring carbon atoms, a substituted or unsubstituted amino group, and a substituted silyl group.

In the formula (21), $Y_{21}$ represents the same as $Y_2$ in the formula (2).

The substituted or unsubstituted amino group in the formula (21) may be a cyclic amino group. Examples of the cyclic amino group are the same as described above.

In the organic EL device of the first exemplary embodiment, $Y_{21}$ in the formula (21) is preferably a boron atom.

In the organic EL device according to the first exemplary embodiment, Ra in the formula (21) is preferably a substituted or unsubstituted aryl group having 6 to 30 ring carbon atoms, more preferably a substituted or unsubstituted phenyl group.

In the organic EL device of the first exemplary embodiment, it is also preferable that Ra in the formula (21) is not bonded to any of Za ring in a form of a benzene ring and Zb ring in a form of a benzene ring to form no ring, and Ra in the formula (21) is not bonded to any of Za ring in a form of a benzene ring and Zc ring in a form of a benzene ring to form no ring.

In the organic EL device of the first exemplary embodiment, the second compound is also preferably a compound represented by a formula (21A) below.

[Formula 75]

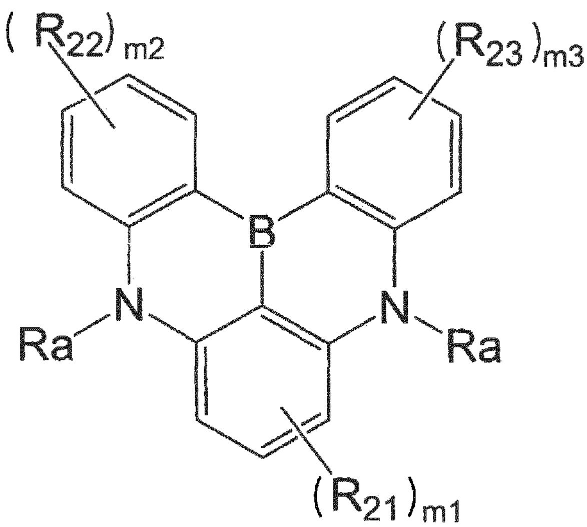

(21A)

Ra, m1 to m3, and $R_{21}$ to $R_{23}$ in the formula (21A) represent the same as Ra, m1 to m3, and $R_{21}$ to $R_{23}$ in the formula (21), respectively.

In the organic EL device according to the first exemplary embodiment, Ra in the formula (21A) is preferably a substituted or unsubstituted aryl group having 6 to 30 ring carbon atoms, more preferably a substituted or unsubstituted phenyl group.

In the organic EL device of the first exemplary embodiment, it is also preferable that Ra in the formula (21A) is not bonded to any of Za ring in a form of a benzene ring and Zb ring in a form of a benzene ring to form no ring, and Ra in the formula (21A) is not bonded to any of Za ring in a form of a benzene ring and Zc ring in a form of a benzene ring to form no ring.

The main peak wavelength of the second compound is preferably in a range from 430 nm to 480 nm, more preferably in a range from 445 nm to 480 nm.

The main peak wavelength herein means a peak wavelength of emission spectrum exhibiting a maximum luminous intensity among emission spectra measured in a toluene solution in which a target compound is dissolved at a concentration in a range from $10^{-6}$ mol/L to $10^{-5}$ mol/L

The second compound preferably emits a blue fluorescence.

The second compound is preferably a material with a high emission quantum efficiency.

Method of Manufacturing Compound

The manufacturing method of the second compound is not particularly limited, and the second compound can be manufactured through known methods.
Specific examples of the second compound of the exemplary embodiment are shown below. The second compound according to the invention is not limited to these specific examples.

R in the specific examples below are each independently a hydrogen atom or a substituent;
R serving as the substituents are each independently a group selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted aryloxy group having 6 to 30 ring carbon atoms, a substituted or unsubstituted amino group (including a cyclic amino group), and a substituted silyl group.

[Formula 76]

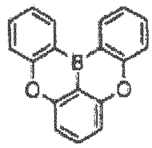
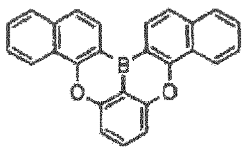
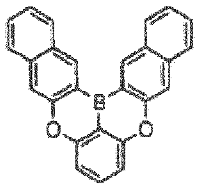
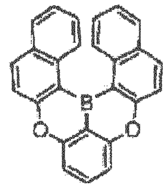

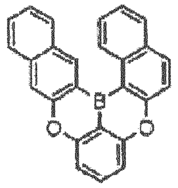
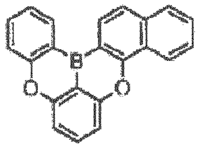
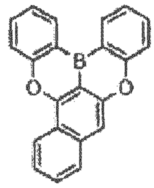
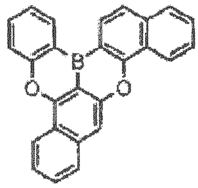

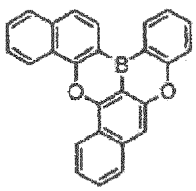
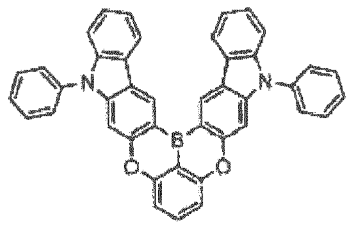
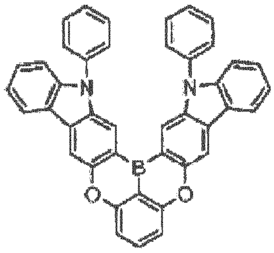

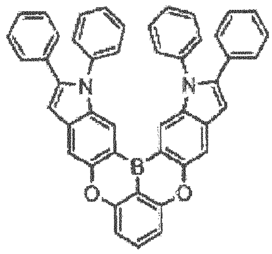
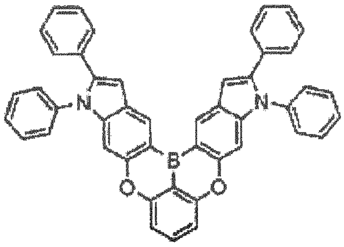
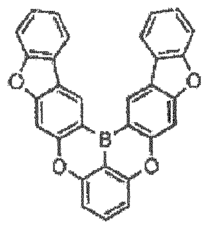

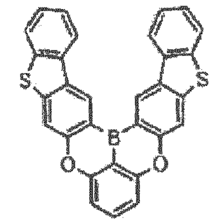
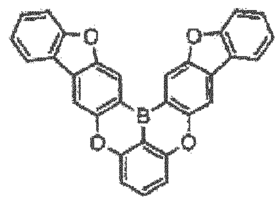
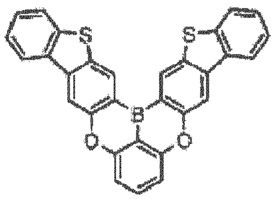

[Formula 77]

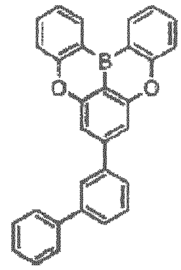
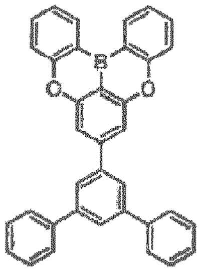
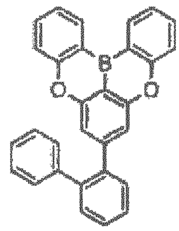
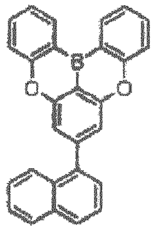
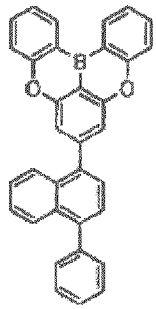
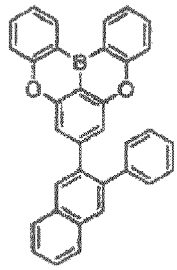
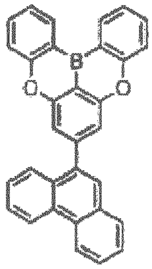
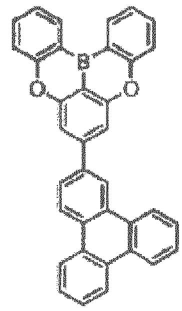
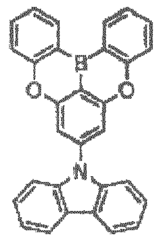
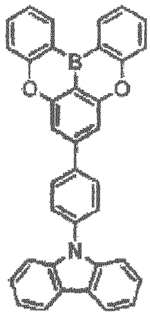
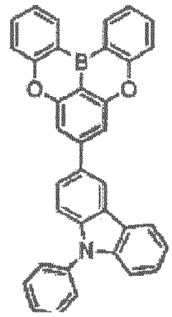
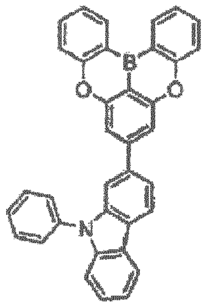

[Formula 78]

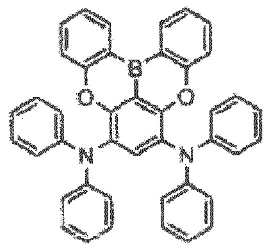

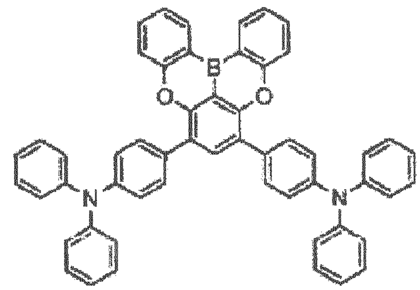

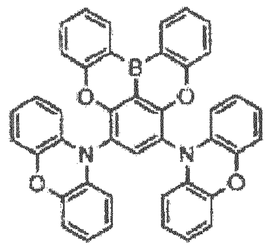

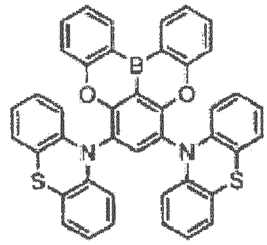

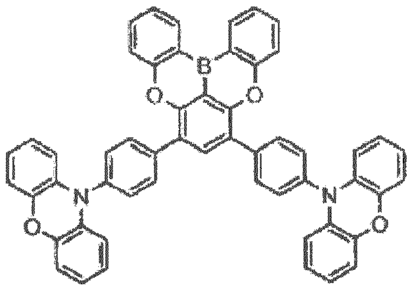

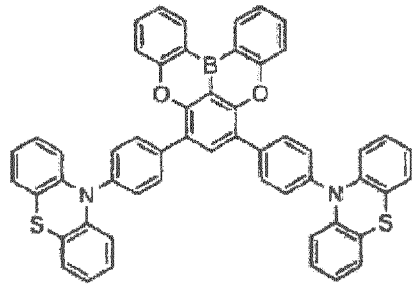

[Formula 79]

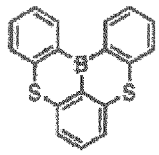
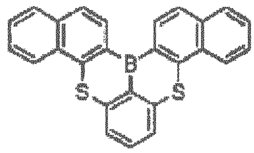
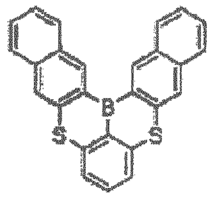

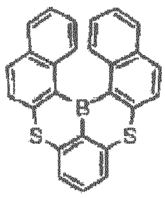
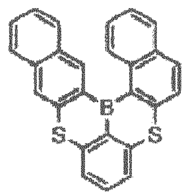
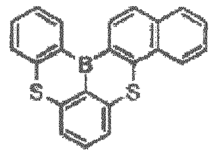

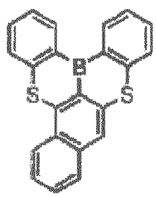
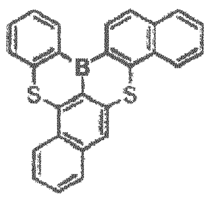
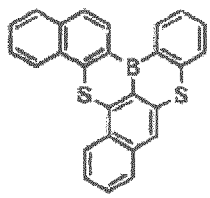

[Formula 80]

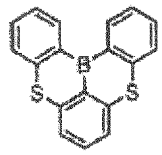

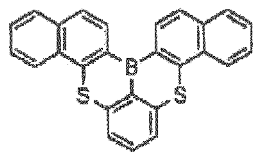

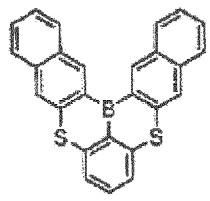

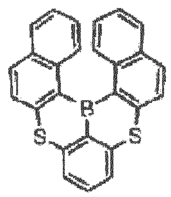

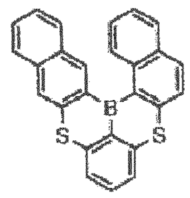

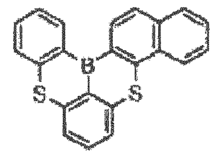

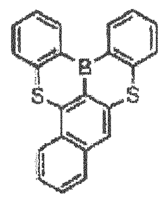

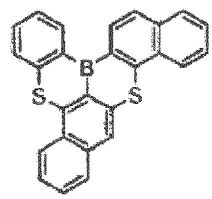

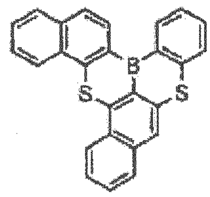

[Formula 81]

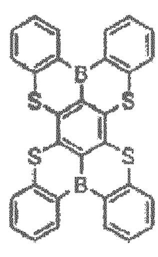
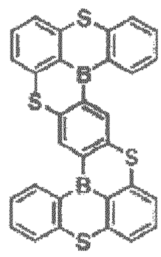
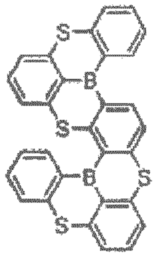
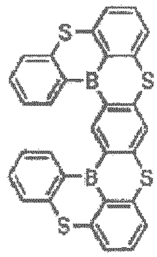

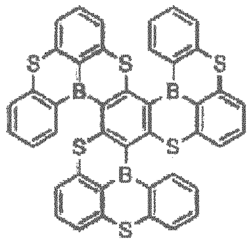

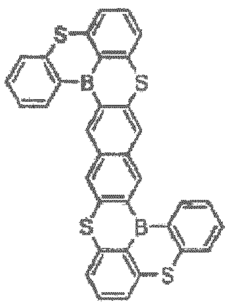
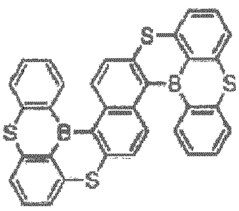
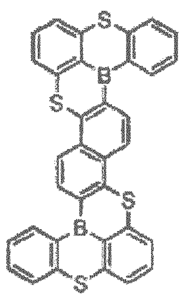
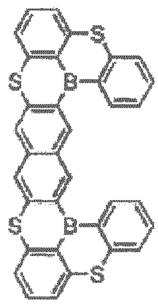

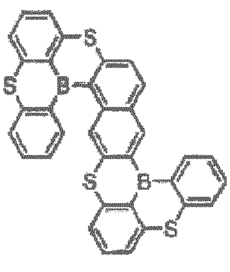
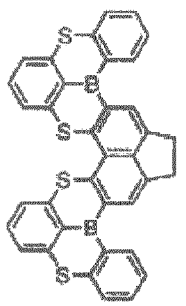
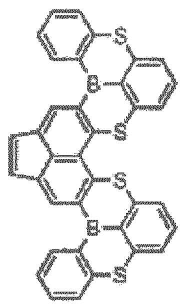

[Formula 82]

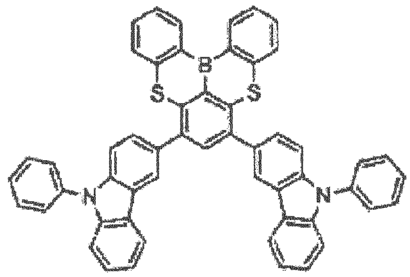

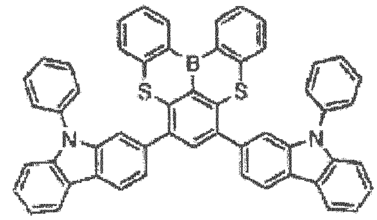

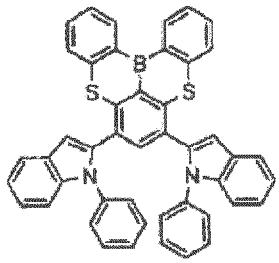

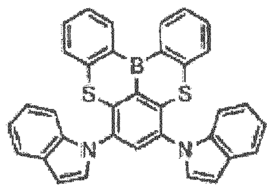

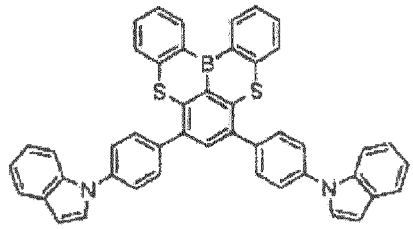

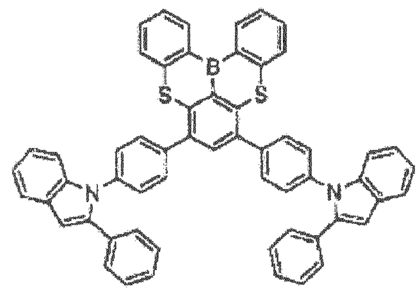

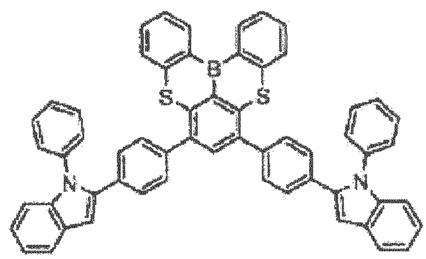

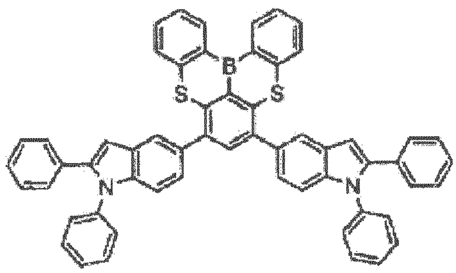

[Formula 83]

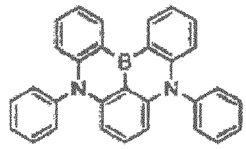
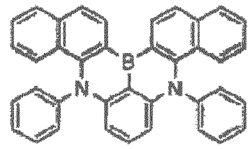
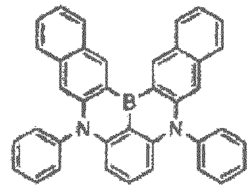
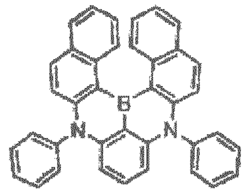
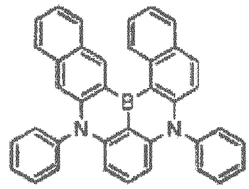
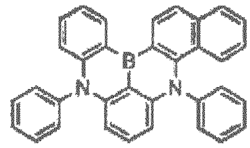
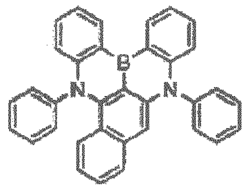
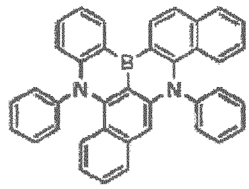
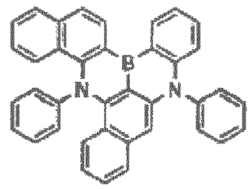
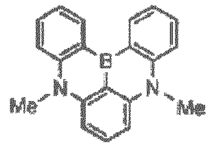
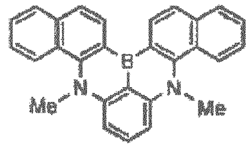
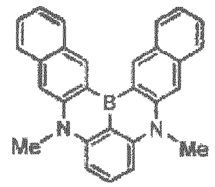
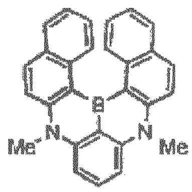
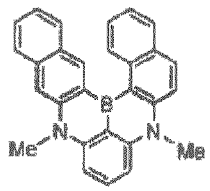
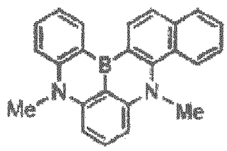
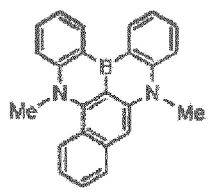
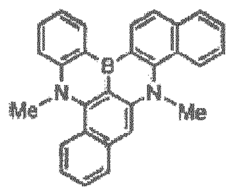
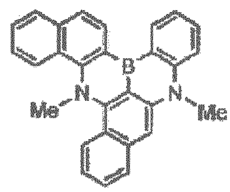

[Formula 84]

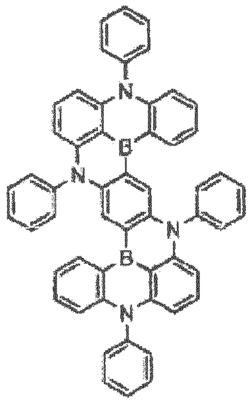

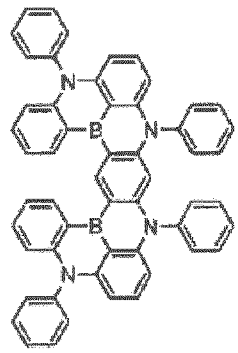

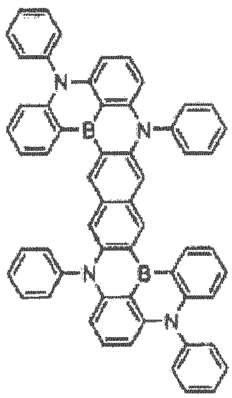

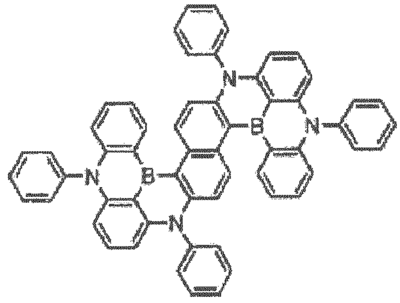

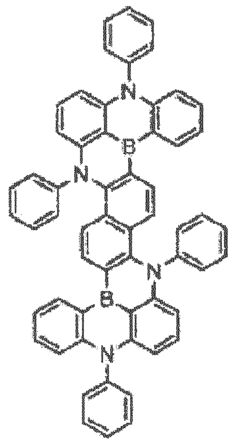

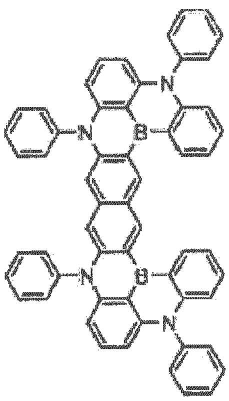

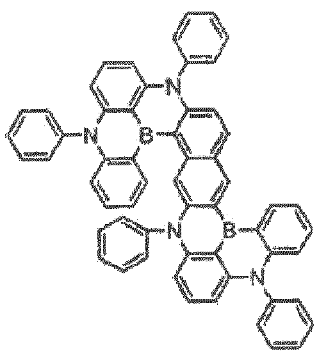

[Formula 85]

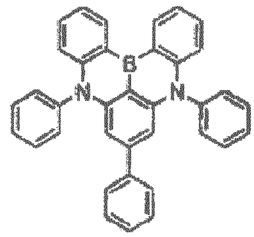

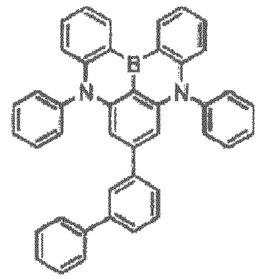

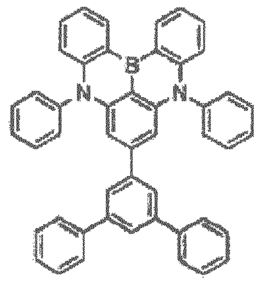

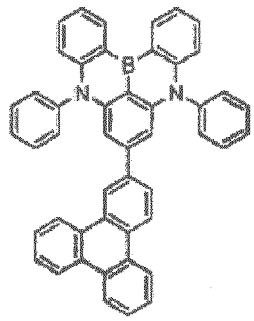

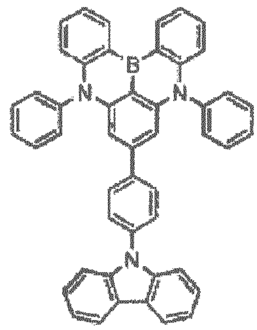

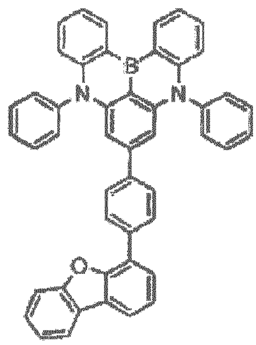

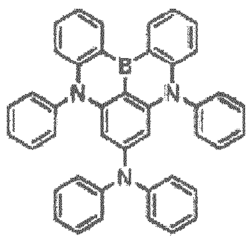

[Formula 86]

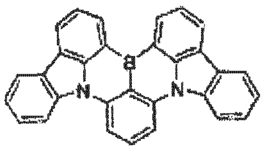
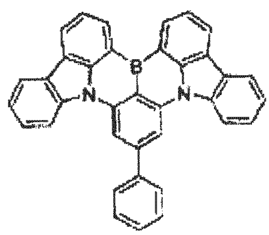
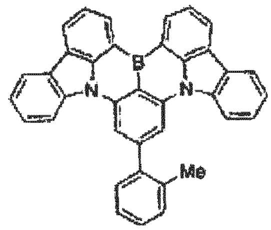
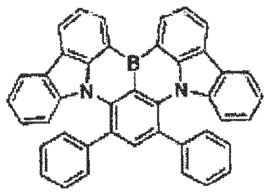
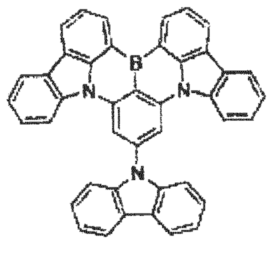
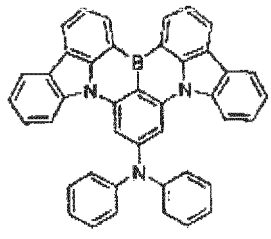
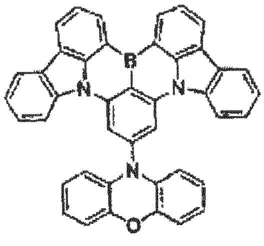
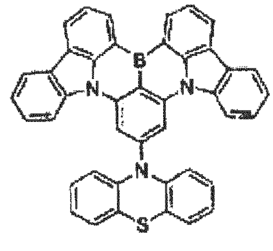
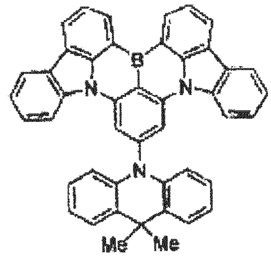
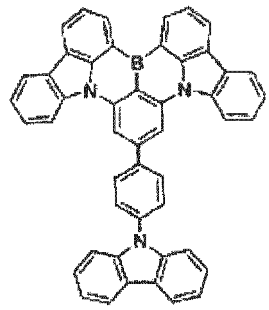
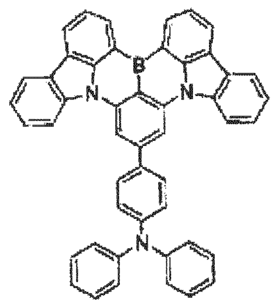
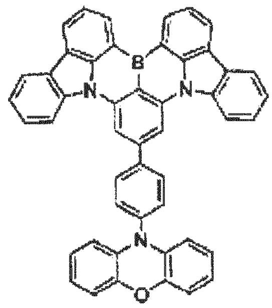
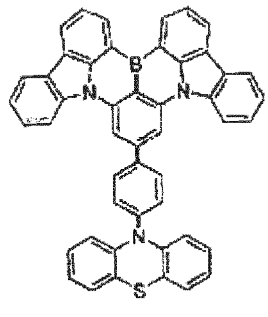
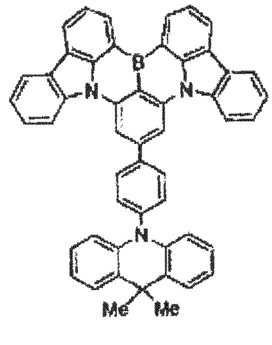

[Formula 87]

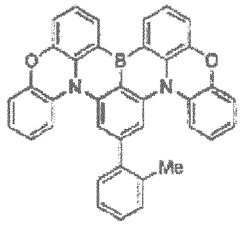
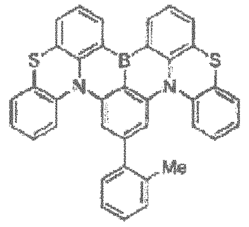
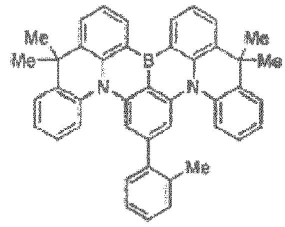
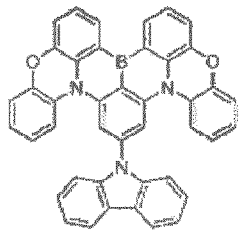
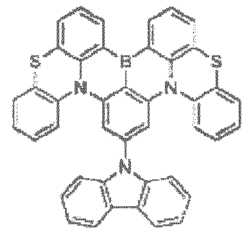
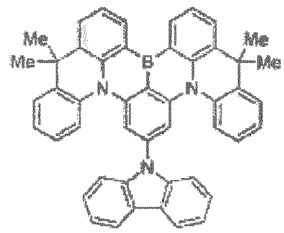
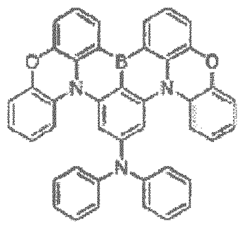
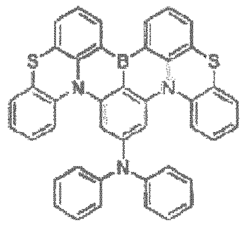
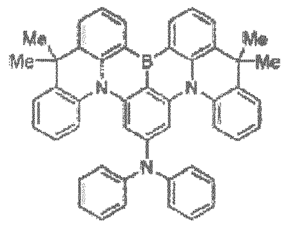
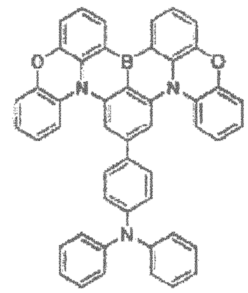
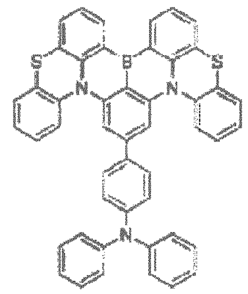
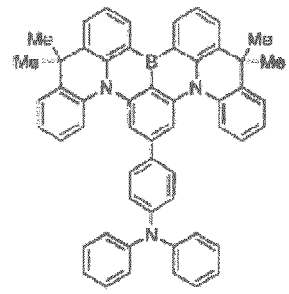
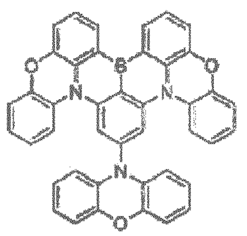
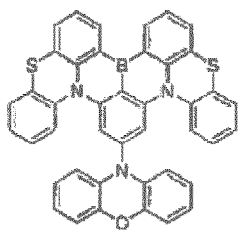
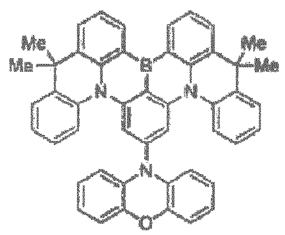

[Formula 88]

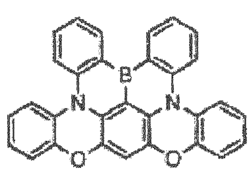
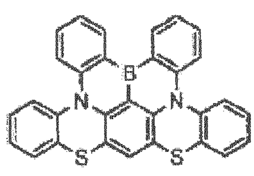
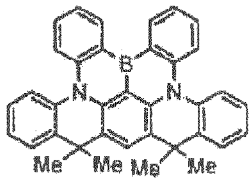

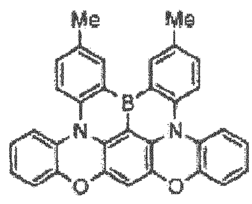
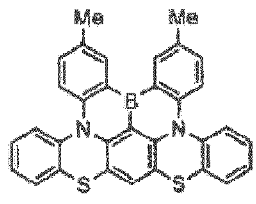
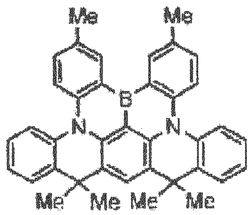

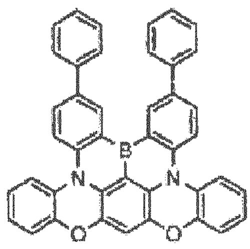
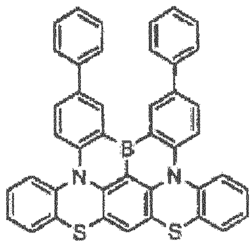
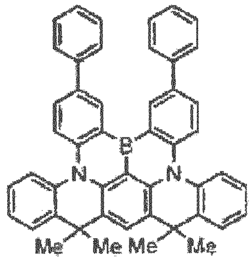

[Formula 89]

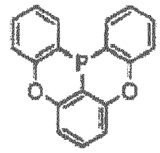
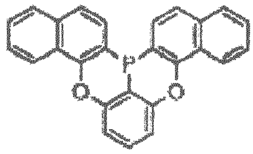
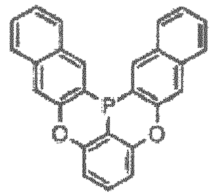

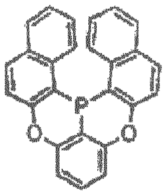
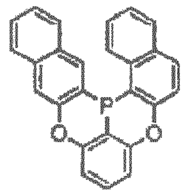
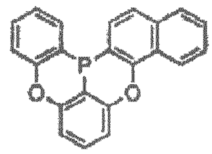

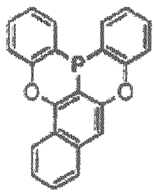
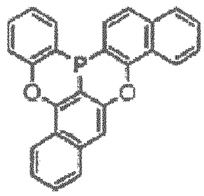
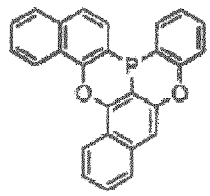

[Formula 90]

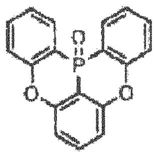

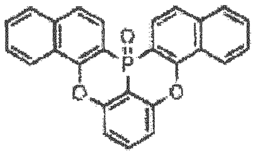

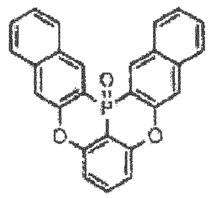

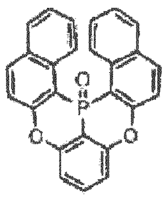

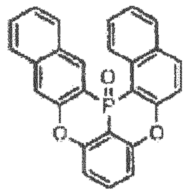

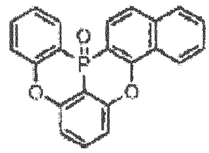

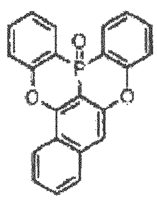

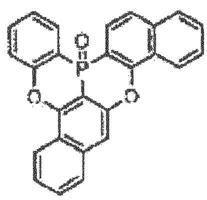

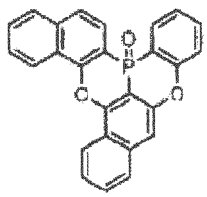

[Formula 91]

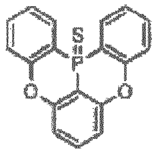

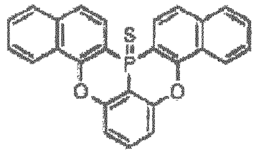

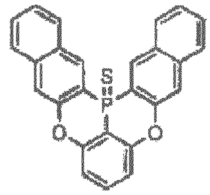

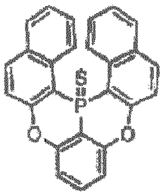

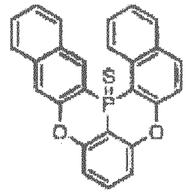

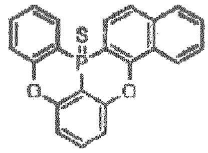

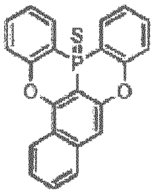

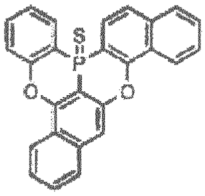

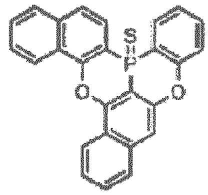

[Formula 92]

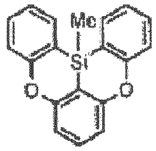
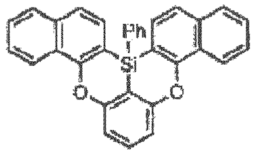
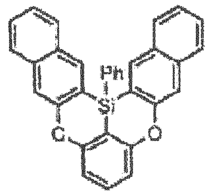
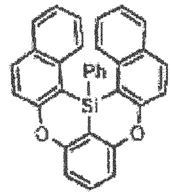

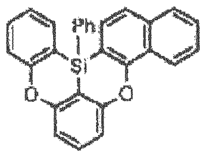
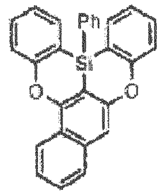
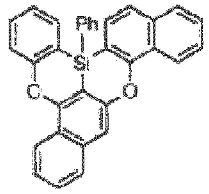
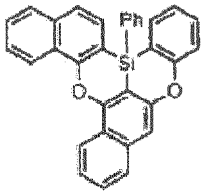

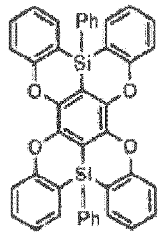
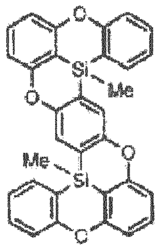

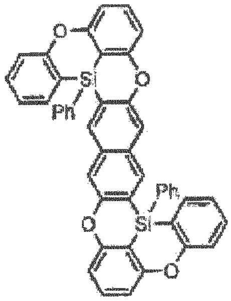
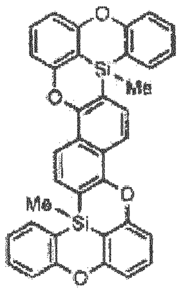
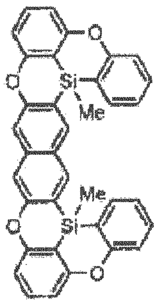

[Formula 93]

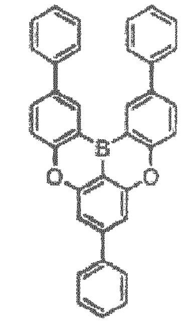
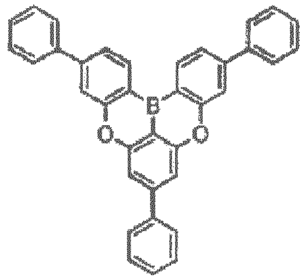
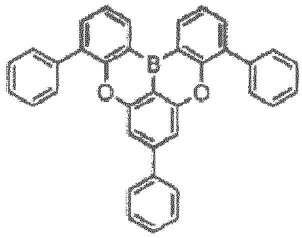

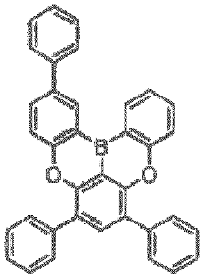
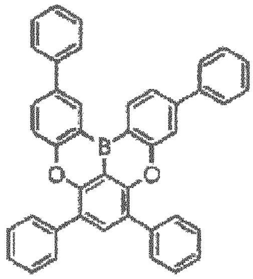
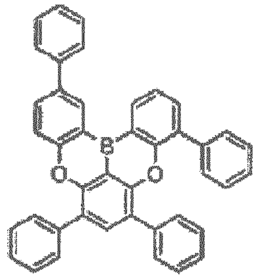

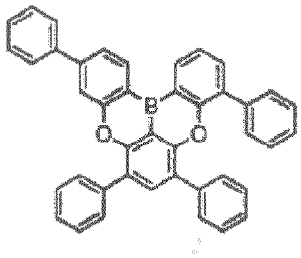

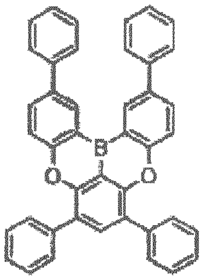
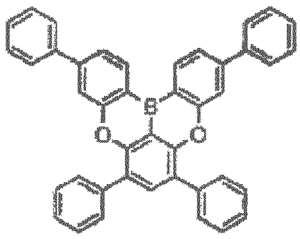
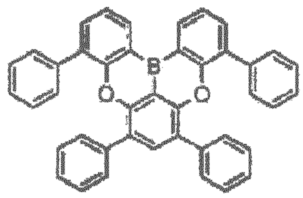

[Formula 94]

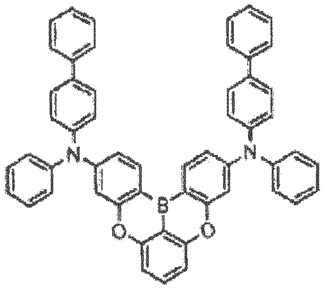

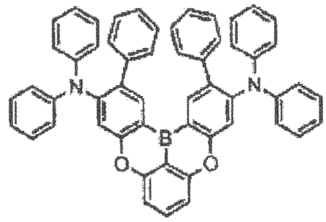

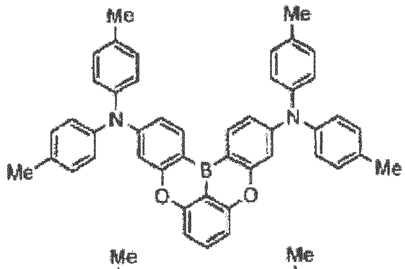

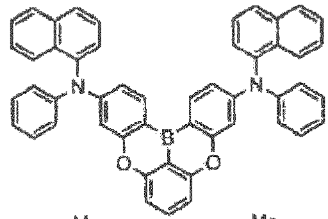

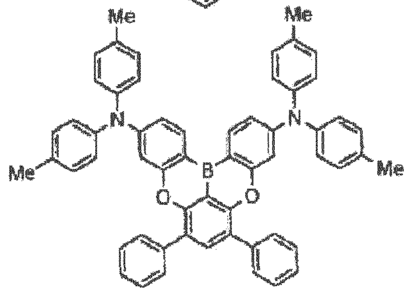

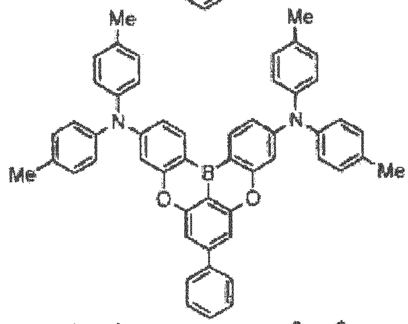

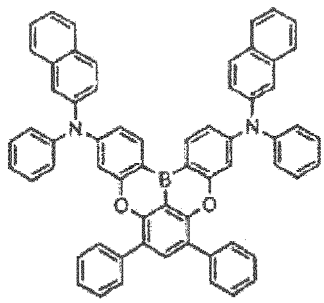

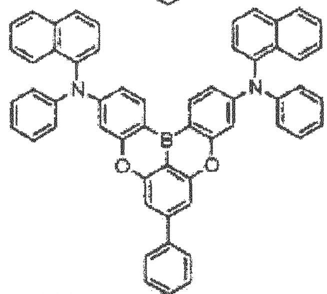

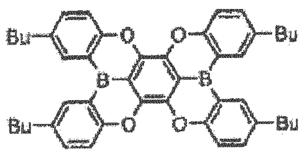

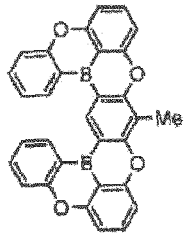

[Formula 95]

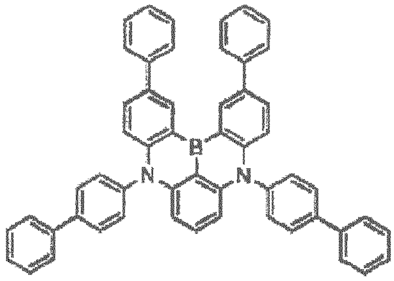

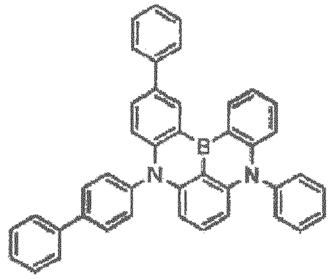

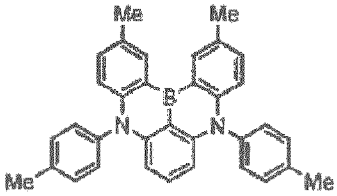

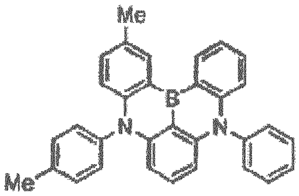

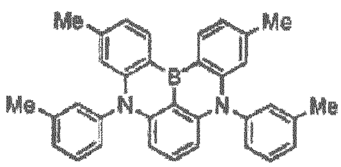

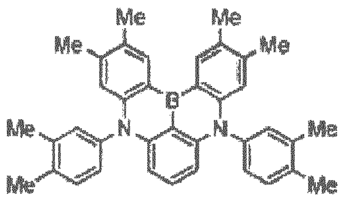

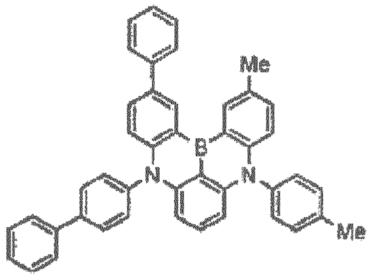

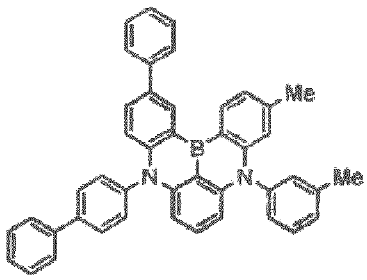

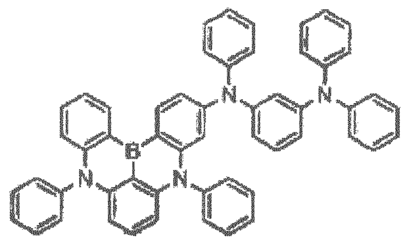

[Formula 96]

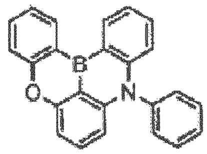

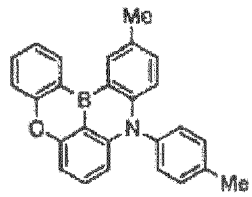

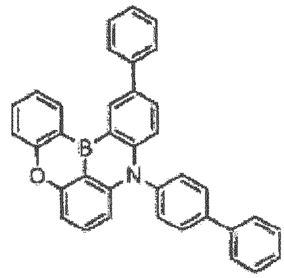

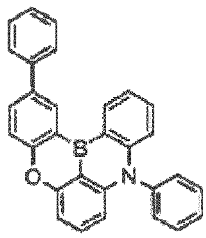

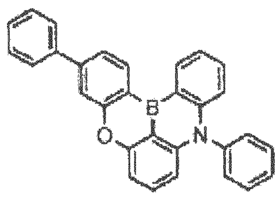

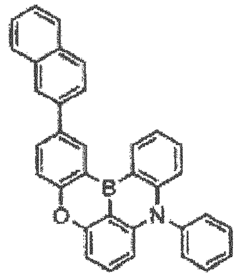

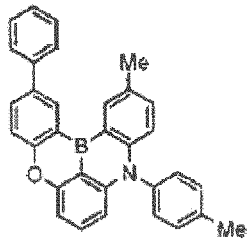

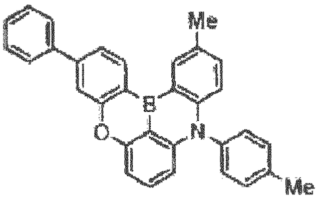

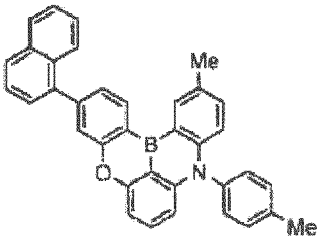

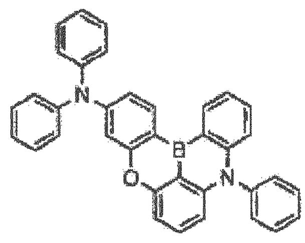

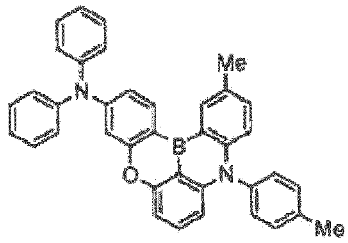

[Formula 97]

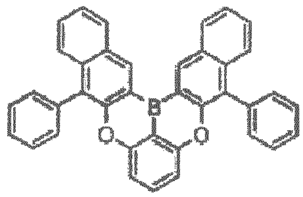

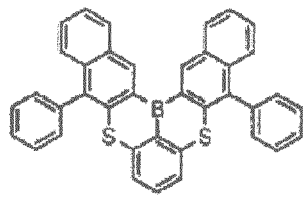

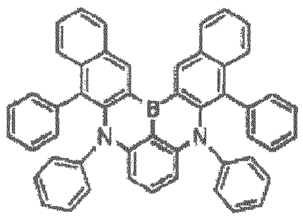

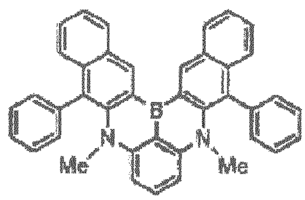

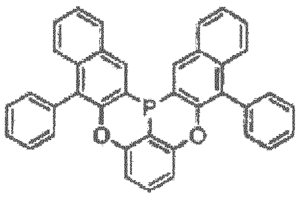

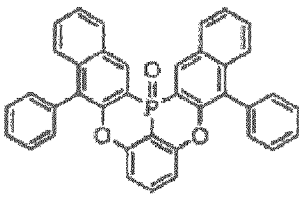

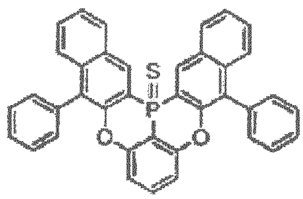

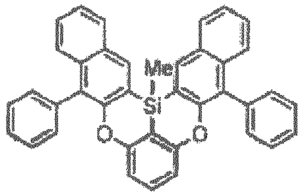

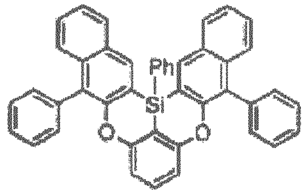

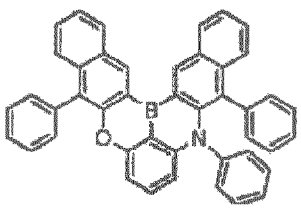

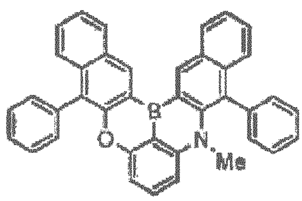

[Formula 98]

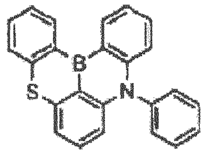
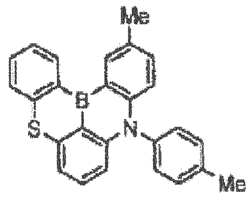
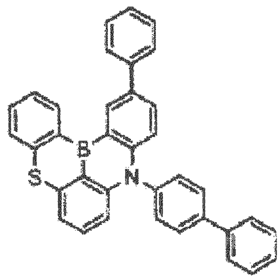

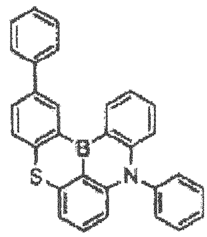
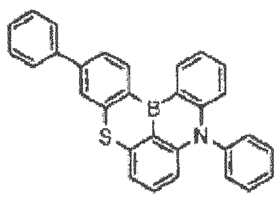
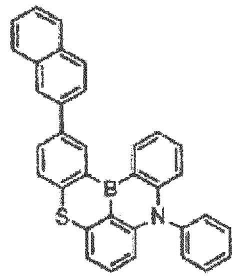

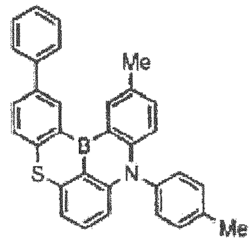
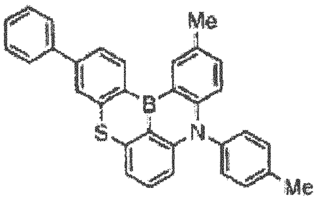
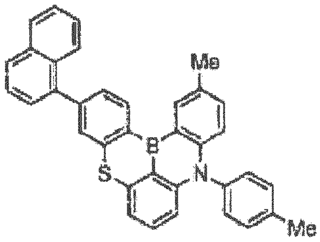

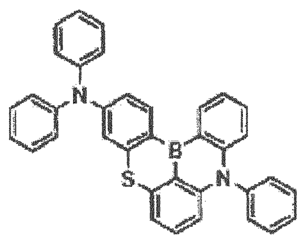
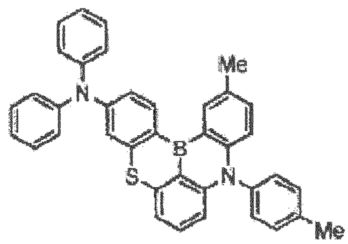

[Formula 99]

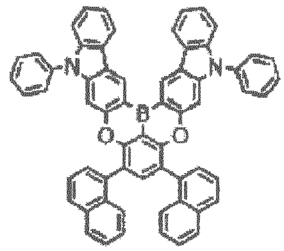
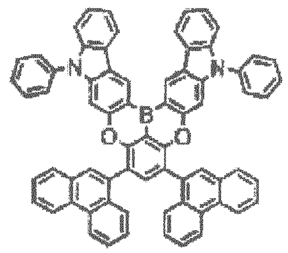
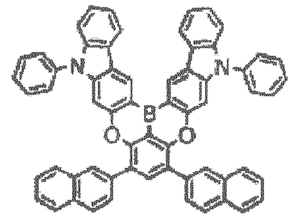

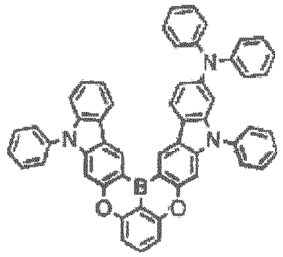
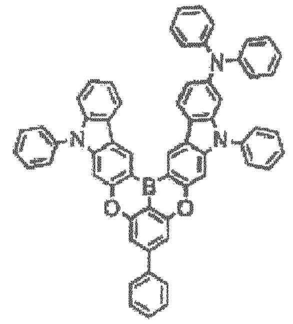
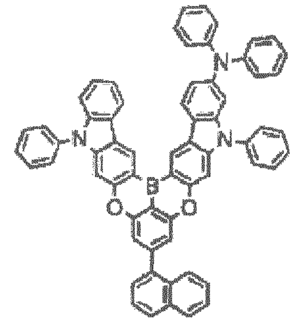

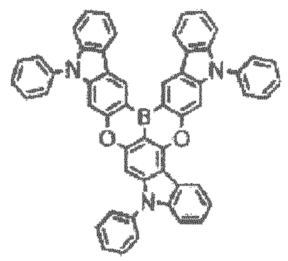
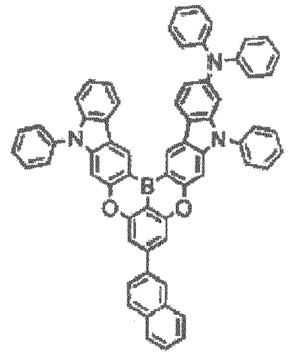
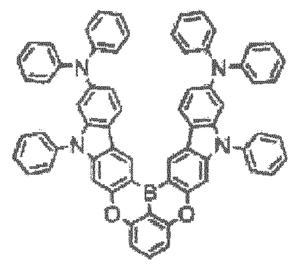

[Formula 100]

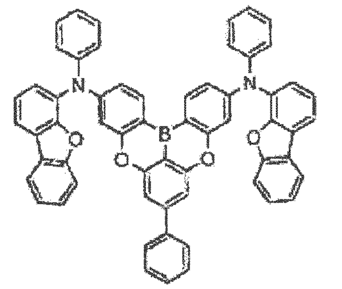

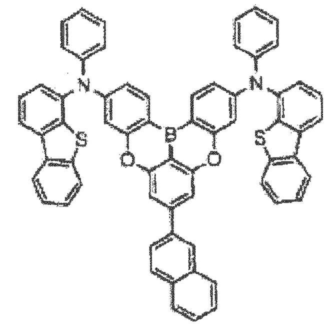

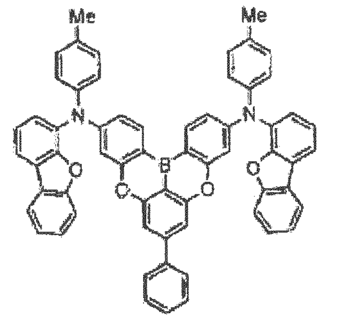

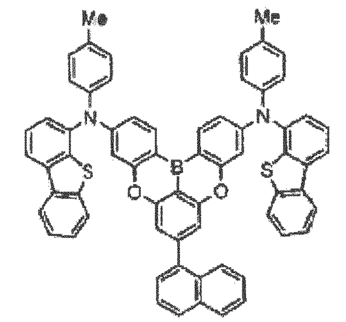

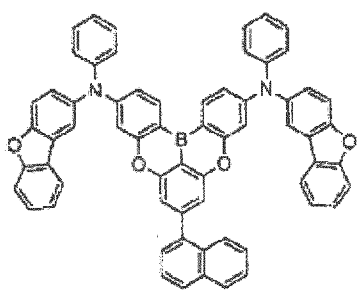

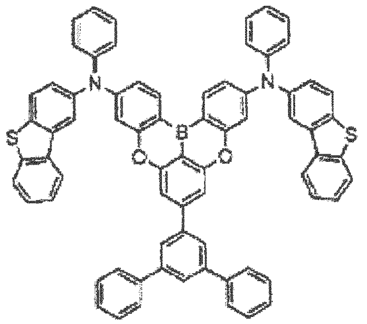

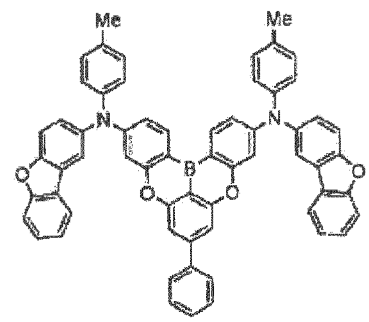

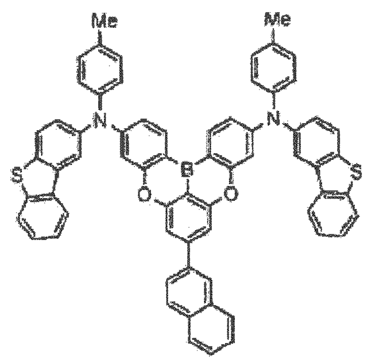

[Formula 101]

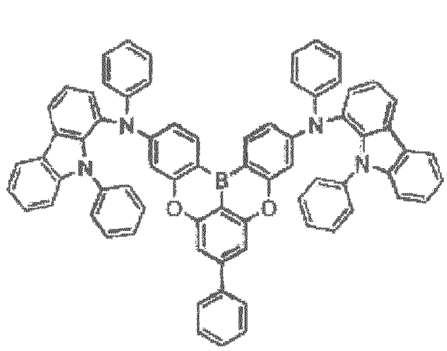

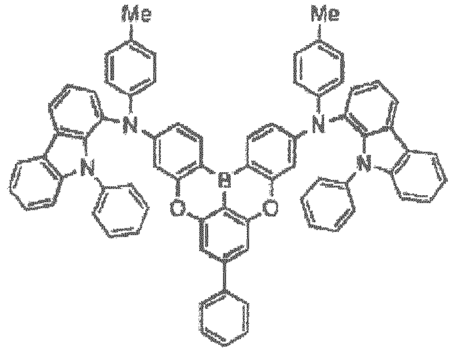

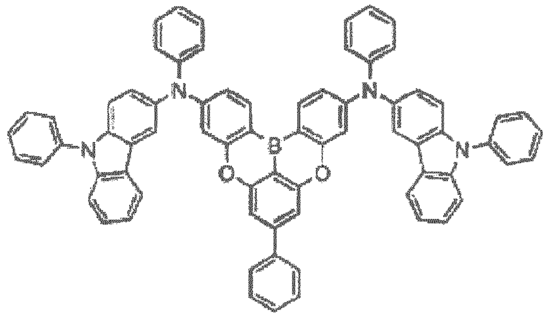

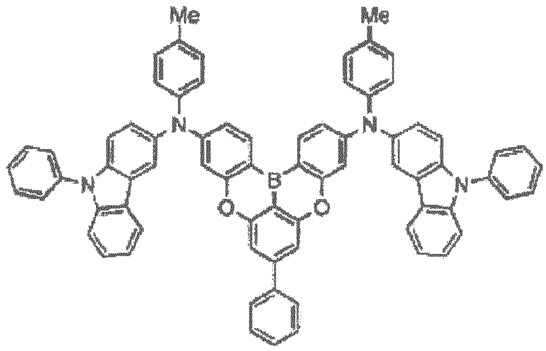

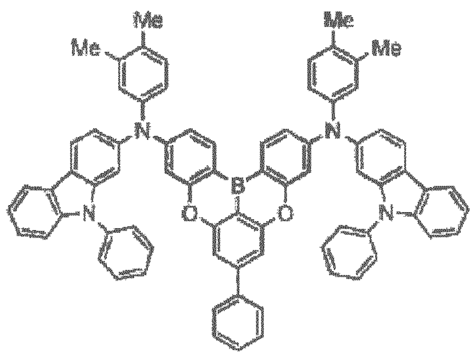

[Formula 102]

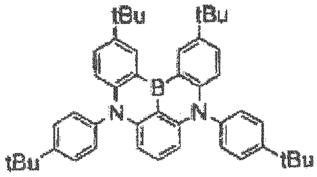
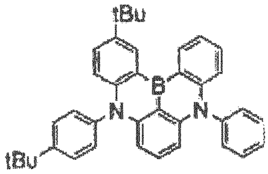

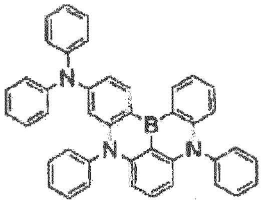
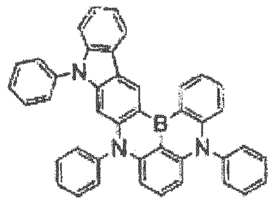
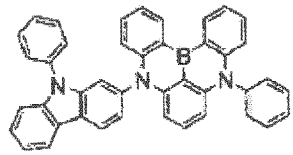

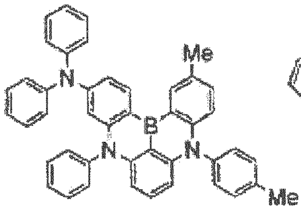
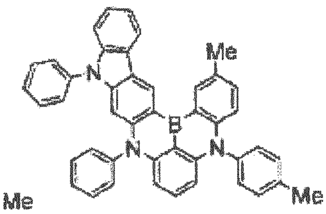
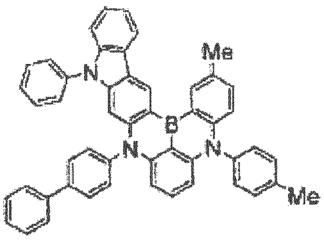

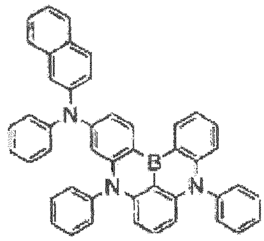
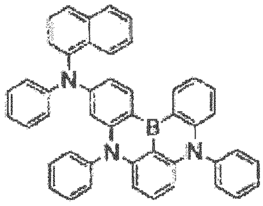
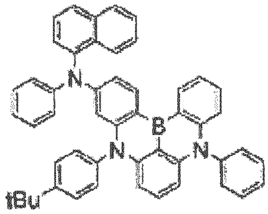

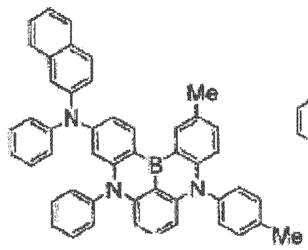
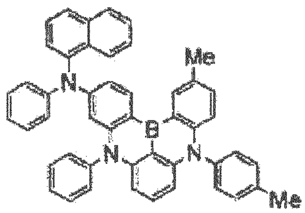
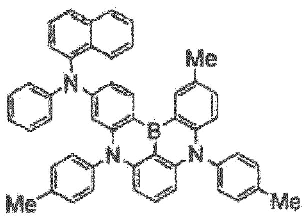

[Formula 103]

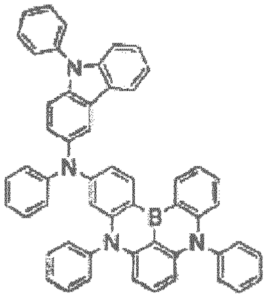

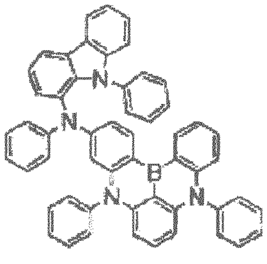

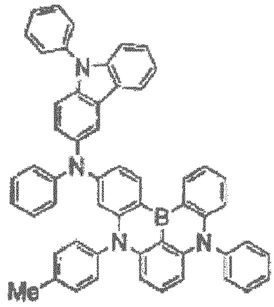

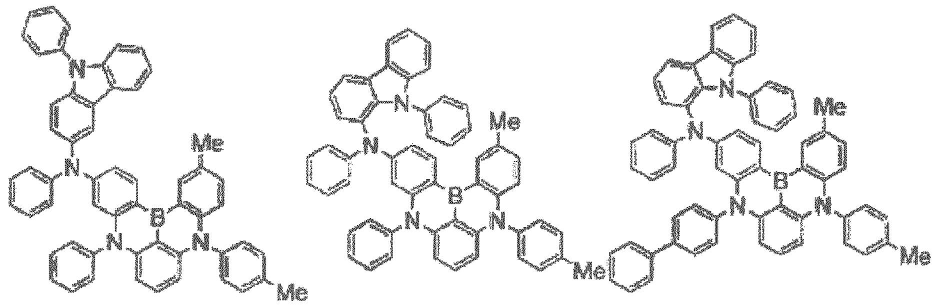

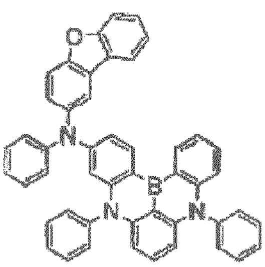

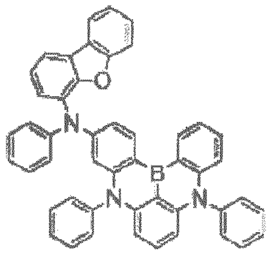

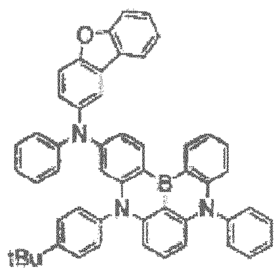

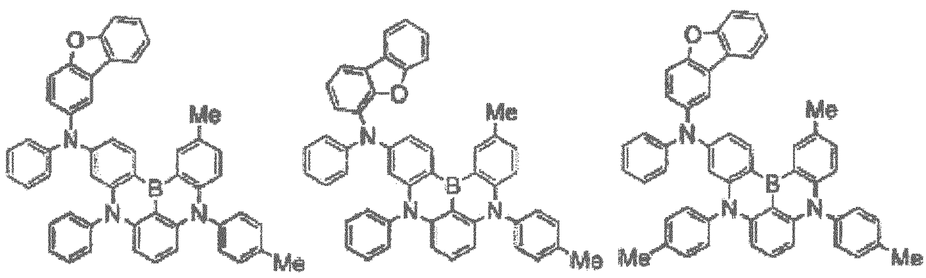

[Formula 104]

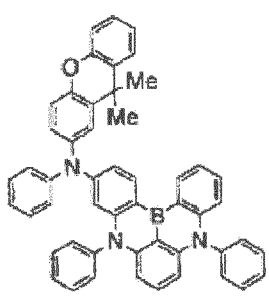
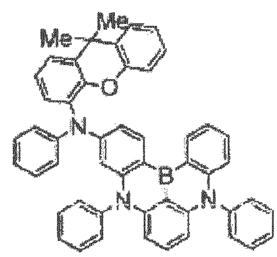
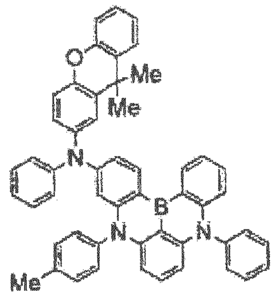

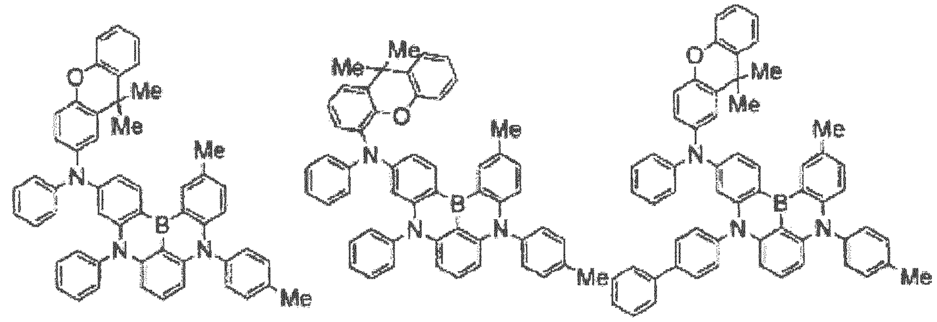

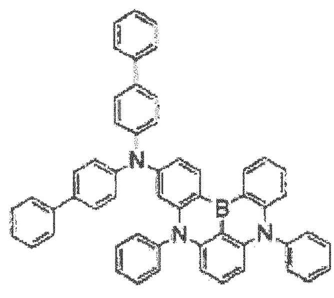
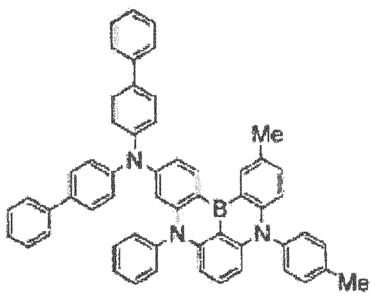

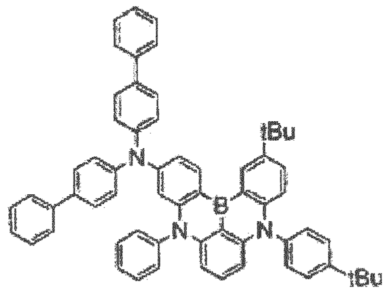
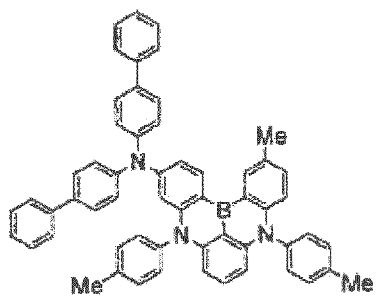

[Formula 105]

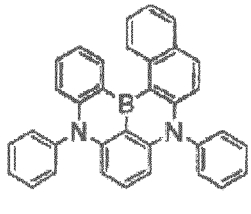

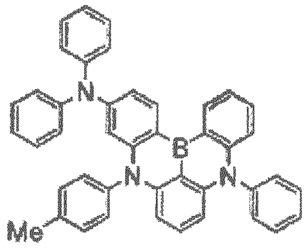

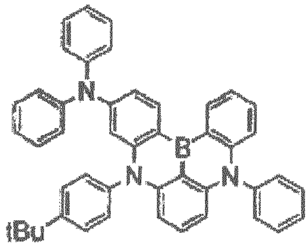

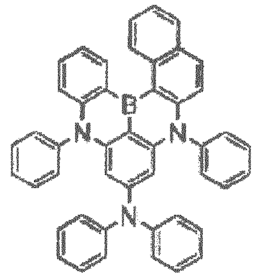

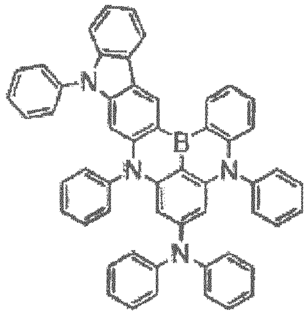

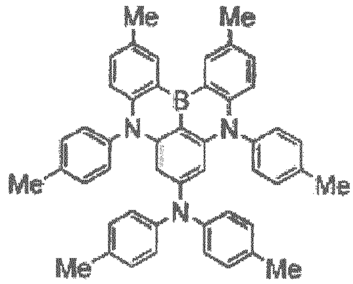

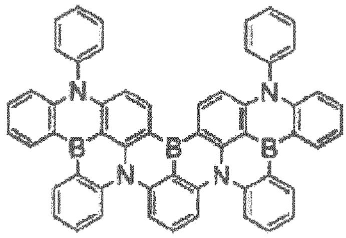

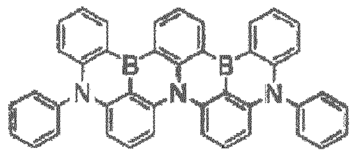

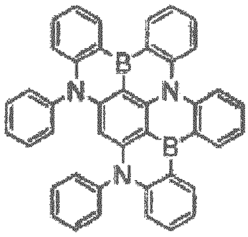

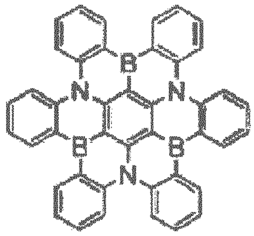

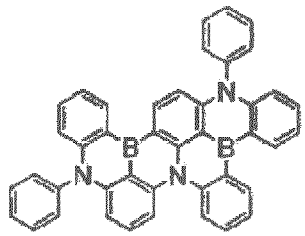

[Formula 106]

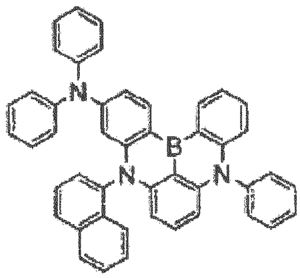
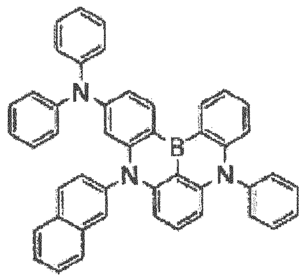
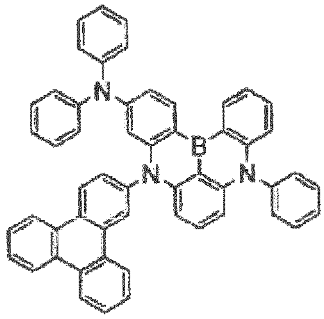

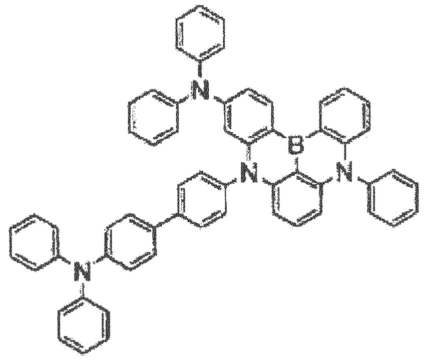
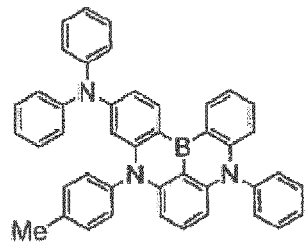

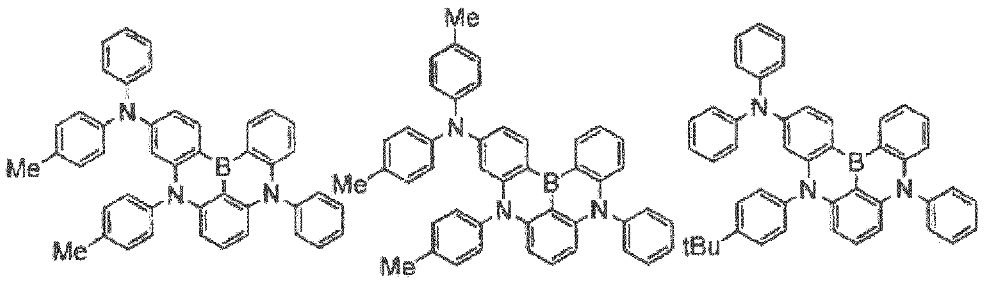

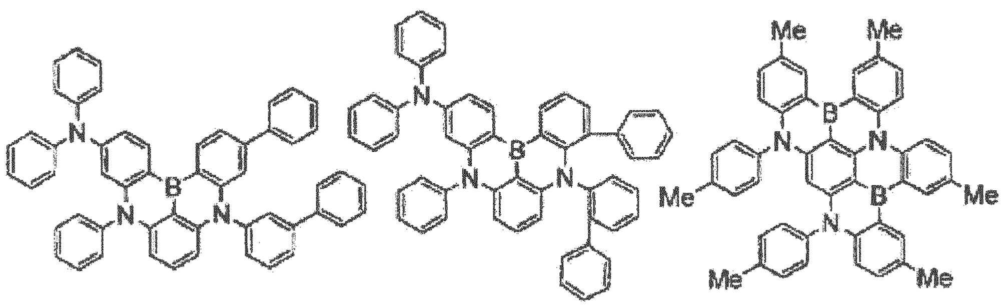

[Formula 107]

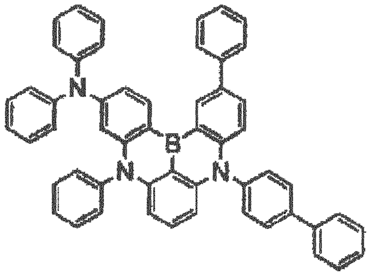

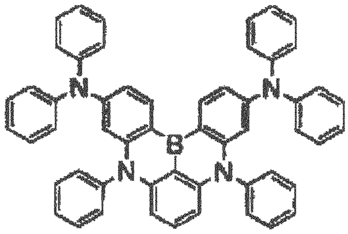

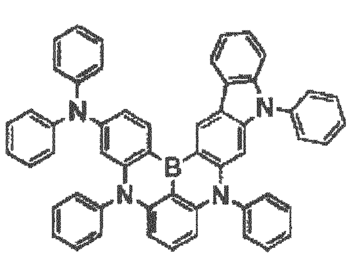

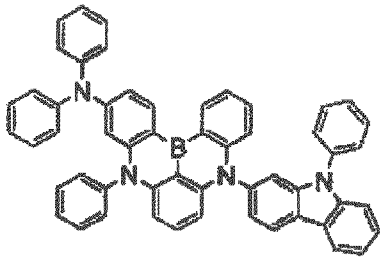

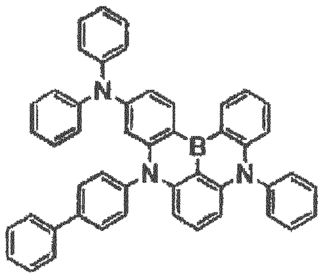

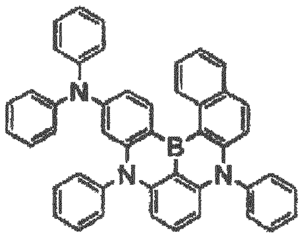

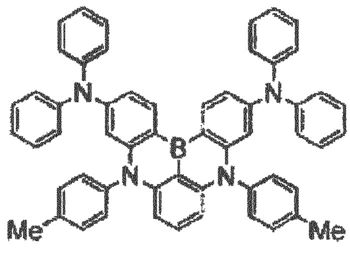

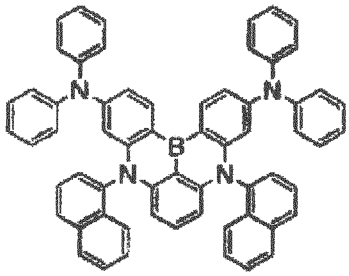

[Formula 108]

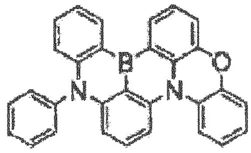
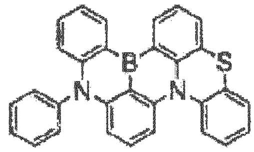
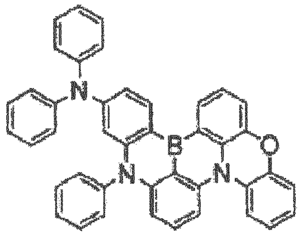

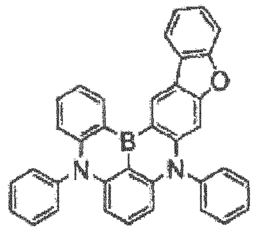
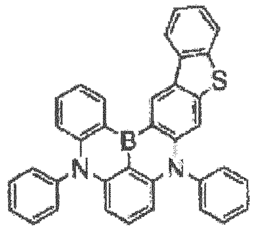
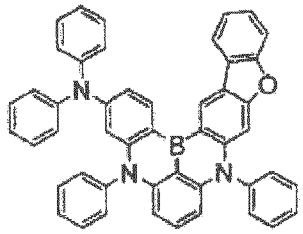

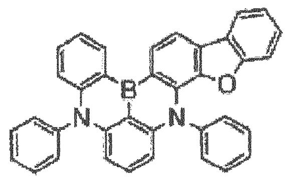
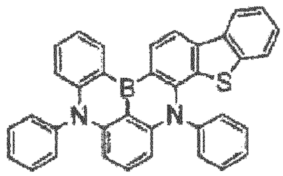
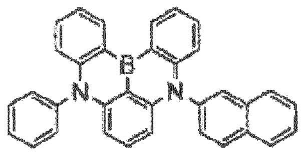

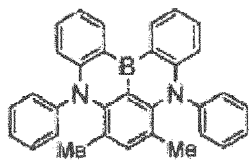
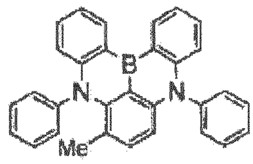
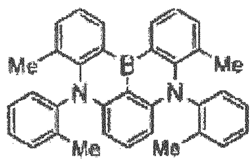

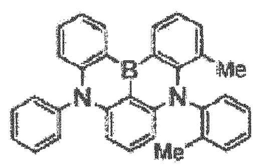
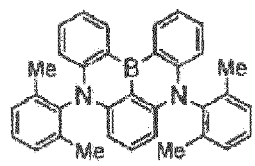
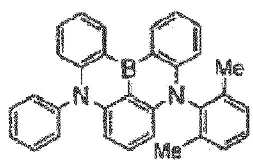

[Formula 109]

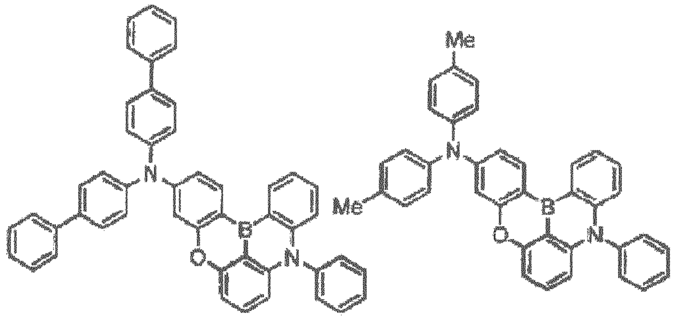

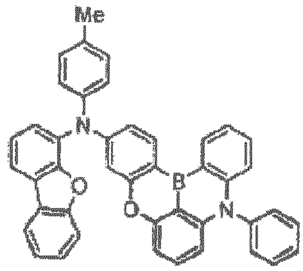

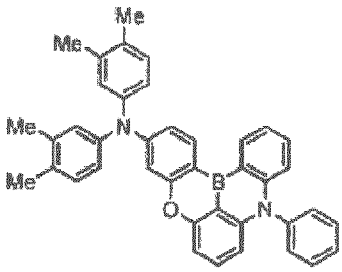

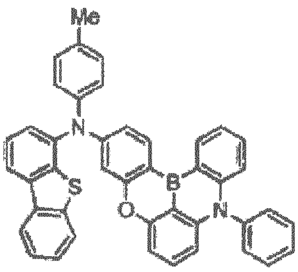

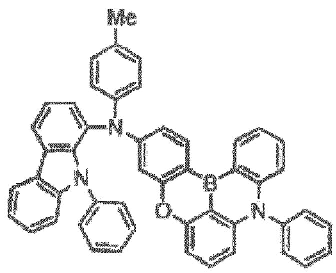

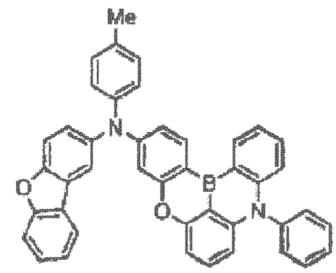

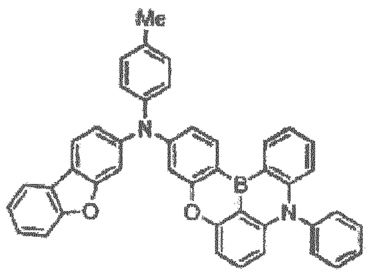

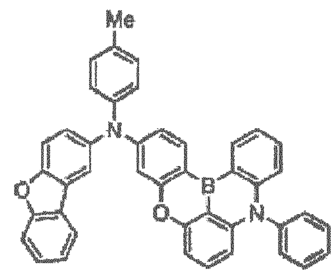

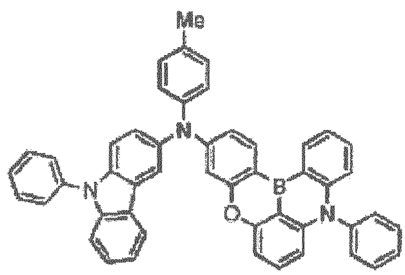

[Formula 110]

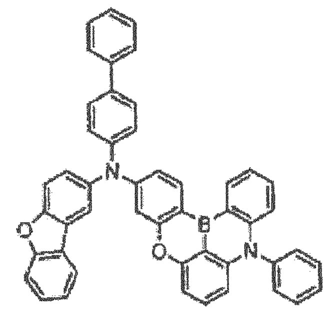

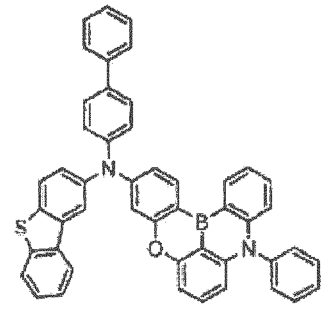

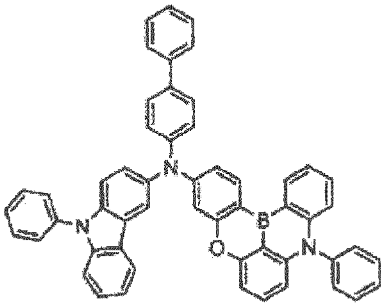

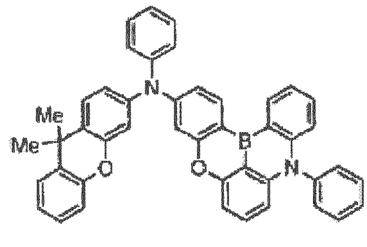

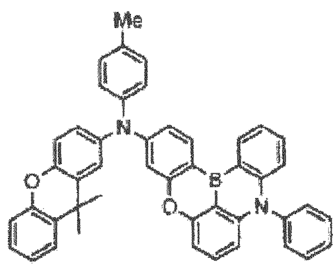

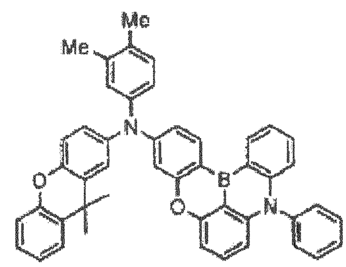

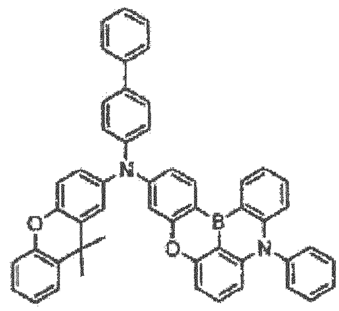

[Formula 111]

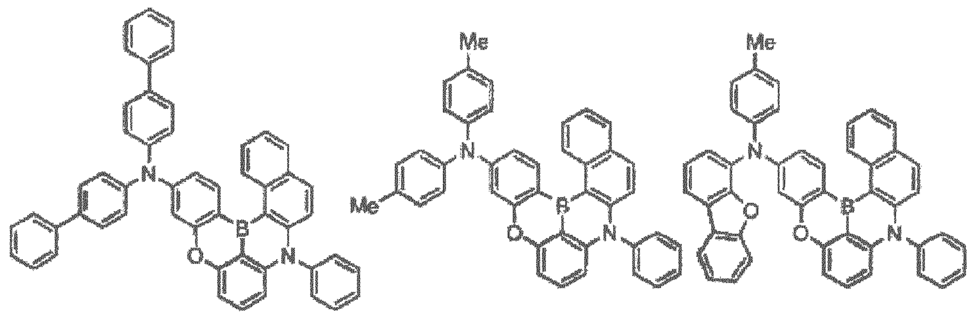

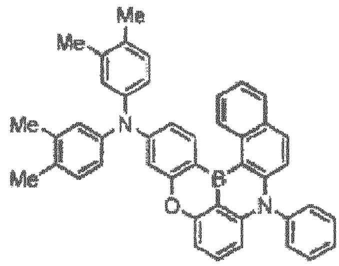

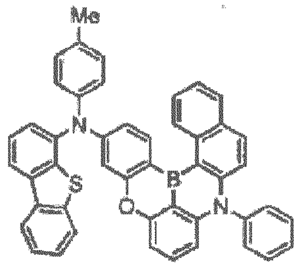

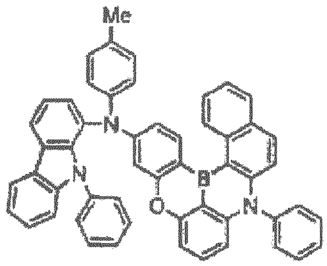

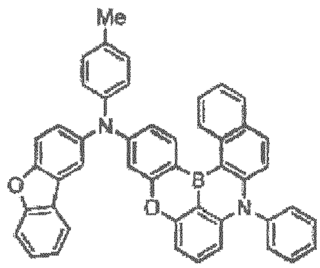

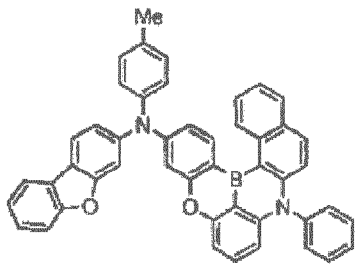

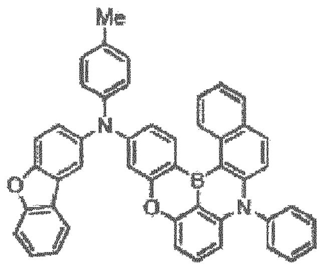

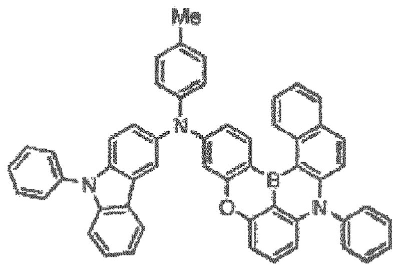

[Formula 112]

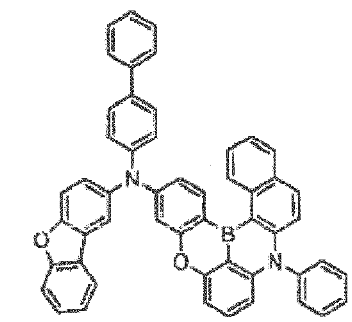

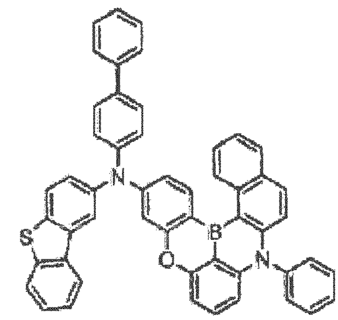

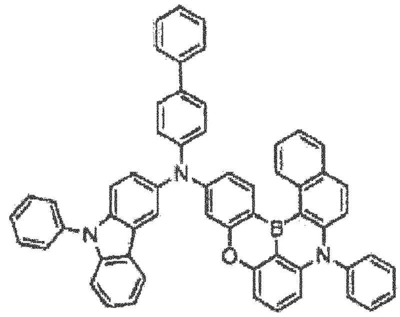

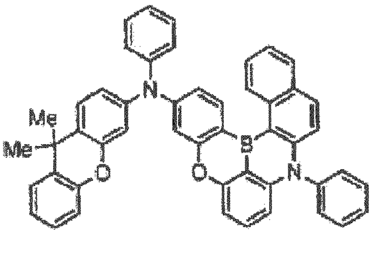

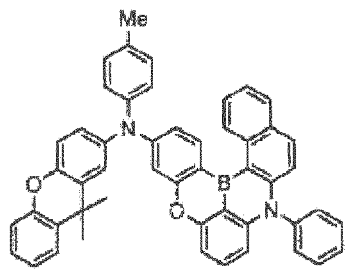

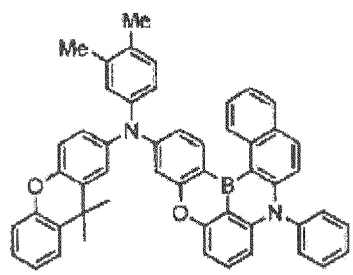

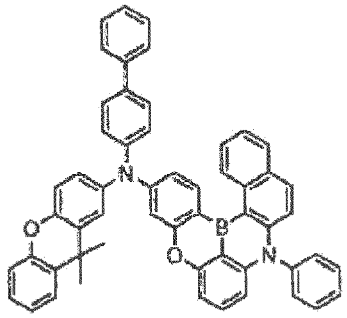

[Formula 113]

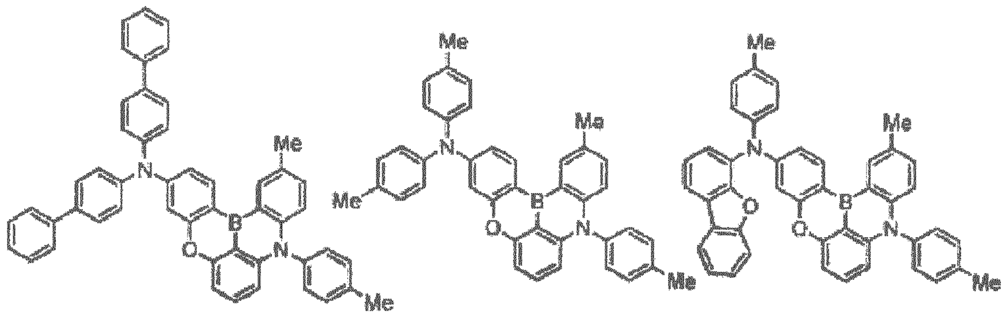

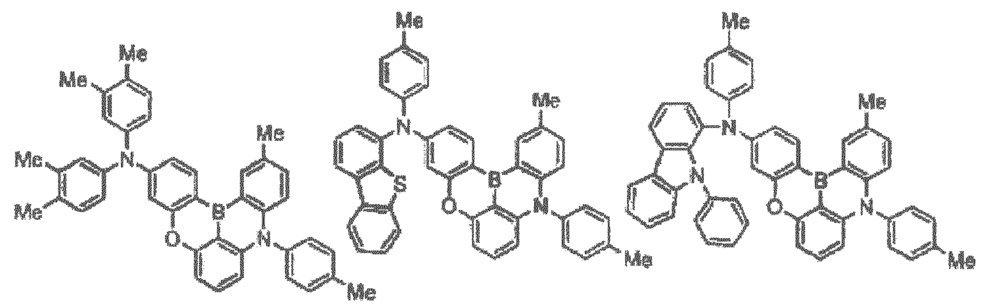

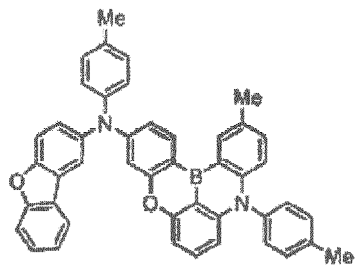

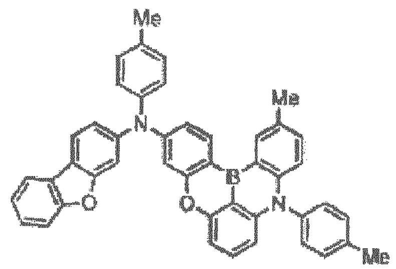

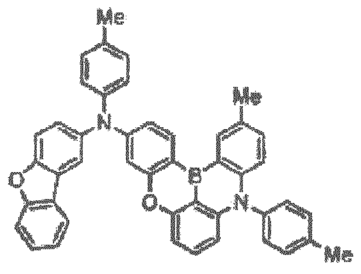

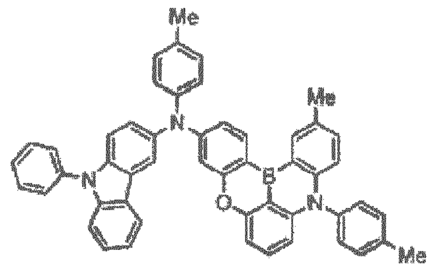

[Formula 114]

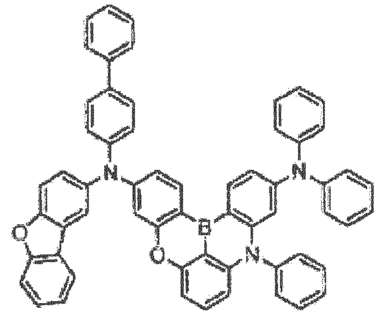
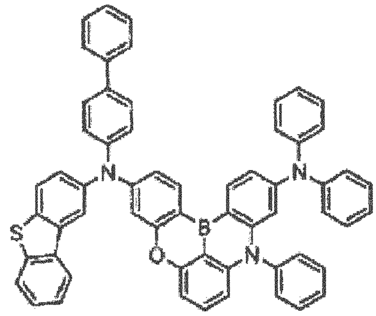
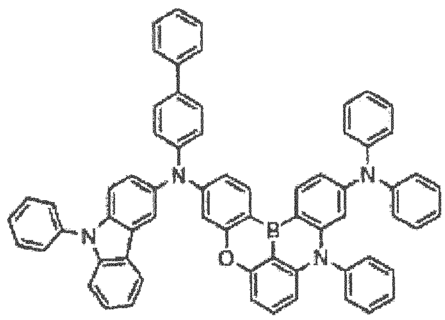
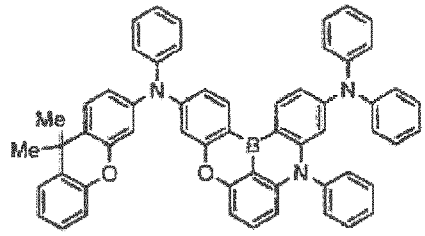
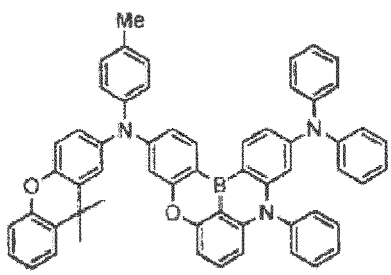
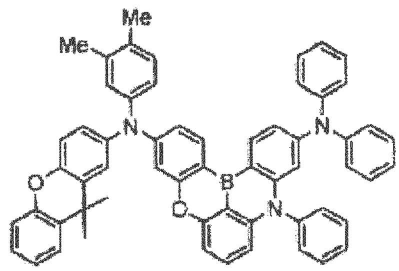
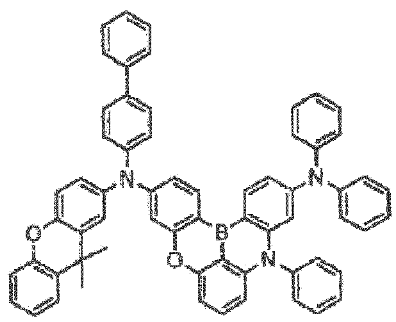
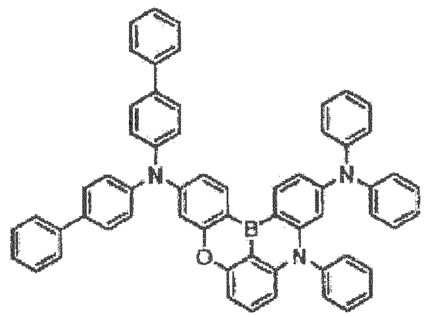

[Formula 115]

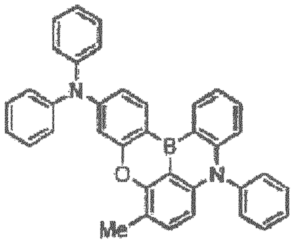

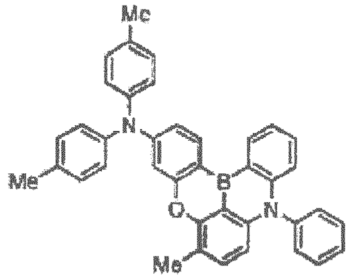

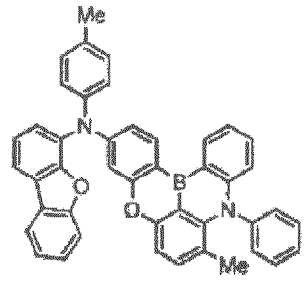

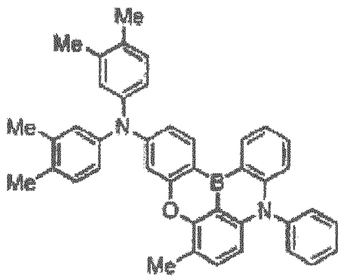

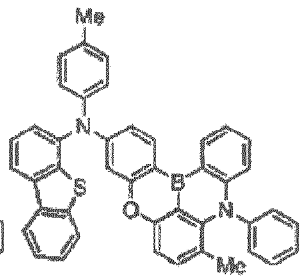

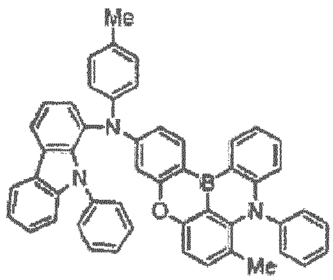

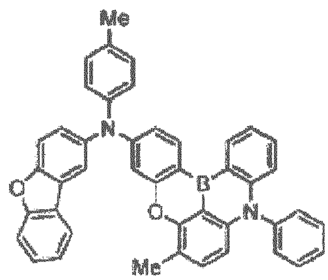

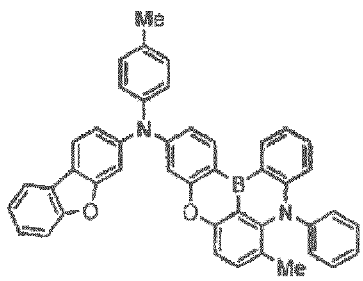

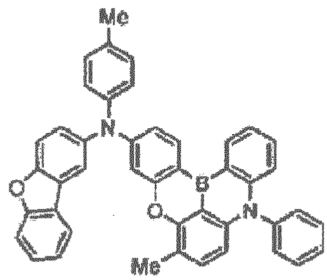

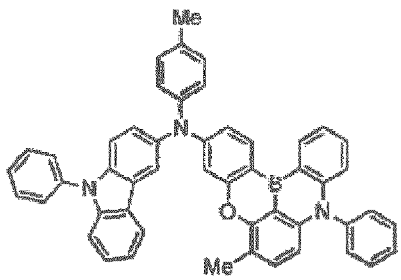

[Formula 116]

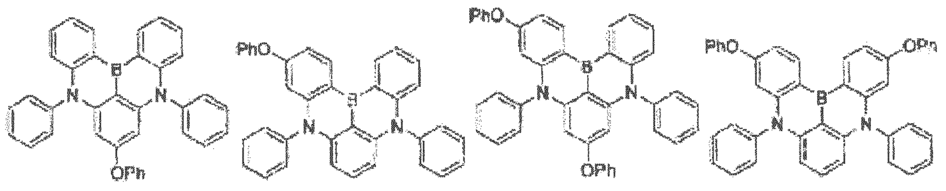

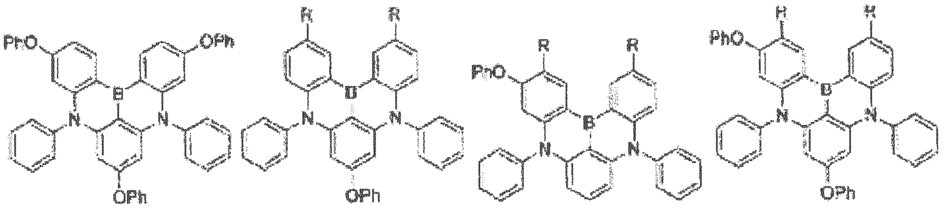

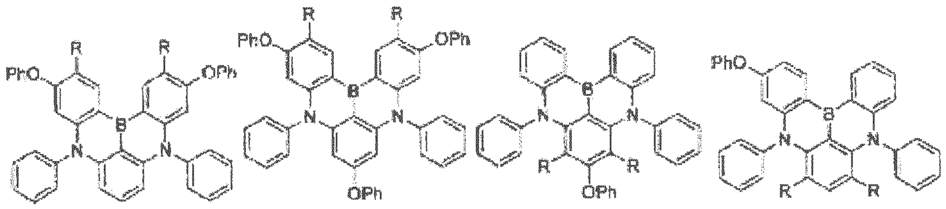

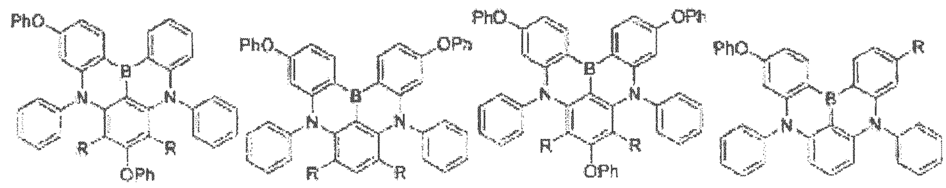

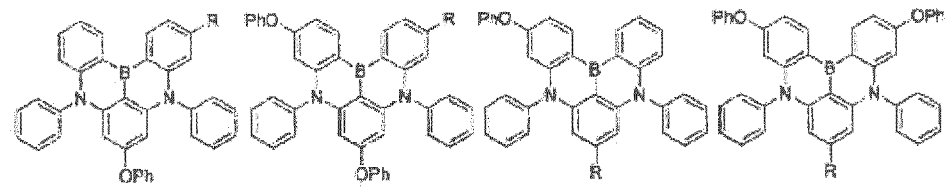

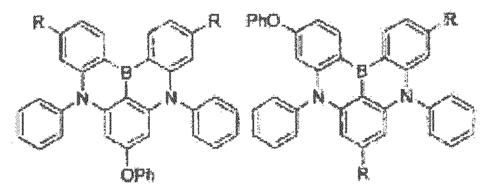

[Formula 117]

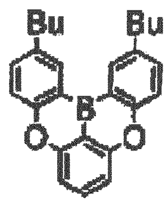
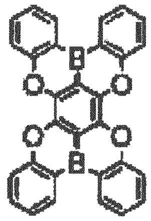
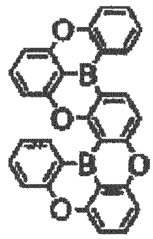
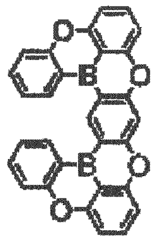
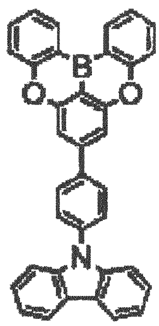
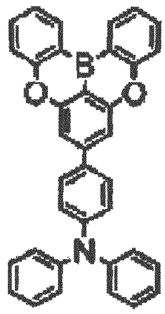

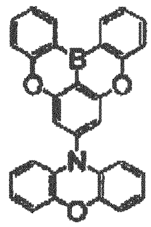
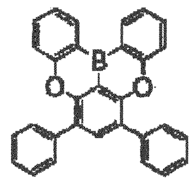
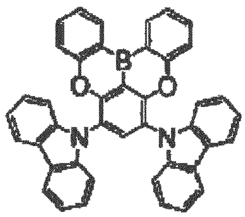

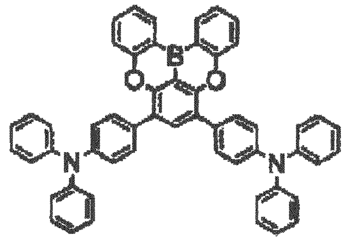
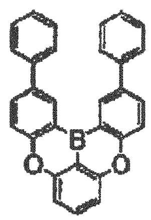
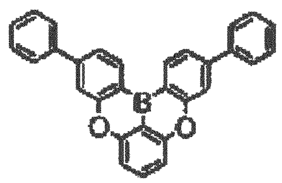
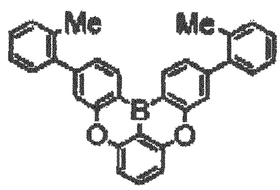

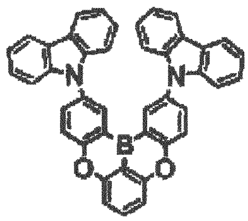
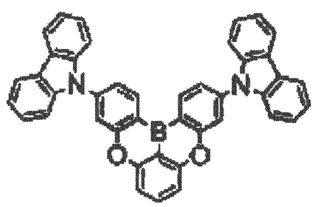
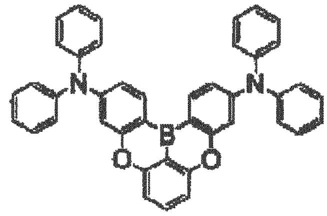

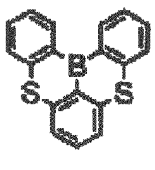
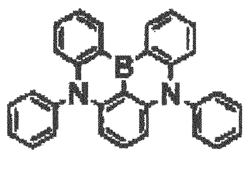
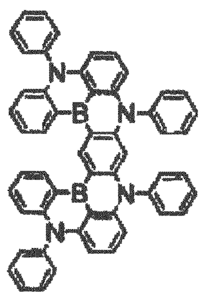
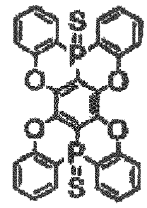
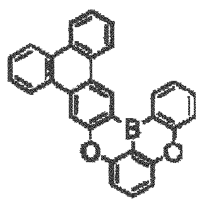

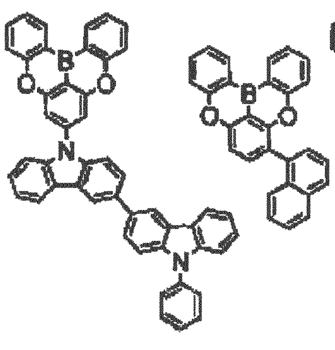
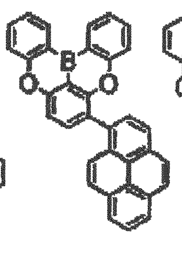
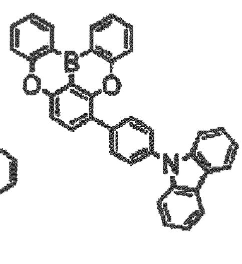

[Formula 118]

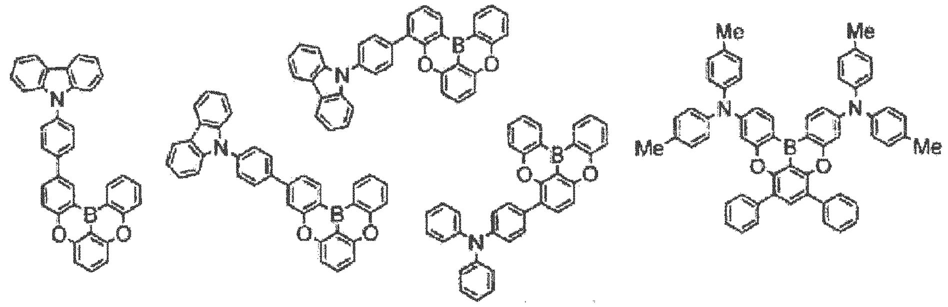
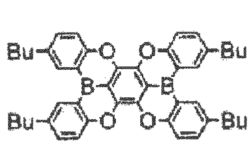
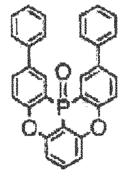
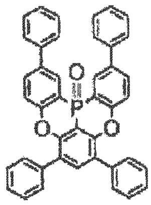
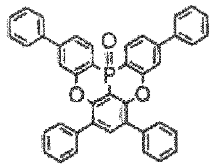
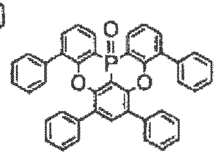
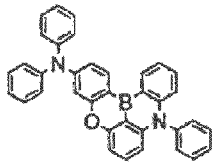
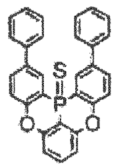
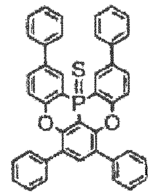
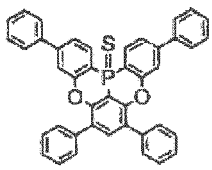
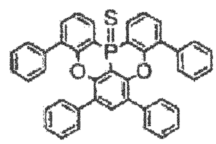
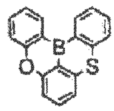
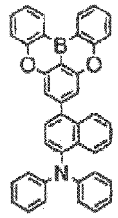
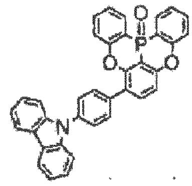
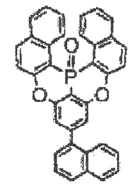
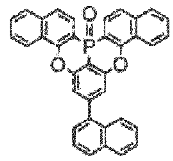
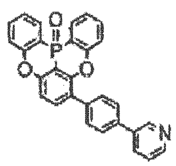
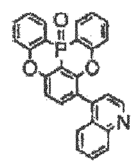
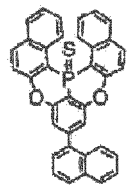
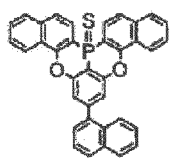
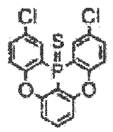
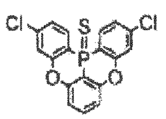
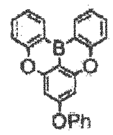
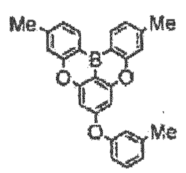

[Formula 119]

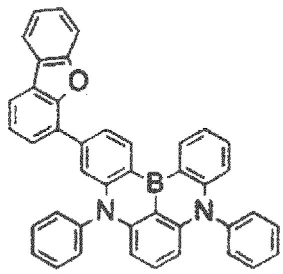

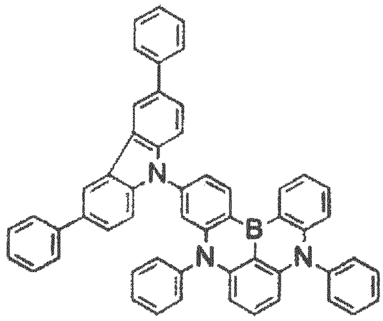

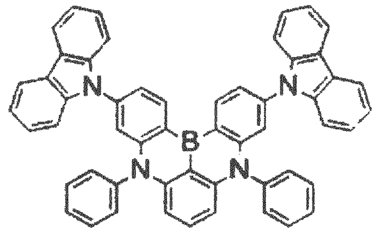

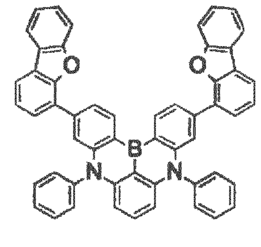

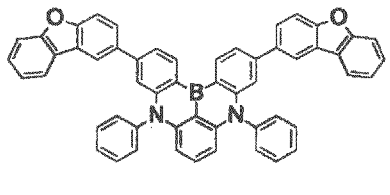

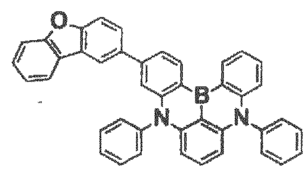

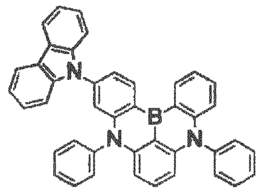

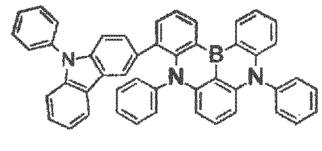

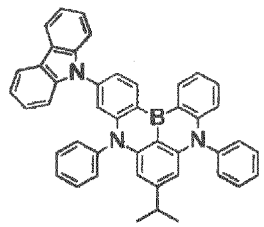

[Formula 120]

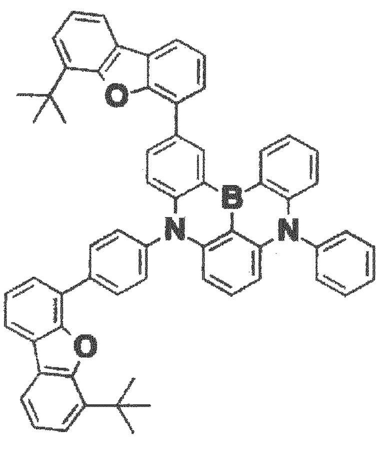

[Formula 121]

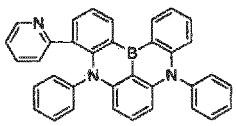

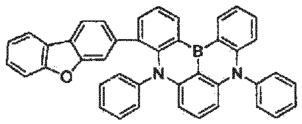

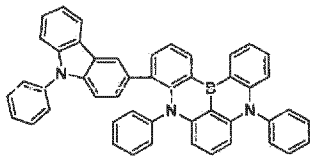

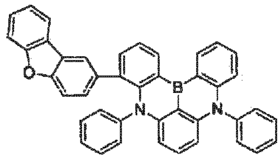

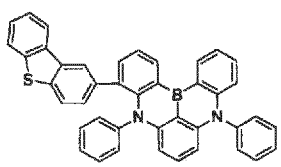

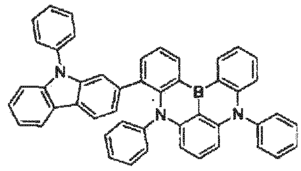

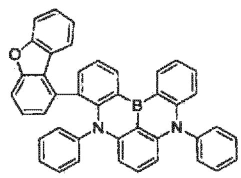

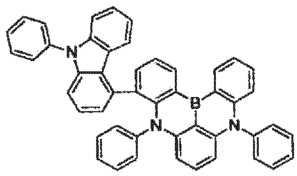

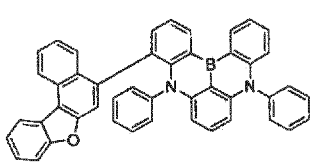

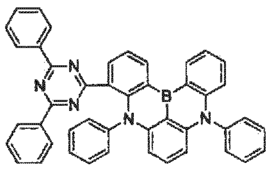

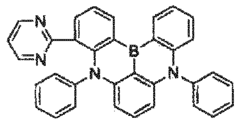

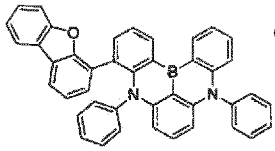

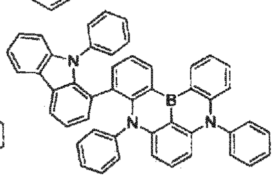

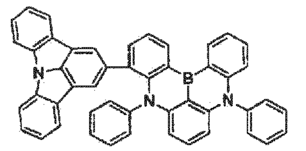

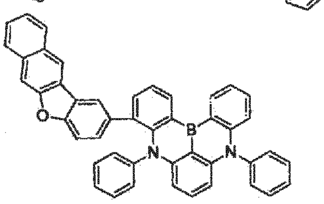

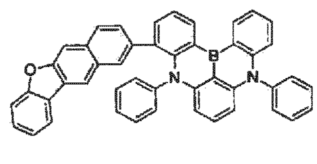

[Formula 122]

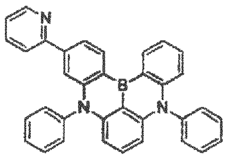
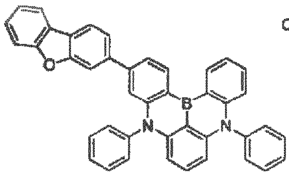
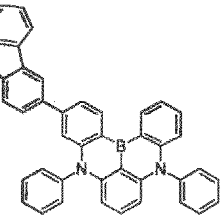
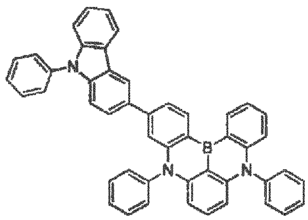
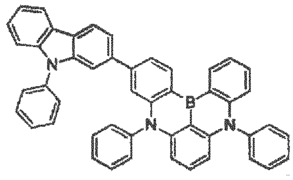
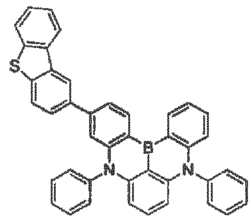
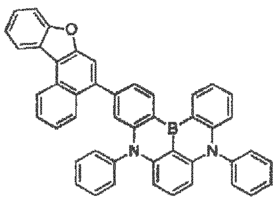
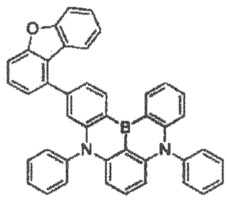
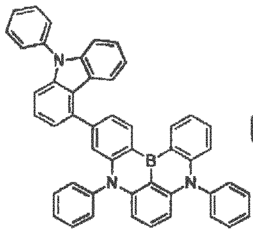
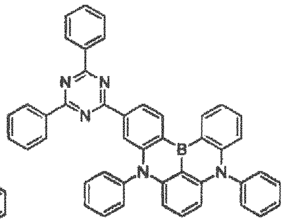
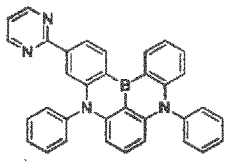
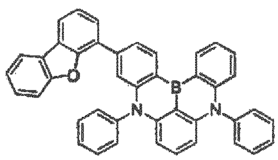
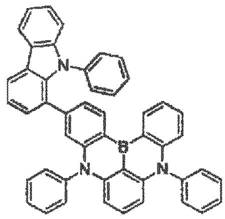
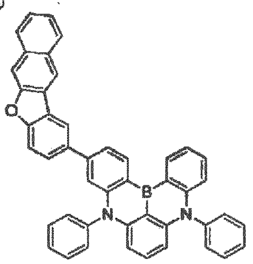
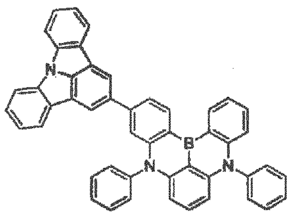
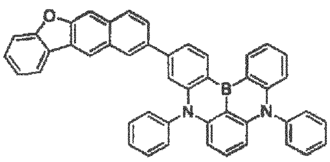

[Formula 123]

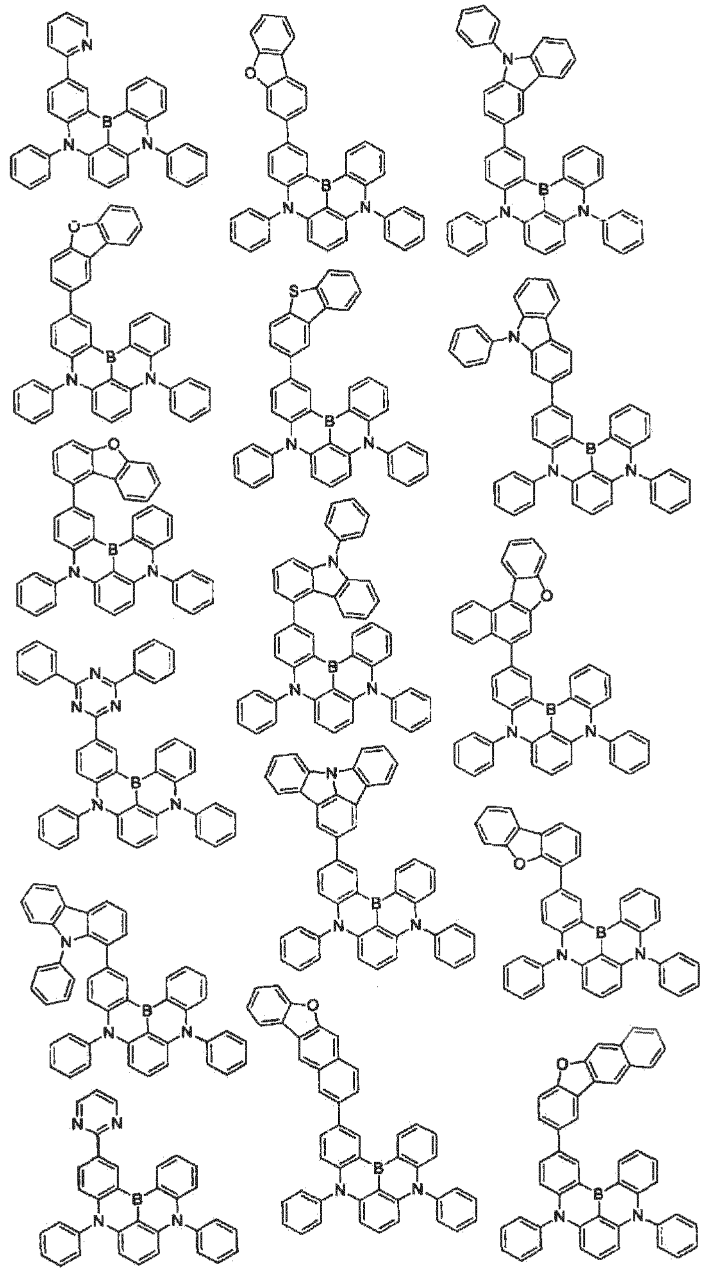

[Formula 124]

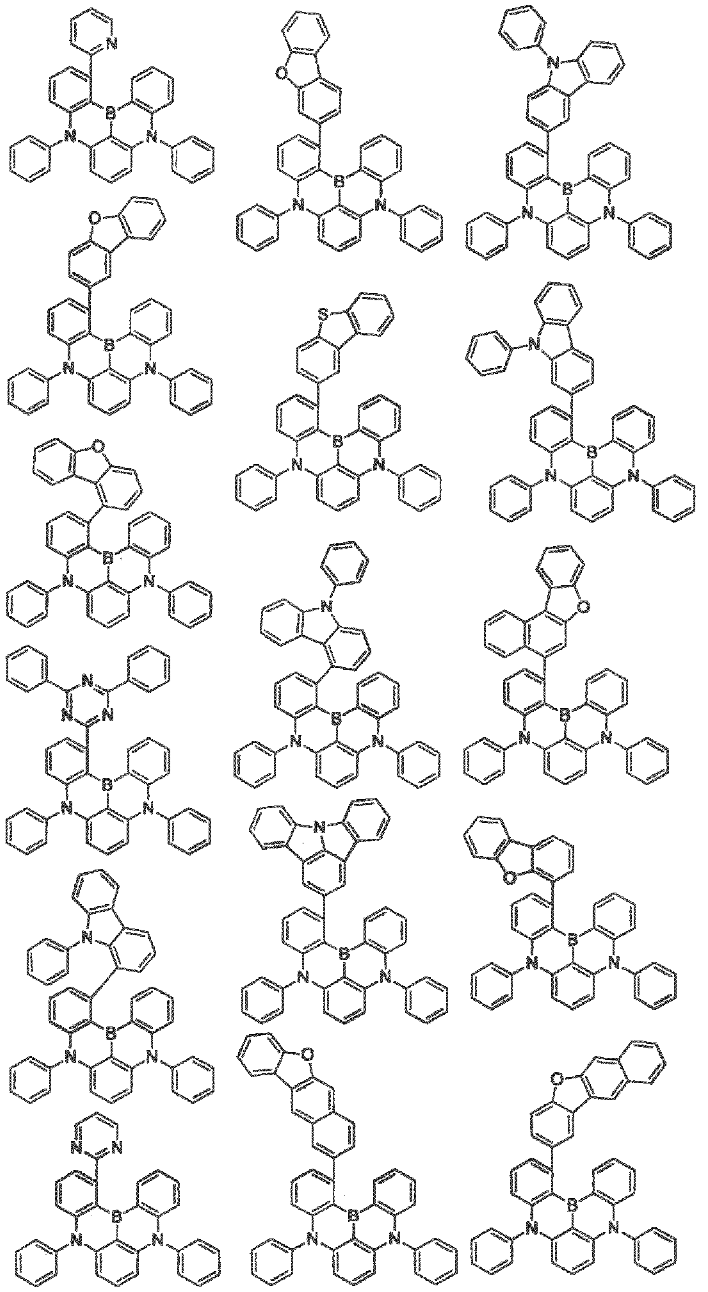

[Formula 125]

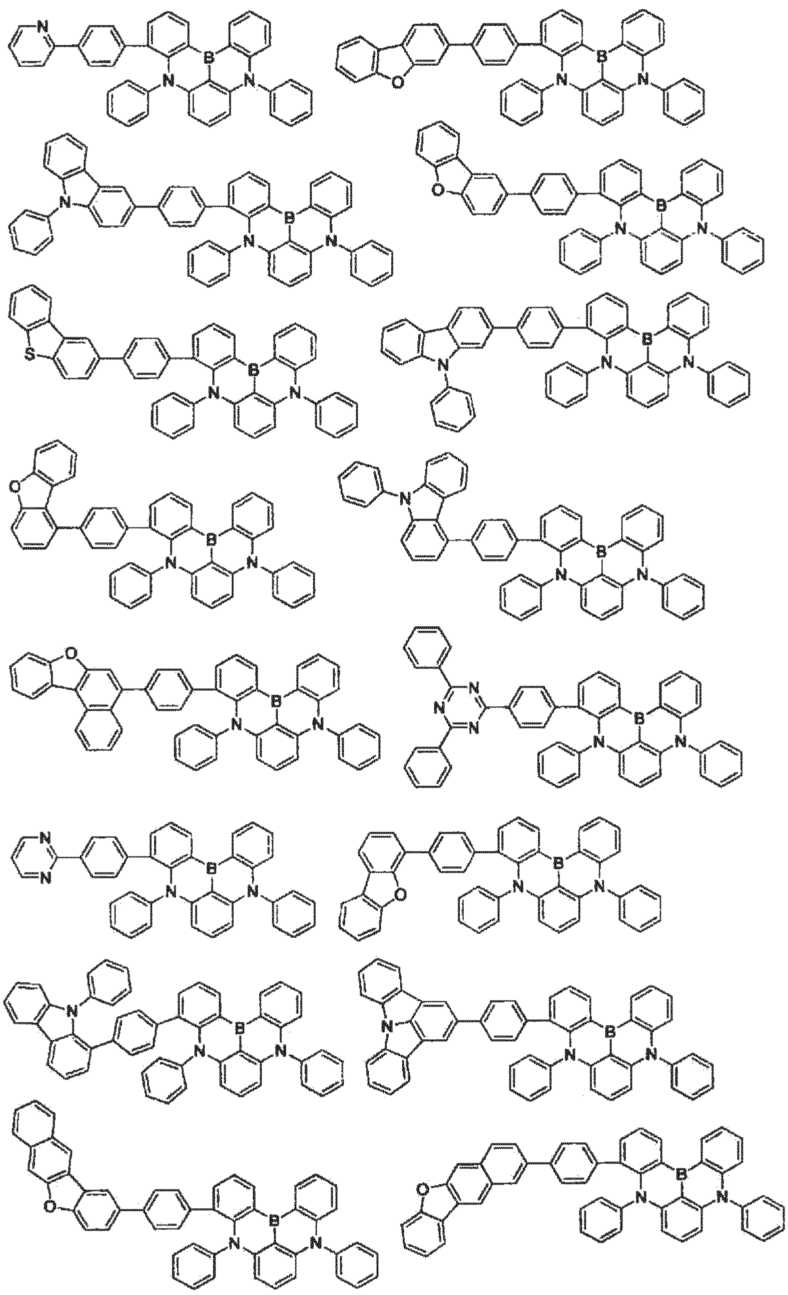

[Formula 126]

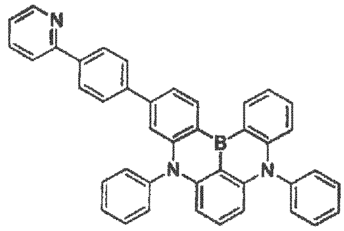

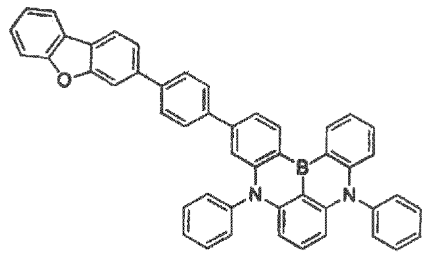

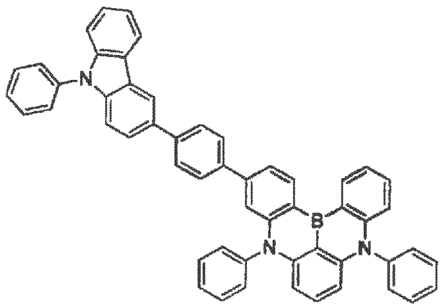

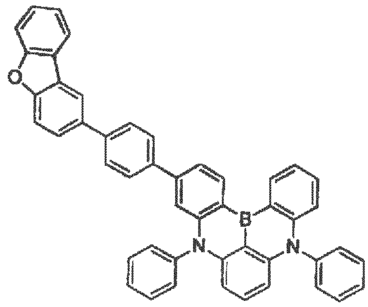

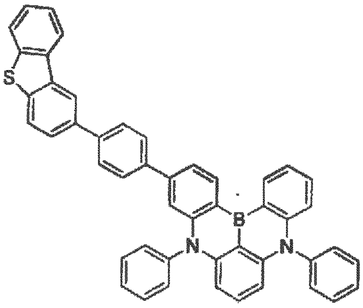

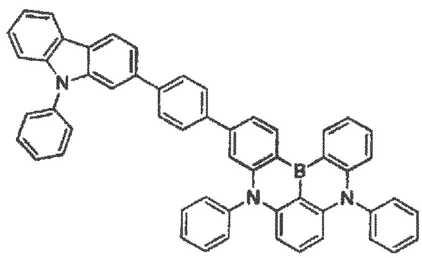

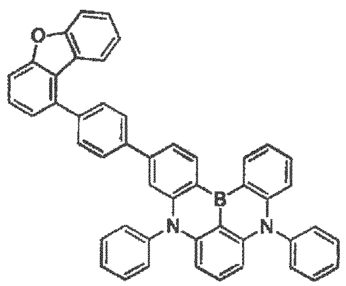

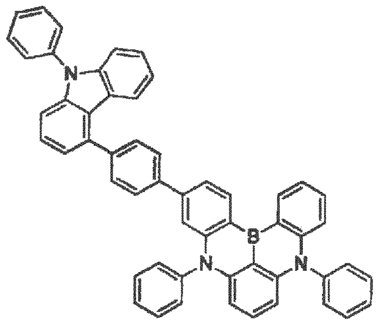

[Formula 127]

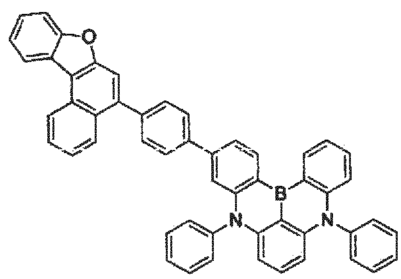

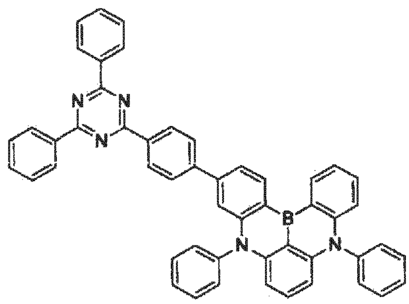

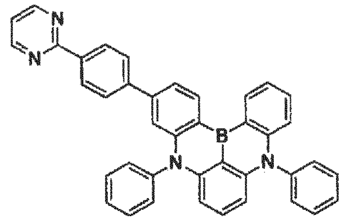

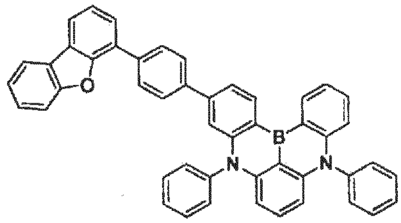

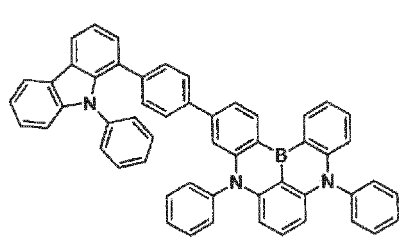

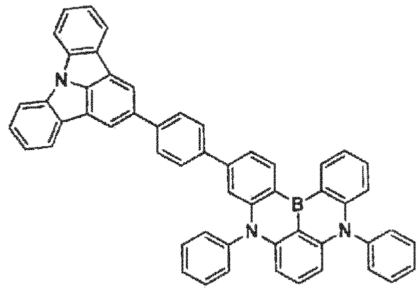

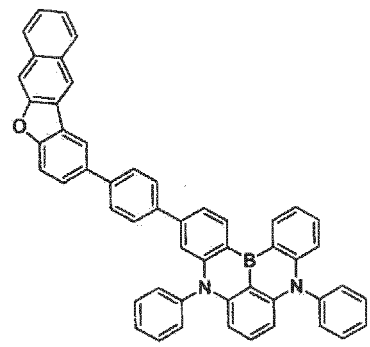

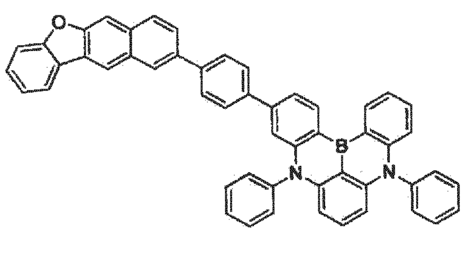

[Formula 128]

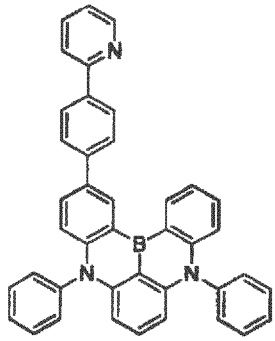
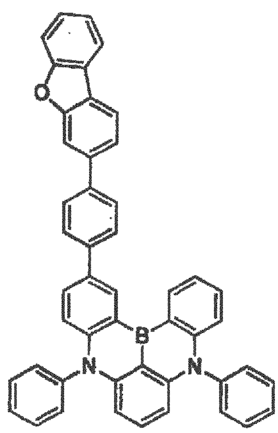
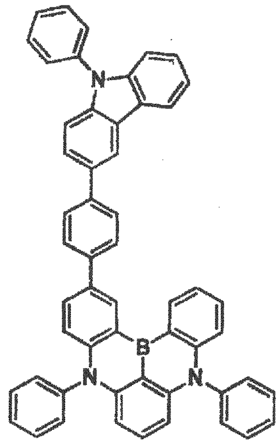
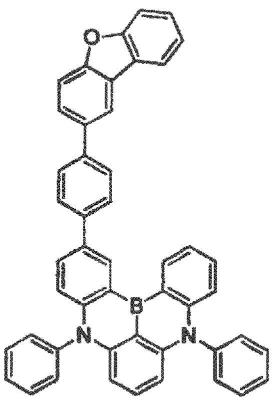
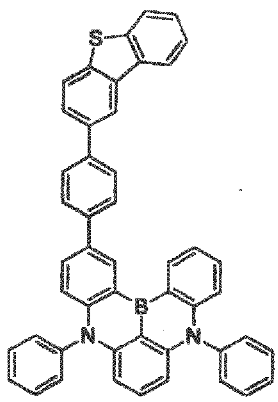
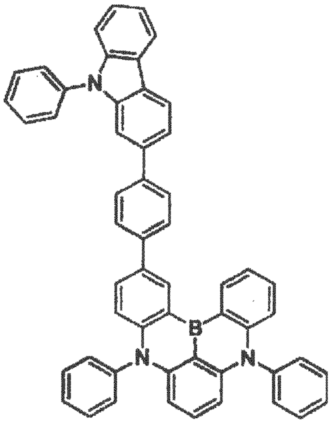
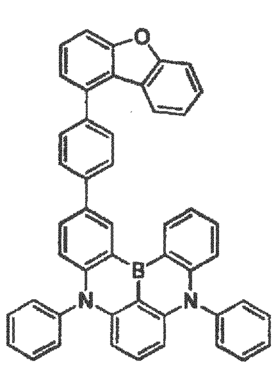
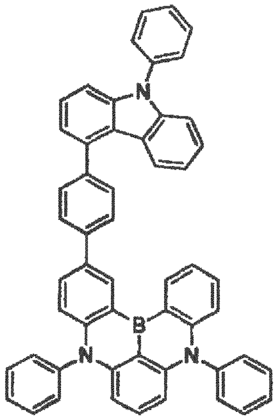
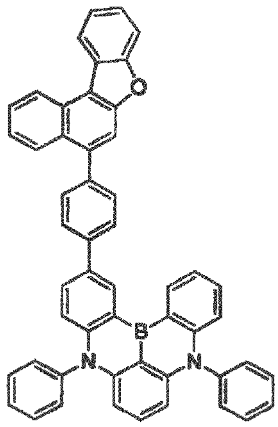

[Formula 129]

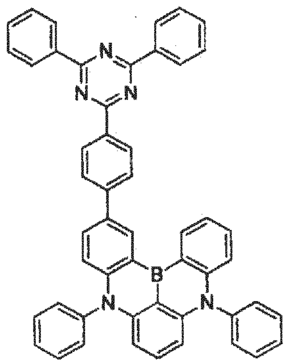

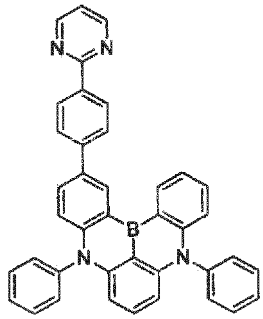

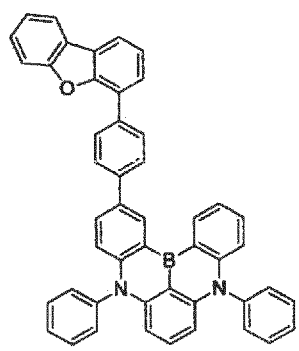

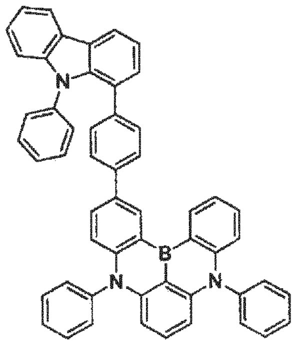

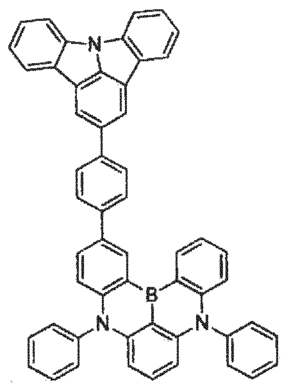

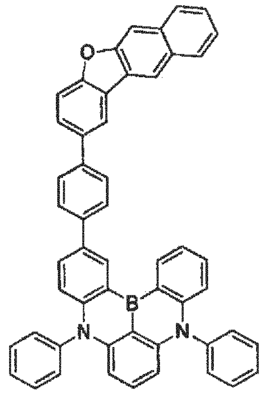

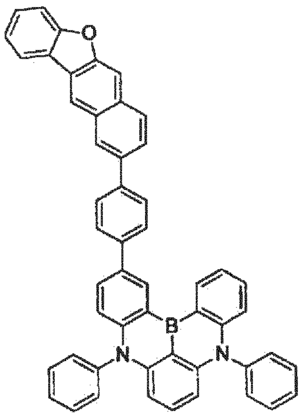

[Formula 130]

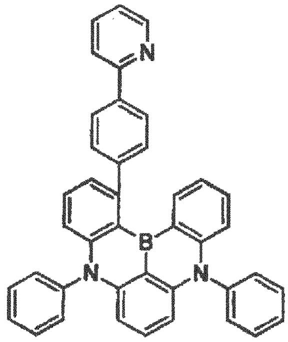
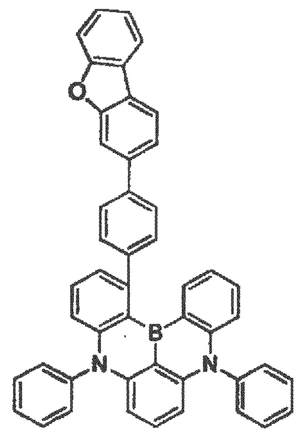
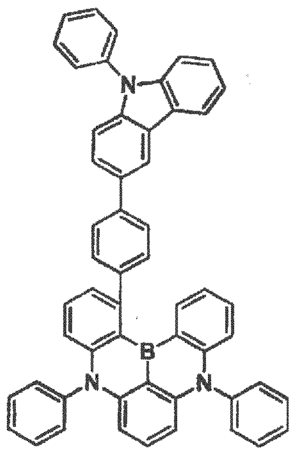
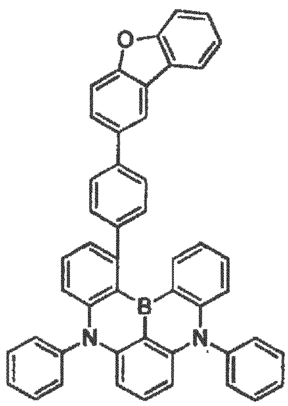
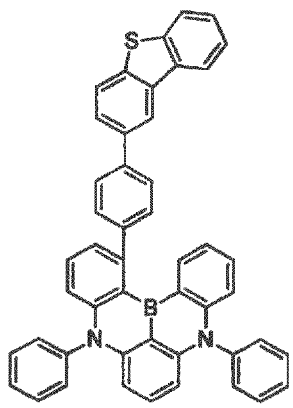
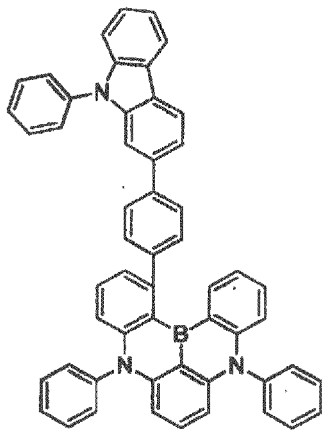
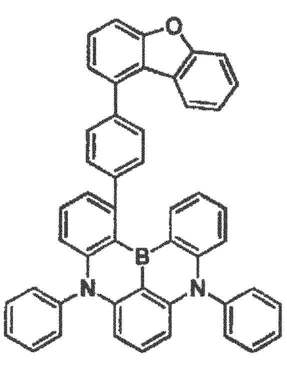
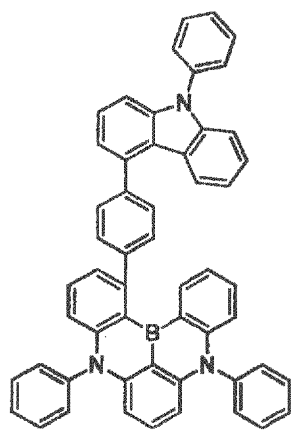
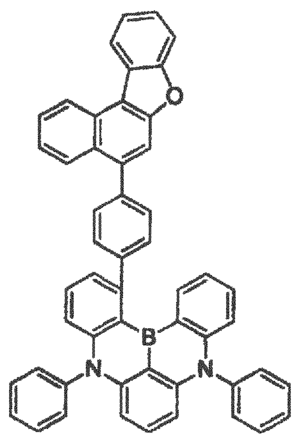

[Formula 131]

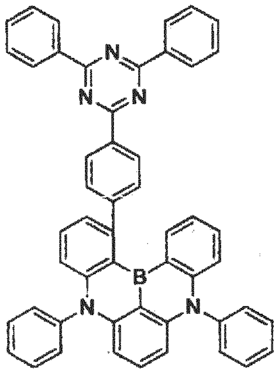
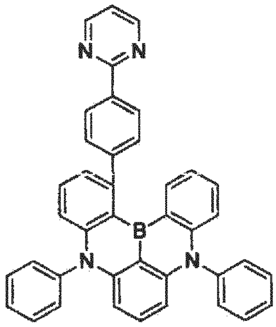
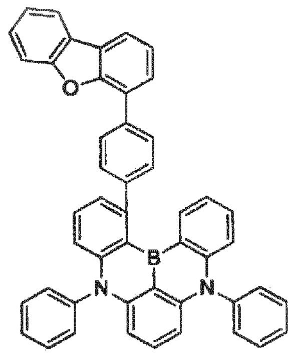
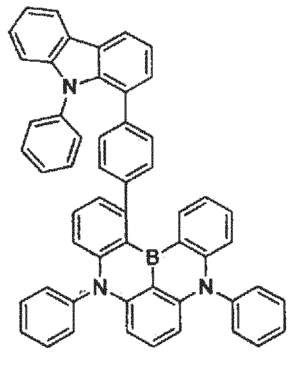
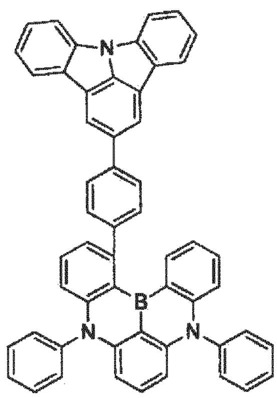
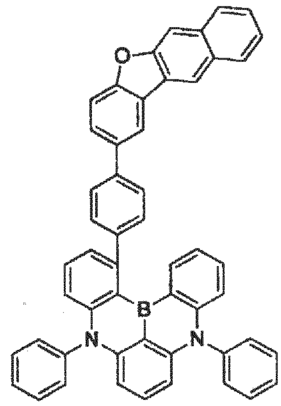
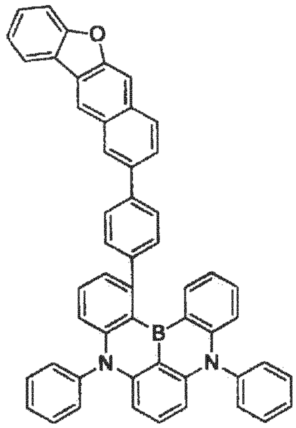

[Formula 132]

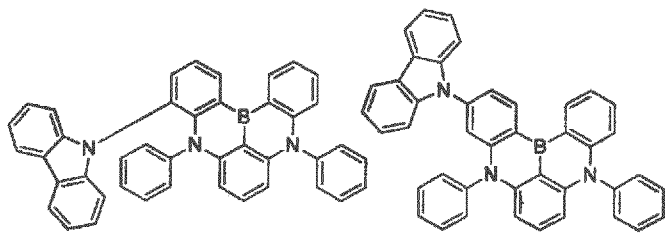

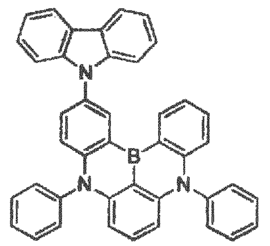

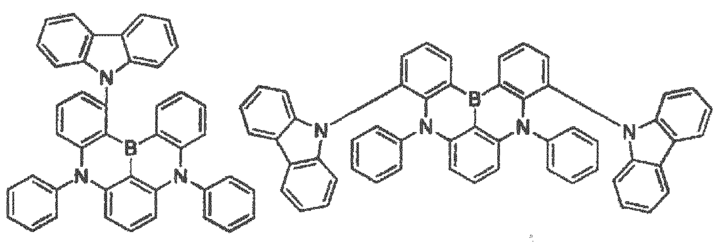

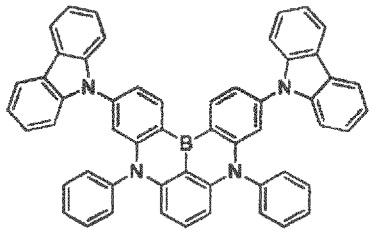

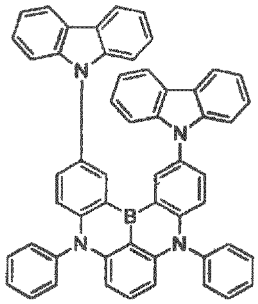

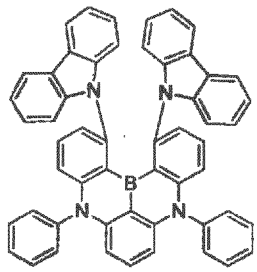

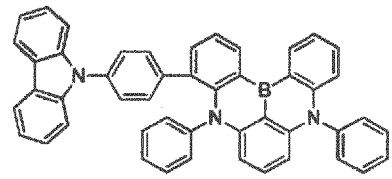

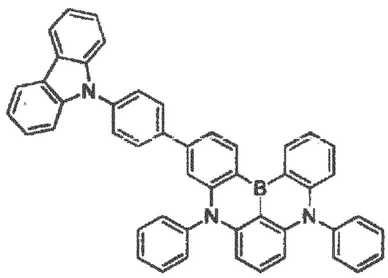

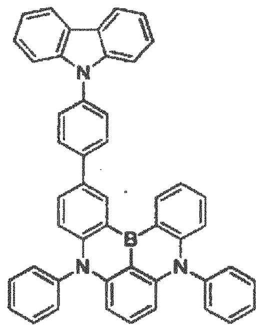

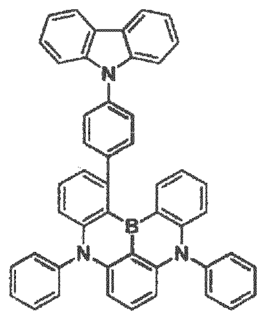

[Formula 133]

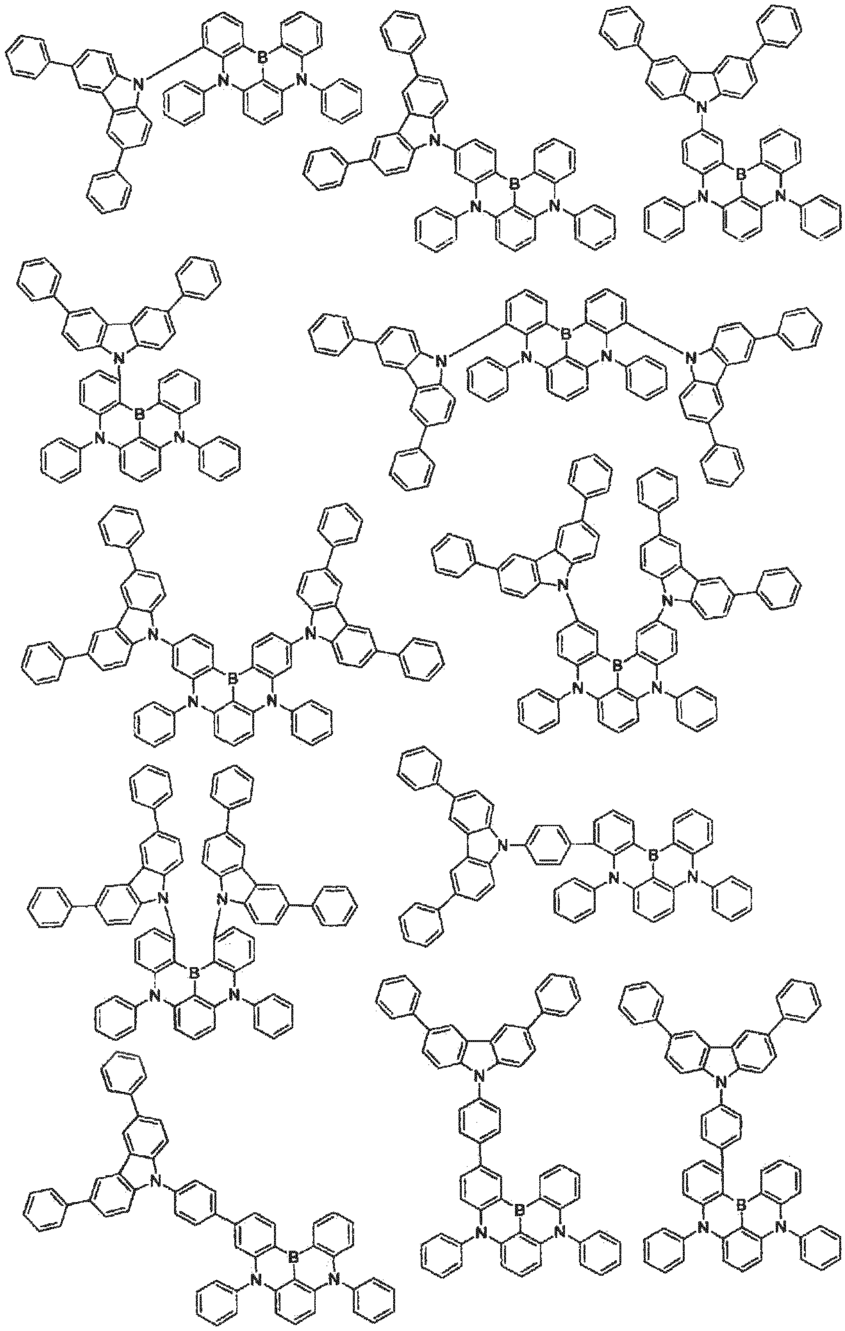

[Formula 134]

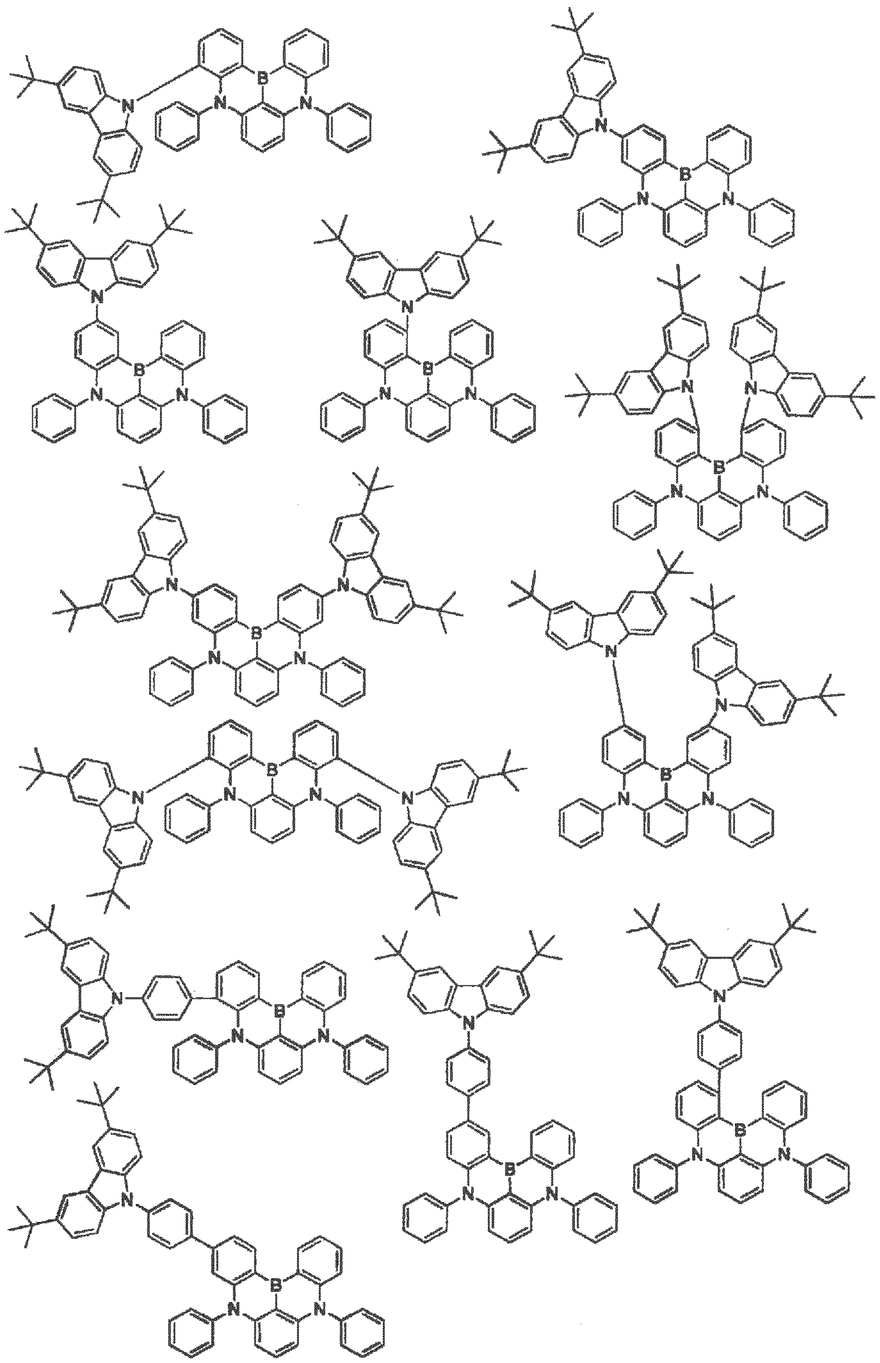

[Formula 135]

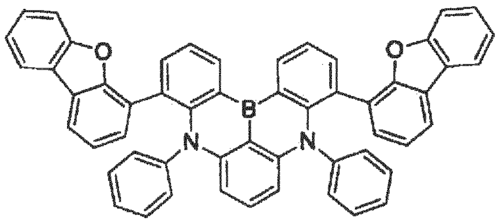
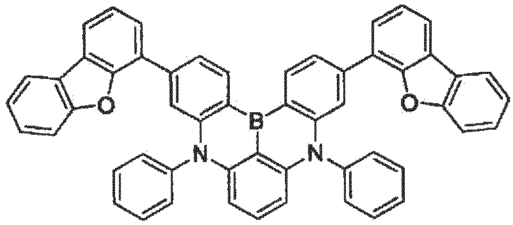
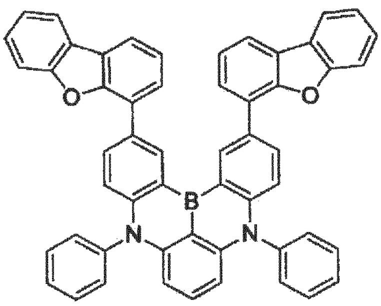
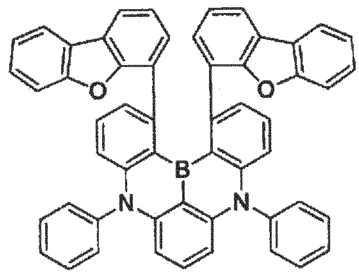
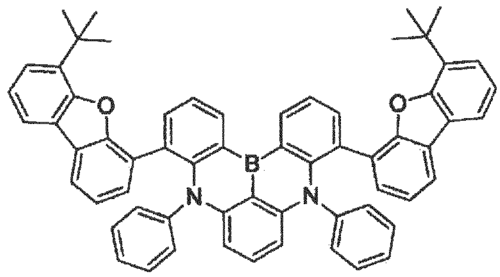
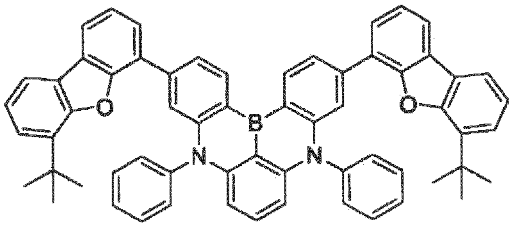
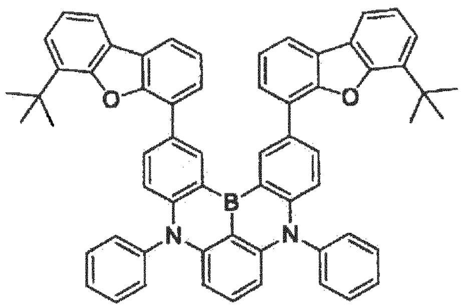
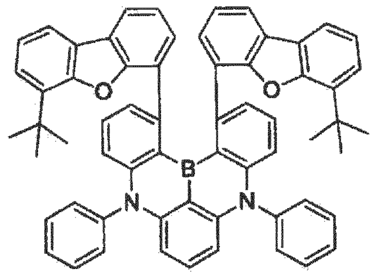

[Formula 136]

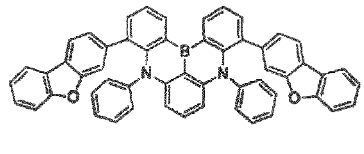
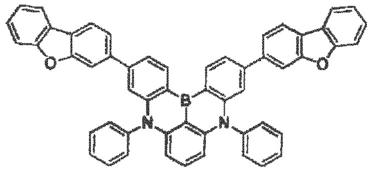

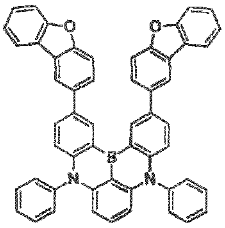
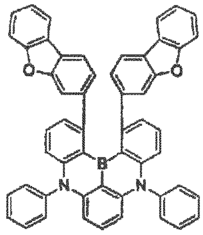

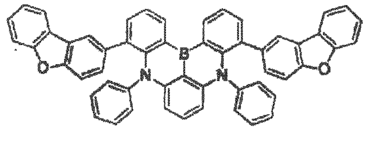
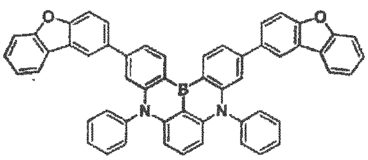

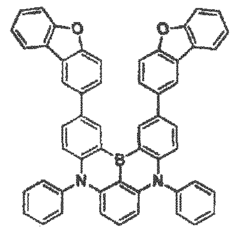
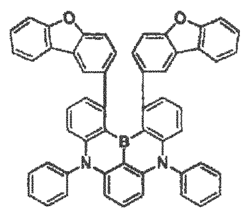

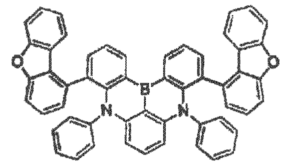
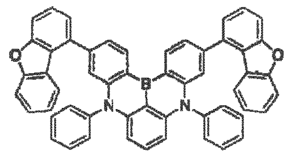

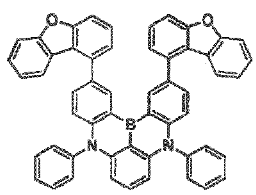
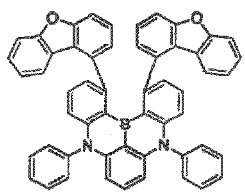

[Formula 137]

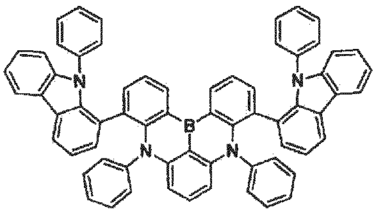

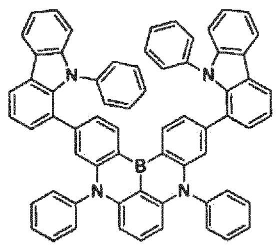

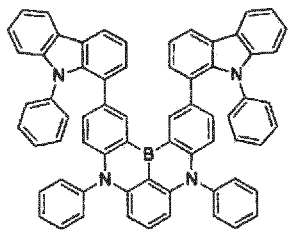

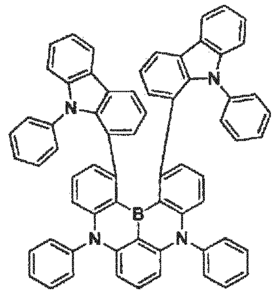

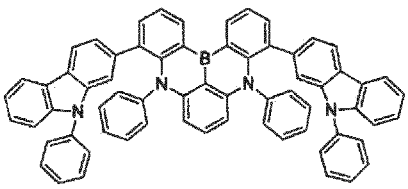

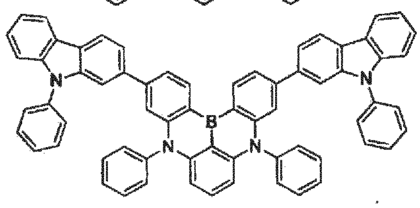

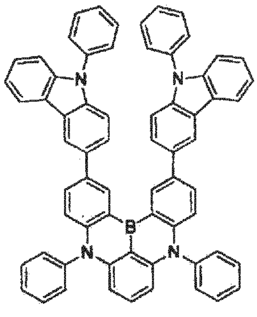

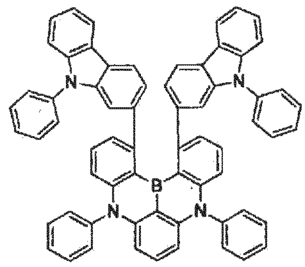

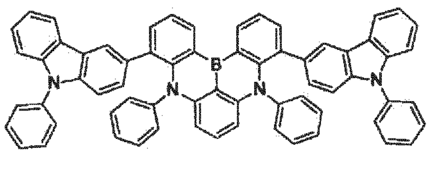

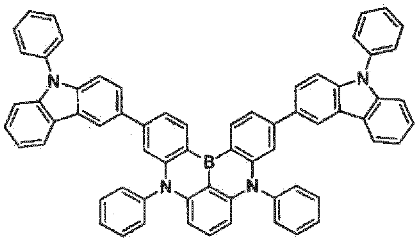

[Formula 138]

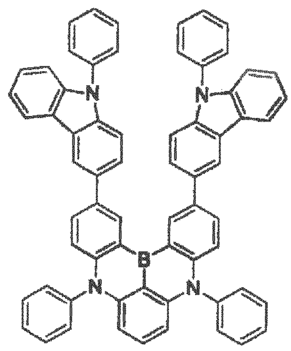

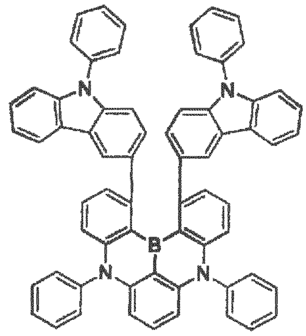

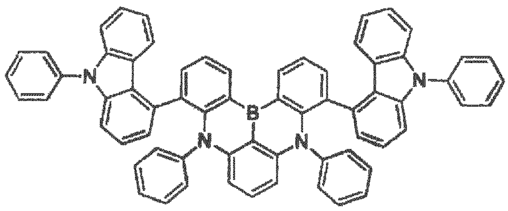

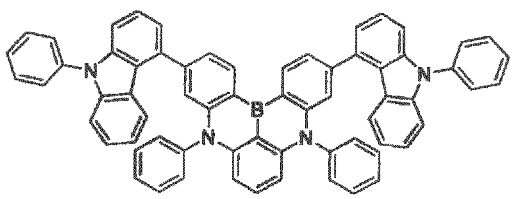

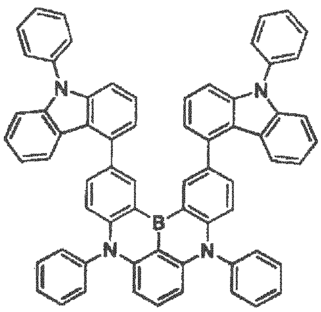

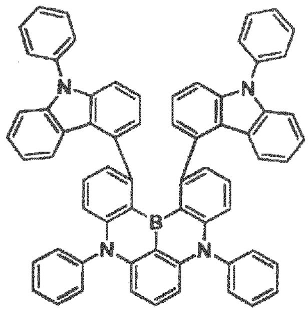

[Formula 139]

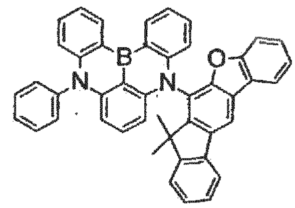

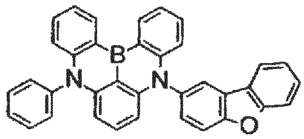

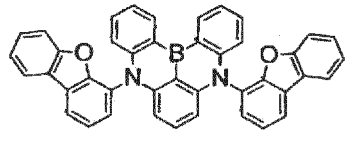

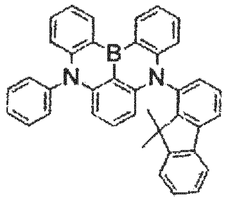

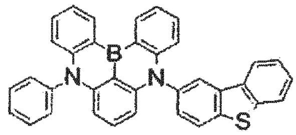

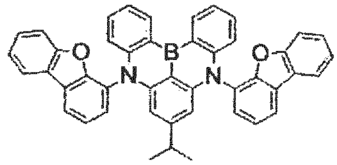

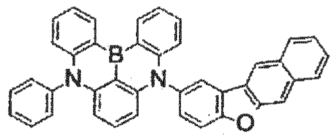

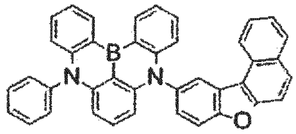

[Formula 140]

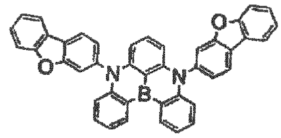
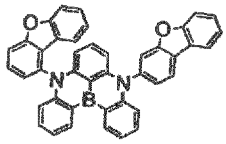
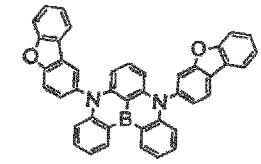
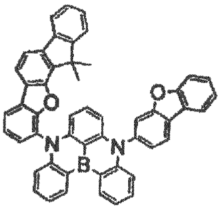
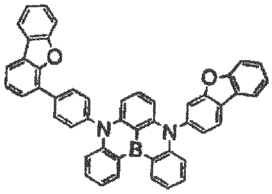
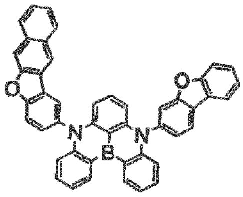
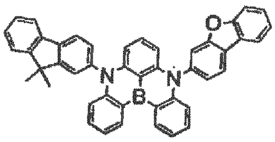
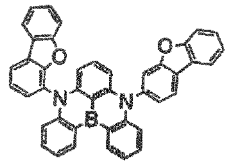
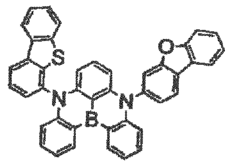
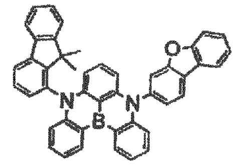
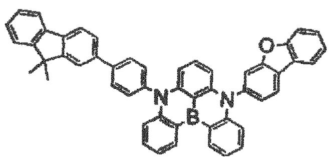
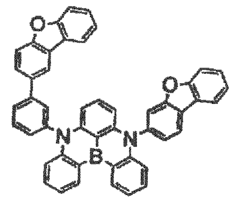
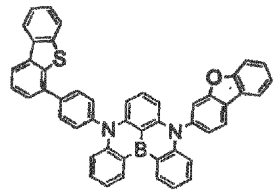
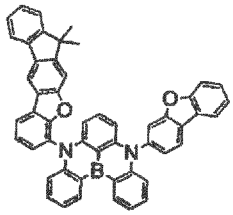
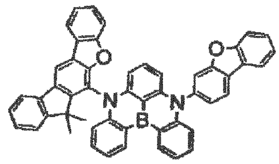
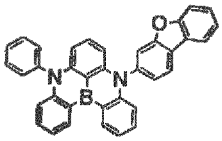
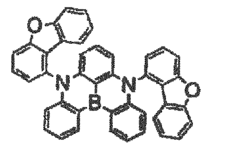
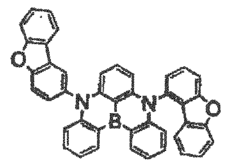
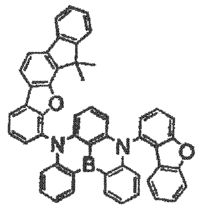
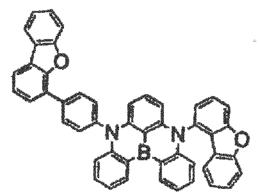
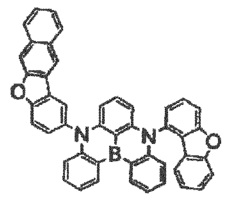
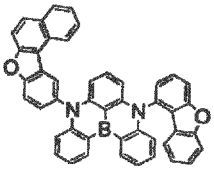
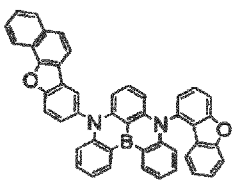
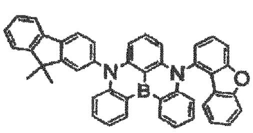

[Formula 141]

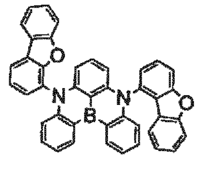 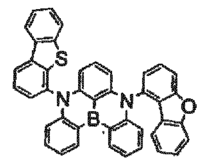 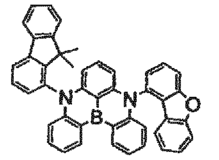

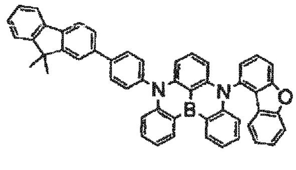 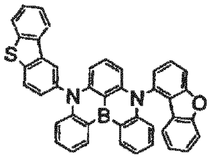 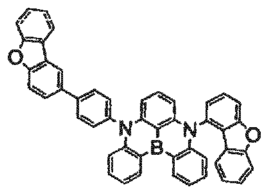

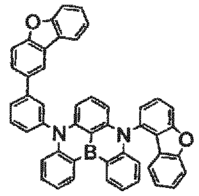 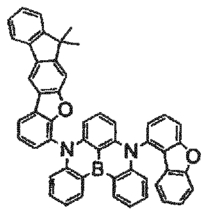 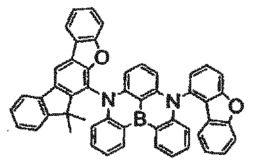

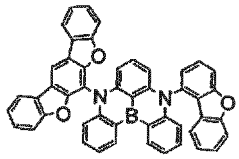 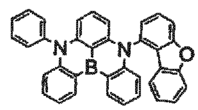 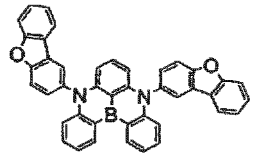

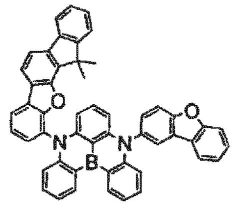 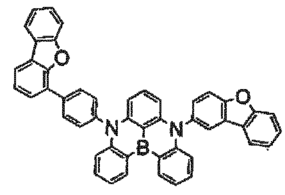 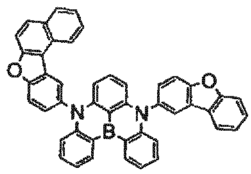

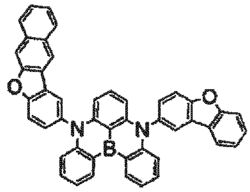 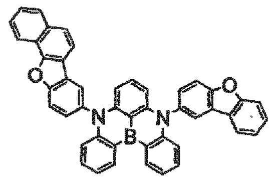 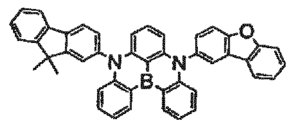

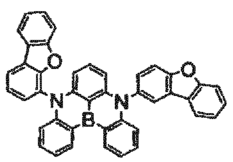 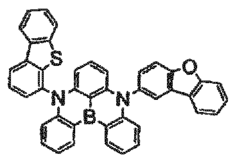 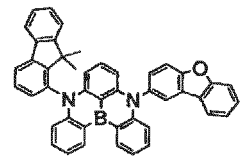

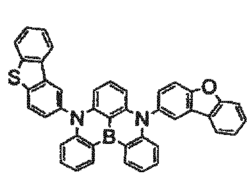 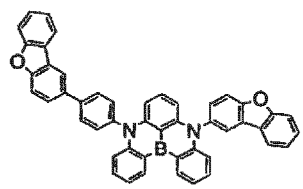 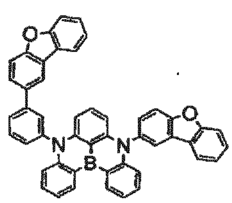

[Formula 142]

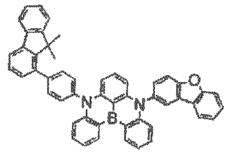
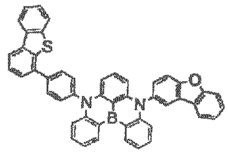
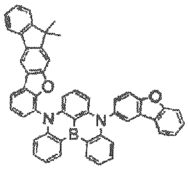
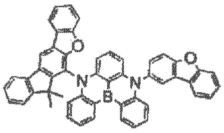
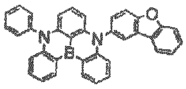
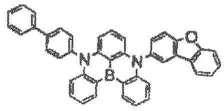
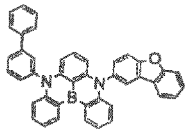
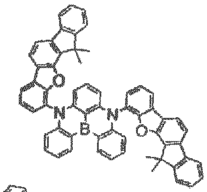
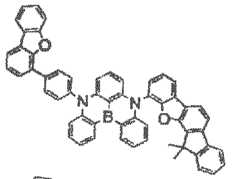
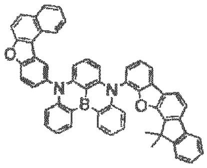
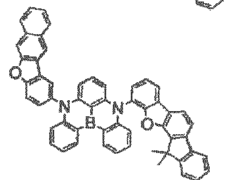
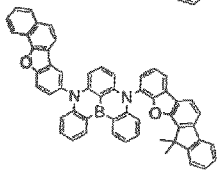
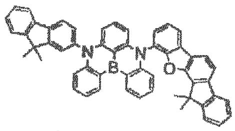
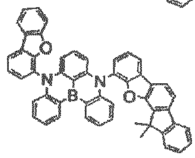
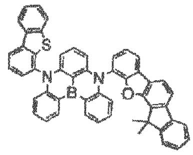
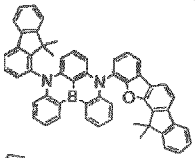
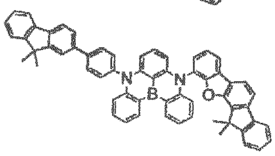
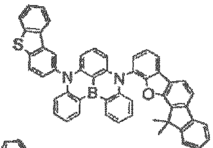
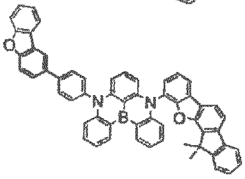
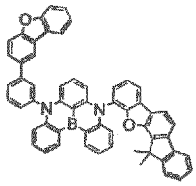
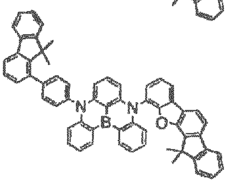
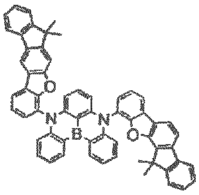
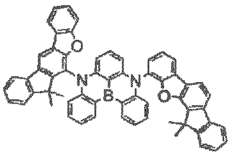
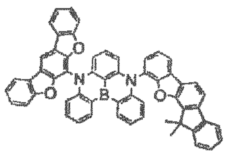

[Formula 143]

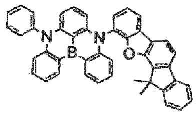
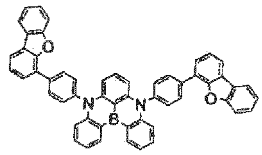
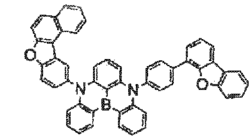
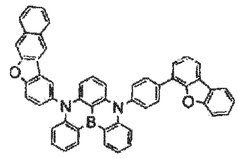
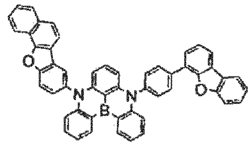
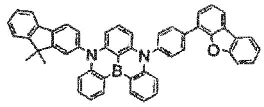
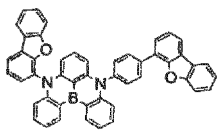
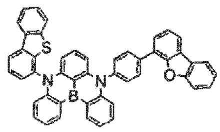
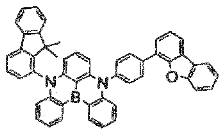
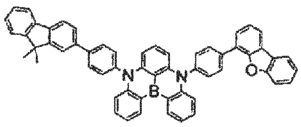
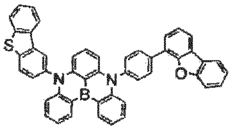
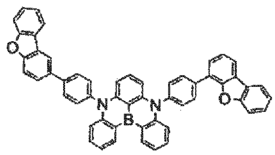
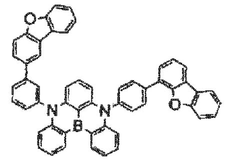
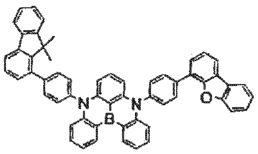
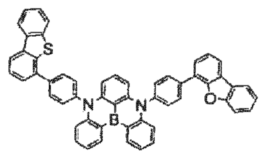
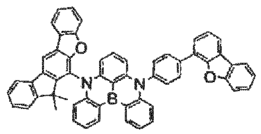
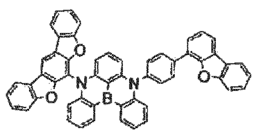
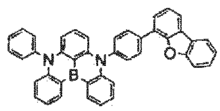
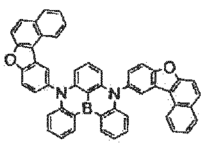
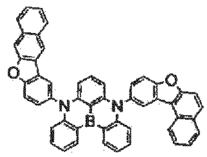
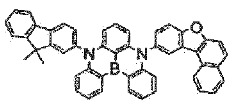
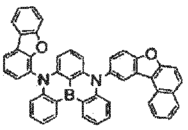
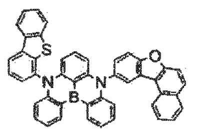
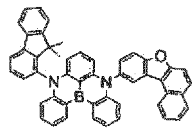

[Formula 144]

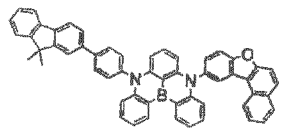
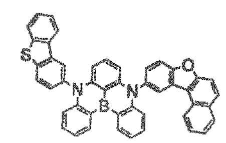
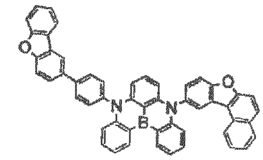
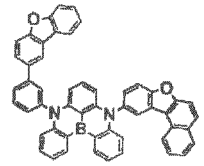
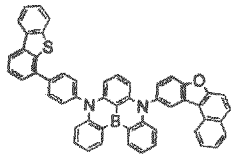
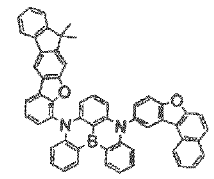
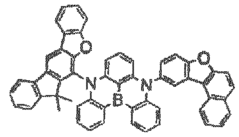
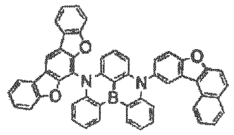
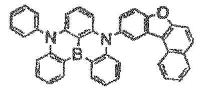
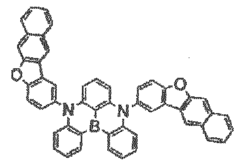
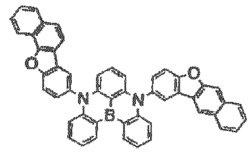
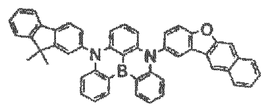
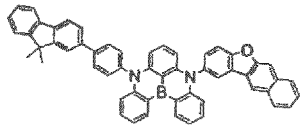
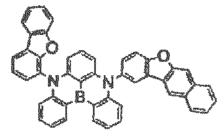
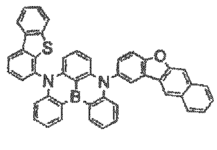
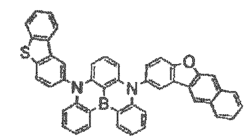
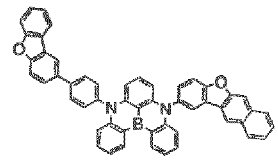
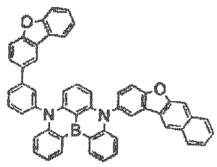
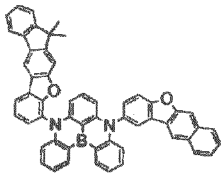
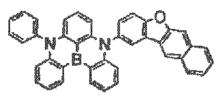
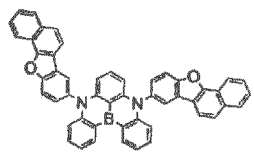
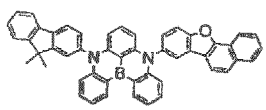
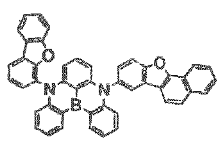
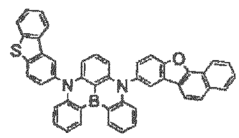

[Formula 145]

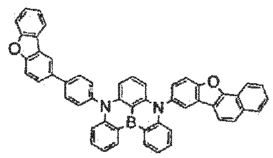
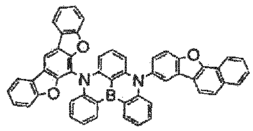
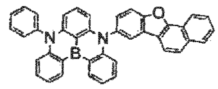
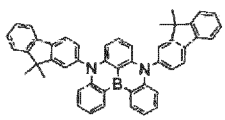
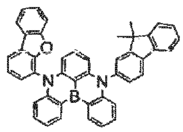
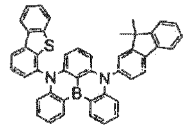
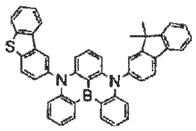
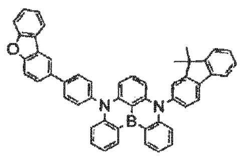
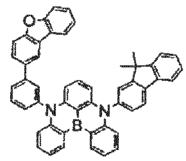
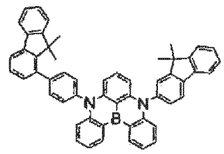
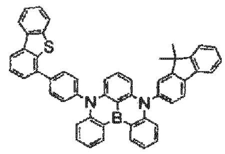
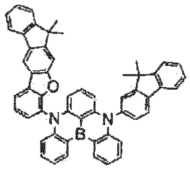
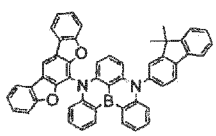
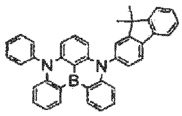
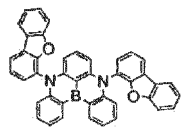
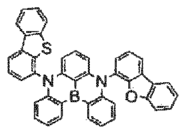
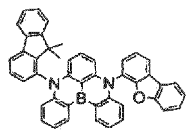
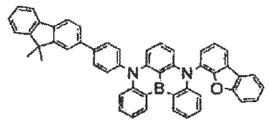
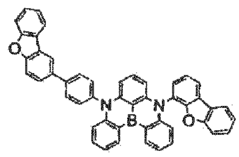
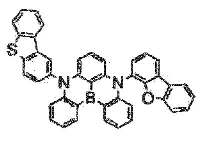
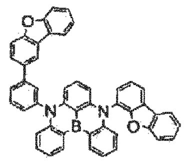
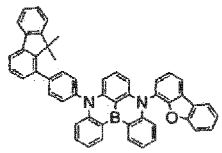
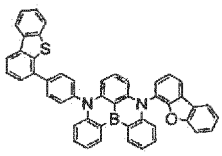
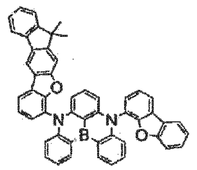

[Formula 146]

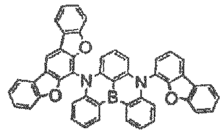
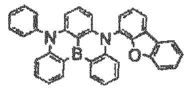
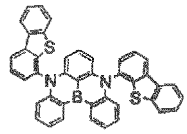
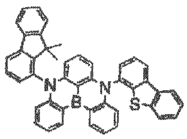
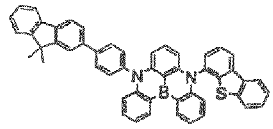
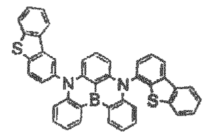
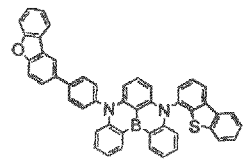
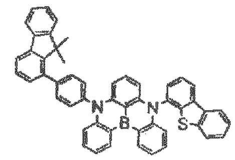
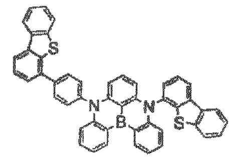
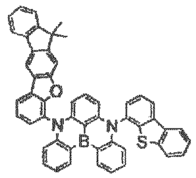
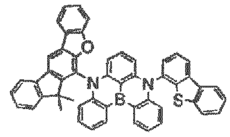
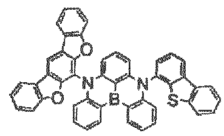
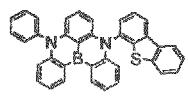
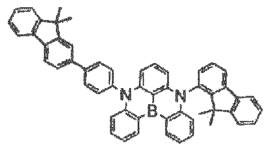
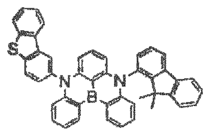
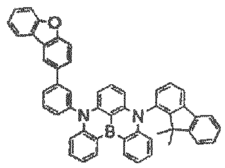
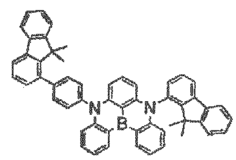
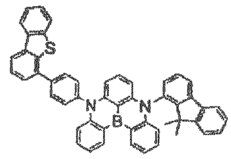
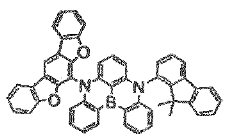
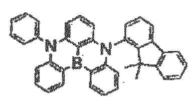
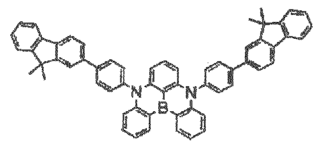
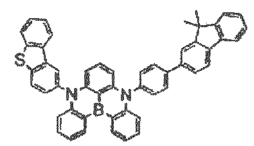
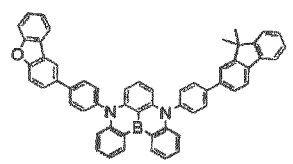
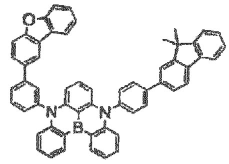

[Formula 147]

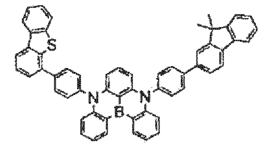
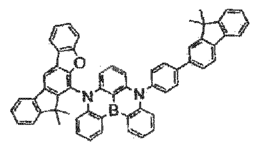
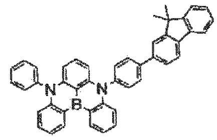
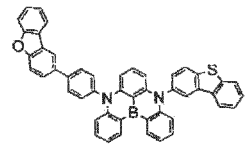
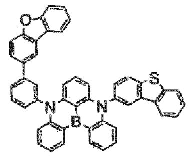
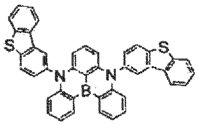
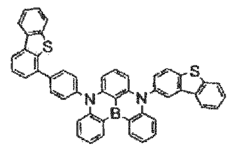
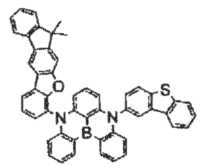
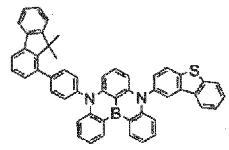
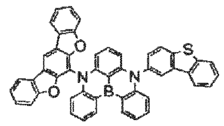
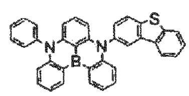
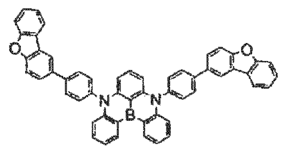
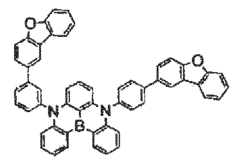
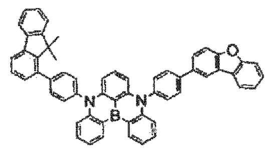
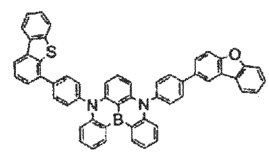
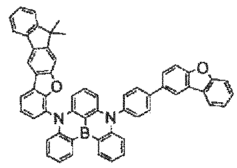
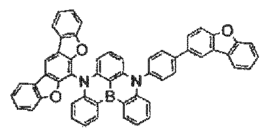
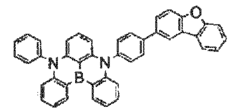
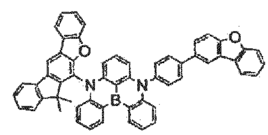
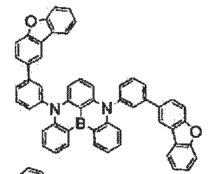
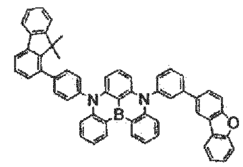
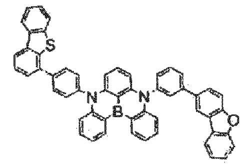
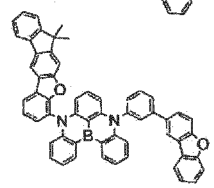
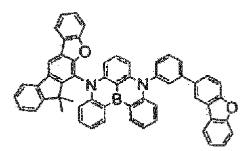

[Formula 148]

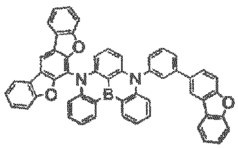
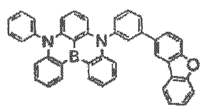
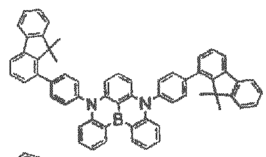
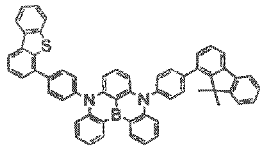
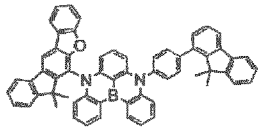
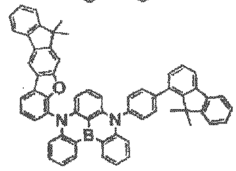
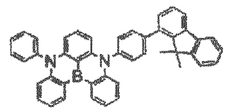
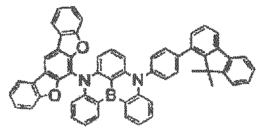
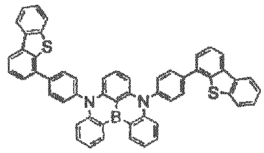
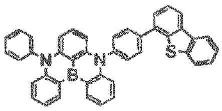
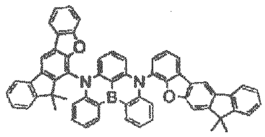
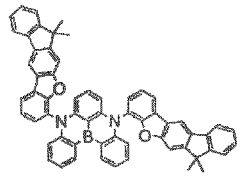
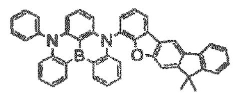
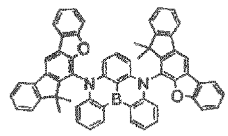
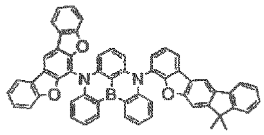
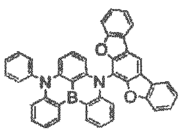
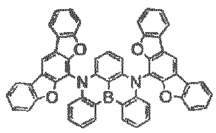
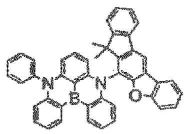
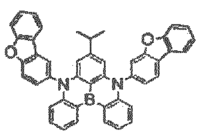
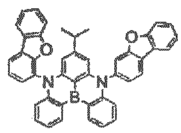
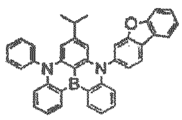
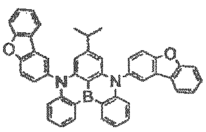
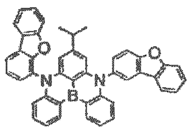
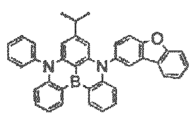

[Formula 149]

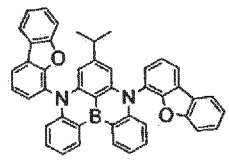
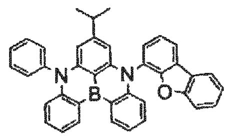
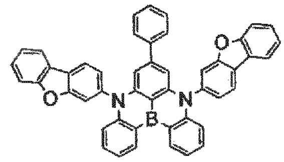
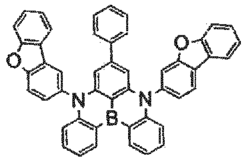
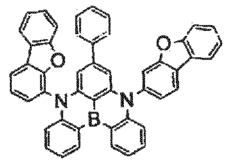
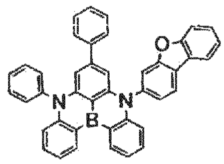
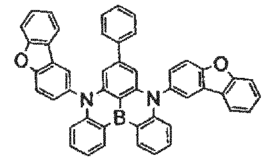
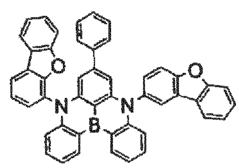
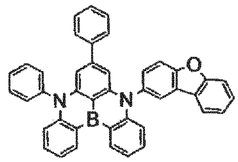
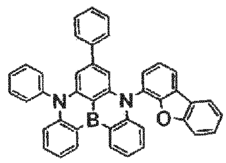
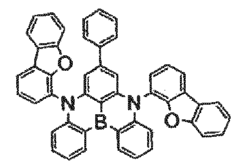

[Formula 150]

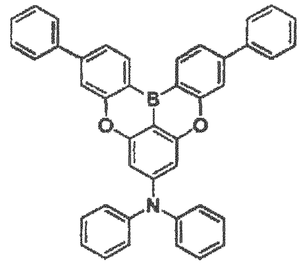
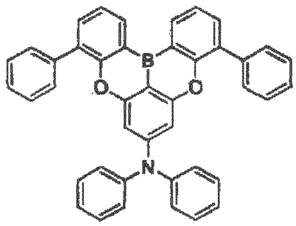
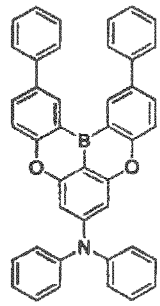
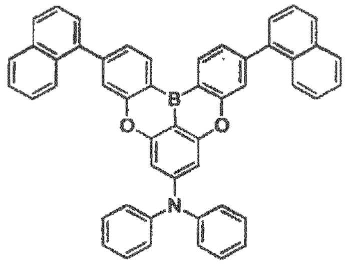
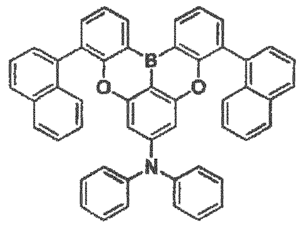
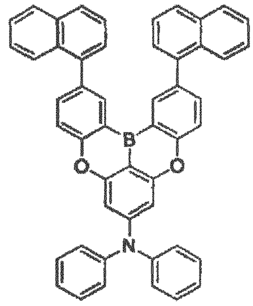
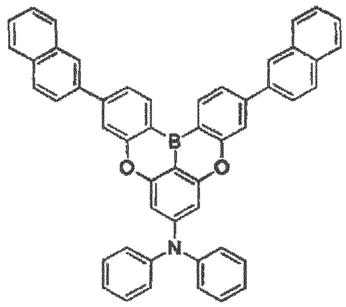
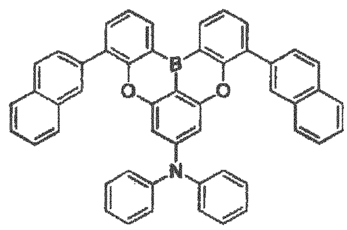
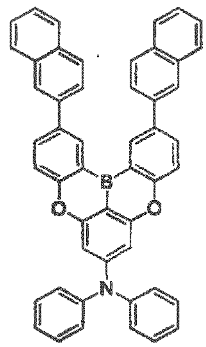
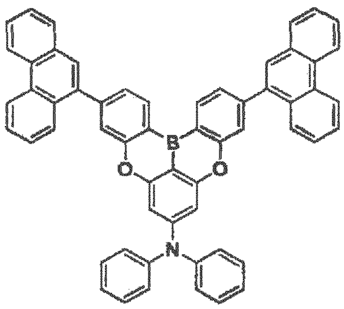
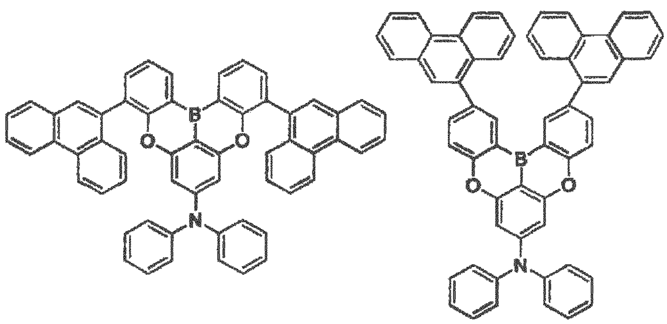

[Formula 151]

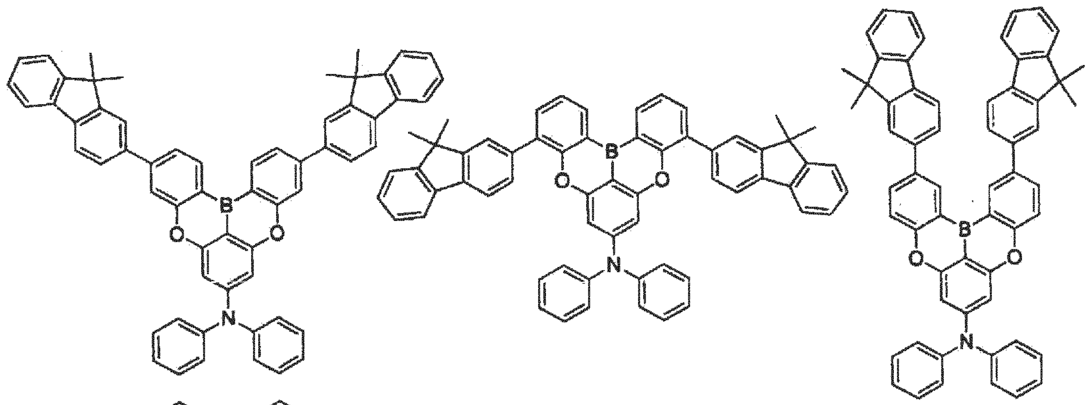

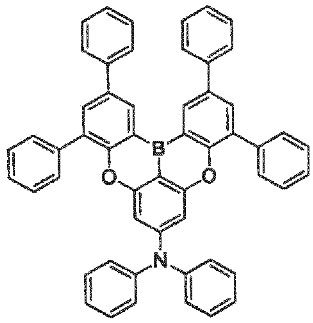

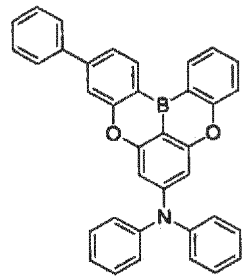

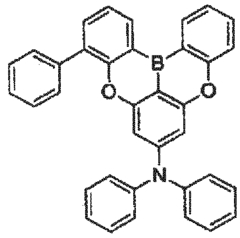

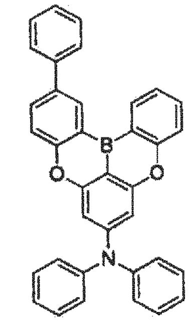

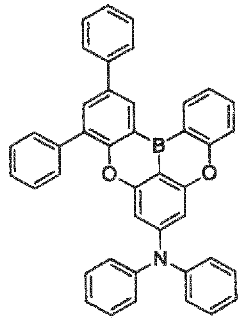

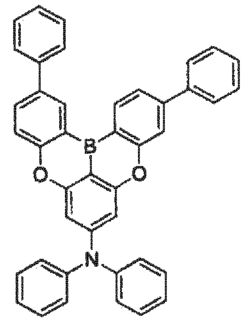

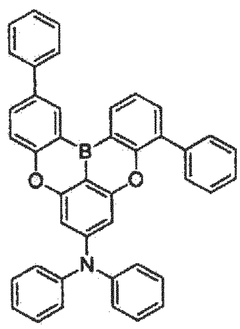

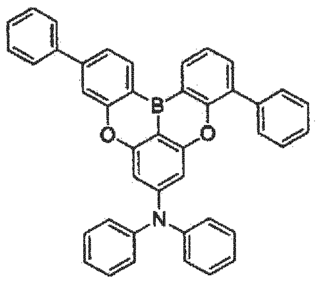

[Formula 152]

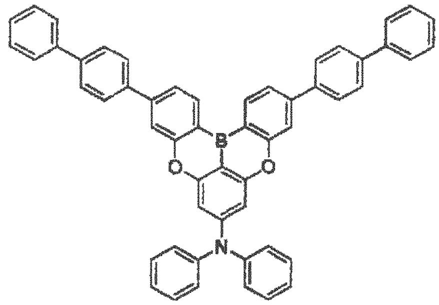

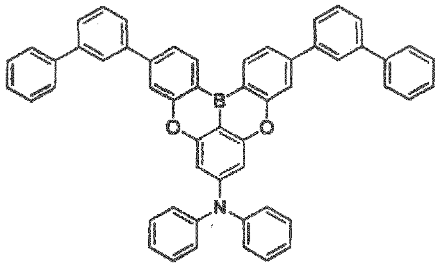

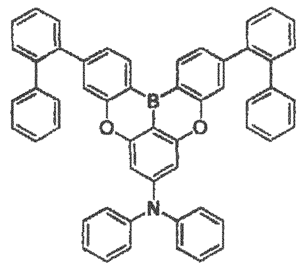

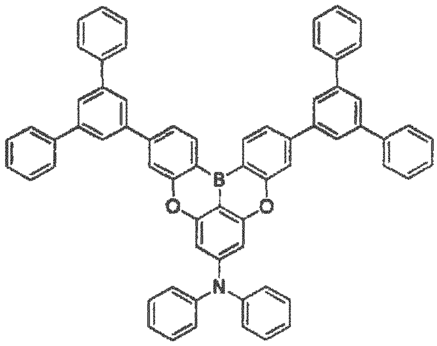

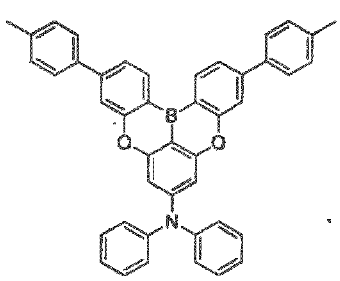

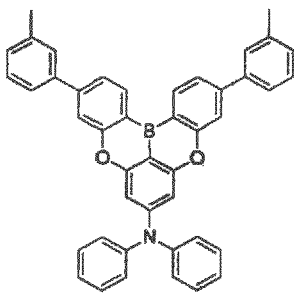

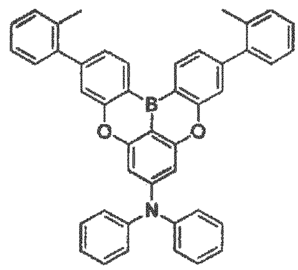

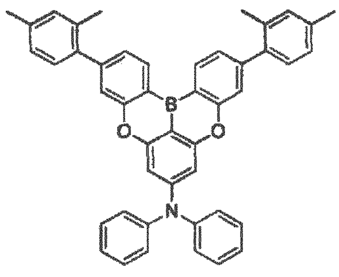

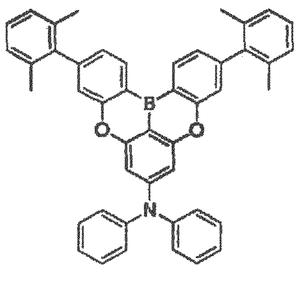

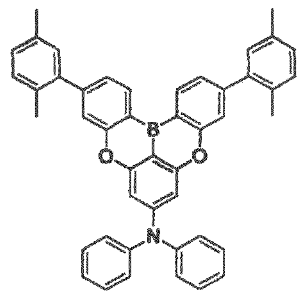

[Formula 153]

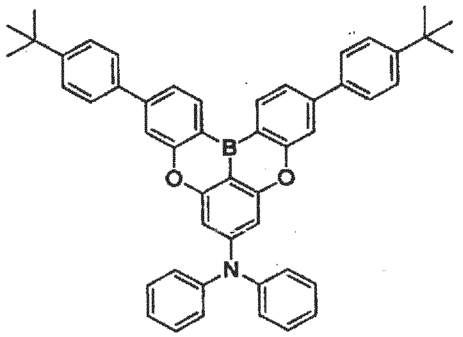

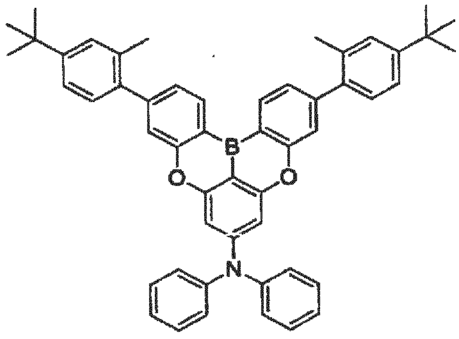

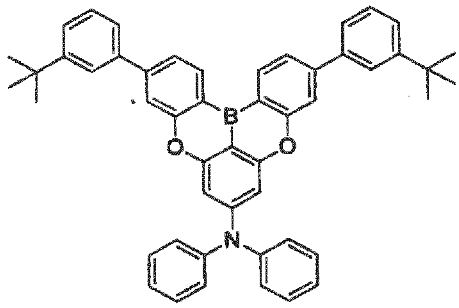

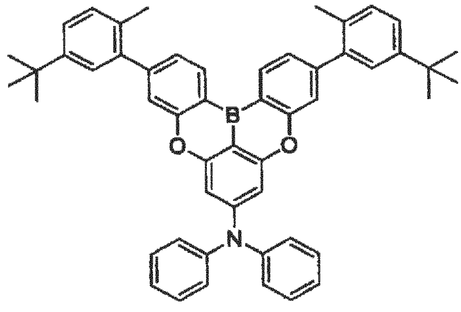

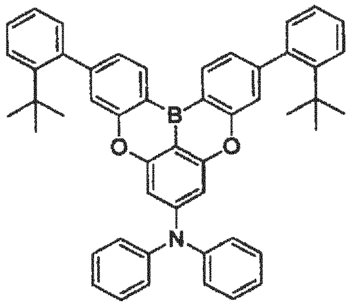

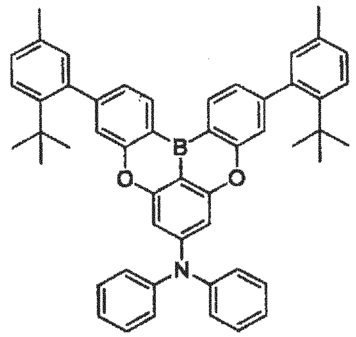

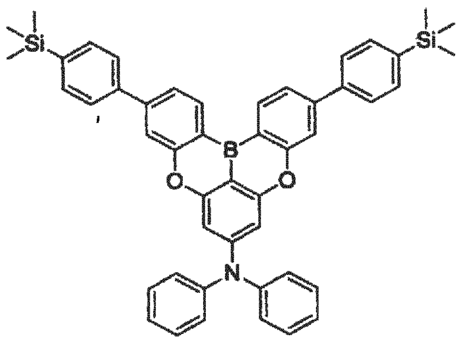

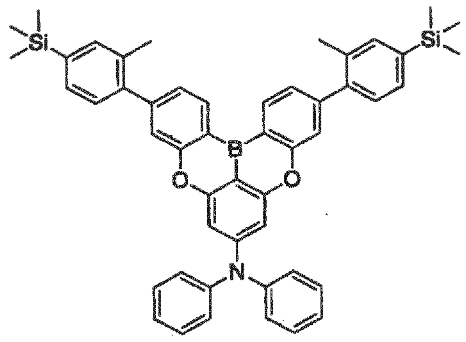

[Formula 154]

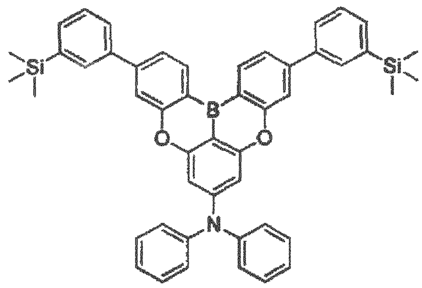

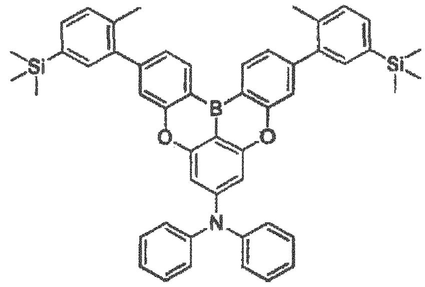

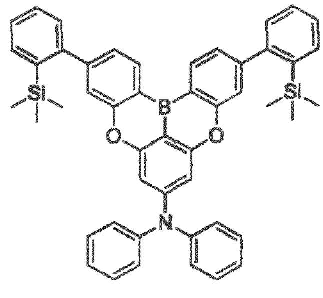

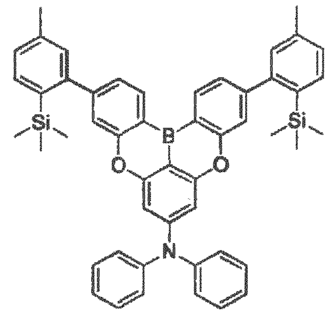

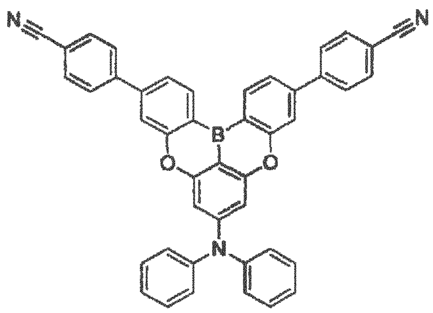

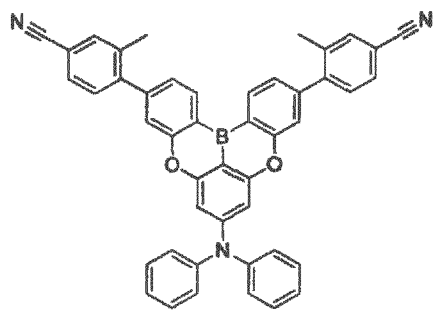

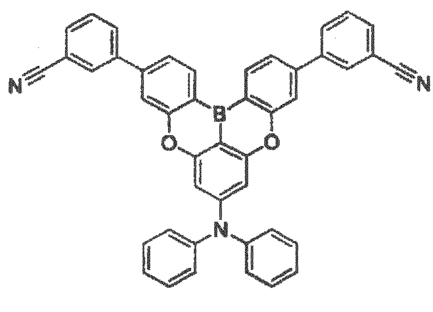

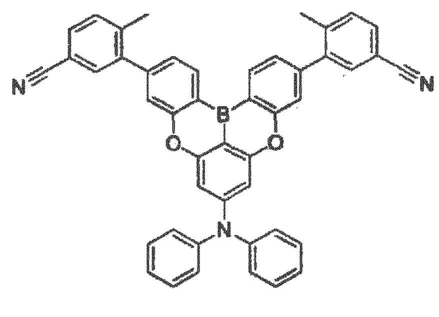

[Formula 155]

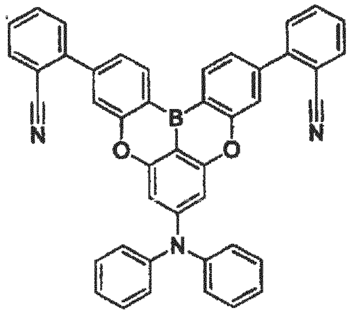

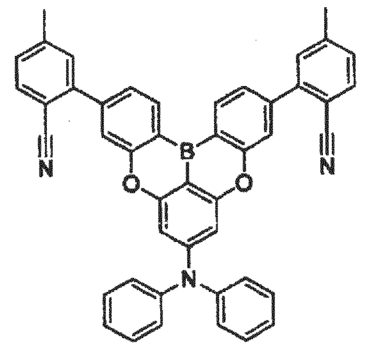

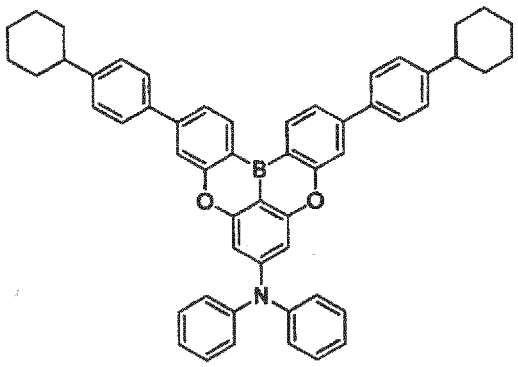

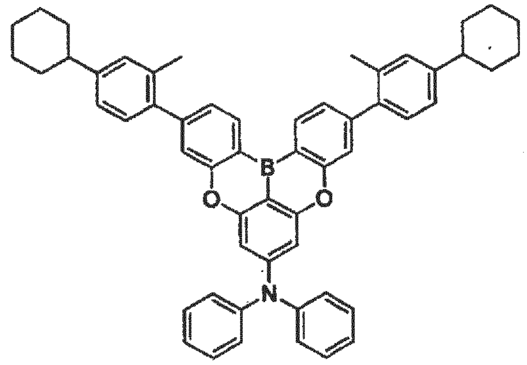

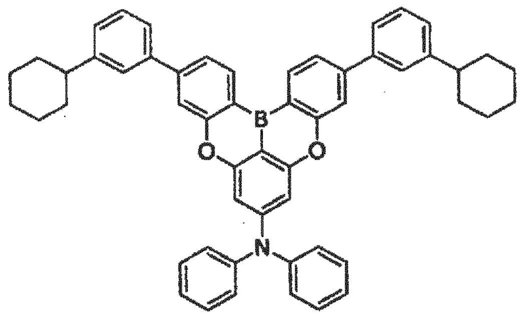

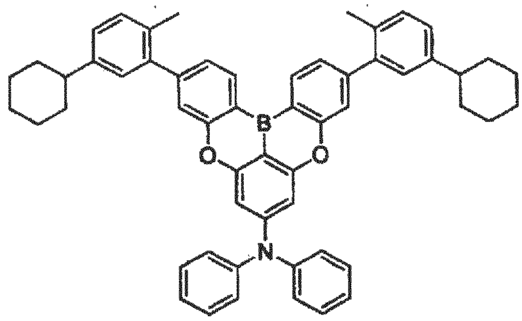

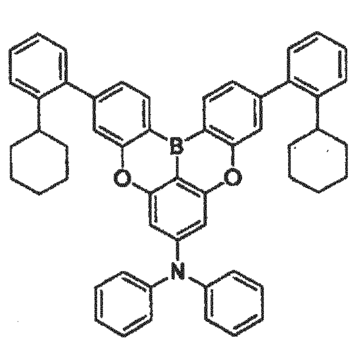

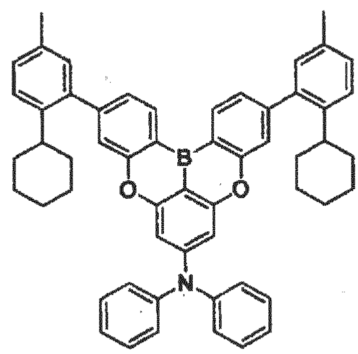

[Formula 156]

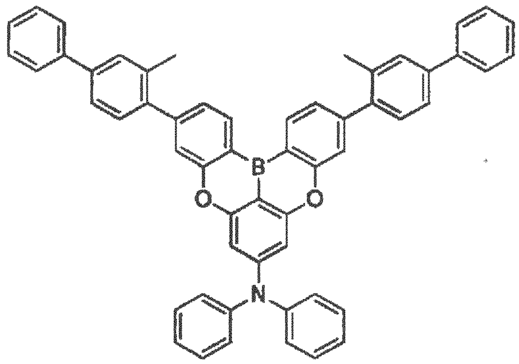

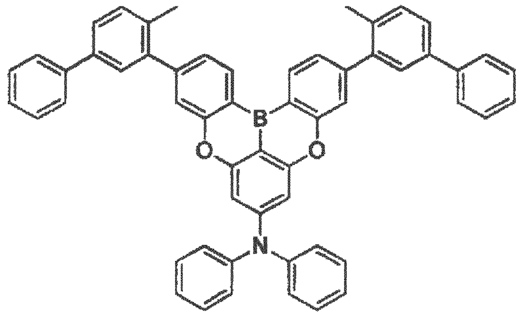

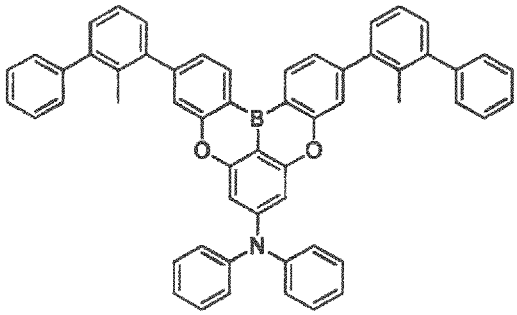

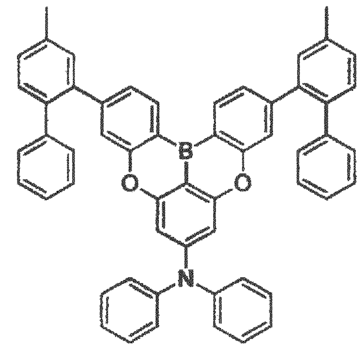

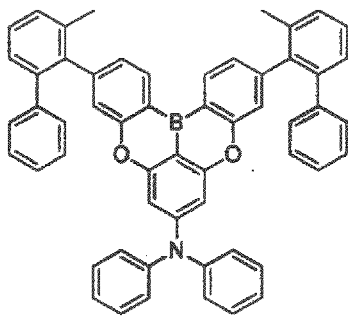

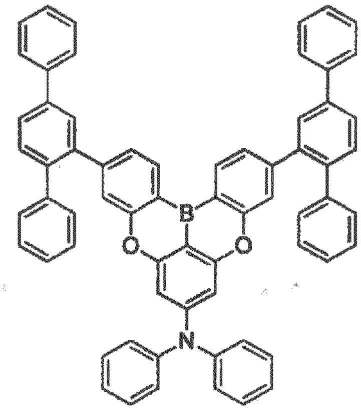

[Formula 157]

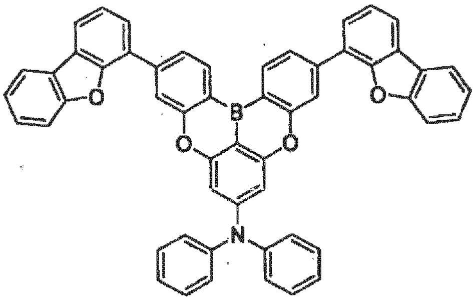

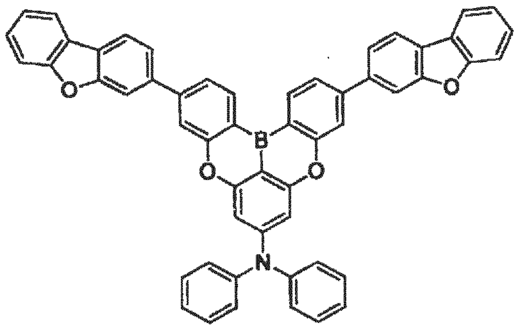

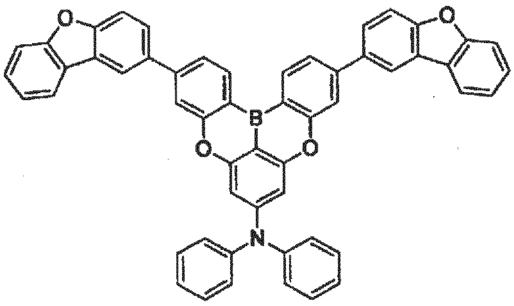

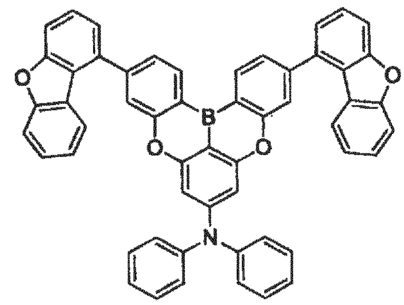

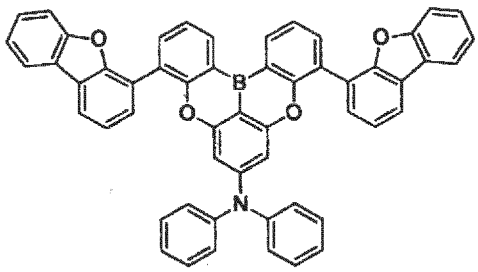

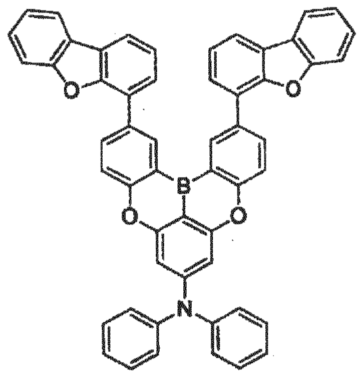

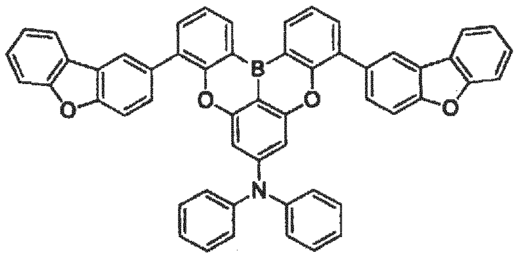

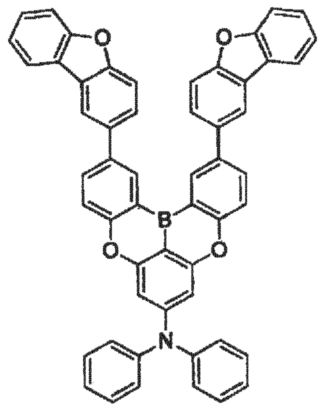

[Formula 158]

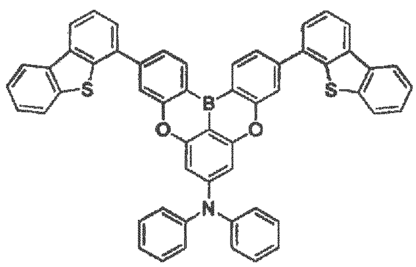

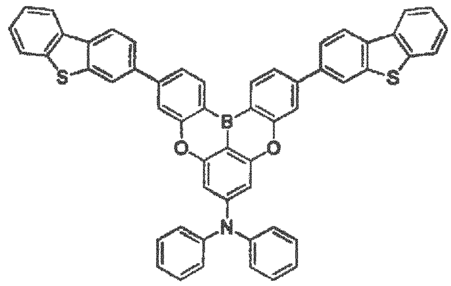

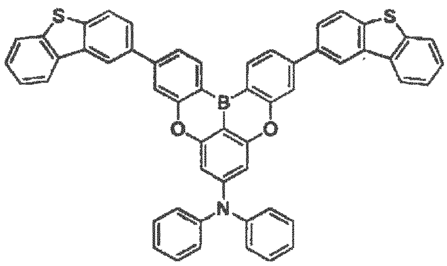

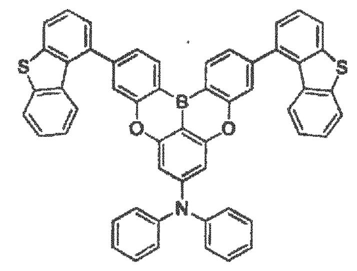

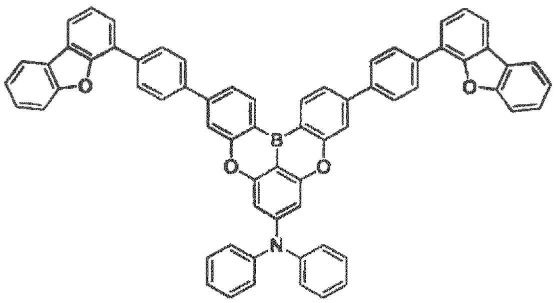

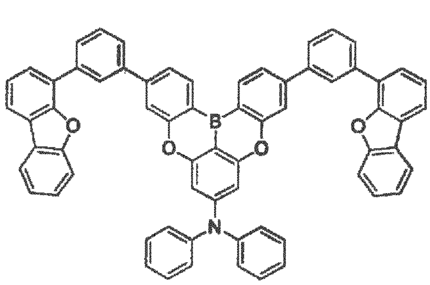

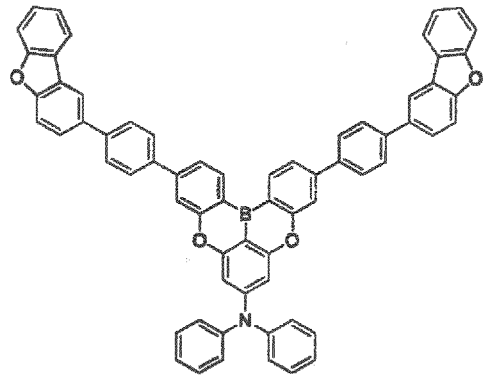

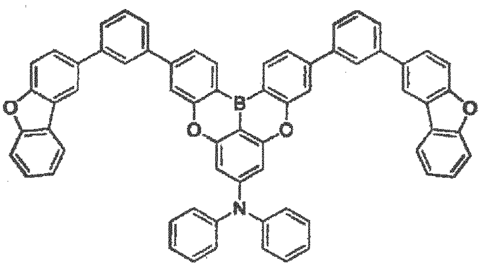

[Formula 159]

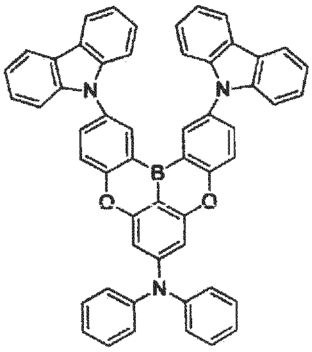

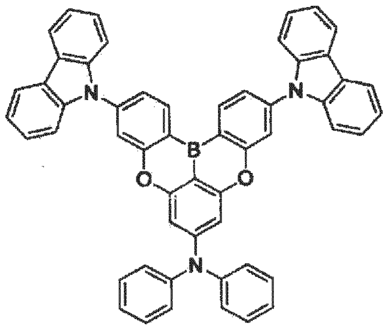

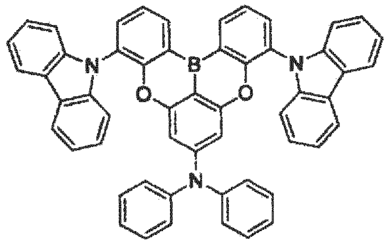

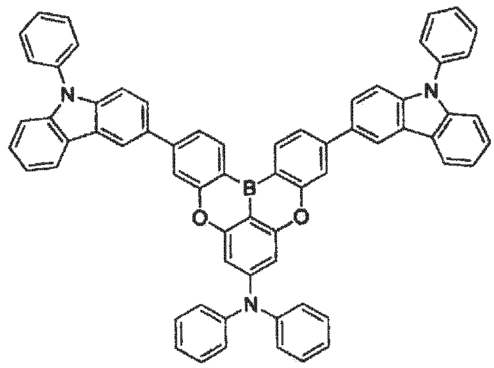

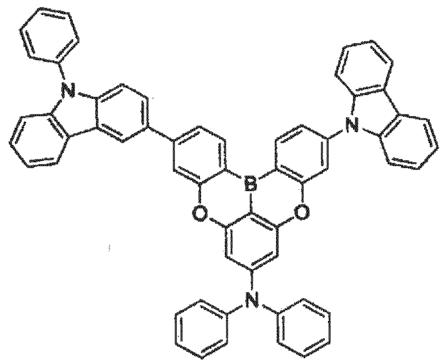

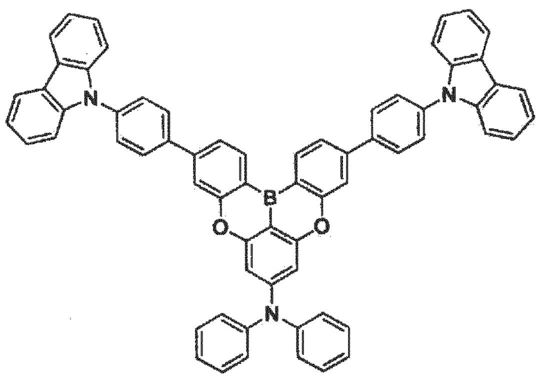

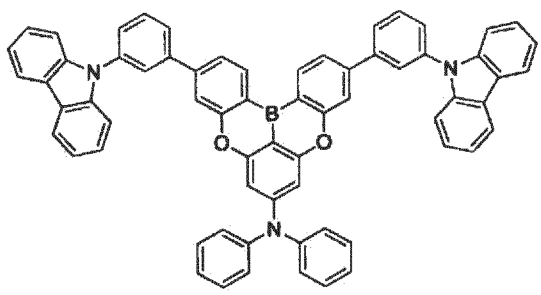

[Formula 160]

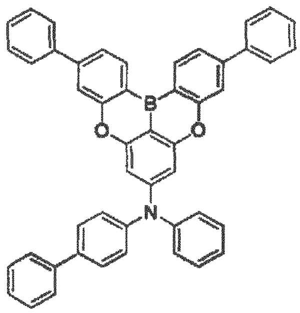
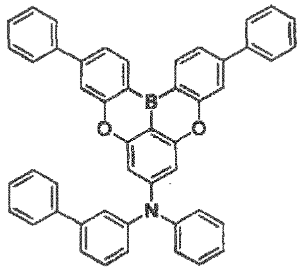
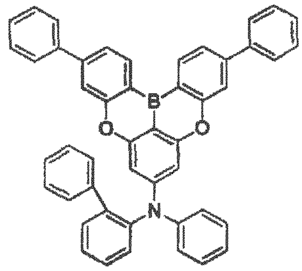
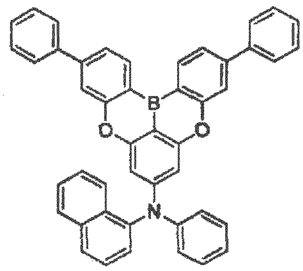
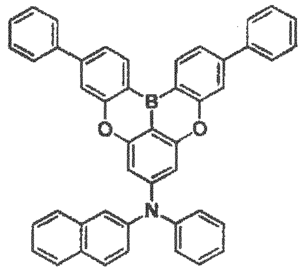
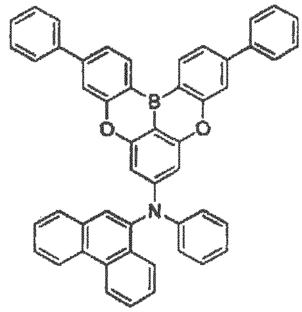
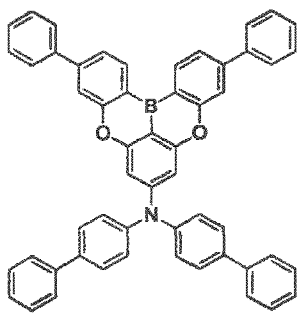
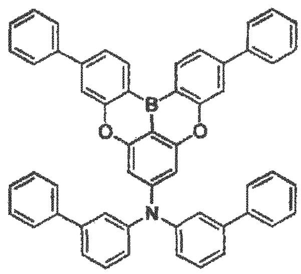
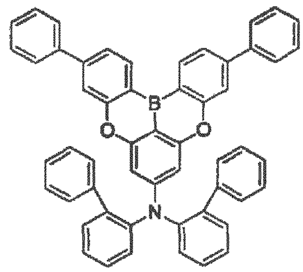
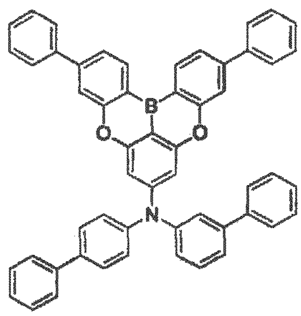
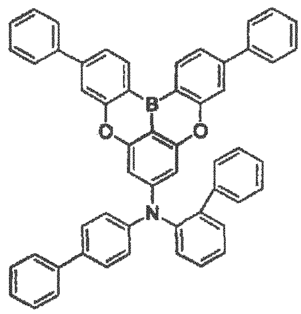
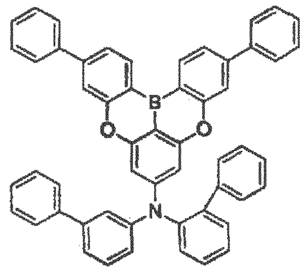

[Formula 161]

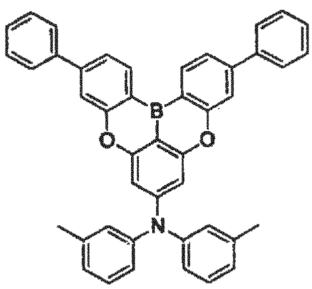
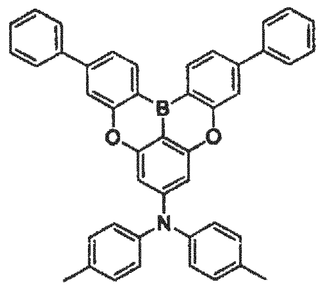
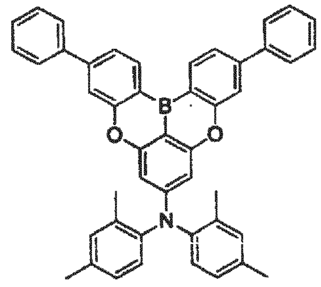

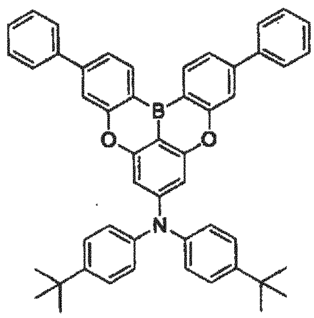
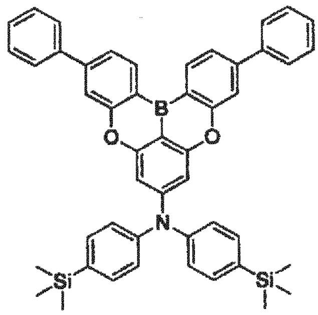
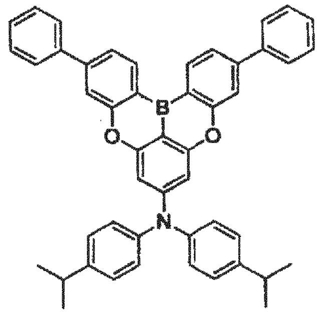

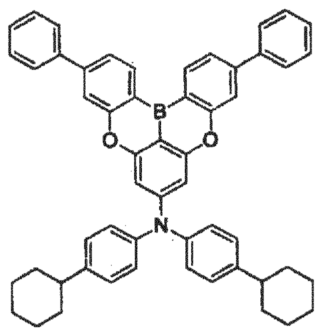
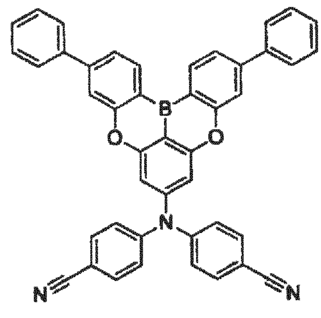
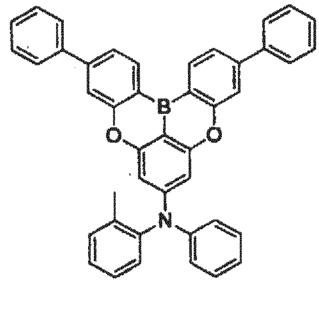

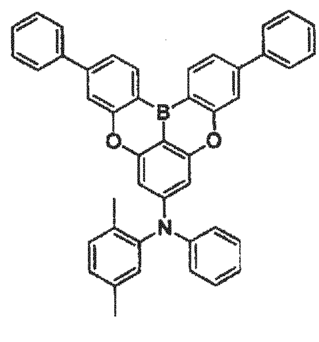
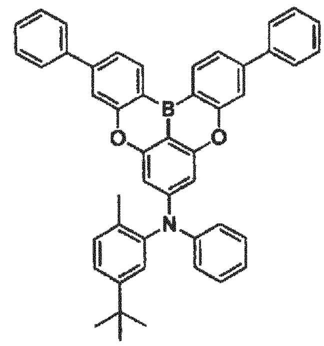
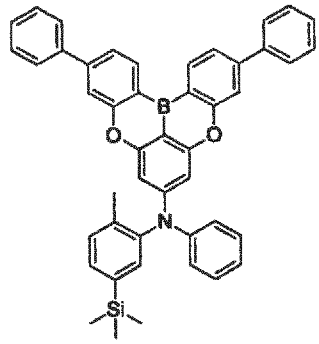

[Formula 162]

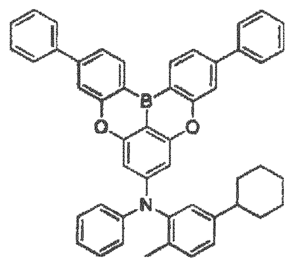
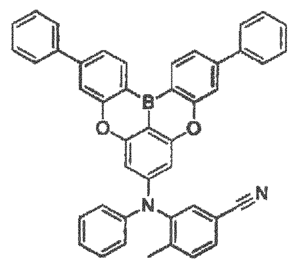
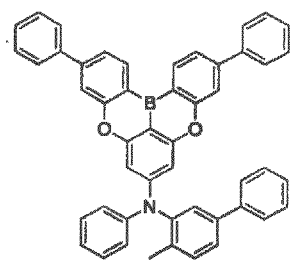

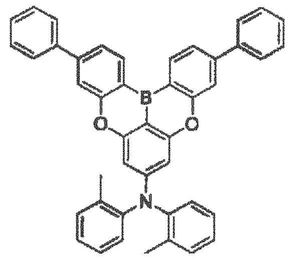
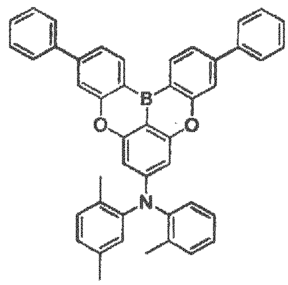
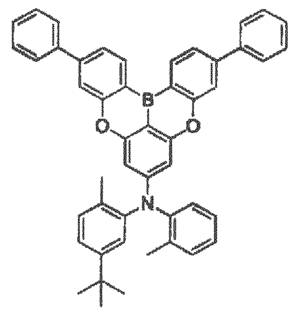

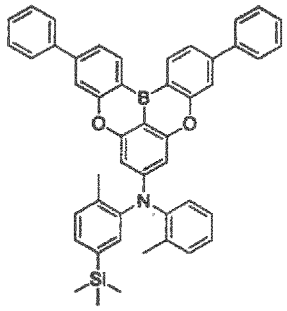
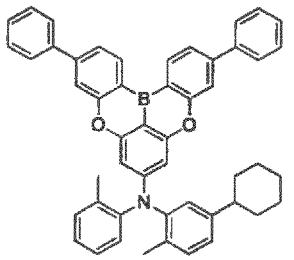
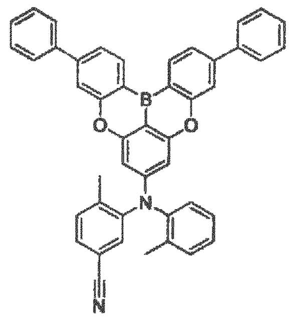

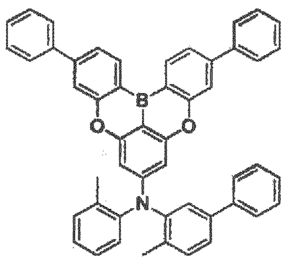
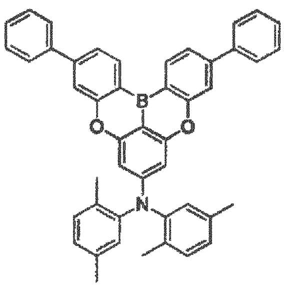
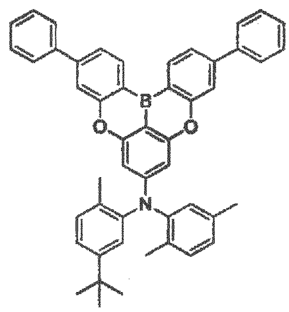

[Formula 163]

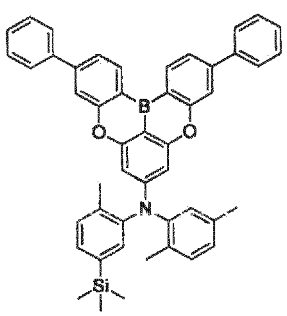
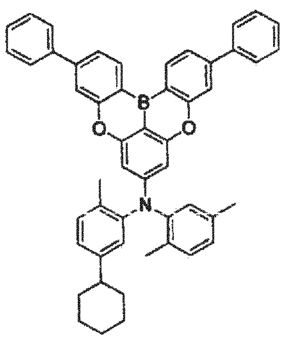
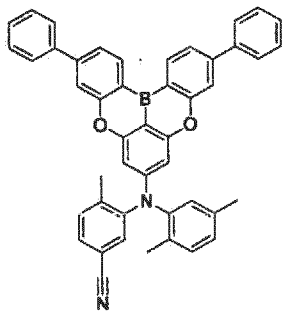

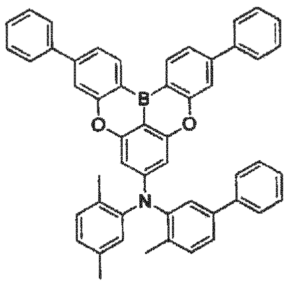
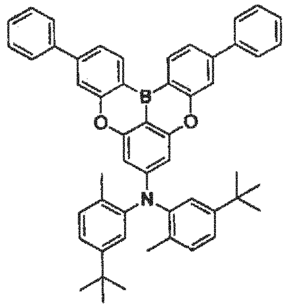
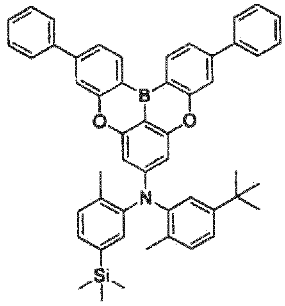

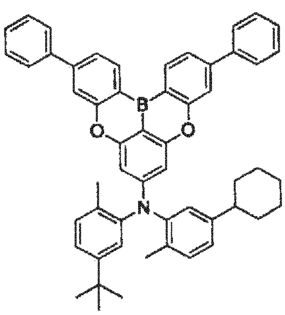
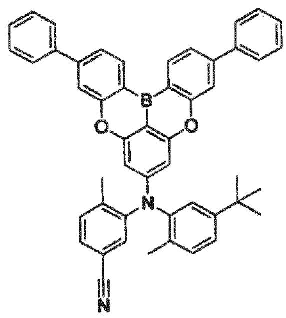
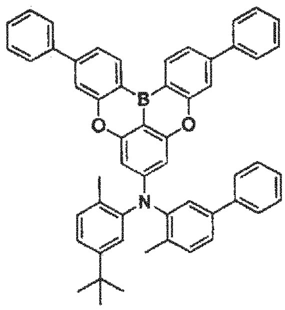

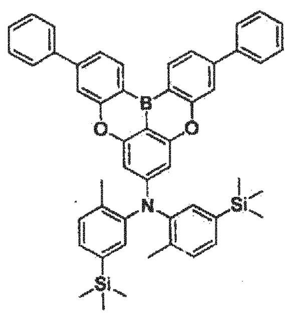
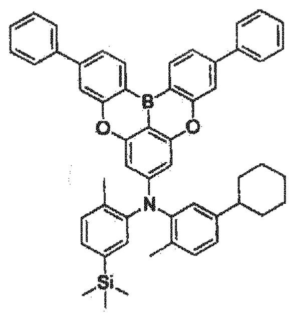
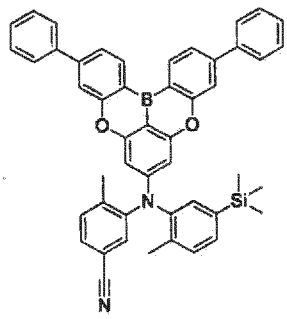

[Formula 164]

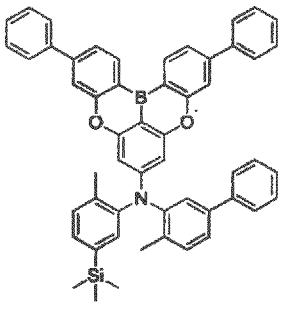
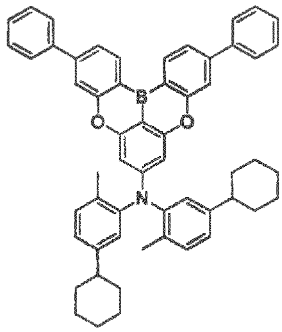
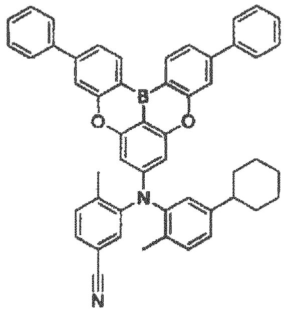
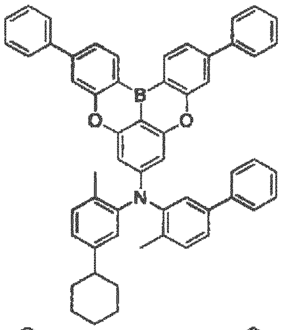
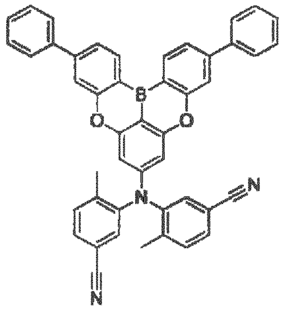
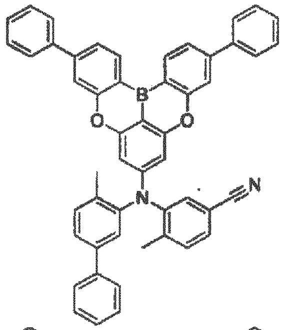
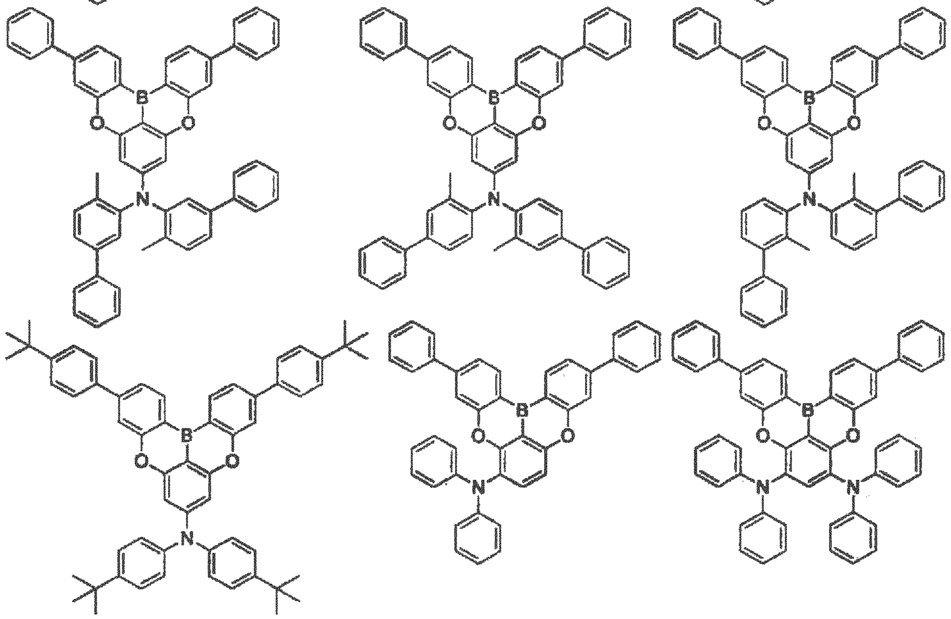

[Formula 165]

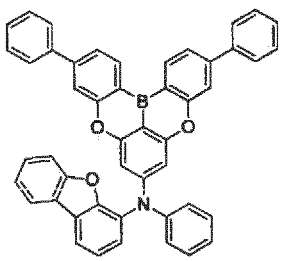
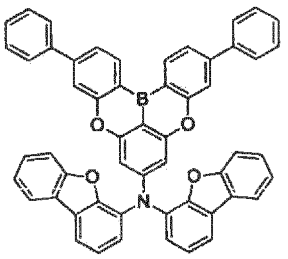
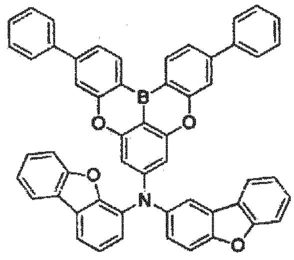

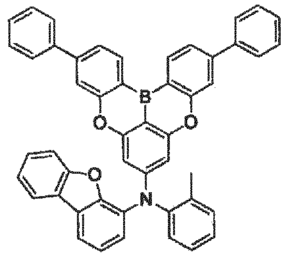
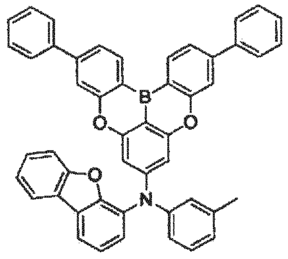
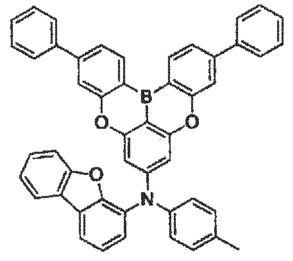

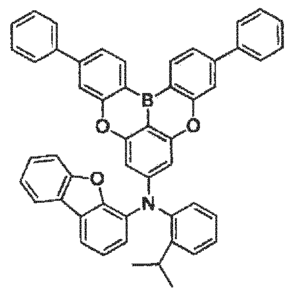
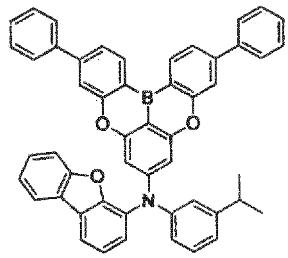
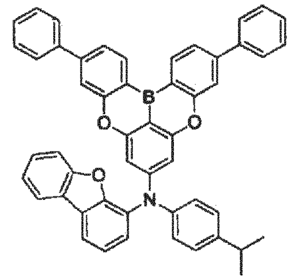

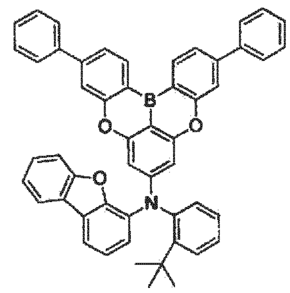
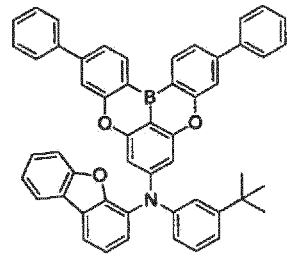
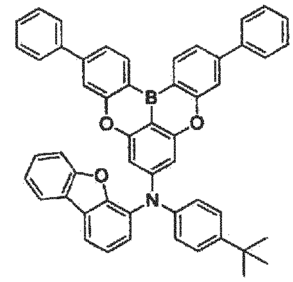

[Formula 166]

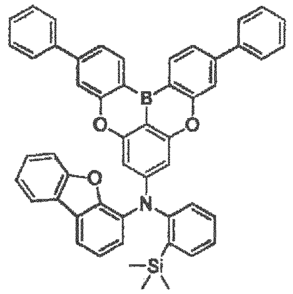
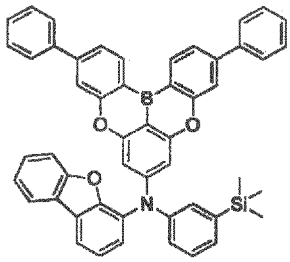
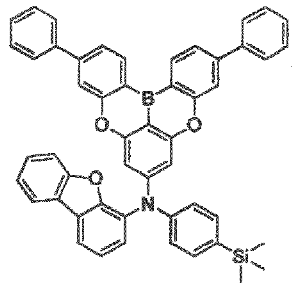
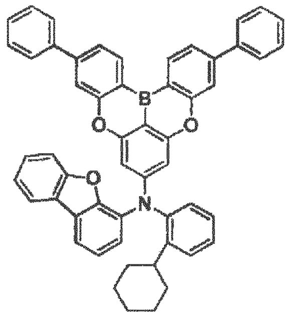
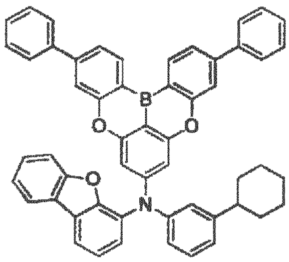
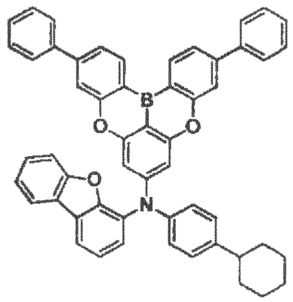
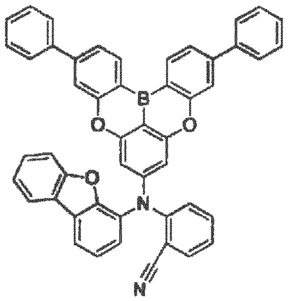
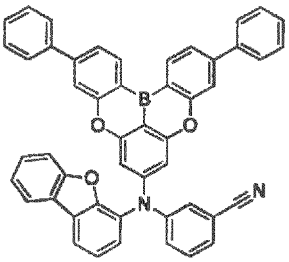
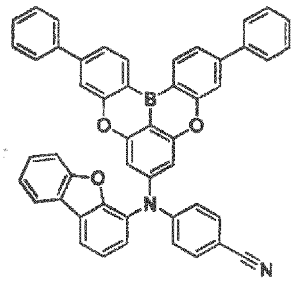
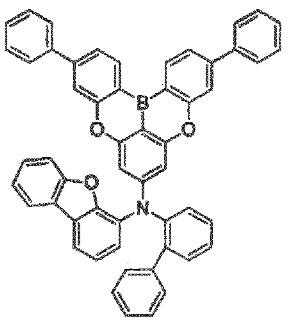
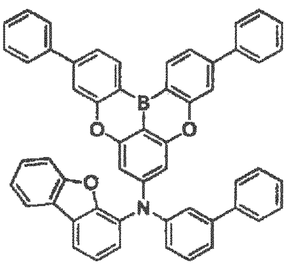
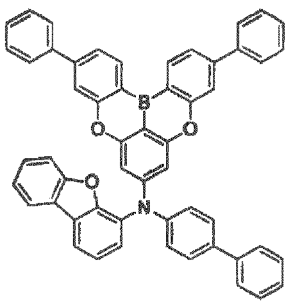

[Formula 167]

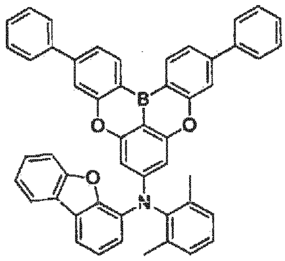
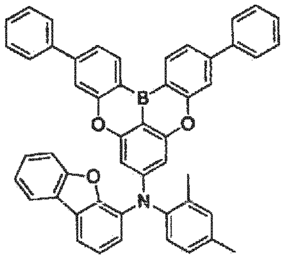
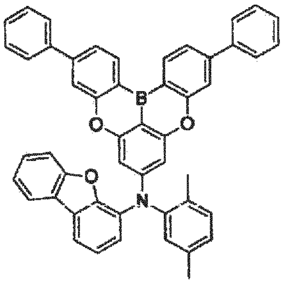

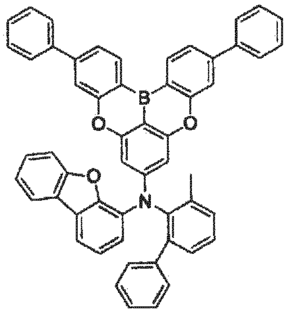
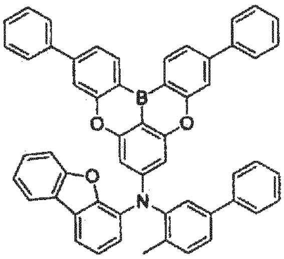
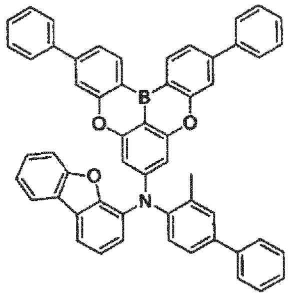

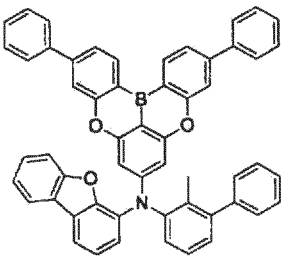
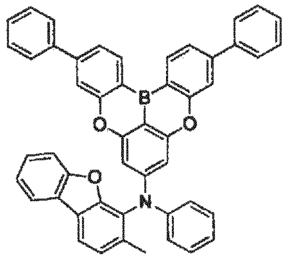
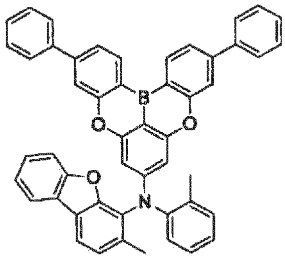

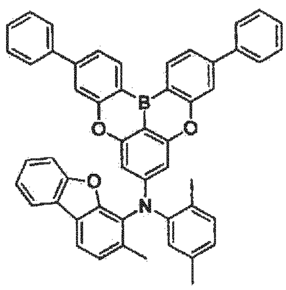
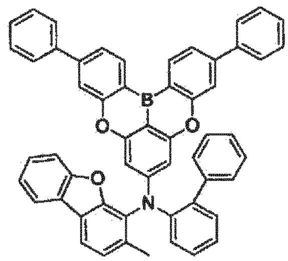
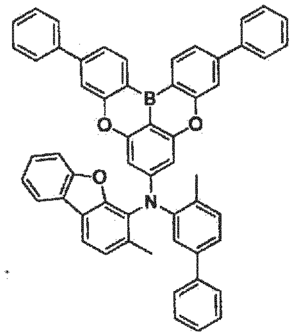

[Formula 168]

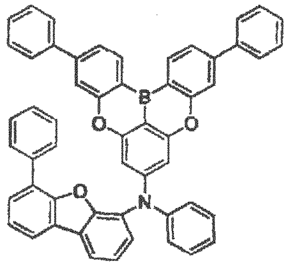
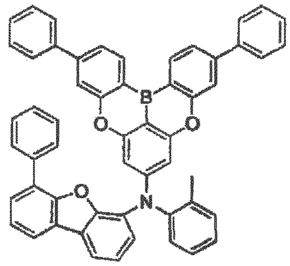
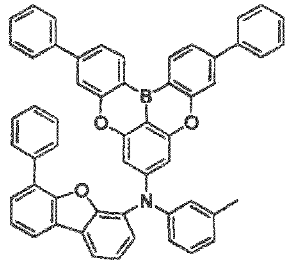
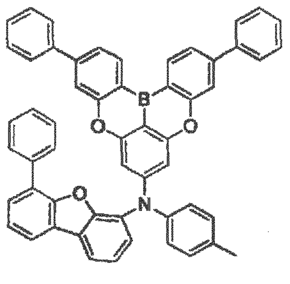
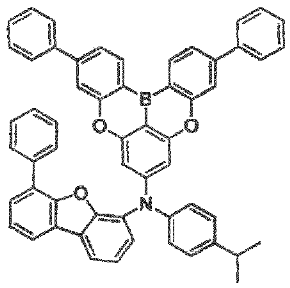
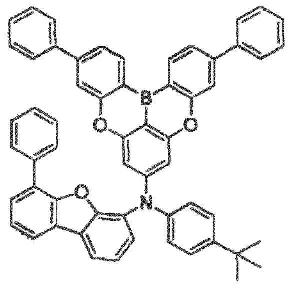
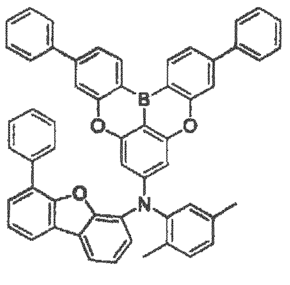
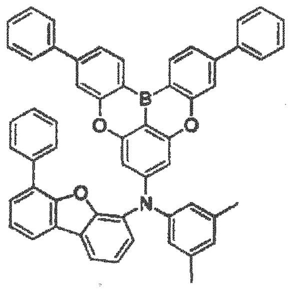
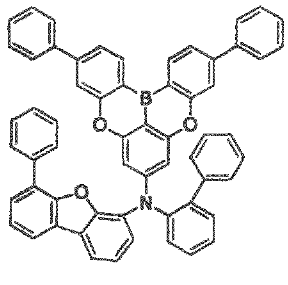
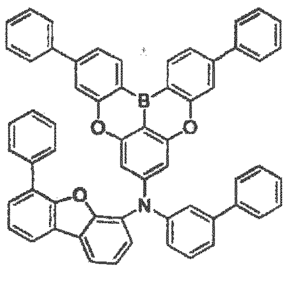
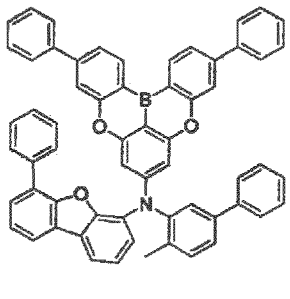
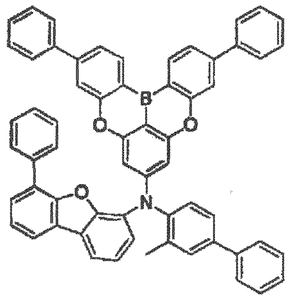

[Formula 169]

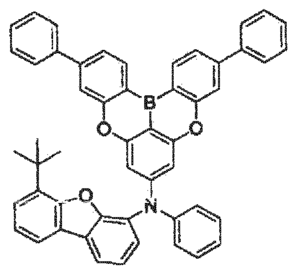
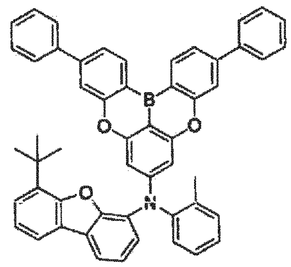
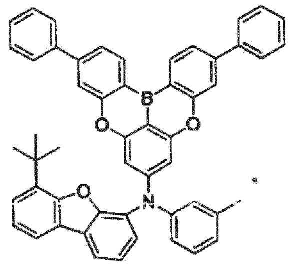

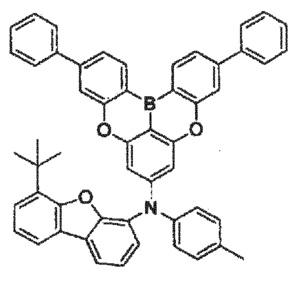
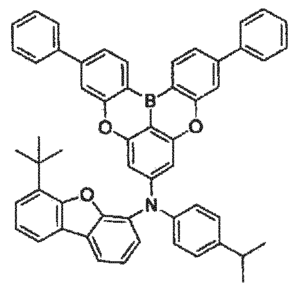
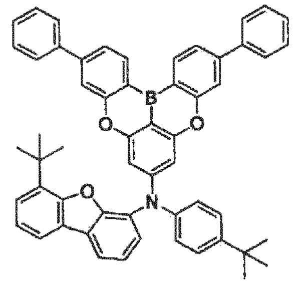

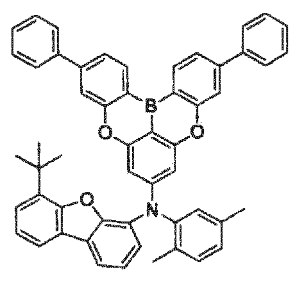
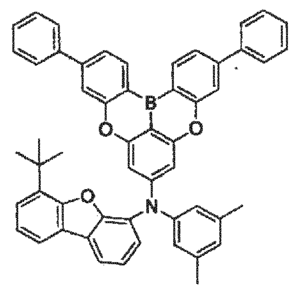
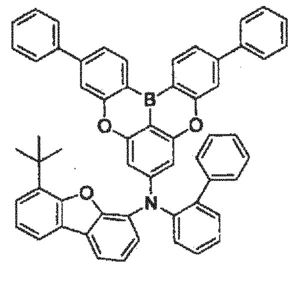

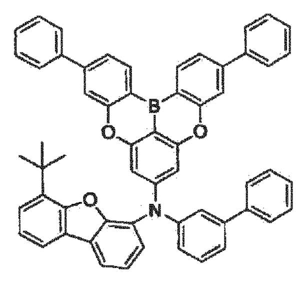
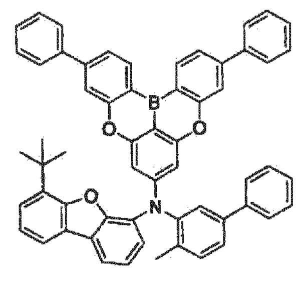
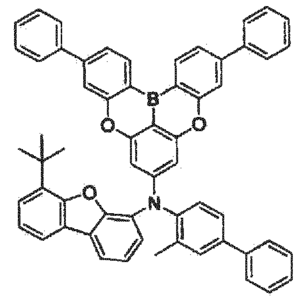

[Formula 170]

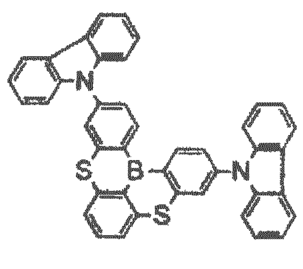
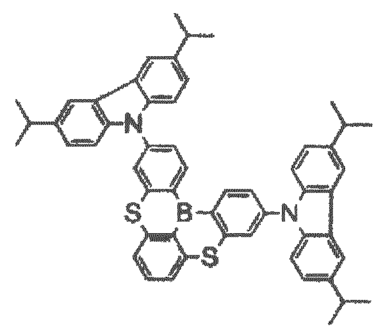
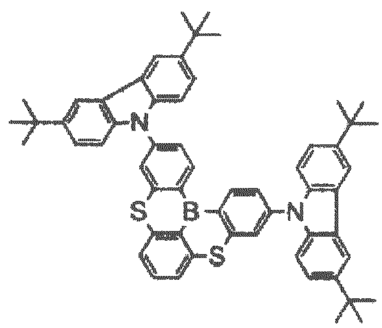

[Formula 171]

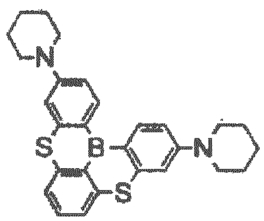

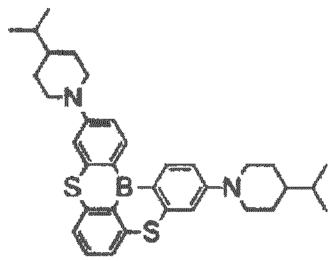

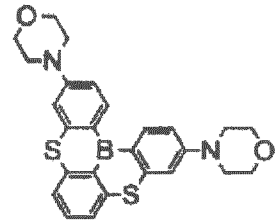

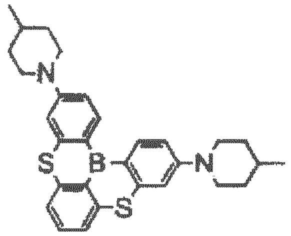

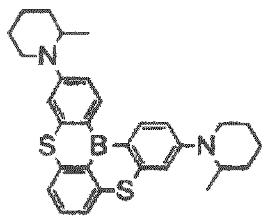

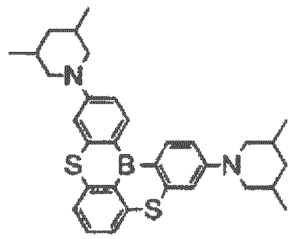

[Formula 172]

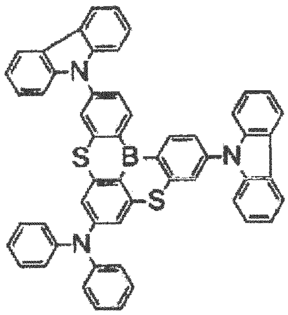
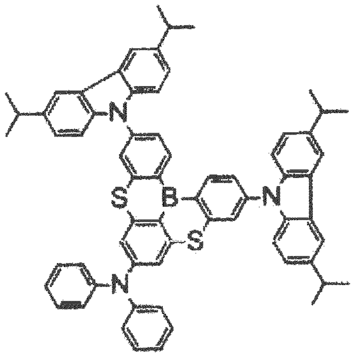
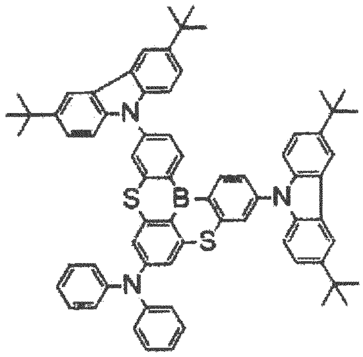

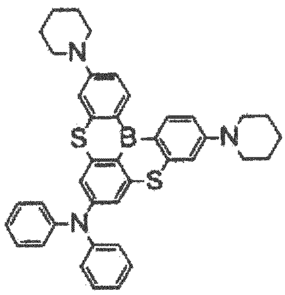
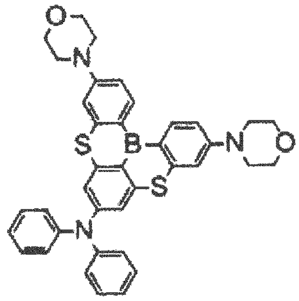
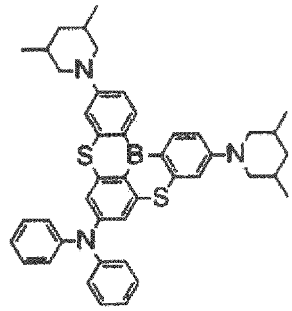

[Formula 173]

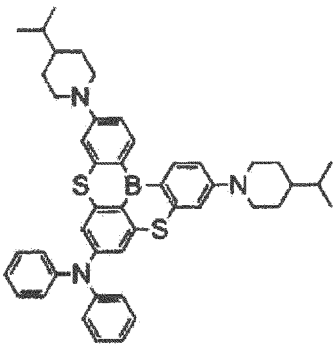
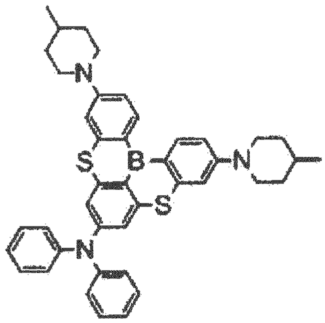
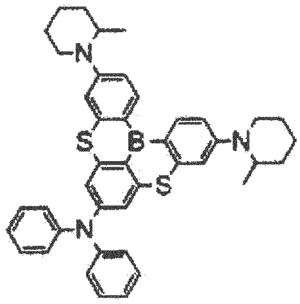

[Formula 174]

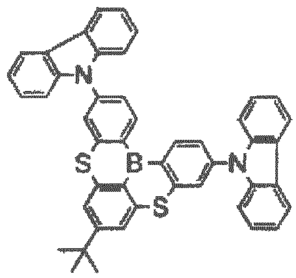
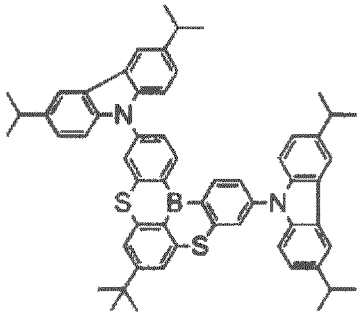
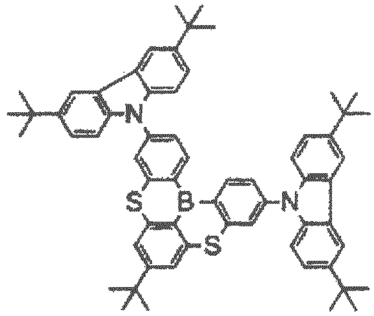

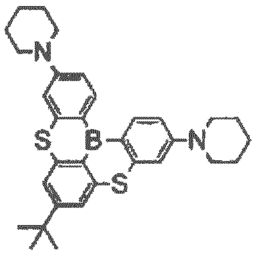
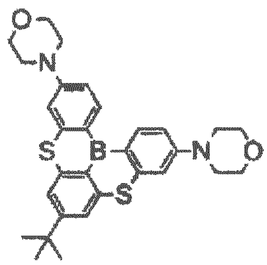
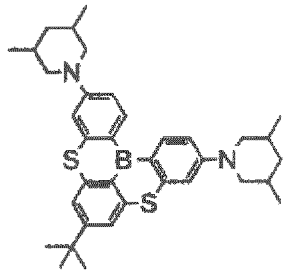

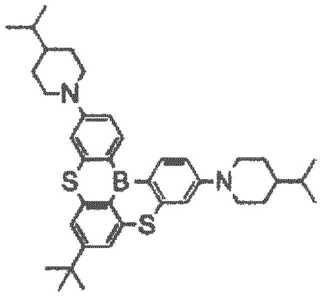
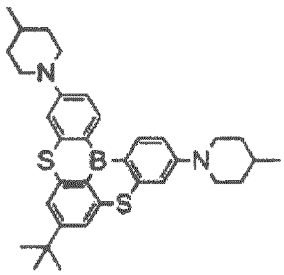
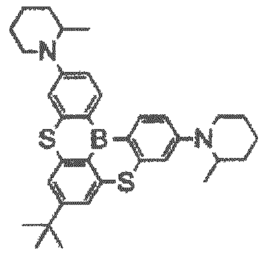

[Formula 175]

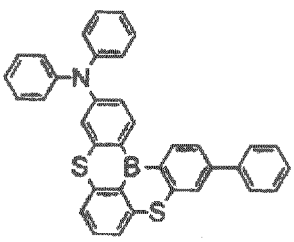

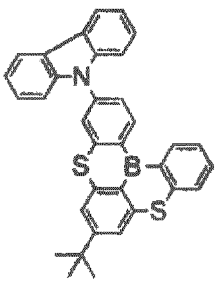
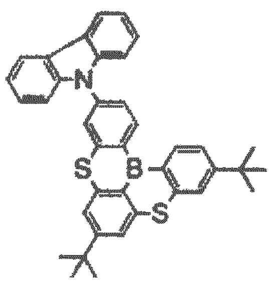
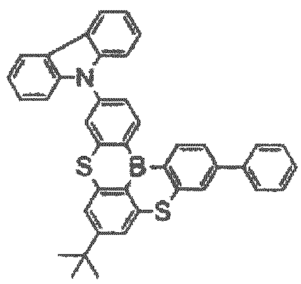

[Formula 176]

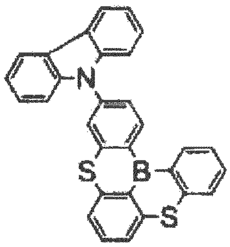
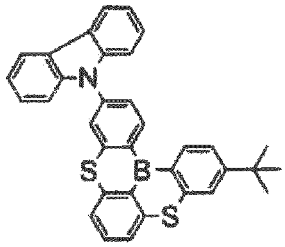
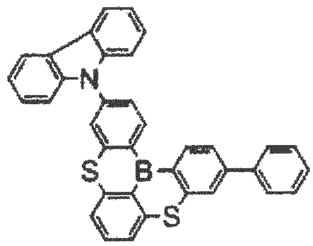

[Formula 177]

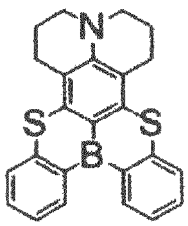

[Formula 178]

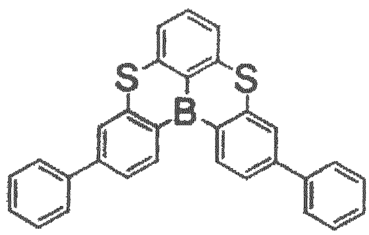

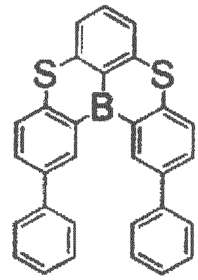

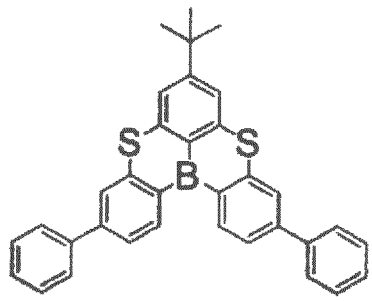

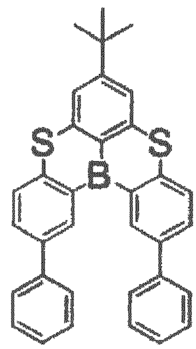

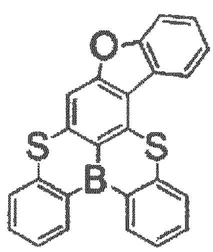

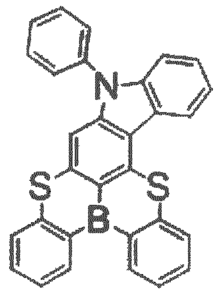

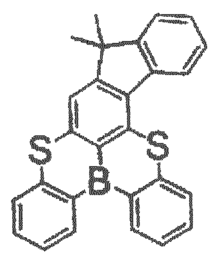

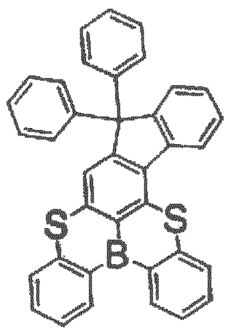

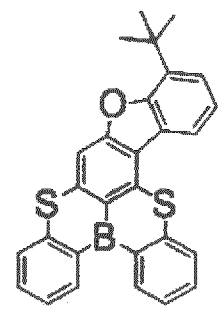

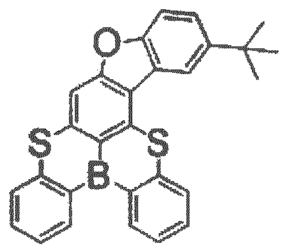

[Formula 179]

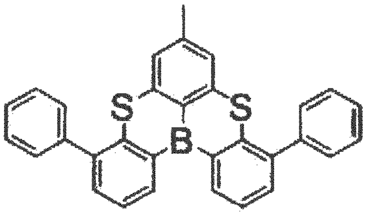

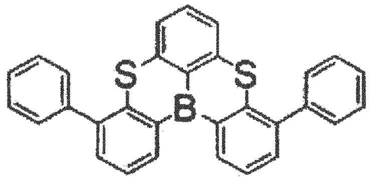

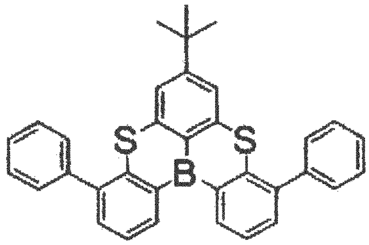

[Formula 180]

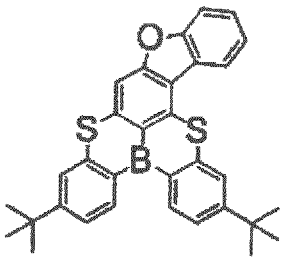

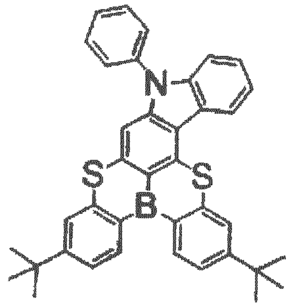

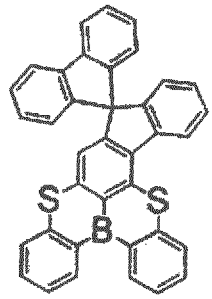

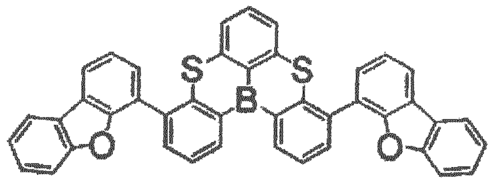

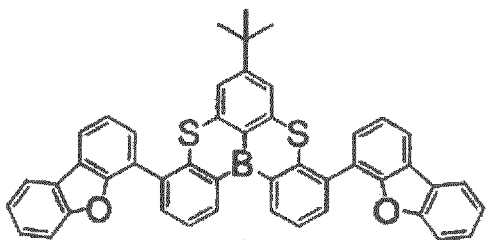

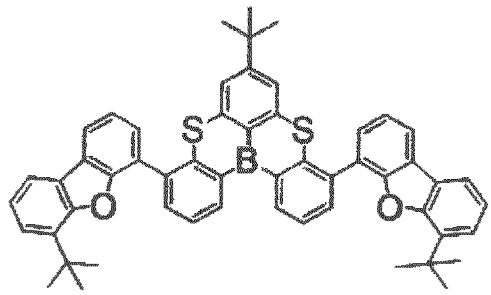

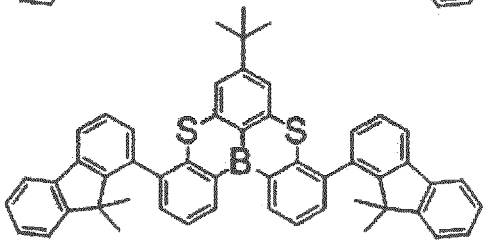

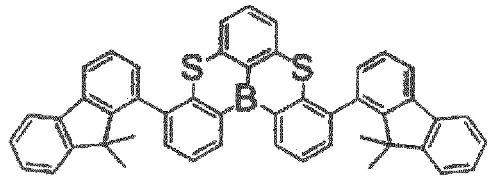

[Formula 181]

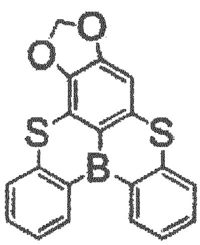

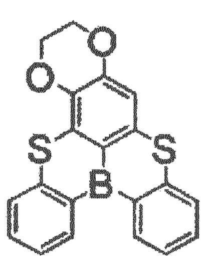

[Formula 182]

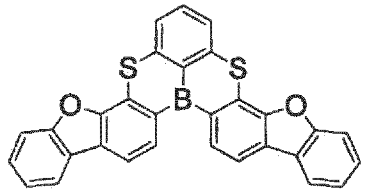

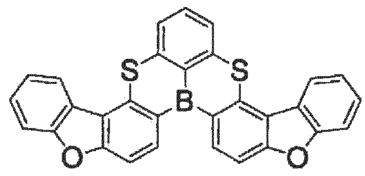

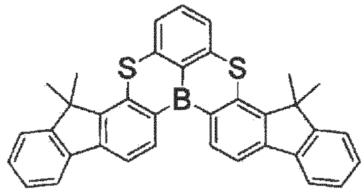

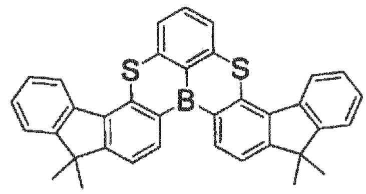

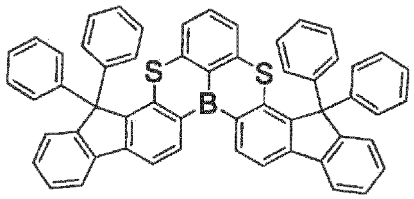

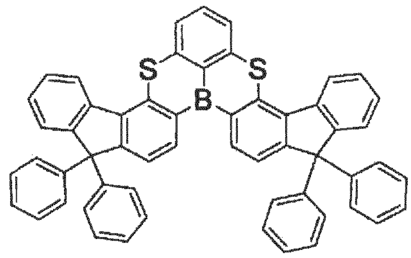

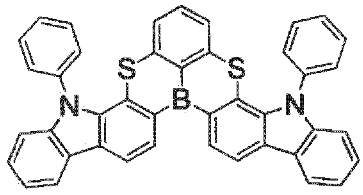

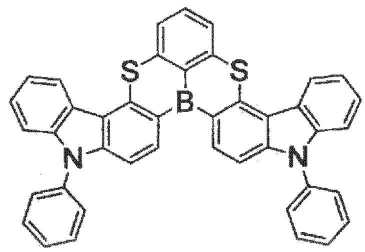

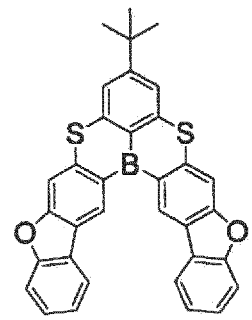

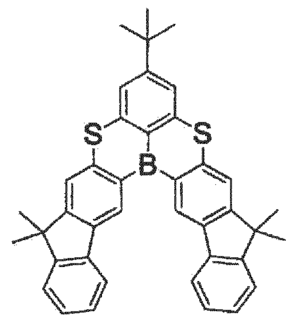

[Formula 183]

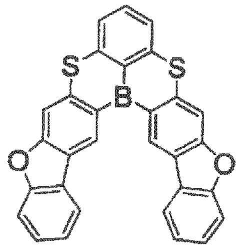

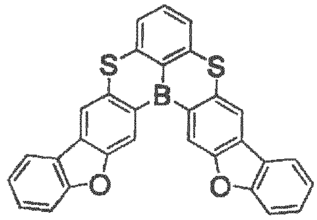

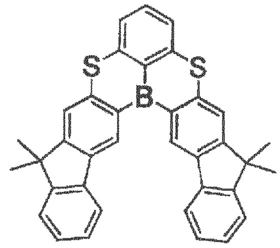

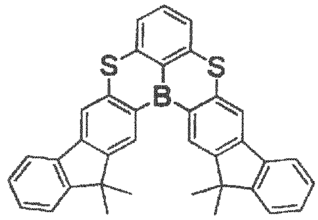

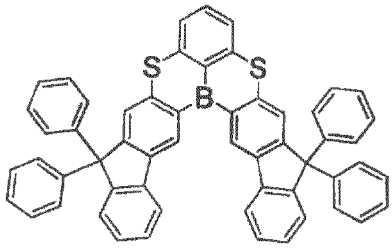

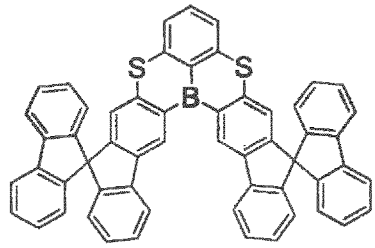

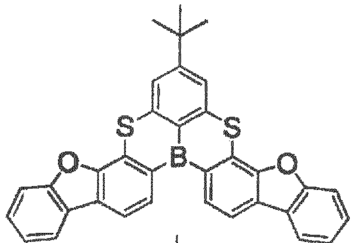

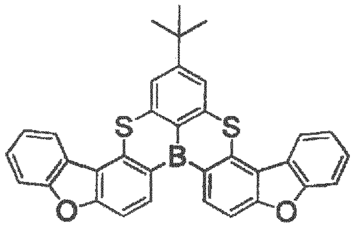

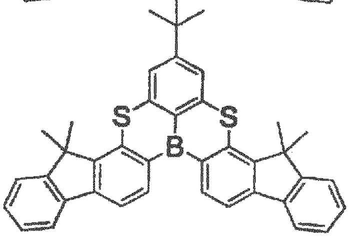

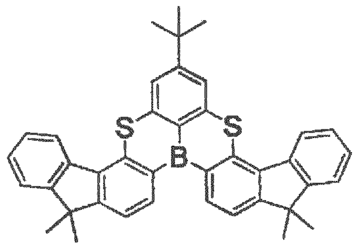

[Formula 184]

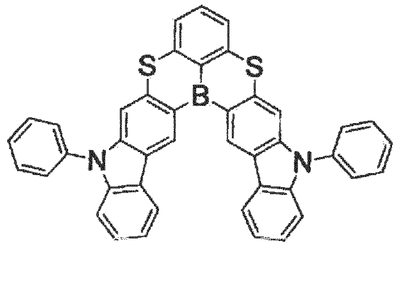

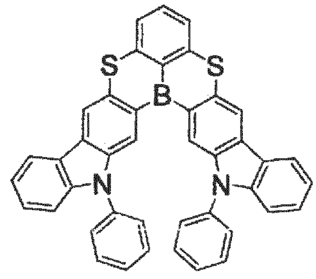

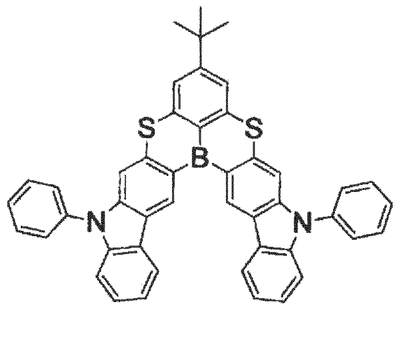

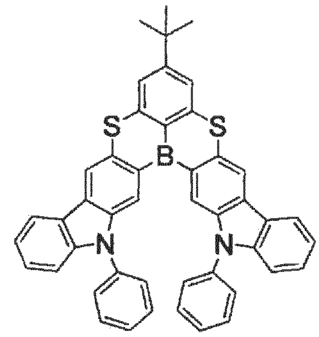

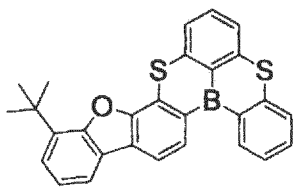

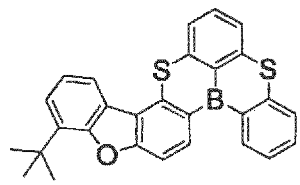

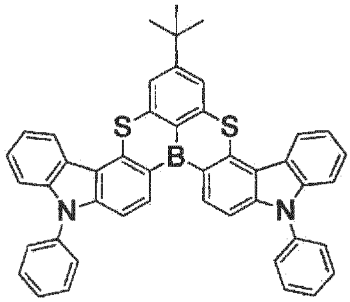

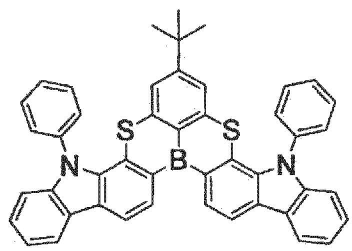

[Formula 185]

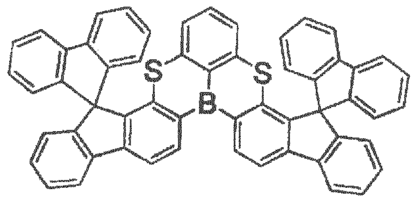

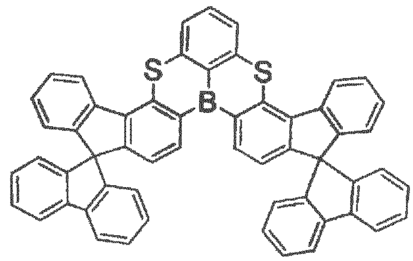

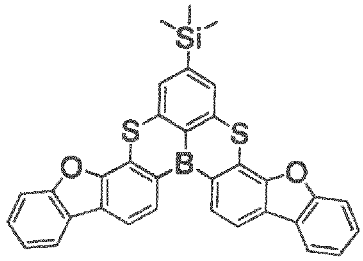

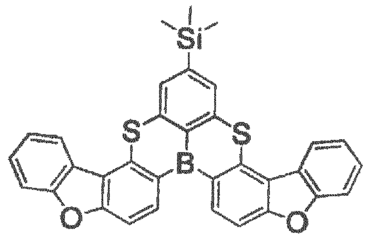

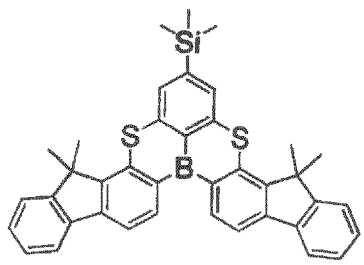

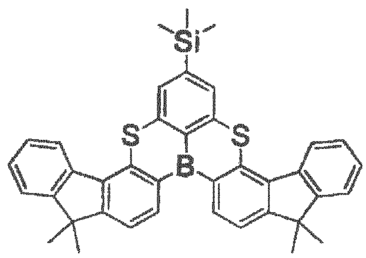

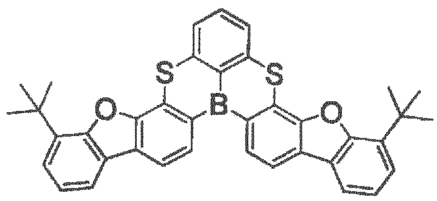

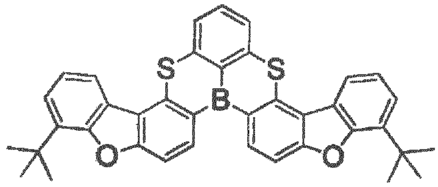

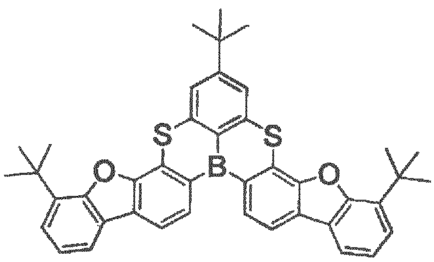

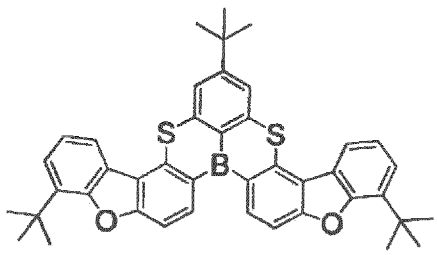

[Formula 186]

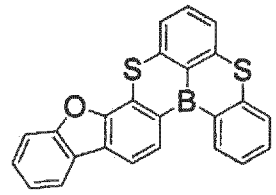
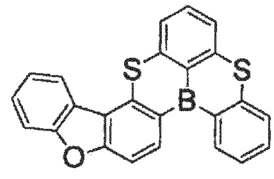
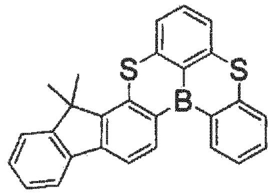
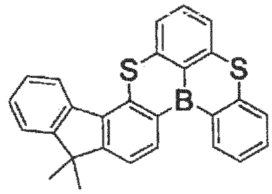
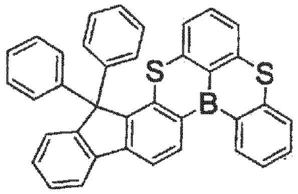
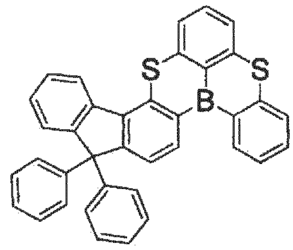
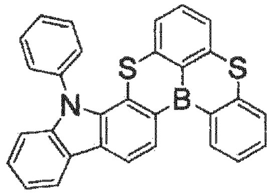
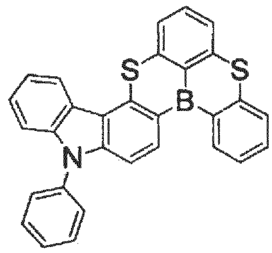
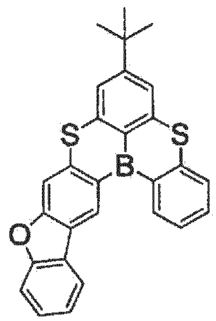
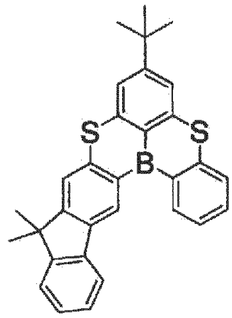

[Formula 187]

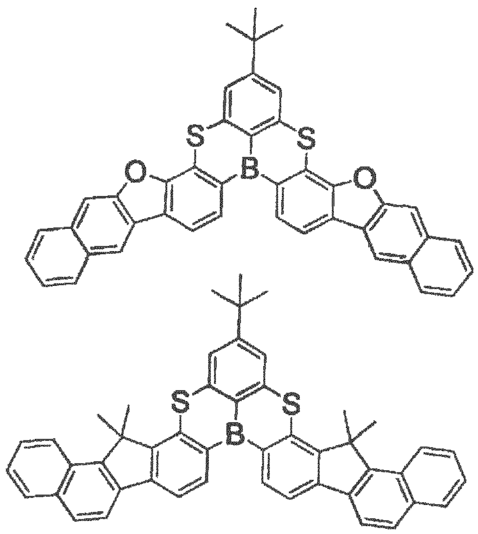

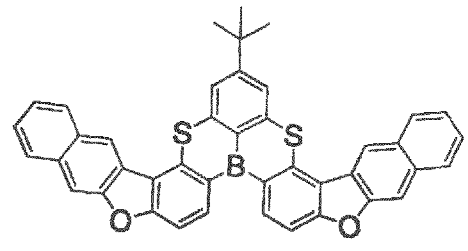

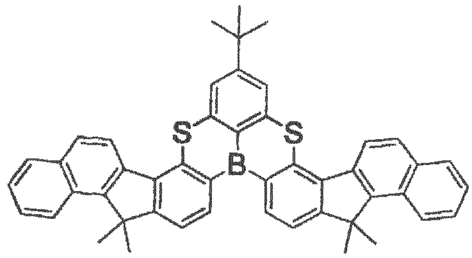

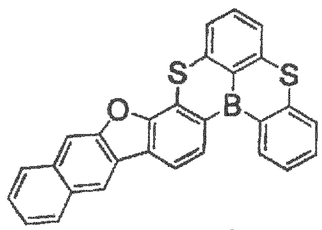

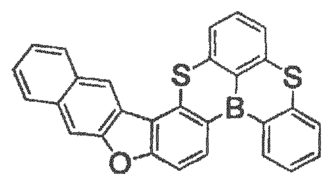

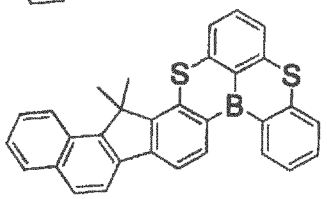

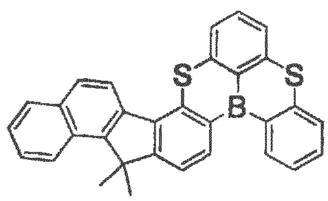

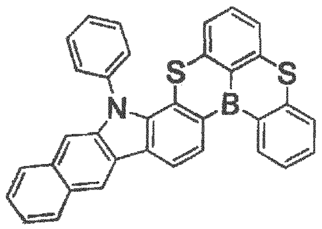

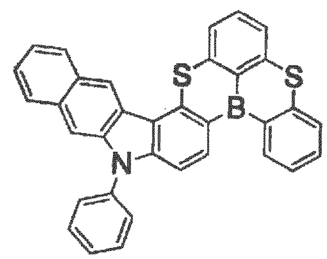

Relationship between First Compound and Second Compound in Emitting Layer

In the organic EL device 1 of the first exemplary embodiment, a singlet energy $S_1(M1)$ of the first compound and a singlet energy $S_1(M2)$ of the second compound preferably satisfy a relationship of a numerical formula (Numerical Formula 1) below.

$$S_1(M1) > S_1(M2) \quad \text{(Numerical Formula 1).}$$

An energy gap $T_{77K}(M1)$ at 77 [K] of the first compound is preferably larger than an energy gap $T_{77K}(M2)$ at 77 [K] of the second compound. Specifically, a relationship represented by a numerical formula below (Numerical Formula 4) is preferably satisfied.

$$T_{77K}(M1) > T_{77K}(M2) \quad \text{(Numerical Formula 4)}$$

When the organic EL device 1 of the first exemplary embodiment emits light, it is preferable that the second compound emits light in the emitting layer 5.

When the organic EL device 1 of the first exemplary embodiment emits light, it is more preferable that the second compound emits light and the other compound (i.e. a compound(s) other than the second compound) does not emit light in the emitting layer 5.

It has been known that an organic EL device using the compound represented by the formula (2) emits light with high efficiency. However, EQE (External Quantum Efficiency) is considerably decreased in a high-current-density area at or around 10 mA/cm$^2$ (i.e. a practical area). Accordingly, in order to solve the above problem, it is found in the invention that the first compound having the specifically selected molecular skeleton is contained in the emitting layer in addition to the compound (second compound) represented by the formula (2), whereby the compound represented by the formula (2) emits light with high efficiency in the high-current-density area and the lifetime of the device is increased. It should be noted that the first compound specifically selected in the invention is chemically stable in oxidation and reduction reactions.

The presence of the first compound having the molecular skeleton selected in the invention and the second compound represented by the formula (2) in the emitting layer allows highly efficient light emission in the high-current-density area. It is believed that a large number of radical species are generated in the high-current-density area due to the large amount of carriers (electrons and holes) injected into the emitting layer. It is speculated that the first compound having the molecular skeleton selected in the invention, which is chemically stable in oxidation and reduction reactions, generates less unstable radical species that cause quenching reaction with excitons contributing to light emission, and, consequently, the highly efficient light emission is maintained in the high-current-density area.

Further, it is believed that the first compound having the molecular skeleton selected in the invention, which is chemically stable in oxidation and reduction reactions, contributes to increase in the lifetime of the device. Preferable examples of the specific molecular structure exhibiting chemical stability in oxidation and reduction reactions include azine skeleton, cyano skeleton, and carbazole skeleton.

It should be noted that, in order to keep the high efficiency in the high-current-density area, it is especially preferable in the invention that an absorption spectrum of the compound represented by the formula (2) well overlaps (i.e. has a large overlapping area) with an emission spectrum of the first compound. Specifically, it is speculated that the first compound is preferably a compound represented by the formula (11E).

Relationship between Triplet Energy and Energy Gap at 77 [K]

Description will be made on a relationship between a triplet energy and an energy gap at 77 [K]. In the first exemplary embodiment, the energy gap at 77 [K] is different from a typically defined triplet energy in some aspects.

The triplet energy is measured as follows. Firstly, a target compound for measurement is dissolved in an appropriate solvent to prepare a solution and the solution is encapsulated in a quartz glass tube to prepare a sample. A phosphorescent spectrum (ordinate axis: phosphorescent luminous intensity, abscissa axis: wavelength) of the sample is measured at a low temperature (77K). A tangent is drawn to the rise of the phosphorescent spectrum on the short-wavelength side. The triplet energy is calculated by a predetermined conversion equation based on a wavelength value at an intersection of the tangent and the abscissa axis.

The delayed fluorescent compound usable in the first exemplary embodiment is preferably a compound having a small $\Delta ST$. When $\Delta ST$ is small, intersystem crossing and inverse intersystem crossing are likely to occur even at a low temperature (77K), so that the singlet state and the triplet state coexist. As a result, the spectrum to be measured in the same manner as the above includes emission from both the singlet state and the triplet state. Although it is difficult to distinguish the emission from the singlet state from the emission from the triplet state, the value of the triplet energy is basically considered dominant.

Accordingly, in the first exemplary embodiment, the triplet energy is measured by the same method as a typical triplet energy T, but a value measured in the following manner is referred to as an energy gap $T_{77K}$ in order to differentiate the measured energy from the typical triplet energy in a strict meaning. The measurement target compound is dissolved in EPA (diethyl ether: isopentane: ethanol = 5: 5: 2 (by volume ratio)) such that a concentration of the compound becomes 10 $\mu$mol/L. The obtained solution is put into a quartz cell to provide a measurement sample. A phosphorescent spectrum (ordinate axis: phosphorescent luminous intensity, abscissa axis: wavelength) of the sample is measured at a low temperature (77K). A tangent is drawn to a rise of the phosphorescent spectrum on the short-wavelength side. An energy amount is calculated as an energy gap $T_{77K}$ at 77[K] by the following conversion equation (F1) based on a wavelength value $\lambda_{edge}$ [nm] at an intersection of the tangent and the abscissa axis.

$$\text{Conversion Equation (F1): } T_{77K}\ [eV] = 1239.85/\lambda_{edge}$$

The tangent to the rise of the phosphorescence spectrum on the short-wavelength side is drawn as follows. While moving on a curve of the phosphorescence spectrum from the short-wavelength side to the maximum spectral value closest to the short-wavelength side among the maximum spectral values, a tangent is checked at each point on the curve toward the long-wavelength of the phosphorescence spectrum. An inclination of the tangent is increased as the curve rises (i.e., a value of the ordinate axis is increased). A tangent drawn at a point of the maximum inclination (i.e., a tangent at an inflection point) is defined as the tangent to the rise of the phosphorescence spectrum on the short-wavelength side.

The maximum with peak intensity being 15% or less of the maximum peak intensity of the spectrum is not included in the above-mentioned maximum closest to the short-wavelength side of the spectrum. The tangent drawn at a point of the maximum spectral value being closest to the short-wavelength side and having the maximum inclination is defined as a tangent to the rise of the phosphorescence spectrum on the short-wavelength side.

For phosphorescence measurement, a spectrophotofluorometer body F-4500 (manufactured by Hitachi High-Technologies Corporation) is usable. The measurement instrument is not limited to the above. A combination of a cooling unit, a low temperature container, an excitation light source and a light-receiving unit may be used for measurement.

Singlet Energy $S_1$

A method of measuring a singlet energy $S_1$ using a solution (hereinafter, occasionally referred to as a solution method) is exemplified by a method below.

10 μmol/L of a toluene solution of the measurement target compound is prepared and put in a quartz cell to prepare a sample. An absorption spectrum (ordinate axis: luminous intensity, abscissa axis: wavelength) of the sample is measured at a normal temperature (300K). A tangent is drawn to the fall of the absorption spectrum on the long-wavelength side, and a wavelength value Aedge [nm] at an intersection of the tangent and the abscissa axis is substituted in the following conversion equation (F2) to calculate a singlet energy.

$$\text{Conversion Equation (F2): } S_1\ [eV] = 1239.85/\lambda edge$$

An absorption spectrum measurement device is not limited to but exemplified by a spectrophotometer (device name: U3310 manufactured by Hitachi, Ltd.).

The tangent to the fall of the absorption spectrum on the long-wavelength side is drawn as follows. While moving on a curve of the absorption spectrum from the maximum spectral value closest to the long-wavelength side in a long-wavelength direction, a tangent at each point on the curve was checked. An inclination of the tangent is decreased and increased in a repeated manner as the curve falls (i.e., a value of the ordinate axis is decreased). A tangent drawn at a point of the minimum inclination closest to the long-wavelength side (except when absorbance is 0.1 or less) is defined as the tangent to the fall of the absorption spectrum on the long-wavelength side.

The maximum absorbance of 0.2 or less is not included in the above-mentioned maximum absorbance on the long-wavelength side.

Content Ratio of Compounds in Emitting Layer

A content ratio between the first compound and the second compound in the emitting layer 5 is preferably in an exemplary range below.

The content ratio of the first compound is preferably in a range from 90 mass% to 99.9 mass%, more preferably in a range from 95 mass% to 99.9 mass%, further preferably in a range from 99 mass% to 99.9 mass%.

The content ratio of the second compound is preferably in a range from 0.01 mass% to 10 mass%, more preferably in a range from 0.01 mass% to 5 mass%, further preferably in a range from 0.01 mass% to 1 mass%.

It should be noted that the emitting layer 5 of the exemplary embodiment may further contain material(s) other than the first and second compounds.

Film Thickness of Emitting Layer

A film thickness of the emitting layer 5 is preferably in a range from 5 nm to 50 nm, more preferably in a range from 7 nm to 50 nm, and further preferably in a range from 10 nm to 50 nm. At 5 nm or more of the film thickness, the emitting layer 5 is easily formable and chromaticity of the emitting layer 5 is easily adjustable. When the film thickness

of the emitting layer 5 is 50 nm or less, an increase in the drive voltage is suppressible.

TADF Mechanism

Fig. 4 shows an exemplary relationship between energy levels of the first and second compounds in the emitting layer. In Fig. 4, S0 represents a ground state. S1(M1) represents the lowest singlet state of the first compound. T1(M1) represents the lowest triplet state of the first compound. S1(M2) represents the lowest singlet state of the second compound. T1(M2) represents the lowest triplet state of the second compound.
A dashed arrow directed from S1(M1) to S1(M2) in Fig. 4 represents Forster energy transfer from the lowest singlet state of the first compound to the second compound.
As shown in Fig. 4, when a compound having a small ΔST(M1) is used as the first compound, inverse intersystem crossing from the lowest triplet state T1(M1) to the lowest singlet state S1(M1) can be caused by a heat energy. Accordingly, Förster energy transfer from the lowest singlet state S1(M1) of the first compound to the second compound is caused to generate the lowest singlet state S1(M2). As a result, fluorescence from the lowest singlet state S1(M2) of the second compound is observable. It is inferred that the internal quantum efficiency can be theoretically raised up to 100% also by using delayed fluorescence by the TADF mechanism.

Substrate

A substrate 2 is used as a support for the organic EL device 1. For instance, glass, quartz, plastics and the like are usable for the substrate 2. A flexible substrate is also usable. The flexible substrate is a bendable substrate, which is exemplified by a plastic substrate. Examples of the material for the plastic substrate include polycarbonate, polyarylate, polyethersulfone, polypropylene, polyester, polyvinyl fluoride, polyvinyl chloride, polyimide, and polyethylene naphthalate. Moreover, an inorganic vapor deposition film is also usable.

Anode

Preferable examples of a material for the anode 3 formed on the substrate 2 include metal, an alloy, an electroconductive compound, and a mixture thereof, which have a large work function (specifically, 4.0 eV or more). Specific examples of the material for the anode include ITO (Indium Tin Oxide), indium tin oxide containing silicon or silicon oxide, indium zinc oxide, indium oxide containing tungsten oxide and zinc oxide, and graphene. In addition, gold (Au), platinum (Pt), nickel (Ni), tungsten (W), chrome (Cr), molybdenum (Mo), iron (Fe), cobalt (Co), copper (Cu), palladium (Pd), titanium (Ti), or nitrides of the metal materials (e.g., titanium nitride) are usable.
The above materials are typically deposited as a film by sputtering. For instance, indium zinc oxide can be deposited as a film by sputtering using a target that is obtained by adding zinc oxide in a range from 1 mass% to 10 mass% to indium oxide. Moreover, for instance, indium oxide containing tungsten oxide and zinc oxide can be deposited as a film by sputtering using a target that is obtained by adding tungsten oxide in a range from 0.5 mass% to 5 mass% and zinc oxide in a range from 0.1 mass% to 1 mass% to indium oxide. In addition, vapor deposition, coating, ink jet printing, spin coating and the like may be used for forming a film.
Among the organic layers formed on the anode 3, the hole injecting layer 6 formed in contact with the anode 3 is formed using a composite material that facilitates injection of holes irrespective of the work function of the anode 3. Accordingly, a material usable as an electrode material (e.g., metal, alloy, an electrically conductive compound, a mixture thereof, and elements belonging to Groups 1 and 2 of the periodic table of the elements) is usable as the material for the anode 3.
The elements belonging to Groups 1 and 2 of the periodic table of the elements, which are materials having a small work function, a rare earth metal and alloy thereof are also usable as the material for the anode 3. The elements belonging to Group 1 of the periodic table of the elements are alkali metal. The elements belonging to Group 2 of the periodic table of the elements are alkaline earth metal. Examples of alkali metal are lithium (Li) and cesium (Cs). Examples of alkaline earth metal are magnesium (Mg), calcium (Ca), and strontium (Sr). Examples of the rare earth metal are europium (Eu) and ytterbium (Yb). Examples of the alloys including these metals are MgAg and AlLi.
When the anode 3 is formed of the alkali metal, alkaline earth metal and alloy thereof, vapor deposition or sputtering is usable. Further, when the anode is formed of silver paste and the like, coating, ink jet printing or the like is usable.

Hole Injecting Layer

The hole injecting layer 6 is a layer containing a highly hole-injectable substance. Examples of the highly hole-injectable substance include molybdenum oxide, titanium oxide, vanadium oxide, rhenium oxide, ruthenium oxide, chromium oxide, zirconium oxide, hafnium oxide, tantalum oxide, silver oxide, tungsten oxide, and manganese oxide.

In addition, the examples of the highly hole-injectable substance further include: an aromatic amine compound, which is a low-molecule compound, such as 4,4',4"-tris(N,N-diphenylamino)triphenylamine (abbreviation: TDATA), 4,4',4"-tris[N-(3-methylphenyl)-N-phenylamino]triphenylamine (abbreviation: MTDATA), 4,4'-bis[N-(4-diphenylaminophenyl)-N-phenylamino]biphenyl(abbreviation: DPAB), 4,4'-bis(N-{4-[N'-(3-methylphenyl)-N'-phenylamino]phenyl}-N-phenylamino)biphenyl (abbreviation: DNTPD), 1,3,5-tris[N-(4-diphenylaminophenyl)-N-phenylamino]benzene (abbreviation: DPA3B), 3-[N-(9-phenylcarbazole-3-yl)-N-phenylamino]-9-phenylcarbazole (abbreviation: PCzPCA1), 3,6-bis[N-(9-phenylcarbazole-3-yl)-N-phenylamino]-9-phenylcarbazole (abbreviation: PCzPCA2), and 3-[N-(1-naphthyl)-N-(9-phenylcarbazole-3-yl)amino]-9-phenylcarbazole (abbreviation: PCzPCN1); and dipyrazino[2,3-f:20,30-h]quinoxaline-2,3,6,7,10,11-hexacarbonitrile (HAT-CN).

Moreover, a high-molecule compound is also usable as the highly hole-injectable substance. Examples of the high-molecule compound are an oligomer, dendrimer and polymer. Specific examples of the high-molecule compound include poly(N-vinylcarbazole) (abbreviation: PVK), poly(4-vinyltriphenylamine) (abbreviation: PVTPA), poly[N-(4-{N'-[4-(4-diphenylamino)phenyl]phenyl-N'-phenylamino}phenyl)methacrylamido] (abbreviation: PTPDMA), and poly[N,N'-bis(4-butylphenyl)-N,N'-bis(phenyl)benzidine] (abbreviation: Poly-TPD). Furthermore, the examples of the high-molecule compound include a high-molecule compound added with an acid such as poly(3,4-ethylene dioxythiophene)/poly(styrene sulfonic acid) (PEDOT/PSS), and polyaniline/poly(styrene sulfonic acid) (PAni/PSS).

Hole Transporting Layer

The hole transporting layer 7 is a layer containing a highly hole-transportable substance. An aromatic amine compound, carbazole derivative, anthracene derivative and the like are usable for the hole transporting layer 7. Specific examples of a material for the hole transporting layer include 4,4'-bis[N-(1-naphthyl)-N-phenylamino]biphenyl (abbreviation: NPB), N,N'-bis(3-methylphenyl)-N,N'-diphenyl-[1,1'-biphenyl]-4,4'-diamine (abbreviation: TPD), 4-phenyl-4'-(9-phenylfluorene-9-yl)triphenylamine (abbreviation: BAFLP), 4,4'-bis[N-(9,9-dimethylfluorene-2-yl)-N-phenylamino]biphenyl (abbreviation: DFLDPBi), 4,4',4"-tris(N,N-diphenylamino)triphenylamine (abbreviation: TDATA), 4,4',4"-tris[N-(3-methylphenyl)-N-phenylamino]triphenylamine (abbreviation: MTDATA), and 4,4'-bis[N-(spiro-9,9'-bifluorene-2-yl)-N-phenylamino]biphenyl (abbreviation: BSPB). The above-described substances mostly have a hole mobility of $10^{-6}cm^2/(V\cdot s)$ or more.

A carbazole derivative (e.g., CBP, 9-[4-(N-carbazolyl)]phenyl-10-phenylanthracene (CzPA), and 9-phenyl-3-[4-(10-phenyl-9-anthryl)phenyl]-9H-carbazole (PCzPA)), an anthracene derivative (e.g., t-BuDNA, DNA, and DPAnth) and the like may be used for the hole transporting layer 7. A high polymer compound such as poly(N-vinylcarbazole) (abbreviation: PVK) and poly(4-vinyltriphenylamine) (abbreviation: PVTPA) is also usable.

However, any substance having a hole transporting performance higher than an electron transporting performance may be used in addition to the above substances. A highly hole-transportable substance may be provided in the form of a single layer or a laminated layer of two or more layers of the above substance(s).

When the hole transporting layer includes two or more layers, one of the layers with a larger energy gap is preferably provided closer to the emitting layer 5.

Electron Transporting Layer

The electron transporting layer 8 is a layer containing a highly electron-transportable substance. As the electron transporting layer 8, (1) a metal complex such as an aluminum complex, beryllium complex and zinc complex, (2) a heteroaromatic compound such as an imidazole derivative, benzimidazole derivative, azine derivative, carbazole derivative, and phenanthroline derivative, and (3) a high-molecule compound are usable. Specifically, as a low-molecule organic compound, a metal complex such as Alq, tris(4-methyl-8-quinolinato)aluminum (abbreviation: $Almq_3$), bis(10-hydroxybenzo[h]quinolinato)beryllium (abbreviation: $BeBq_2$), BAlq, Znq, ZnPBO and ZnBTZ are usable. In addition to the metal complex, a heteroaromatic compound such as 2-(4-biphenyl)-5-(4-tert-butylphenyl)-1,3,4-oxadiazole (abbreviation: PBD), 1,3-bis[5-(ptert-butylphenyl)-1,3,4-oxadiazole-2-yl]benzene (abbreviation: OXD-7), 3-(4-tert-butylphenyl)-4-phenyl-5-(4-biphenyl)-1,2,4-triazole (abbreviation: TAZ), 3-(4-tert-butylphenyl)-4-(4-ethylphenyl)-5-(4-biphenyl)-1,2,4-triazole (abbreviation: p-EtTAZ), bathophenanthroline (abbreviation: BPhen), bathocuproine (abbreviation: BCP), and 4,4'-bis(5-methylbenzoxazole-2-yl)stilbene (abbreviation: BzOs) are usable. In the first exemplary embodiment, a benzimidazole compound is suitably usable. The above-described substances mostly have an electron mobility of $10^{-6}$ $cm^2/(V\cdot s)$ or more. However, any substance having an electron transporting performance higher than a hole transporting performance may be used for the electron transporting layer 8 in addition to the above substances. The electron transporting layer 8 may be provided in the form of a single layer or a laminated layer of two or more layers of the above substance(s).

Moreover, a high-molecule compound is also usable for the electron transporting layer 8. For instance, poly[(9,9-dihexylfluorene-2,7-diyl)-co-(pyridine-3,5-diyl)] (abbreviation: PF-Py), poly[(9,9-dioctylfluorene-2,7-diyl)-co-(2,2'-bipyridine-6,6'-diyl)] (abbreviation: PF-BPy) and the like are usable.

Electron injecting Layer

The electron injecting layer 9 is a layer containing a highly electron-injectable substance. For the electron injecting layer 9, an alkali metal, alkaline earth metal or a compound thereof are usable, examples of which include lithium (Li), cesium (Cs), calcium (Ca), lithium fluoride (LiF), cesium fluoride (CsF), calcium fluoride (CaF2), and lithium oxide (LiOx). In addition, a substance obtained by blending an alkali metal, alkaline earth metal or a compound thereof in the electron transportable substance, specifically, for instance, a substance obtained by blending magnesium (Mg) in Alq may be used. With this substance, electrons can be more efficiently injected from the cathode 4.

Alternatively, a composite material provided by mixing an organic compound with an electron donor may be used for the electron injecting layer 9. The composite material exhibits excellent electron injecting performance and electron transporting performance since the electron donor generates electrons in the organic compound. In this arrangement, the organic compound is preferably a material exhibiting excellent transporting performance of the generated electrons. Specifically, for instance, the above-described substance for the electron transporting layer 8 (e.g., the metal complex and heteroaromatic compound) is usable. The electron donor may be any substance exhibiting electron donating performance to the organic compound. Specifically, an alkali metal, an alkaline earth metal and a rare earth metal are preferable, examples of which include lithium, cesium, magnesium, calcium, erbium and ytterbium. Moreover, an alkali metal oxide or alkaline earth metal oxide is preferably used as the electron donor, examples of which include lithium oxide, calcium oxide, and barium oxide. Further, Lewis base such as magnesium oxide is also usable. Furthermore, an organic compound such as tetrathiafulvalene (abbreviation: TTF) is also usable.

Cathode

Metal, alloy, an electrically conductive compound, a mixture thereof and the like, which have a small work function, specifically, of 3.8 eV or less, are preferably usable as a material for the cathode 4. Specific examples of the material for the cathode are the elements belonging to Groups 1 and 2 of the periodic table of the elements, a rare earth metal and alloys thereof. The elements belonging to Group 1 of the periodic table of the elements are alkali metal. The elements belonging to Group 2 of the periodic table of the elements are alkaline earth metal. Examples of alkali metal are lithium (Li) and cesium (Cs). Examples of alkaline earth metal are magnesium (Mg), calcium (Ca), and strontium (Sr). Examples of the rare earth metal are europium (Eu) and ytterbium (Yb). Examples of the alloys including these metals are MgAg and AlLi.

When the cathode 4 is formed of the alkali metal, alkaline earth metal and alloy thereof, vapor deposition or sputtering is usable. Further, when the anode is formed of silver paste and the like, coating, ink jet printing or the like is usable.

By providing the electron injecting layer 9, various conductive materials such as Al, Ag, ITO, graphene and indium tin oxide containing silicon or silicon oxide are usable for forming the cathode 4 irrespective of the magnitude of the work function. The conductive materials can be deposited as a film by sputtering, ink jet printing, spin coating and the like.

Layer Formation Method(s)

A method for forming each layer of the organic EL device 1 in the exemplary embodiment is subject to no limitation except for the above particular description, where known methods such as dry film-forming and wet film-forming are applicable. Examples of the dry film-forming include vacuum deposition, sputtering, plasma and ion plating. Examples of the wet film-forming include spin coating, dipping, flow coating and ink-jet.

Film Thickness

There is no restriction except for the above particular description for a film thickness of each of the organic layers of the organic EL device 1 in the first exemplary embodiment. The thickness is usually preferably in a range from several nanometers to 1 μm in order to cause less defects (e.g., pin holes) and prevent deterioration in the efficiency due to the necessity in applying high voltage.

Herein, numerical ranges defined with the use of "to" means a range whose lower limit is a value recited before "to" and whose upper limit is a value recited after "to."

Herein, the number of carbon atoms forming a ring (also referred to as ring carbon atoms) means the number of carbon atoms included in atoms forming the ring itself of a compound in which the atoms are bonded to form the ring

(e.g., a monocyclic compound, a fused ring compound, a cross-linked compound, a carbocyclic compound, and a heterocyclic compound). When the ring is substituted by a substituent, carbon atom(s) included in the substituent is not counted as the ring carbon atoms. The same applies to the "ring carbon atoms" described below, unless particularly noted. For instance, a benzene ring has 6 ring carbon atoms, a naphthalene ring has 10 ring carbon atoms, a pyridinyl group has 5 ring carbon atoms, and a furanyl group has 4 ring carbon atoms. When a benzene ring or a naphthalene ring is substituted, for instance, by an alkyl group, the carbon atoms of the alkyl group are not counted as the ring carbon atoms. For instance, when a fluorene ring (inclusive of a spirofluorene ring) is bonded as a substituent to a fluorene ring, the carbon atoms of the fluorene ring as a substituent are not counted as the ring carbon atoms.

Herein, the number of atoms forming a ring (also referred to as ring atoms) means the number of atoms forming the ring itself of a compound in which the atoms are bonded to form the ring (e.g., a monocyclic compound, a fused ring compound, a cross-linked compound, a carbocyclic compound, and a heterocyclic compound). Atom(s) not forming the ring and atom(s) included in the substituent substituting the ring are not counted as the ring atoms. The same applies to the "ring atoms" described below, unless particularly noted. For instance, a pyridine ring has 6 ring atoms, a quinazoline ring has 10 ring atoms, and a furan ring has 5 ring atoms. Hydrogen atoms bonded to carbon atoms of each of the pyridine ring or the quinazoline ring and atoms forming a substituent are not counted as the ring atoms. For instance, when a fluorene ring (inclusive of a spirofluorene ring) is bonded as a substituent to a fluorene ring, the atoms of the fluorene ring as a substituent are not counted as the ring atoms.

Next, each of substituents described in the above formulae will be described.

Examples of the aryl group having 6 to 30 ring carbon atoms (occasionally referred to as an aromatic hydrocarbon group) herein are a phenyl group, biphenyl group, terphenyl group, naphthyl group, anthryl group, phenanthryl group, fluorenyl group, pyrenyl group, chrysenyl group, fluoranthenyl group, benz[a]anthryl group, benzo[c]phenanthryl group, triphenylenyl group, benzo[k]fluoranthenyl group, benzo[g]chrysenyl group, benzo[b]triphenylenyl group, picenyl group, and perylenyl group.

Herein, the aryl group preferably has 6 to 20 ring carbon atoms, more preferably 6 to 14 ring carbon atoms, further preferably 6 to 12 ring carbon atoms, unless otherwise defined. Among the aryl group, a phenyl group, biphenyl group, naphthyl group, phenanthryl group, terphenyl group and fluorenyl group are particularly preferable. A carbon atom at a position 9 of each of 1-fluorenyl group, 2-fluorenyl group, 3-fluorenyl group and 4-fluorenyl group is preferably substituted by at least one group selected from the group consisting of a substituted or unsubstituted alkyl group having 1 to 30 carbon atoms and a substituted or unsubstituted aryl group having 6 to 18 ring carbon atoms later described in the exemplary embodiment.

The heteroaryl group (occasionally, referred to as heterocyclic group, heteroaromatic ring group or aromatic heterocyclic group) having 5 to 30 ring atoms preferably contains at least one atom selected from the group consisting of nitrogen, sulfur, oxygen, silicon, selenium atom and germanium atom, and more preferably contains at least one atom selected from the group consisting of nitrogen, sulfur and oxygen.

Examples of the heterocyclic group having 5 to 30 ring atoms in the first exemplary embodiment are a pyridyl group, pyrimidinyl group, pyrazinyl group, pyridazynyl group, triazinyl group, quinolyl group, isoquinolinyl group, naphthyridinyl group, phthalazinyl group, quinoxalinyl group, quinazolinyl group, phenanthridinyl group, acridinyl group, phenanthrolinyl group, pyrrolyl group, imidazolyl group, pyrazolyl group, triazolyl group, tetrazolyl group, indolyl group, benzimidazolyl group, indazolyl group, imidazopyridinyl group, benzotriazolyl group, carbazolyl group, furyl group, thienyl group, oxazolyl group, thiazolyl group, isoxazolyl group, isothiazolyl group, oxadiazolyl group, thiadiazolyl group, benzofuranyl group, benzothienyl group, benzoxazolyl group, benzothiazolyl group, benzisoxazolyl group, benzisothiazolyl group, benzoxadiazolyl group, benzothiadiazolyl group, dibenzofuranyl group, dibenzothienyl group, piperidinyl group, pyrrolidinyl group, piperazinyl group, morpholyl group, phenazinyl group, phenothiazinyl group, and phenoxazinyl group.

Herein, the heterocyclic group preferably has 5 to 20 ring atoms, more preferably 5 to 14 ring atoms. Among the above heterocyclic group, a 1-dibenzofuranyl group, 2-dibenzofuranyl group, 3-dibenzofuranyl group, 4-dibenzofuranyl group, 1-dibenzothienyl group, 2-dibenzothienyl group, 3-dibenzothienyl group, 4-dibenzothienyl group, 1-carbazolyl group, 2-carbazolyl group, 3-carbazolyl group, 4-carbazolyl group, and 9-carbazolyl group are further preferable. A nitrogen atom at a position 9 of each of 1-carbazolyl group, 2-carbazolyl group, 3-carbazolyl group and 4-carbazolyl group is preferably substituted by at least one group selected from the group consisting of a substituted or unsubstituted aryl group having 6 to 30 ring carbon atoms and a substituted or unsubstituted heterocyclic group having 5 to 30 ring atoms described herein.

Herein, the heterocyclic group may be a group derived from any one of partial structures represented by formulae (XY-1) to (XY-18).

[Formula 188]

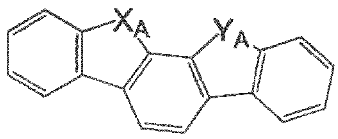

(XY-1)

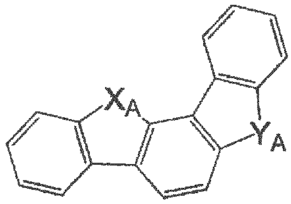

(XY-2)

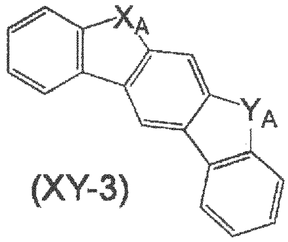

(XY-3)

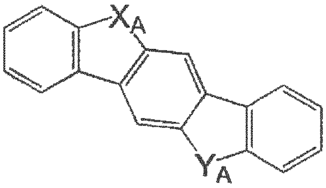

(XY-4)

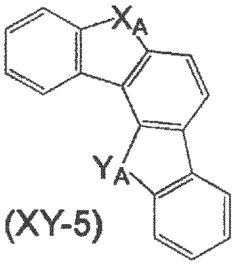

(XY-5)

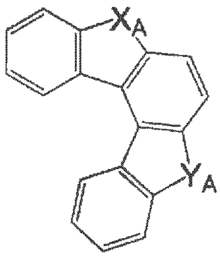

(XY-6)

[0324]

[Formula 189]

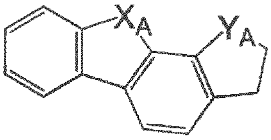

(XY-7)

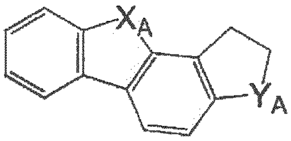

(XY-8)

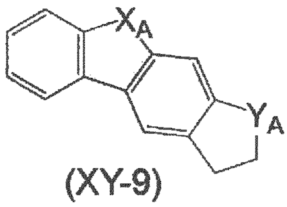

(XY-9)

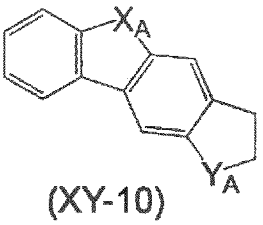

(XY-10)

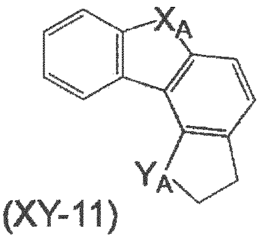

(XY-11)

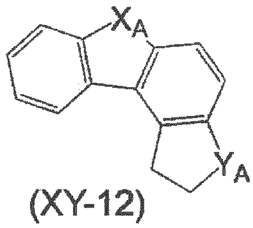

(XY-12)

[Formula 190]

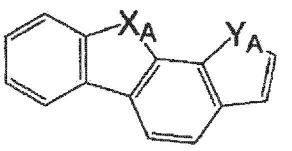

(XY-13)

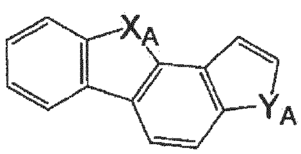

(XY-14)

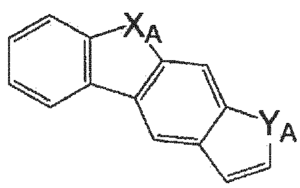

(XY-15)

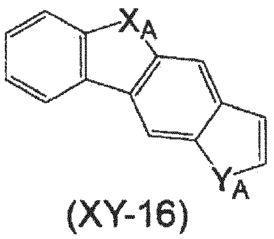

(XY-16)

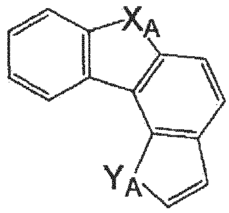

(XY-17)

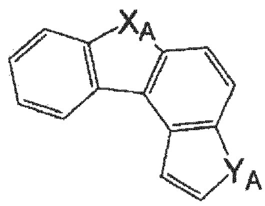

(XY-18)

In the formulae (XY-1) to (XY-18), $X_A$ and $Y_A$ are each independently a hetero atom, and are preferably an oxygen atom, sulfur atom, selenium atom, silicon atom or germanium atom. The partial structures represented by the formulae (XY-1) to (XY-18) may each have a bond(s) in any position to become a heterocyclic group, in which the heterocyclic group may be substituted.

Herein, examples of the substituted or unsubstituted carbazolyl group may include a group in which a carbazole ring is further fused with a ring(s) as shown in the following formulae. Such a group may be substituted. The group may be bonded in any position as desired.

[Formula 191]

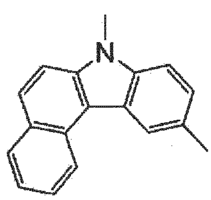

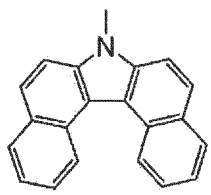

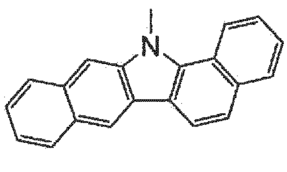

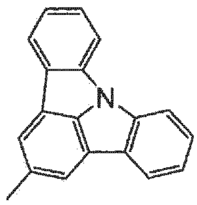

The alkyl group having 1 to 30 carbon atoms herein may be linear, branched or cyclic. Alternatively, the alkyl group having 1 to 30 carbon atoms herein may be an alkyl halide group.

Examples of the linear or branched alkyl group include: a methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, amyl group, isoamyl group, 1-methylpentyl group, 2-methylpentyl group, 1-pentylhexyl group, 1-butylpentyl group, 1-heptyloctyl group, and 3-methylpentyl group.

Herein, the linear or branched alkyl group preferably has 1 to 10 carbon atoms, more preferably 1 to 6 carbon atoms. Among the linear or branched alkyl group, a methyl group, ethyl group, propyl group, isopropyl group, n-butyl group, s-butyl group, isobutyl group, t-butyl group, n-pentyl group, n-hexyl group, amyl group, isoamyl group and neopentyl group are further preferable.

Examples of the cyclic alkyl group herein include a cycloalkyl group having 3 to 30 ring carbon atoms.

Examples of the cycloalkyl group having 3 to 30 herein are a cyclopropyl group, cyclobutyl group, cyclopentyl group, cyclohexyl group, 4-metylcyclohexyl group, adamantyl group and norbornyl group. The cycloalkyl group preferably has 3 to 10 ring carbon atoms, more preferably 5 to 8 ring carbon atoms. Among the cycloalkyl group, a cyclopentyl group or a cyclohexyl group is further preferable.

Herein, examples of the alkyl halide group provided by substituting an alkyl group with a halogen atom include an alkyl halide group provided by substituting the above alkyl group having 1 to 30 carbon atoms with one or more halogen atoms, preferably a fluorine atom(s).

Herein, examples of the alkyl halide group having 1 to 30 carbon atoms include a fluoromethyl group, difluoromethyl group, trifluoromethyl group, fluoroethyl group, trifluoromethylmethyl group, trifluoroethyl group and pentafluoroethyl group.

Herein, examples of the substituted silyl group include an alkylsilyl group having 3 to 30 carbon atoms and an arylsilyl group having 6 to 30 ring carbon atoms.

The alkylsilyl group having 3 to 30 carbon atoms herein is exemplified by a trialkylsilyl group having the above examples of the alkyl group having 1 to 30 carbon atoms. Specific examples of the alkylsilyl group are a trimethylsilyl group, triethylsilyl group, tri-n-butylsilyl group, tri-n-octylsilyl group, triisobutylsilyl group, dimethylethylsilyl group, dimethylisopropylsilyl group, dimethyl-n-propylsilyl group, dimethyl-n-butylsilyl group, dimethyl-t-butylsilyl group, diethylisopropylsilyl group, vinyl dimethylsilyl group, propyldimethylsilyl group, and triisopropylsilyl group. Three alkyl groups in the trialkylsilyl group may be mutually the same or different.

Examples of the arylsilyl group having 6 to 30 ring carbon atoms herein include a dialkylarylsilyl group, alkyldiarylsilyl group and triarylsilyl group.

The dialkylarylsilyl group is exemplified by a dialkylarylsilyl group including two alkyl groups selected from the group of the alkyl groups listed as the examples of the alkyl group having 1 to 30 carbon atoms and one aryl group selected from the group of the aryl groups listed as the examples of the aryl group having 6 to 30 ring carbon atoms. The dialkylarylsilyl group preferably has 8 to 30 carbon atoms.

The alkyldiarylsilyl group is exemplified by an alkyldiarylsilyl group including one alkyl group selected from the group of the alkyl groups listed as the examples of the alkyl group having 1 to 30 carbon atoms and two aryl groups selected from the group of the aryl groups listed as the examples of the aryl group having 6 to 30 ring carbon atoms. The alkyldiarylsilyl group preferably has 13 to 30 carbon atoms.

The triarylsilyl group is exemplified by a triarylsilyl group including three aryl groups selected from the group of the examples of the aryl group having 6 to 30 ring carbon atoms. The triarylsilyl group preferably has 18 to 30 carbon atoms.

Herein, an aryl group included in an aralkyl group (occasionally referred to as an arylalkyl group) is an aromatic hydrocarbon group or a heterocyclic group.

Herein, the aralkyl group having 7 to 30 carbon atoms is preferably an aralkyl group including an aryl group having 6 to 30 ring carbon atoms and is represented by $-Z_3-Z_4$. $Z_3$ is exemplified by an alkylene group corresponding to the above alkyl group having 1 to 30 carbon atoms. $Z_4$ is exemplified by the above aryl group having 6 to 30 ring carbon atoms. This aralkyl group is preferably an aralkyl group including an aryl moiety having 6 to 30 carbon atoms, preferably 6 to 20 carbon atoms, more preferably 6 to 12 carbon atoms and an alkyl moiety having 1 to 30 carbon atoms, preferably 1 to 20 carbon atoms, more preferably 1 to 10 carbon atoms, further preferably 1 to 6 carbon atoms. Examples of the aralkyl group include a benzyl group, 2-phenylpropane-2-yl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, and 2-β-naphthylisopropyl group.

Herein, a substituted phosphoryl group is represented by a formula (P) below.

[Formula 192]

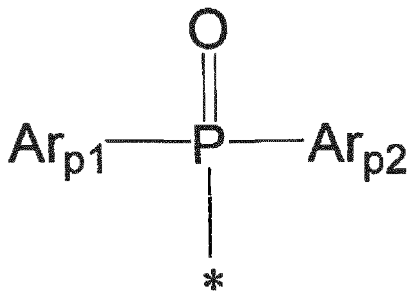

(P)

In the above formula (P), $Ar_{P1}$ and $Ar_{P2}$ are preferably each independently a substituent selected from the group consisting of an alkyl group having 1 to 30 carbon atoms and an aryl group having 6 to 30 ring carbon atoms, more preferably a substituent selected from the group consisting of an alkyl group having 1 to 10 carbon atoms and an aryl group having 6 to 20 ring carbon atoms, further preferably a substituent selected from the group consisting of an alkyl group having 1 to 6 carbon atoms and an aryl group having 6 to 14 ring carbon atoms.

Herein, the alkoxy group having 1 to 30 carbon atoms is represented by $-OZ_1$. $Z_1$ is exemplified by the above

alkyl group having 1 to 30 carbon atoms. Examples of the alkoxy group include a methoxy group, ethoxy group, propoxy group, butoxy group, pentyloxy group and hexyloxy group. The alkoxy group preferably has 1 to 20 carbon atoms.

A halogenated alkoxy group provided by substituting an alkoxy group with a halogen atom is exemplified by one provided by substituting an alkoxy group having 1 to 30 carbon atoms with one or more fluorine atoms.

Herein, an aryl group included in an aryloxy group (occasionally referred to as an arylalkoxy group) also includes a heteroaryl group.

Herein, the arylalkoxy group having 6 to 30 ring carbon atoms is represented by $-OZ_2$. $Z_2$ is exemplified by the above aryl group having 6 to 30 ring carbon atoms. The arylalkoxy group preferably has 6 to 20 ring carbon atoms. The arylalkoxy group is exemplified by a phenoxy group.

Herein, a substituted amino group is represented by -NHRv or $-N(R_V)_2$. Examples of Rv include the above alkyl group having 1 to 30 carbon atoms, the above aryl group having 6 to 30 ring carbon atoms, and the above heteroaryl group having 5 to 30 ring atoms.

Herein, an alkylthio group having 1 to 30 carbon atoms and an arylthio group having 6 to 30 ring carbon atoms are represented by -SRv. Examples of Rv include the above alkyl group having 1 to 30 carbon atoms and the above aryl group having 6 to 30 ring carbon atoms. The alkythio group preferably has 1 to 20 carbon atoms, and the arylthio group has 6 to 20 ring carbon atoms.

Herein, examples of the halogen atom include a fluorine atom, chlorine atom, bromine tom and iodine atom, among which a fluorine atom is preferable.

Herein, "carbon atoms forming a ring (ring carbon atoms)" mean carbon atoms forming a saturated ring, unsaturated ring, or aromatic ring. "Atoms forming a ring (ring atoms)" mean carbon atoms and hetero atoms forming a hetero ring including a saturated ring, unsaturated ring, and aromatic ring.

Herein, a hydrogen atom includes isotope having different numbers of neutrons, specifically, protium, deuterium and tritium.

Herein, a substituent when referring to the "substituted or unsubstituted" is at least one group selected from the group consisting of an aryl group having 6 to 30 ring carbon atoms, heteroaryl group having 5 to 30 ring atoms, (linear or branched) alkyl group having 1 to 30 carbon atoms, cycloalkyl group having 3 to 30 ring carbon atoms, alkyl halide group having 1 to 30 carbon atoms, alkylsilyl group having 3 to 30 carbon atoms, arylsilyl group having 6 to 30 ring carbon atoms, alkoxy group having 1 to 30 carbon atoms, aryloxy group having 6 to 30 carbon atoms, substituted amino group, alkylthio group having 1 to 30 carbon atoms, arylthio group having 6 to 30 ring carbon atoms, aralkyl group having 7 to 30 carbon atoms, (linear or branched) alkenyl group having 2 to 30 carbon atoms, halogen atom, alkynyl group having 2 to 30 carbon atoms, cyano group, hydroxyl group, nitro group, and carboxy group.

Herein, the substituent when referring to the "substituted or unsubstituted" is preferably at least one group selected from the group consisting of an aryl group having 6 to 30 ring carbon atoms, heteroaryl group having 5 to 30 ring atoms, (linear or branched) alkyl group having 1 to 30 carbon atoms, halogen atom, and cyano group, more preferably, the specific examples of the substituent that are rendered preferable in the description of each of the substituents.

Herein, the substituent when referring to the "substituted or unsubstituted" may be further substituted by at least one group selected from the group consisting of an aryl group having 6 to 30 ring carbon atoms, heteroaryl group having 5 to 30 ring atoms, (linear or branched) alkyl group having 1 to 30 carbon atoms, cycloalkyl group having 3 to 30 carbon atoms, alkyl halide group having 1 to 30 carbon atoms, alkylsilyl group having 3 to 30 carbon atoms, arylsilyl group having 6 to 30 ring carbon atoms, alkoxy group having 1 to 30 carbon atoms, aryloxy group having 6 to 30 carbon atoms, substituted amino group, alkylthio group having 1 to 30 carbon atoms, arylthio group having 6 to 30 ring carbon atoms, aralkyl group having 7 to 30 carbon atoms, alkenyl group having 2 to 30 carbon atoms, alkynyl group having 2 to 30 carbon atoms, halogen atom, cyano group, hydroxyl group, nitro group, and carboxy group. In addition, plural ones of these substituents may be mutually bonded to form a ring.

Herein, a substituent further substituting the substituent when referring to the "substituted or unsubstituted" is preferably at least one group selected from the group consisting of an aryl group having 6 to 30 ring carbon atoms, heteroaryl group having 5 to 30 ring atoms, (linear or branched) alkyl group having 1 to 30 carbon atoms, halogen atom, and cyano group, more preferably the specific examples of the substituent that are rendered preferable in the description of each of the substituents.

"Unsubstituted" in "substituted or unsubstituted" means that a group is not substituted by the above-described substituents but bonded with a hydrogen atom.

Herein, "XX to YY carbon atoms" in the description of "substituted or unsubstituted ZZ group having XX to YY carbon atoms" represent carbon atoms of an unsubstituted ZZ group and do not include carbon atoms of a substituent(s) of a substituted ZZ group.

Herein, "XX to YY atoms" in the description of "substituted or unsubstituted ZZ group having XX to YY atoms" represent atoms of an unsubstituted ZZ group and does not include atoms of a substituent(s) of a substituted ZZ group.

The same as the above applies to "substituted or unsubstituted" as for a compound or a partial structure thereof described herein.

Herein, when substituents are mutually bonded to form a ring, the structure of the ring is a saturated ring, unsaturated ring, aromatic hydrocarbon ring, or a heterocyclic ring.

Herein, examples of the aromatic hydrocarbon group and the heterocyclic group in the linking group include divalent or higher-valent groups obtained by removing at least one atom from the above monovalent groups.

The organic EL device according to the first exemplary embodiment emits light with high efficiency.

Further, luminous efficiency of the organic EL device of the first exemplary embodiment is improvable especially in a blue wavelength region.

Electronic Device

The organic EL device 1 according to the first exemplary embodiment of the invention is usable in an electronic device such as a display unit and a light-emitting unit. Examples of the display unit include display components such as an organic EL panel module, TV, mobile phone, tablet, and personal computer. Examples of the light-emitting unit include an illuminator and a vehicle light.

Second Exemplary Embodiment

An arrangement of an organic EL device according to a second exemplary embodiment will be described below. In the description of the second exemplary embodiment, the same components as those in the first exemplary embodiment are denoted by the same reference signs and names to simplify or omit an explanation of the components. In the second exemplary embodiment, the same materials and compounds as described in the first exemplary embodiment are usable, unless otherwise specified.

The organic EL device according to the second exemplary embodiment is different from the organic EL device according to the first exemplary embodiment in that the emitting layer further contains a third compound. Other components are the same as those in the first exemplary embodiment.

Third Compound

A singlet energy $S_1(M3)$ of the third compound and the singlet energy $S_1(M1)$ of the first compound preferably satisfy a relationship of a numerical formula (Numerical Formula 2) below.

$$S_1(M3) > S_1(M1) \quad \text{(Numerical Formula 2).}$$

The third compound may be a compound exhibiting delayed fluorescence or a compound exhibiting no delayed fluorescence.

The third compound is also preferably a host material (occasionally referred to as a matrix material). When the first compound and the third compound are the host materials, one of the compounds may be referred to as a first host material and the other of the compounds may be referred to as a second host material.

The third compound is not particularly limited, but is preferably a compound other than an amine compound. For instance, a carbazole derivative, dibenzofuran derivative and dibenzothiophene derivative are usable as the third compound. However, the third compound is not limited thereto.

The third compound preferably has at least one of a partial structure represented by a formula (31) below, a partial structure represented by a formula (32), a partial structure represented by a formula (33), and a partial structure represented by a formula (34) below in one molecule.

[Formula 193]

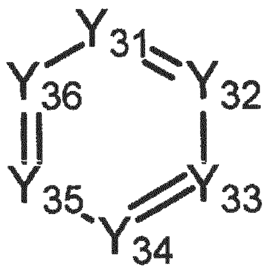

(31)

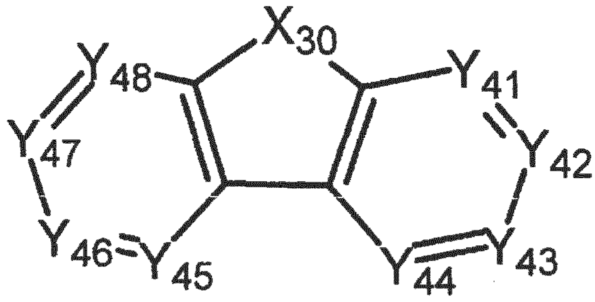

(32)

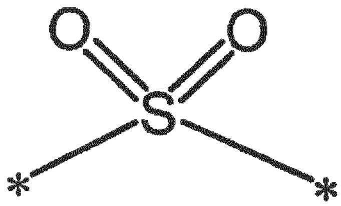

(33)

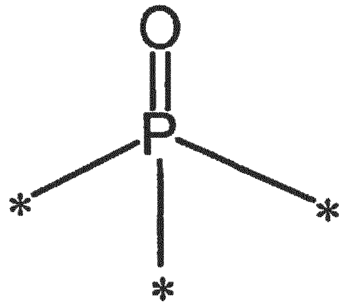

(34)

In the formula (31): $Y_{31}$ to $Y_{36}$ each independently represent a nitrogen atom or a carbon atom bonded to another atom in the molecule of the third compound, where at least one of $Y_{31}$ to $Y_{36}$ is a carbon atom bonded to another atom in the molecule of the third compound.

In the formula (32): $Y_{41}$ to $Y_{48}$ each independently represent a nitrogen atom or a carbon atom bonded to another atom in the molecule of the third compound, where at least one of $Y_{41}$ to $Y_{48}$ is a carbon atom bonded to another atom in the molecule of the third compound.

$X_{30}$ is a nitrogen atom bonded to another atom in the molecule of the third compound, or an oxygen atom or a sulfur atom.

"‘ in the formulae (33) to (34) each independently represent a bonding position with another atom or another structure in the molecule of the third compound.

In the organic EL device of the second exemplary embodiment, the third compound preferably has at least one of the partial structure represented by the formula (31) and the partial structure represented by the formula (32) in one molecule.

In the organic EL device of the second exemplary embodiment, $X_{30}$ in the formula (32) is preferably a nitrogen atom or an oxygen atom.

In the organic EL device of the second exemplary embodiment, the third compound is more preferably a compound having the partial structure represented by the formula (32), a partial structure represented by a formula (3a) below, and a partial structure represented by a formula (3b) below.

[Formula 194]

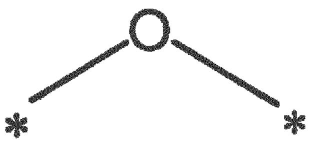

(3a)

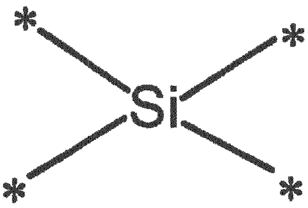

(3b)

**[0208]** * in the formulae (3a) and (3b) each independently represent a bonding position with another atom or another structure in the molecule of the third compound.

In the organic EL device of the second exemplary embodiment, at least two of $Y_{41}$ to $Y_{48}$ in the formula (32) are preferably carbon atoms bonded to other atoms in the molecule of the third compound; and a cyclic structure including the carbon atoms is preferably formed.

For instance, the partial structure represented by the formula (32) is preferably a partial structure selected from the group consisting of partial structures represented by formulae (321), (322), (323), (324), (325) and (326) below.

[Formula 195]

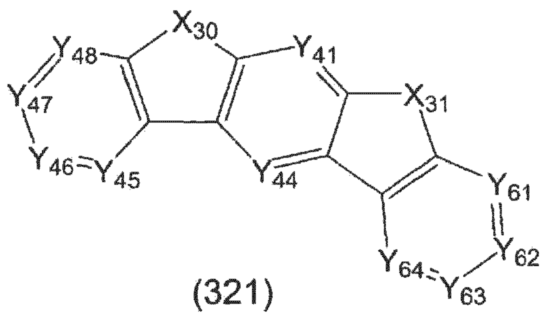

(321)

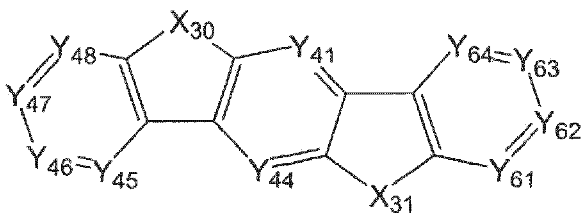

(322)

[Formula 196]

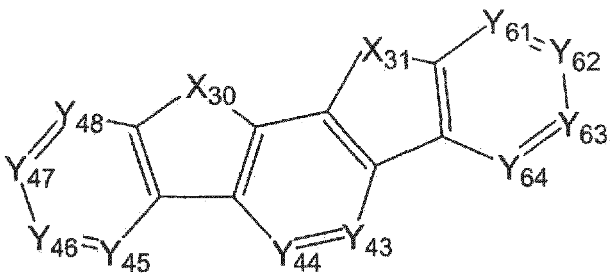

(323)

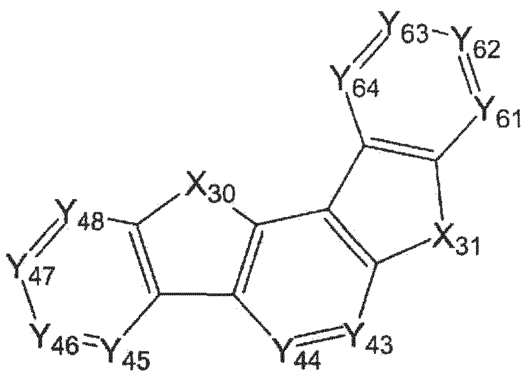

(324)

[Formula 197]

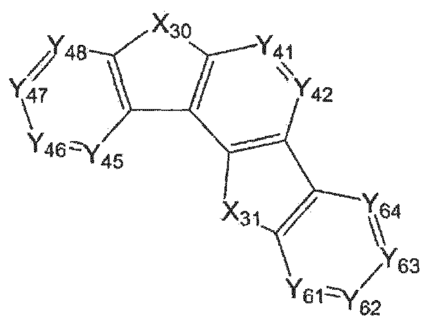

(325)

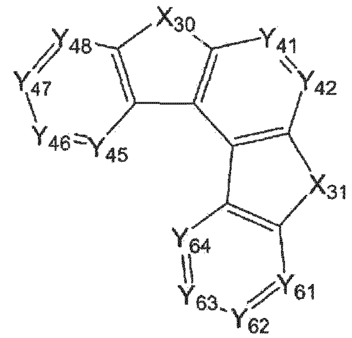

(326)

In the formulae (321) to (326): $X_{30}$ are each independently a nitrogen atom bonded to another atom in the molecule of the third compound, or an oxygen atom or a sulfur atom;

$Y_{41}$ to $Y_{48}$ each independently represent a nitrogen atom or a carbon atom bonded to another atom in the molecule of the third compound;

$X_{31}$ are each independently a nitrogen atom bonded to another atom in the molecule of the third compound, an oxygen atom, a sulfur atom or a carbon atom bonded to another atom in the molecule of the third compound; and

$Y_{61}$ to $Y_{64}$ each independently represent a nitrogen atom or a carbon atom bonded to another atom in the molecule of the third compound.

In the second exemplary embodiment, the third compound preferably includes the partial structure represented by the formula (323) among the formulae (321) to (326).

The partial structure represented by the formula (31) is in a form of at least one group selected from the group consisting of groups represented by formulae (31a) and (31b) below and is preferably contained in the third compound.

The third compound preferably includes at least one of the partial structure represented by the formula (31a) and the partial structure represented by the formula (31b). For the third compound, bonding positions are preferably both situated in meta positions as in the partial structures represented by the formulae (31a) and (31b) in order to keep a high energy gap $T_{77K}(M3)$ at 77 [K].

[Formula 198]

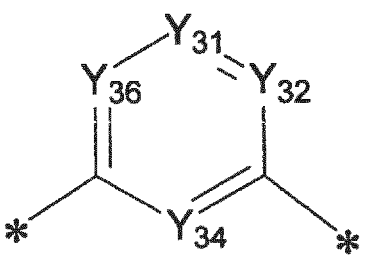

(31a)

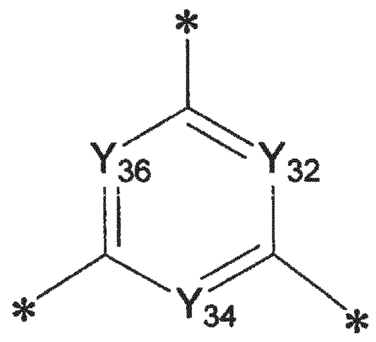

(31b)

In the formula (31a), $Y_{31}$, $Y_{32}$, $Y_{34}$, and $Y_{36}$ are each independently a nitrogen atom or $CR_{31}$.

In the formula (31b), $Y_{32}$, $Y_{34}$, and $Y_{36}$ are each independently a nitrogen atom or $CR_{31}$.

In the above formulae (31a) and (31b): $R_{31}$ is each independently a hydrogen atom or a substituent;

$R_{31}$ serving as the substituent is each independently a group selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted or unsubstituted silyl

group, a substituted germanium group, a substituted phosphine oxide group, a halogen atom, a cyano group, a nitro group, and a substituted or unsubstituted carboxy group,

with a proviso that the substituted or unsubstituted aryl group having 6 to 30 ring carbon atoms in $R_{31}$ is preferably a non-fused ring.

**[0222]** * in the formulae (31a) and (31b) each independently represent a bonding position with another atom or another structure in the molecule of the third compound.

In the formula (31a), $Y_{31}$, $Y_{32}$, $Y_{34}$ and $Y_{36}$ are preferably each independently $CR_{31}$, a plurality of $R_{31}$ being mutually the same or different.

Further, in the formula (31b), $Y_{32}$, $Y_{34}$ and $Y_{36}$ are preferably each independently $CR_{31}$, a plurality of $R_{31}$ being mutually the same or different.

The substituted germanium group is preferably represented by - $Ge(R_{301})_3$. $R_{301}$ are each independently a substituent. The substituent $R_{301}$ is preferably a group selected from the group consisting of a substituted or unsubstituted alkyl group having 1 to 30 carbon atoms or a substituted or unsubstituted aryl group having 6 to 30 ring carbon atoms. A plurality of $R_{301}$ are mutually the same or different.

The partial structure represented by the formula (32) is preferably contained in the third compound in the form of at least one group selected from the group consisting of groups represented by formulae (35) to (39) and (30a) below.

[Formula 199]

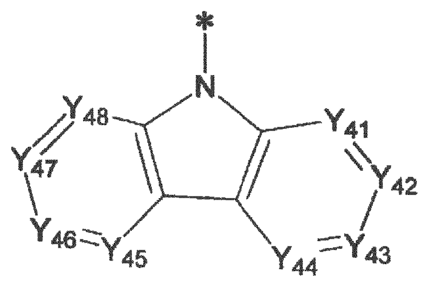

(35)

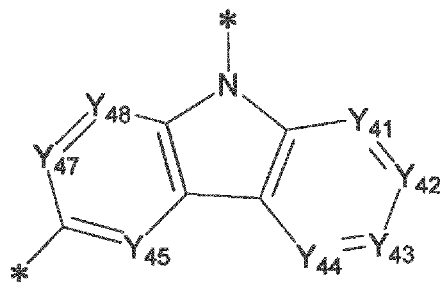

(36)

[Formula 200]

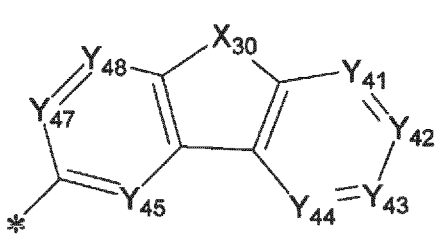

(37)

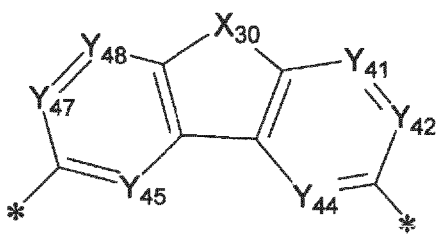

(38)

[Formula 201]

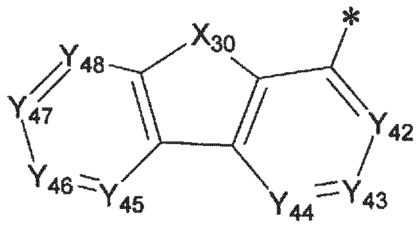

(39)

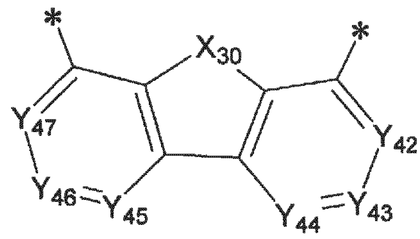

(30a)

In the formula (35), $Y_{41}$ to $Y_{48}$ each independently represent a nitrogen atom or $CR_{32}$.

In the formulae (36) and (37), $Y_{41}$ to $Y_{45}$, $Y_{47}$, and $Y_{48}$ each independently represent a nitrogen atom or $CR_{32}$.

In the formula (38), $Y_{41}$, $Y_{42}$, $Y_{44}$, $Y_{45}$, $Y_{47}$, and $Y_{48}$ each independently represent a nitrogen atom or $CR_{32}$.

In the formula (39), $Y_{42}$ to $Y_{48}$ each independently represent a nitrogen atom or $CR_{32}$.

In the formula (30a), $Y_{42}$ to $Y_{47}$ each independently represent a nitrogen atom or $CR_{32}$.

In the above formulae (35) to (39) and (30a): $R_{32}$ is each independently a hydrogen atom or a substituent;

$R_{32}$ serving as the substituent is selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted or unsubstituted silyl group, a substituted germanium group, a substituted phosphine oxide group, a halogen atom, a cyano group, a nitro group, and a substituted or unsubstituted carboxy group; and

a plurality of $R_{32}$ are mutually the same or different.

**[0233]** * in the formulae (35) and (36) each independently represent a bonding position with another atom or another structure in the molecule of the third compound.

In the above formulae (37) to (39) and (30a): $X_{30}$ represents $NR_{33}$, an oxygen atom or a sulfur atom;

$R_{33}$ is a group selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted or unsubstituted silyl group, a substituted germanium group, a substituted phosphine oxide group, a fluorine atom, a cyano group, a nitro group, and a substituted or unsubstituted carboxy group; and

a plurality of $R_{33}$ are mutually the same or different, where the substituted or unsubstituted aryl group having 6 to 30 ring carbon atoms in $R_{33}$ is preferably a non-fused ring.

**[0235]** * in the formulae (35) to (39) and (30a) each independently represent a bonding position with another atom or another structure in the molecule of the third compound.

In the formula (35), $Y_{41}$ to $Y_{48}$ are each independently preferably $CR_{32}$. In the formulae (36) and (37), $Y_{41}$ to $Y_{45}$, $Y_{47}$ and $Y_{48}$ are each independently preferably $CR_{32}$. In the formula (38), $Y_{41}$, $Y_{42}$, $Y_{44}$, $Y_{45}$, $Y_{47}$ and $Y_{48}$ are each independently preferably $CR_{32}$. In the formula (39), $Y_{42}$ to $Y_{48}$ are each independently preferably $CR_{32}$. In the formula (30a), $Y_{42}$ to $Y_{47}$ are each independently preferably $CR_{32}$. A plurality of $R_{32}$ may be mutually the same or different.

In the third compound, $X_{30}$ is preferably an oxygen atom or a sulfur atom, more preferably an oxygen atom.

In the third compound, $R_{31}$ and $R_{32}$ each independently represent a hydrogen atom or a substituent. $R_{31}$ and $R_{32}$ serving as the substituents are preferably each independently a group selected from the group consisting of a fluorine atom, a cyano group, a substituted or unsubstituted alkyl group having 1 to 30 carbon atoms, a substituted or unsubstituted aryl group having 6 to 30 ring carbon atoms, and a substituted or unsubstituted heteroaryl group having 5 to 30 ring atoms. $R_{31}$ and $R_{32}$ are more preferably a hydrogen atom, a cyano group, a substituted or unsubstituted aryl group having 6 to 30 ring carbon atoms, or a substituted or unsubstituted heteroaryl group having 5 to 30 ring atoms. When

$R_{31}$ and $R_{32}$ serving as the substituents are each a substituted or unsubstituted aryl group having 6 to 30 ring carbon atoms, the aryl group is preferably a non-fused ring.

The third compound is also preferably an aromatic hydrocarbon compound or an aromatic heterocyclic compound. The third compound preferably contains no fused aromatic hydrocarbon ring in a molecule.

Method of Manufacturing Third Compound

The third compound can be manufactured by methods disclosed in International Publication No. WO2012/153780, International Publication No. WO2013/038650, and the like. Moreover, the third compound can be exemplarily manufactured with use of a known alternative reaction and a starting material depending on a target object.

Examples of the substituent for the third compound are shown below, but the invention is not limited thereto.

Specific examples of the aryl group (occasionally referred to as an aromatic hydrocarbon group) include a phenyl group, tolyl group, xylyl group, naphthyl group, phenanthryl group, pyrenyl group, chrysenyl group, benzo[c]phenanthryl group, benzo[g]chrysenyl group, benzoanthryl group, triphenylenyl group, fluorenyl group, 9,9-dimethylfluorenyl group, benzofluorenyl group, dibenzofluorenyl group, biphenyl group, terphenyl group, quarterphenyl group and fluoranthenyl group, among which a phenyl group, biphenyl group, terphenyl group, quarterphenyl group, naphthyl group, triphenylenyl group and fluorenyl group are preferable.

Specific examples of the aryl group having a substituent include a tolyl group, xylyl group and 9,9-dimethylfluorenyl group.

As is understood from the specific examples, the aryl group includes both fused aryl group and non-fused aryl group.

Preferable examples of the aryl group include a phenyl group, biphenyl group, terphenyl group, quarterphenyl group, naphthyl group, triphenylenyl group and fluorenyl group.

Specific examples of the aromatic heterocyclic group (occasionally referred to as a heteroaryl group, heteroaromatic ring group or heterocyclic group) include a pyrrolyl group, pyrazolyl group, pyrazinyl group, pyrimidinyl group, pyridazynyl group, pyridyl group, triazinyl group, indolyl group, isoindolyl group, imidazolyl group, benzimidazolyl group, indazolyl group, imidazo[1,2-a]pyridinyl group, furyl group, benzofuranyl group, isobenzofuranyl group, dibenzofuranyl group, azadibenzofuranyl group, thiophenyl group, benzothienyl group, dibenzothienyl group, azadibenzothienyl group, quinolyl group, isoquinolyl group, quinoxalinyl group, quinazolinyl group, naphthyridinyl group, carbazolyl group, azacarbazolyl group, phenanthridinyl group, acridinyl group, phenanthrolinyl group, phenazinyl group, phenothiazinyl group, phenoxazinyl group, oxazolyl group, oxadiazolyl group, furazanyl group, benzoxazolyl group, thienyl group, thiazolyl group, thiadiazolyl group, benzothiazolyl group, triazolyl group and tetrazolyl group, among which a dibenzofuranyl group, dibenzothienyl group, carbazolyl group, pyridyl group, pyrimidinyl group, triazinyl group, azadibenzofuranyl group and azadibenzothienyl group are preferable.

Preferable examples of the heteroaryl group include a dibenzofuranyl group, dibenzothienyl group, carbazolyl group, pyridyl group, pyrimidinyl group, triazinyl group, azadibenzofuranyl group or azadibenzothienyl group. Further preferable examples of the heteroaryl group include a dibenzofuranyl group, dibenzothienyl group, azadibenzofuranyl group and azadibenzothienyl group.

In the third compound, the substituted silyl group is also preferably a group selected from the group consisting of a substituted or unsubstituted trialkylsilyl group, a substituted or unsubstituted arylalkylsilyl group, and a substituted or unsubstituted triarylsilyl group.

Specific examples of the substituted or unsubstituted trialkylsilyl group include trimethylsilyl group and triethylsilyl group.

Specific examples of the substituted or unsubstituted arylalkylsilyl group include diphenylmethylsilyl group, ditolylmethylsilyl group, and phenyldimethylsilyl group.

Specific examples of the substituted or unsubstituted triarylsilyl group include triphenylsilyl group and tritolylsilyl group.

In the third compound, the substituted phosphine oxide group is also preferably a substituted or unsubstituted diarylphosphine oxide group.

Specific examples of the substituted or unsubstituted diaryl phosphine oxide group include a diphenyl phosphine oxide group and ditolyl phosphine oxide group.

In the third compound, a substituted carboxy group is exemplified by a benzoyloxy group.

Specific examples of the third compound of the second exemplary embodiment are shown below. It should be noted that the third compound according to the invention is not limited to these specific examples.

[Formula 202]

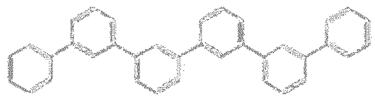
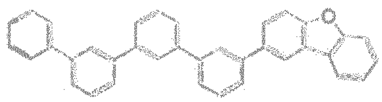
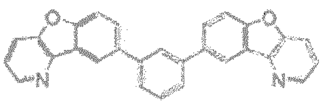
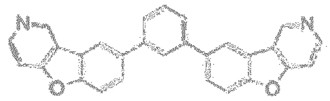
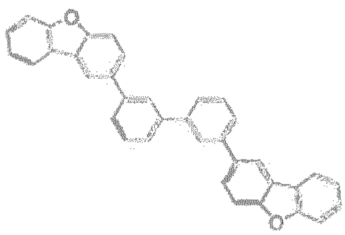
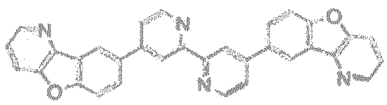
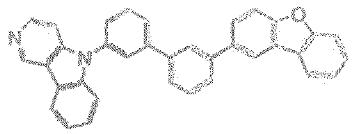

[Formula 203]

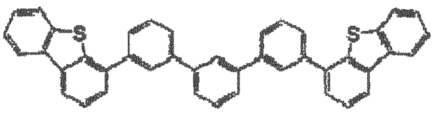
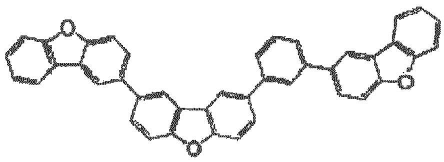
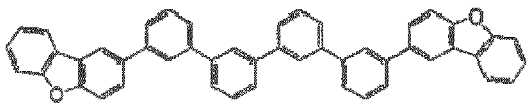
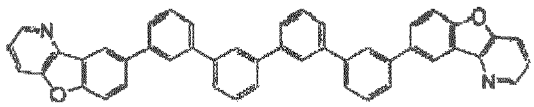
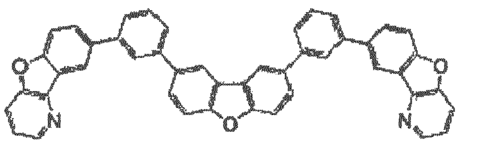
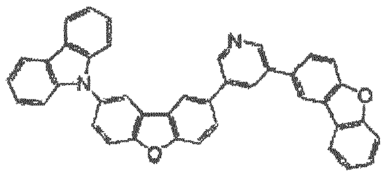

[Formula 204]

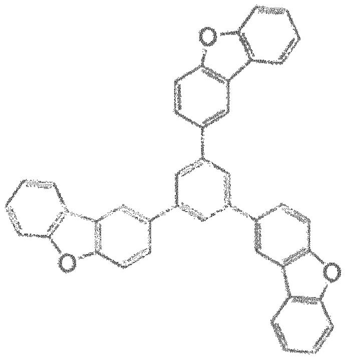
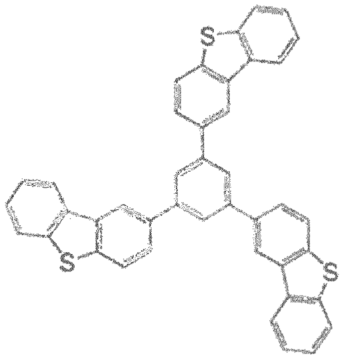

[Formula 205]

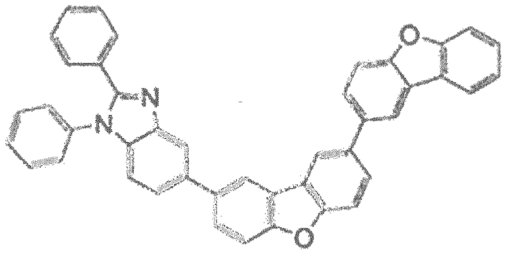

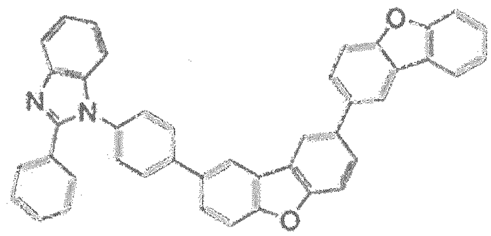

[Formula 206]

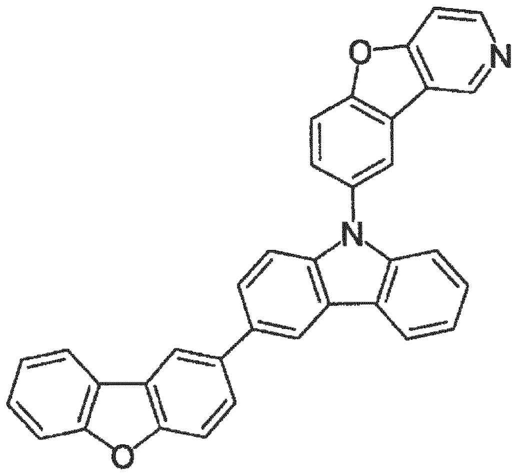

[Formula 207]

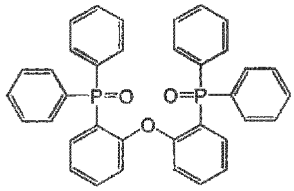

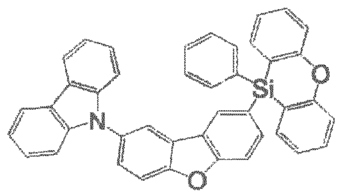

Relationship between First Compound, Second Compound and Third Compound in Emitting Layer

The first compound, the second compound, and the third compound in the emitting layer preferably satisfy the relationships represented by the above numerical formulae (Numerical Formulae 1 and 2). Specifically, a relationship represented by a numerical formula below (Numerical Formula 3) is preferably satisfied.

$$S_1(M3) > S_1(M1) > S_1(M2) \quad \text{(Numerical Formula 3)}$$

The energy gap $T_{77K}(M3)$ at 77 [K] of the third compound is preferably larger than the energy gap $T_{77K}(M1)$ at 77 [K] of the first compound. Specifically, a relationship represented by a numerical formula below (Numerical Formula 5) is preferably satisfied.

$$T_{77K}(M3) > T_{77K}(M1) \quad \text{(Numerical Formula 5)}$$

The energy gap $T_{77K}(M3)$ at 77 [K] of the third compound is preferably larger than the energy gap $T_{77K}(M2)$ at 77 [K] of the second compound. Specifically, a relationship represented by a numerical formula below (Numerical Formula 6) is preferably satisfied.

$$T_{77K}(M3) > T_{77K}(M2) \quad \text{(Numerical Formula 6)}$$

The first compound, the second compound, and the third compound in the emitting layer preferably satisfy the relationships represented by the numerical formulae (Numerical Formulae 4 and 5). Specifically, a relationship represented by a numerical formula below (Numerical Formula 7) is preferably satisfied.

$$T_{77K}(M3) > T_{77K}(M1) > T_{77K}(M2) \quad \text{(Numerical Formula 7)}$$

When the organic EL device in the second exemplary embodiment emits light, it is preferable that the second compound mainly emits light in the emitting layer.

Content Ratio of Compounds in Emitting Layer

A content ratio between the first compound, the second compound and the third compound in the emitting layer is preferably in an exemplary range below.

The content ratio of the first compound is preferably in a range from 10 mass% to 80 mass%, more preferably in a range from 10 mass% to 60 mass%, further preferably in a range from 20 mass% to 60 mass%.

The content ratio of the second compound is preferably in a range from 0.01 mass% to 10 mass%, more preferably in a range from 0.01 mass% to 5 mass%, further preferably in a range from 0.01 mass% to 1 mass%.

A content ratio of the third compound is preferably in a range from 10 mass% to 80 mass%.

An upper limit of a total content ratio of the first compound, second compound and third compound in the emitting layer is 100 mass%. It should be noted that the emitting layer of the second exemplary embodiment may further contain material(s) other than the first, second and third compounds.

Fig. 5 shows an example of a relationship between energy levels of the first, second and third compounds in the emitting layer. In Fig. 5, S0 represents a ground state. S1(M1) represents the lowest singlet state of the first compound. T1(M1) represents the lowest triplet state of the first compound. S1(M2) represents the lowest singlet state of the second compound. T1(M2) represents the lowest triplet state of the second compound. S1(M3) represents the lowest singlet state of the third compound. T1(M3) represents the lowest triplet state of the third compound. A dashed arrow directed from S1(M1) to S1(M2) in Fig. 5 represents Förster energy transfer from the lowest singlet state of the first compound to the lowest singlet state of the second compound.

As shown in Fig. 5, when a compound having a small $\Delta ST(M1)$ is used as the first compound, inverse intersystem crossing from the lowest triplet state T1(M1) to the lowest singlet state S1(M1) can be caused by a heat energy. Accordingly, Förster energy transfer from the lowest singlet state S1(M1) of the first compound to the second compound is caused to generate the lowest singlet state S1(M2). As a result, fluorescence from the lowest singlet state S1(M2) of the second compound is observable. It is inferred that the internal quantum efficiency can be theoretically raised up to 100% also by using delayed fluorescence by the TADF mechanism.

The organic EL device according to the second exemplary embodiment emits light with high efficiency.

Further, luminous efficiency of the organic EL device of the second exemplary embodiment is improvable especially in a blue wavelength region.

The emitting layer of the organic EL device according to the second exemplary embodiment includes the delayed fluorescent first compound, the fluorescent second compound, and the third compound having a larger singlet energy than the first compound, whereby the luminous efficiency of the organic EL device is improved. It is inferred that the luminous efficiency is improved because the carrier balance of the emitting layer is improved by containing the third compound. In the organic EL device of the second exemplary embodiment, the second compound may be a delayed fluorescent compound.

The organic EL device according to the second exemplary embodiment is usable in an electronic device such as a display unit and a light-emitting unit as in the organic EL device according to the first exemplary embodiment.

Modification of Embodiments

It should be noted that the invention is not limited to the above exemplary embodiments but may include any modification and improvement as long as such modification and improvement are compatible with the invention.

The emitting layer is not limited to a single layer. In some embodiments, the emitting layer is provided in a form of a laminate of a plurality of emitting layers. When the organic EL device has a plurality of emitting layers, it is only required that at least one of the emitting layers satisfies the conditions described in the above exemplary embodiments. For instance, in some embodiments, the rest of the emitting layers is a fluorescent emitting layer or a phosphorescent emitting layer using emission by electronic transition from the triplet state directly to the ground state.
When the organic EL device includes the plurality of emitting layers, in some embodiments, the plurality of emitting layers are adjacent to each other, or provide a so-called tandem-type organic EL device in which a plurality of emitting units are layered through an intermediate layer.
For instance, a blocking layer is provided in contact with at least one of an anode-side and a cathode-side of the emitting layer in some embodiments. It is preferable that the blocking layer is adjacent to the emitting layer and blocks at least one of holes, electrons and excitons.
For instance, when the blocking layer is provided in contact with the cathode-side of the emitting layer, the blocking layer permits transport of electrons, but prevents holes from reaching a layer provided near the cathode (e.g., the electron transporting layer) beyond the blocking layer. When the organic EL device includes the electron transporting layer, the blocking layer is preferably interposed between the emitting layer and the electron transporting layer.
When the blocking layer is provided in contact with the emitting layer near the anode, the blocking layer permits transport of holes, but prevents electrons from reaching a layer provided near the anode (e.g., the hole transporting layer) beyond the blocking layer. When the organic EL device includes the hole transporting layer, the blocking layer is preferably interposed between the emitting layer and the hole transporting layer.
Further, a blocking layer may be provided in contact with the emitting layer to prevent an excitation energy from leaking from the emitting layer into a layer in the vicinity thereof. Excitons generated in the emitting layer are prevented from moving into a layer provided near the electrode (e.g., the electron transporting layer and the hole transporting layer) beyond the blocking layer.
The emitting layer and the blocking layer are preferably bonded to each other.
Specific structure and shape of the components in the present invention may be designed in any manner as long as an object of the present invention can be achieved.

Examples

Examples of the invention will be described below. However, the invention is by no means limited by these Examples.

Compounds

Compounds used for preparing the organic EL device are shown below.

[Formula 208]

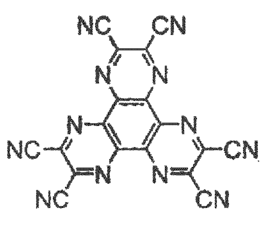

HI

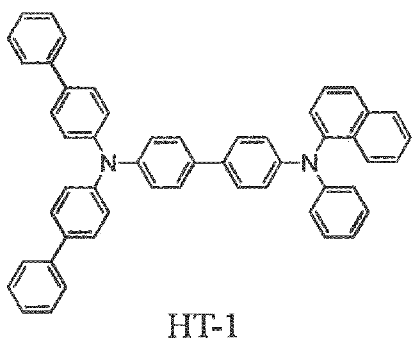

HT-1

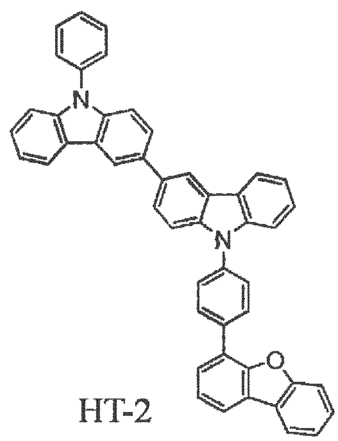

HT-2

[Formula 209]

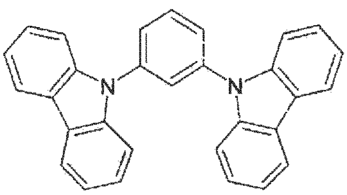

mCP

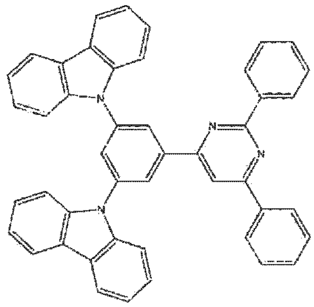

ET-1

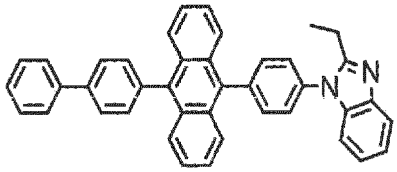

ET-2

[Formula 210]

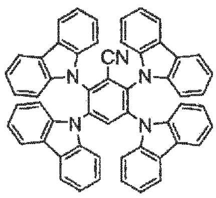

TADF-1

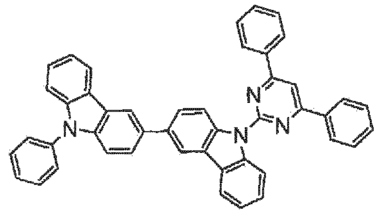

TADF-2

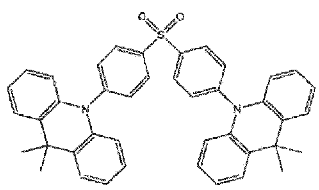

TADF-3

[Formula 211]

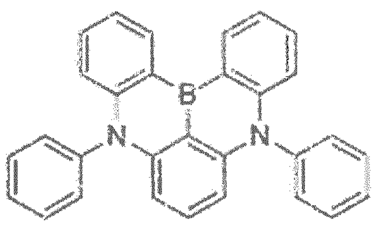

BN-1

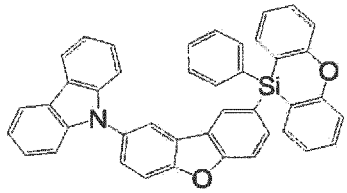

A-1

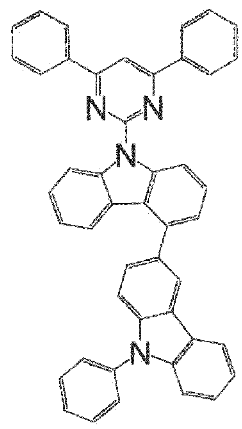

A-2

Evaluation of Compounds

A method of measuring properties of the compounds is described below.

Delayed Fluorescence

Occurrence of delayed fluorescence was determined by measuring transient PL (PhotoLuminescence) using a device shown in Fig. 2. A sample was prepared by co-depositing the compound TADF-1 and the compound TH-2 on

a quartz substrate at a ratio of the compound TADF-1 of 12 mass% to form a 100-nm-thick thin film. Emission from the compound TADF-1 include: Prompt emission observed immediately when the excited state is achieved by exciting the compound TADF-1 with a pulse beam (i.e., a beam emitted from a pulse laser unit) having an absorbable wavelength; and Delayed emission observed not immediately when but after the excited state is achieved. When the amount of Prompt emission is denoted by $X_P$ and the amount of Delayed emission is denoted by $X_D$, the delayed fluorescence in Examples means that a value of $X_D/X_P$ is 0.05 or more.

It was found that the value of $X_D/X_P$ in the compound TADF-1 was 0.05 or more. The transient PL of each of the samples prepared using the compounds TADF-2 and TADF-3 was measured in the same manner as the above. It was then found that the value of $X_D/X_P$ was 0.05 or more.

The amount of Prompt emission and the amount of Delayed emission can be obtained through the same method as a method described in "Nature 492, 234-238, 2012." A device used for calculating the amounts of Prompt Emission and Delayed Emission is not limited to the device of Fig. 2 and a device described in the above document.

Singlet Energy $S_1$

The singlet energy $S_1$ of each of the compounds TADF-1, TADF-2, TADF-3, BN-1, A-1, and A-2 was measured through the above-described solution method.

The singlet energy $S_1$ of the compound TADF-1 was 2.9 eV.

The singlet energy $S_1$ of the compound TADF-2 was 3.0 eV.

The singlet energy $S_1$ of the compound TADF-3 was 3.0 eV.

The singlet energy $S_1$ of the compound BN-1 was 2.7 eV.

The singlet energy $S_1$ of the compound A-1 was 3.5 eV.

The singlet energy $S_1$ of the compound A-2 was 3.1 eV.

Main Peak Wavelength of Compounds

A toluene, in which the measurement target compound was dissolved at a concentration in a range from $10^{-6}$ mol/L to $10^{-5}$ mol/L, was prepared and the emission spectrum of the toluene solution was measured. In the emission spectrum, a peak wavelength of the emission spectrum at the maximum luminous intensity was defined as a main peak wavelength.

The main peak wavelength of the compound BN-1 was 452 nm.

Preparation of Organic EL device

Organic EL devices were prepared in the following manner and evaluated.

Example 1

A glass substrate (size: 25 mm × 75 mm × 1.1 mm thick, manufactured by Geomatec Co., Ltd.) having an ITO transparent electrode (anode) was ultrasonic-cleaned in isopropyl alcohol for five minutes, and then UV/ozone-cleaned for 30 minutes. A film of ITO was 130 nm thick.

After the glass substrate having the transparent electrode line was cleaned, the glass substrate was mounted on a substrate holder of a vacuum vapor-deposition apparatus. Initially, a compound HI was vapor-deposited on a surface of the glass substrate where the transparent electrode line was provided in a manner to cover the transparent electrode, thereby forming a 5-nm-thick hole injecting layer.

Next, the compound HT-1 was vapor-deposited on the hole injecting layer to form an 80-nm-thick first hole transporting layer on the HI film.

Subsequently, the compound HT-2 was vapor-deposited on the first hole transporting layer to form a 10-nm-thick second hole transporting layer.

Further, a compound mCP was vapor-deposited on the second hole transporting layer to form a 5-nm-thick third hole transporting layer.

Next, the compound TADF-1 (the first compound), the compound BN-1 (the second compound) and the compound A-1 (the third compound) were codeposited on the third hole transporting layer to form a 25-nm-thick emitting layer. In the emitting layer, the concentrations of the compounds TADF-1, BN-1 and A-1 were 24 mass%, 1 mass% and 75 mass%, respectively.

The compound ET-1 was then vapor-deposited on the emitting layer to form a 5-nm-thick first electron transporting layer.

The compound ET-2 was then vapor-deposited on the first electron transporting layer to form a 20-nm-thick

second electron transporting layer.

Next, lithium fluoride (LiF) was vapor-deposited on the second electron transporting layer to form a 1-nm-thick electron injecting electrode (cathode).

A metal aluminum (Al) was then deposited on the electron injecting electrode to form an 80-nm-thick metal Al cathode.

A device arrangement of the organic EL device in Example 1 is schematically shown as follows.

ITO (130) / HI (5) / HT-1 (80) / HT-2 (10) / mCP (5) / A-1:TADF-1:BN-1 (25, 75%:24%:1%) / ET-1 (5) : ET-2 (20) / LiF (1) / Al (80)

Numerals in parentheses represent a film thickness (unit: nm). The numerals represented by percentage in parentheses indicate a ratio (mass%) of the first, second and third compounds in the emitting layer.

Example 2

An organic EL device of Example 2 was prepared in the same manner as the organic EL device of Example 1 except that the concentration of the compound TADF-1 was determined at 99 mass%, the concentration of the compound BN-1 was determined at 1 mass%, and the compound A-1 was not used in the emitting layer of Example 1.

A device arrangement of the organic EL device in Example 2 is schematically shown as follows.

ITO (130) / HI (5) / HT-1 (80) / HT-2 (10) / mCP (5) /TADF-1:BN-1 (25, 99%:1%) / ET-1 (5) : ET-2 (20) / LiF (1) / Al (80)

Example 3 - for reference, not according to the invention

An organic EL device of Example 3 was prepared in the same manner as the organic EL device of Example 1 except that the compound TADF-2 was used in place of the compound TADF-1 and the compound A-2 was used in place of the compound A-1 in the emitting layer of Example 1.

A device arrangement of the organic EL device in Example 3 is schematically shown as follows.

ITO (130) / HI (5) / HT-1 (80) / HT-2 (10) / mCP (5) / A-2:TADF-2:BN-1 (25, 75%:24%:1%) / ET-1 (5) : ET-2 (20) / LiF (1) / Al (80)

Comparative 1

An organic EL device of Comparative 1 was prepared in the same manner as the organic EL device of Example 1 except that the concentration of the compound A-1 was determined at 99 mass%, the concentration of the compound BN-1 was determined at 1 mass%, and the compound TADF-1 was not used in the emitting layer of Example 1.

A device arrangement of the organic EL device of Comparative 1 is schematically shown as follows.

ITO (130) / HI (5) / HT-1 (80) / HT-2 (10) / mCP (5) /A-1:BN-1 (25, 99%:1%) / ET-1 (5) : ET-2 (20) / LiF (1) / Al (80)

Comparative 2

An organic EL device of Comparative 2 was prepared in the same manner as the organic EL device of Example 1 except that a compound TADF-3 was used in place of the compound TADF-1 in the emitting layer of Example 1.

A device arrangement of the organic EL device of Comparative 2 is schematically shown as follows.

ITO (130) / HI (5) / HT-1 (80) / HT-2 (10) / mCP (5) / A-1:TADF-3:BN-1 (25, 75%:24%:1%) / ET-1 (5) : ET-2 (20) / LiF (1) / Al (80)

Comparative 3

An organic EL device of Comparative 3 was prepared in the same manner as the organic EL device of Comparative 1 except that the compound mCP was used in place of the compound A-1, the concentration of the compound mCP was determined at 99 mass%, and the concentration of the compound BN-1 was determined at 1 mass% in the emitting layer of Comparative 1.
A device arrangement of the organic EL device of Comparative 3 is schematically shown as follows.

ITO (130) / HI (5) / HT-1 (80) / HT-2 (10) / mCP (5) /mCP:BN-1 (25, 99%:1%) / ET-1 (5) : ET-2 (20) / LiF (1) / Al (80)

Evaluation 1 of Organic EL Devices

The prepared organic EL devices of Examples 1 to 3 and Comparatives 1 to 3 were evaluated as follows. The evaluation results are shown in Table 1.

External Quantum Efficiency EQE and Main Peak Wavelength λp

Voltage was applied on each of the organic EL devices such that a current density was 10mA/cm$^2$, where spectral radiance spectra were measured by a spectroradiometer (CS-1000 manufactured by Konica Minolta, Inc.).
The external quantum efficiency EQE (unit: %) was calculated based on the obtained spectral-radiance spectra, assuming that the spectra was provided under a Lambertian radiation.
Voltage was applied on each of the organic EL devices such that a current density was 0.1 mA/cm$^2$, where spectral radiance spectrum was measured by the spectroradiometer (CS-1000 manufactured by Konica Minolta, Inc.) and a main peak wavelength λp (unit: nm) was calculated from the obtained spectral radiance spectrum.

Table 1

| | **EQE [%]** | **λp [nm]** |
|---|---|---|
| EXAMPLE 1 | **12.25** | **457** |
| EXAMPLE 2 | **7.88** | **461** |
| EXAMPLE 3 | **5.70** | **461** |
| COMPARATIVE 1 | **2.56** | **457** |
| COMPARATIVE 2 | **2.10** | **457** |
| COMPARATIVE 3 | **1.98** | **457** |

The organic EL devices of Examples 1 to 3, which contained the first compound and second compound represented by the formula (2) in the emitting layer, exhibited improved luminous efficiency in the high-current-density area as compared with the organic EL devices of Comparatives 1 to 3.

Evaluation 2 of Organic EL Devices

The prepared organic EL devices of Examples 1 and 3 and Comparative 2 were evaluated as follows. The evaluation results are shown in Table 2.

Lifetime LT95 and Lifetime LT50

A continuous direct-current test was conducted on the organic EL devices at an initial current density of 10 mA/cm$^2$, where a time elapsed before a luminance intensity was reduced to 95% of the initial luminance intensity and a time elapsed before a luminance intensity was reduced to 50% of the initial luminance intensity were measured and were defined as lifetime LT95 (unit: hr.) and LT50 (unit: hr.), respectively.

Table 2

| | LT95 [hrs] | LT50 [hrs] |
|---|---|---|
| EXAMPLE 1 | 0.7 | 10.4 |
| EXAMPLE 3 | 0.9 | 19.7 |
| COMPARATIVE 2 | <0.1 | 1.0 |

As shown in Table 2, it was determined that the lifetime of the organic EL devices of Examples 1 and 3 was longer than the lifetime of the organic EL device of Comparative 2.

EXPLANATION OF CODES

1...organic EL device, 2...substrate, 3...anode, 4...cathode, 5...emitting layer, 6...hole injecting layer, 7...hole transporting layer, 8...electron transporting layer, 9...electron injecting layer

## Claims

1. An organic electroluminescence device, comprising:

an anode;
an emitting layer; and
a cathode, wherein
the emitting layer comprises a first compound and a second compound,
the first compound is a thermally activated delayed fluorescent compound,
the first compound is a compound represented by a formula (11D) below,
the second compound is represented by a formula (2) below, and
a singlet energy $S_1(M1)$ of the first compound and a singlet energy $S_1(M2)$ of the second compound satisfy a relationship of Numerical Formula 1 below,

$$S_1(M1) > S_1(M2) \quad \text{(Numerical Formula 1)},$$

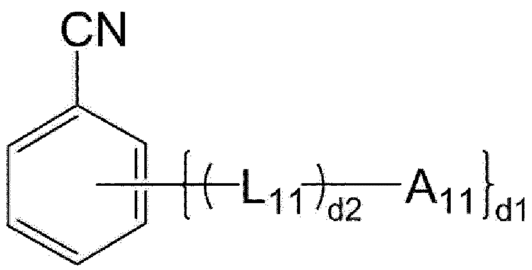

(11D)

wherein in the formula (11D):

d1 is 5, d2 are each independently 0 or 1;
$L_{11}$ are each independently a single bond or a linking group;
$L_{11}$ serving as the substituents are each independently a group derived from a group selected from the group consisting of a substituted or unsubstituted aryl group having 6 to 30 ring carbon atoms, and a substituted or unsubstituted heteroaryl group having 5 to 30 ring atoms;
$A_{11}$ are each independently a hydrogen atom or a substituent; and
$A_{11}$ serving as the substituents are each independently a group selected from the group consisting of a cyano group, a substituted or unsubstituted aryl group having 6 to 30 ring carbon atoms, and a substituted or unsubstituted heteroaryl group having 5 to 30 ring atoms,
with a proviso that at least one of $A_{11}$ is a group represented by the formula (11a)

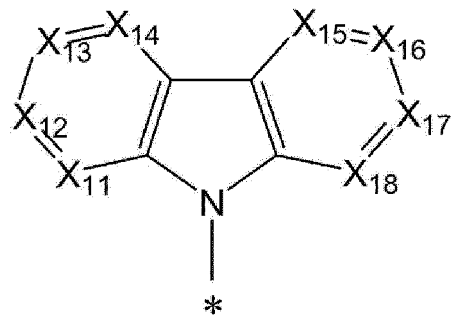

(11a)

wherein in the formula (11a):

$X_{11}$ to $X_{18}$ are each independently a nitrogen atom or CRx (a carbon atom having a substituent Rx);
Rx are each independently a hydrogen atom or a substituent;
Rx serving as the substituent is selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted fluoroalkyl group having 1 to 30 carbon atoms, a substituted or unsubstituted cycloalkyl group having 3 to 30 ring carbon atoms, a substituted or unsubstituted aralkyl group having 7 to 30 carbon atoms, a substituted phosphoryl group, a substituted silyl group, a cyano group, a nitro group, and a carboxyl group;
a plurality of Rx are mutually the same or different;
when a plurality of ones of $X_{11}$ to $X_{18}$ are CRx and Rx are substituents, Rx are bonded to each other to form a ring, or are not bonded to form no ring; and
* represents a bonding position to a carbon atom of the cyclic structure represented by $L_{11}$ or the benzonitrile moiety in the formula (11D),

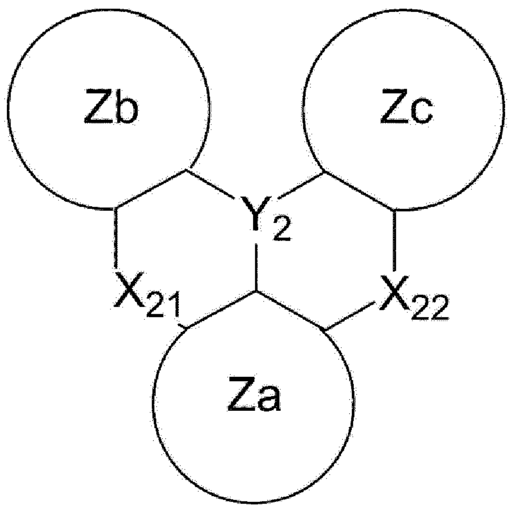

(2)

where, in the formula (2): Za ring, Zb ring and Zc ring are each independently a cyclic structure selected from the group consisting of a substituted or unsubstituted aryl ring having 6 to 30 ring carbon atoms, and a substituted or unsubstituted heteroaryl ring having 5 to 30 ring atoms;
$X_{21}$ and $X_{22}$ are each independently an oxygen atom, NRa, or a sulfur atom;
when $X_{21}$ is NRa, Ra is bonded to Za ring or Zb ring to form a ring or is not bonded to form no ring;
when $X_{22}$ is NRa, Ra is bonded to Za ring or Zc ring to form a ring or is not bonded to form no ring;
Ra is each independently a group selected from the group consisting of a substituted or unsubstituted aryl group having 6 to 30 ring carbon atoms, a substituted or unsubstituted heteroaryl group having 5 to 30 ring atoms, and a substituted or unsubstituted alkyl group having 1 to 30 carbon atoms;
$Y_2$ is any one of a boron atom, a phosphorus atom, SiRb, P=O, or P=S; and
Rb is each independently a group selected from the group consisting of a substituted or unsubstituted

aryl group having 6 to 30 ring carbon atoms, a substituted or unsubstituted heteroaryl group having 5 to 30 ring atoms, and a substituted or unsubstituted alkyl group having 1 to 30 carbon atoms.

**2.** The organic electroluminescence device according to claim 1, wherein the second compound is a compound represented by a formula (2A) below,

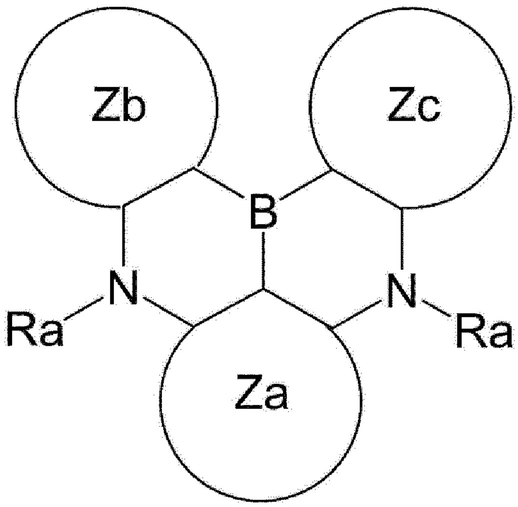

(2A)

where, in the formula (2A), Za ring, Zb ring, Zc ring, and Ra represent the same as Za ring, Zb ring, Zc ring, and Ra in the formula (2), respectively.

**3.** The organic electroluminescence device according to claim 1, wherein

the second compound is a compound represented by a formula (21) below,

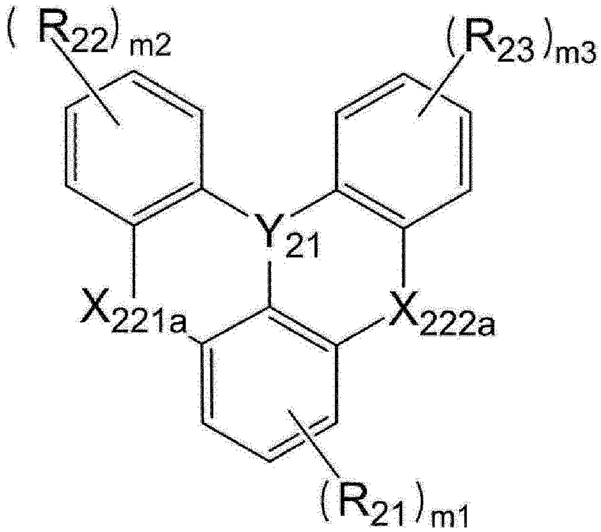

(21)

where, in the formula (21): $X_{221a}$ and $X_{222a}$, which are mutually the same, are any one of oxygen atoms, NRa, and sulfur atoms;
m1 is 3, and each of m2 and m3 is 4;
$R_{21}$ to $R_{23}$ are each independently a hydrogen atom or a substituent;
$R_{21}$ to $R_{23}$ serving as the substituents are each independently a group selected from the group consisting of a substituted or unsubstituted aryl group having 6 to 30 ring carbon atoms, a substituted or unsubstituted heteroaryl group having 5 to 30 ring atoms, a substituted or unsubstituted alkyl group having 1 to 30 carbon atoms, a substituted or unsubstituted aryloxy group having 6 to 30 ring carbon atoms, a substituted or unsubstituted amino group, and a substituted silyl group; and

in the formula (21), $Y_{21}$ represents the same as $Y_2$ in the formula (2).

**4.** The organic electroluminescence device according to claim 3, wherein the second compound is a compound represented by a formula (21A) below,

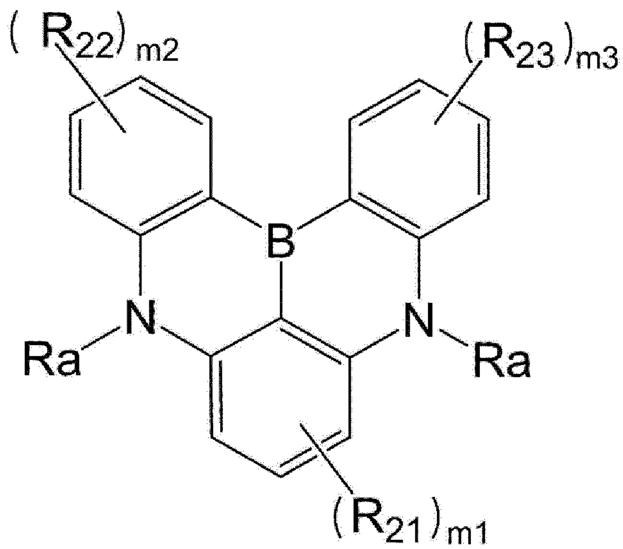

(21A)

where Ra, m1 to m3, and $R_{21}$ to $R_{23}$ in the formula (21A) represent the same as Ra, m1 to m3, and $R_{21}$ to $R_{23}$ in the formula (21), respectively.

**5.** The organic electroluminescence device according to any one of claims 1 to 4, wherein Ra is a substituted or unsubstituted aryl group having 6 to 30 ring carbon atoms.

**6.** The organic electroluminescence device according to any one of claims 1 to 5, wherein Ra is a substituted or unsubstituted phenyl group.

**7.** The organic electroluminescence device according to any one of claims 1 to 6, wherein Ra in the formula (2) is not bonded to any of Za ring and Zb ring to form no ring, and Ra in the formula (2) is not bonded to any of Za ring and Zc ring to form no ring.

**8.** The organic electroluminescence device according to any one of claims 1 to 7, wherein the second compound is a thermally activated delayed fluorescent compound.

**9.** The organic electroluminescence device according to any one of claims 1 to 8, wherein when the organic electroluminescence device emits light, the second compound emits light in the emitting layer.

**10.** The organic electroluminescence device according to any one of claims 1 to 9, wherein

the emitting layer further comprises a third compound, and
the third compound has at least one of a partial structure represented by a formula (31) below, a partial structure represented by a formula (32) below, a partial structure represented by a formula (33) below, or a partial structure represented by a formula (34) below in one molecule,

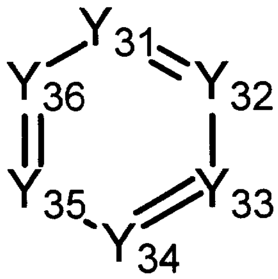

(31)

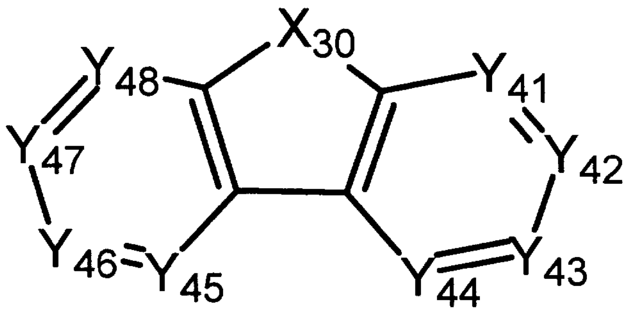

(32)

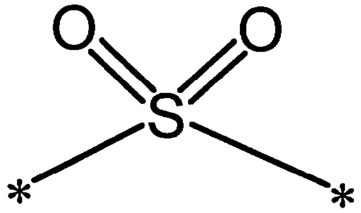

(33)

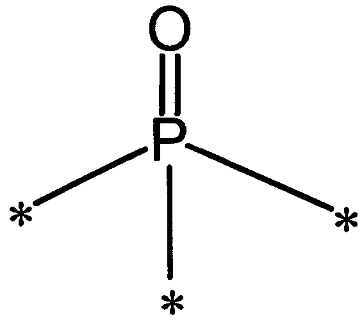

(34)

where, in the formula (31): $Y_{31}$ to $Y_{36}$ each independently represent a nitrogen atom or a carbon atom bonded to another atom in the molecule of the third compound, at least one of $Y_{31}$ to $Y_{36}$ being the carbon atom bonded to another atom in the molecule of the third compound,

in the formula (32): $Y_{41}$ to $Y_{48}$ each independently represent a nitrogen atom or a carbon atom bonded to another atom in the molecule of the third compound, at least one of $Y_{41}$ to $Y_{48}$ being the carbon atom bonded to another atom in the molecule of the third compound; and

$X_{30}$ is a nitrogen atom bonded to another atom in the molecule of the third compound, or an oxygen atom or a sulfur atom, and

* in the formulae (33) to (34) each independently represent a bonding position with another atom or another structure in the molecule of the third compound.

**11.** The organic electroluminescence device according to claim 10, wherein $X_{30}$ in the formula (32) is a nitrogen atom or an oxygen atom.

**12.** The organic electroluminescence device according to claim 10 or 11, wherein a singlet energy $S_1(M1)$ of the first compound and a singlet energy $S_1(M3)$ of the third compound satisfy a relationship of Numerical Formula 2 below,

$$S_1(M3) > S_1(M1) \quad \text{(Numerical Formula 2)}.$$

**13.** An electronic device comprising the organic electroluminescence device according to any one of claims 1 to 12.

## Patentansprüche

**1.** Eine organische Elektrolumineszenzvorrichtung, die umfasst:

eine Anode;

eine emittierende Schicht; und
eine Kathode, wobei
die emittierende Schicht eine erste Verbindung und eine zweite Verbindung umfasst,
die erste Verbindung eine thermisch aktiviert verzögert fluoreszierende Verbindung ist,
die erste Verbindung eine durch die untenstehende Formel (11D) dargestellte Verbindung ist,
die zweite Verbindung eine durch die untenstehende Formel (2) dargestellte Verbindung ist, und
eine Singulett-Energie $S_1$(M1) der ersten Verbindung und eine Singulett-Energie $S_1$(M2) der zweiten Verbindung die Beziehung der folgenden Numerischen Formel 1 erfüllen,

$$S_1(M1) > S_1(M2) \quad \text{(Numerische Formel 1)},$$

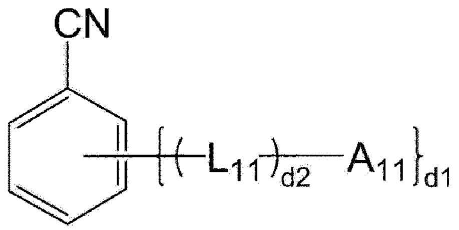

(11D)

wobei in der Formel (11D):
d1 5 ist, d2 jeweils unabhängig voneinander 0 oder 1 ist;
$L_{11}$ jeweils unabhängig eine Einfachbindung oder eine verbindende Gruppe sind;
$L_{11}$, die als Substituenten dienen, jeweils unabhängig eine Gruppe sind, die von einer Gruppe abgeleitet ist, die aus der Gruppe ausgewählt ist, die aus einer substituierten oder unsubstituierten Arylgruppe mit 6 bis 30 Ringkohlenstoffatomen, und einer substituierten oder unsubstituierten Heteroarylgruppe mit 5 bis 30 Ringatomen besteht;
$A_{11}$ jeweils unabhängig voneinander ein Wasserstoffatom oder ein Substituent sind; und
$A_{11}$, die als Substituenten dienen, jeweils unabhängig voneinander eine Gruppe sind, die aus der Gruppe ausgewählt ist, die aus einer Cyanogruppe, einer substituierten oder unsubstituierten Arylgruppe mit 6 bis 30 Ringkohlenstoffatomen, und einer substituierten oder unsubstituierten Heteroarylgruppe mit 5 bis 30 Ringatomen besteht,
mit der Maßgabe, dass mindestens eines der $A_{11}$ eine Gruppe ist, die durch die Formel (11a) wiedergegeben wird,

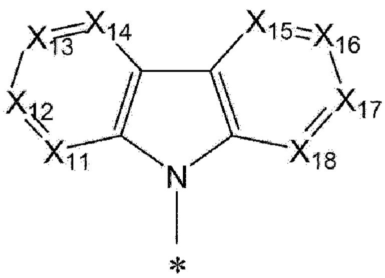

(11a)

wobei in der Formel (11a):

$X_{11}$ bis $X_{18}$ jeweils unabhängig voneinander ein Stickstoffatom oder CRx (ein Kohlenstoffatom mit einem Substituenten Rx) sind;
Rx jeweils unabhängig voneinander ein Wasserstoffatom oder ein Substituent sind;
Rx, das als Substituent dient, aus der Gruppe ausgewählt ist, die aus einer substituierten oder unsubstituierten Arylgruppe mit 6 bis 30 Ringkohlenstoffatomen, einer substituierten oder unsubstituierten Heteroarylgruppe mit 5 bis 30 Ringatomen, einer substituierten oder unsubstituierten Alkylgruppe mit 1 bis 30 Kohlenstoffatomen, einer substituierten oder unsubstituierten Fluoralkylgruppe mit 1 bis 30 Kohlenstoffatomen, einer substituierten oder unsubstituierten Cycloalkylgruppe mit 3 bis 30 Ringkohlenstoffatomen, einer substituierten oder unsubstituierten Aralkylgruppe mit 7 bis 30 Kohlenstoffatomen, einer substituierten Phosphorylgruppe, einer substituierten Silylgruppe, einer Cyanogruppe, einer Nitrogruppe, und einer Carboxylgruppe besteht;
eine Vielzahl von Rx untereinander gleich oder verschieden sind;
wenn mehrere von $X_{11}$ bis $X_{18}$ CRx sind und Rx Substituenten sind, Rx aneinander gebunden sind, um einen Ring zu bilden, oder nicht gebunden sind, um keinen Ring zu bilden; und
* eine Bindungsposition zu einem Kohlenstoffatom der durch $L_{11}$ dargestellten cyclischen Struktur oder der Benzonitrileinheit in der Formel (11D) darstellt,

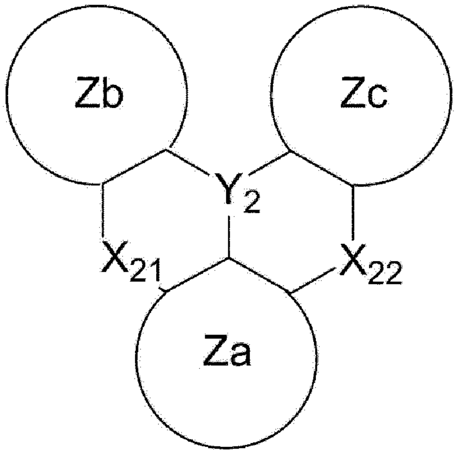

(2)

wobei in der Formel (2): der Za-Ring, der Zb-Ring und der Zc-Ring jeweils unabhängig voneinander eine cyclische Struktur sind, ausgewählt aus der Gruppe, die aus einem substituierten oder unsubstituierten Arylring mit 6 bis 30 Ringkohlenstoffatomen, und einem substituierten oder unsubstituierten Heteroarylring mit 5 bis 30 Ringatomen besteht;

$X_{21}$ und $X_{22}$ jeweils unabhängig voneinander ein Sauerstoffatom, NRa oder ein Schwefelatom sind;

wenn $X_{21}$ NRa ist, Ra an den Za-Ring oder Zb-Ring gebunden ist, um einen Ring zu bilden, oder nicht gebunden ist, um keinen Ring zu bilden;
wenn $X_{22}$ NRa ist, Ra an den Za-Ring oder Zc-Ring gebunden ist, um einen Ring zu bilden, oder nicht gebunden ist, um keinen Ring zu bilden;
Ra jeweils unabhängig voneinander eine Gruppe ist, die aus der Gruppe ausgewählt ist, die aus einer substituierten oder unsubstituierten Arylgruppe mit 6 bis 30 Ringkohlenstoffatomen, einer substituierten oder unsubstituierten Heteroarylgruppe mit 5 bis 30 Ringatomen, und einer substituierten oder unsubstituierten Alkylgruppe mit 1 bis 30 Kohlenstoffatomen besteht;
$Y_2$ ein Boratom, ein Phosphoratom, SiRb, P=O oder P=S ist; und
Rb jeweils unabhängig voneinander eine Gruppe ist, die aus der Gruppe ausgewählt ist, die aus einer substituierten oder unsubstituierten Arylgruppe mit 6 bis 30 Ringkohlenstoffatomen, einer substituierten oder unsubstituierten Heteroarylgruppe mit 5 bis 30 Ringatomen, und einer substituierten oder unsubstituierten Alkylgruppe mit 1 bis 30 Kohlenstoffatomen besteht.

**2.** Die organische Elektrolumineszenzvorrichtung gemäß Anspruch 1, wobei die zweite Verbindung eine Verbindung ist, die durch die nachstehende Formel (2A) dargestellt wird,

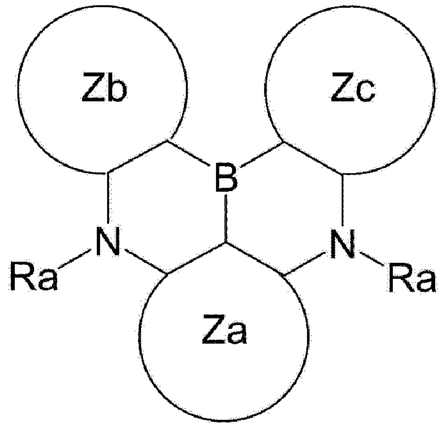

(2A)

wobei in der Formel (2A) Za-Ring, Zb-Ring, Zc-Ring und Ra dasselbe darstellen wie Za-Ring, Zb-Ring, Zc-Ring beziehungsweise Ra in der Formel (2).

**3.** Die organische Elektrolumineszenzvorrichtung gemäß Anspruch 1, wobei die zweite Verbindung eine Verbindung ist, die durch die nachstehende Formel (21) dargestellt wird,

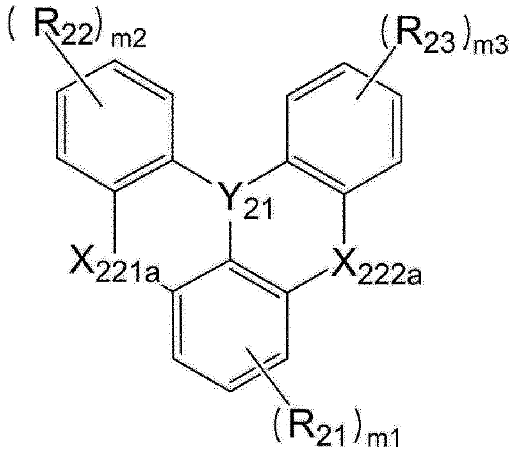

(21)

wobei in der Formel (21): $X_{221a}$ und $X_{222a}$, die untereinander gleich sind, eines von Sauerstoffatomen, NRa und Schwefelatomen sind;

m1 3 ist, und m2 und m3 jeweils 4 sind;

$R_{21}$ bis $R_{23}$ jeweils unabhängig voneinander ein Wasserstoffatom oder ein Substituent sind; $R_{21}$ bis $R_{23}$, die als Substituenten dienen, jeweils unabhängig voneinander eine Gruppe sind, die aus der Gruppe ausgewählt ist, die aus einer substituierten oder unsubstituierten Arylgruppe mit 6 bis 30 Ringkohlenstoffatomen, einer substituierten oder unsubstituierten Heteroarylgruppe mit 5 bis 30 Ringatomen, einer substituierten oder unsubstituierten Alkylgruppe mit 1 bis 30 Kohlenstoffatomen, einer substituierten oder unsubstituierten Aryloxygruppe mit 6 bis 30 Ringkohlenstoffatomen, einer substituierten oder unsubstituierten Aminogruppe, und einer substituierten Silylgruppe besteht; und

in der Formel (21) $Y_{21}$ das gleiche wie $Y_2$ in der Formel (2) darstellt.

**4.** Die organische Elektrolumineszenzvorrichtung gemäß Anspruch 3, wobei die zweite Verbindung eine Verbindung ist, die durch die nachstehende Formel (21A) dargestellt wird,

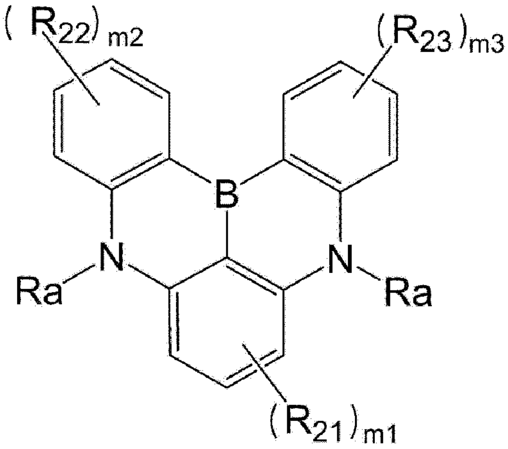

(21A)

worin Ra, m1 bis m3 und $R_{21}$ bis $R_{23}$ in der Formel (21A) das gleiche bedeuten wie Ra, m1 bis m3 beziehungsweise $R_{21}$ bis $R_{23}$ in der Formel (21).

5. Die organische Elektrolumineszenzvorrichtung gemäß einem der Ansprüche 1 bis 4, wobei Ra eine substituierte oder unsubstituierte Arylgruppe mit 6 bis 30 Ringkohlenstoffatomen ist.

6. Die organische Elektrolumineszenzvorrichtung gemäß einem der Ansprüche 1 bis 5, wobei Ra eine substituierte oder unsubstituierte Phenylgruppe ist.

7. Die organische Elektrolumineszenzvorrichtung gemäß einem der Ansprüche 1 bis 6, wobei Ra in der Formel (2) nicht an einen der Ringe Za und Zb gebunden ist, um keinen Ring zu bilden, und Ra in der Formel (2) nicht an einen der Ringe Za und Zc gebunden ist, um keinen Ring zu bilden.

8. Die organische Elektrolumineszenzvorrichtung gemäß einem der Ansprüche 1 bis 7, wobei die zweite Verbindung eine thermisch aktiviert verzögert fluoreszierende Verbindung ist.

9. Die organische Elektrolumineszenzvorrichtung gemäß einem der Ansprüche 1 bis 8, wobei, wenn die organische Elektrolumineszenzvorrichtung Licht emittiert, die zweite Verbindung Licht in der emittierenden Schicht emittiert.

10. Die organische Elektrolumineszenzvorrichtung gemäß einem der Ansprüche 1 bis 9, wobei

die emittierende Schicht darüber hinaus eine dritte Verbindung umfasst, und
die dritte Verbindung mindestens eine durch die nachstehende Formel (31) dargestellte Teilstruktur, eine durch die nachstehende Formel (32) dargestellte Teilstruktur, eine durch die nachstehende Formel (33) dargestellte Teilstruktur oder eine durch die nachstehende Formel (34) dargestellte Teilstruktur in einem Molekül aufweist,

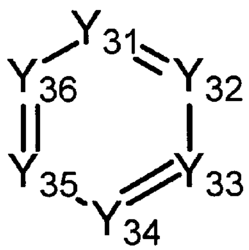

(31)

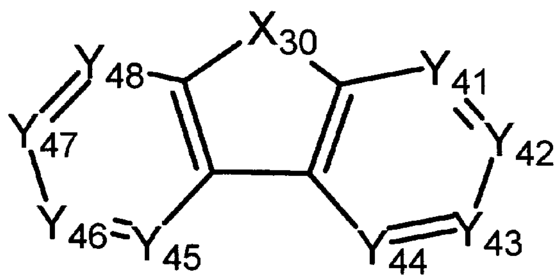

(32)

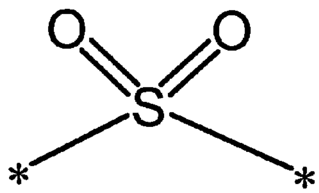

(33)

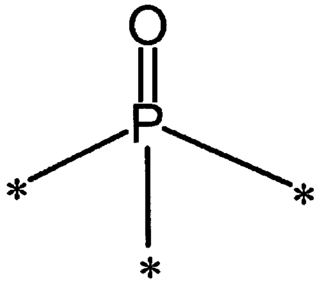

(34)

worin, in der Formel (31): $Y_{31}$ bis $Y_{36}$ jeweils unabhängig voneinander ein Stickstoffatom oder ein Kohlenstoffatom darstellen, das an ein anderes Atom im Molekül der dritten Verbindung gebunden ist, wobei mindestens eines von $Y_{31}$ bis $Y_{36}$ das Kohlenstoffatom ist, das an ein anderes Atom im Molekül der dritten Verbindung gebunden ist,
in der Formel (32): $Y_{41}$ bis $Y_{48}$ jeweils unabhängig voneinander ein Stickstoffatom oder ein Kohlenstoffatom darstellen, das an ein anderes Atom im Molekül der dritten Verbindung gebunden ist, wobei mindestens eines von $Y_{41}$ bis $Y_{48}$ das Kohlenstoffatom ist, das an ein anderes Atom im Molekül der dritten Verbindung gebunden ist; und
$X_{30}$ ein Stickstoffatom ist, das an ein anderes Atom im Molekül der dritten Verbindung gebunden ist, oder ein Sauerstoffatom oder ein Schwefelatom, und
* in den Formeln (33) bis (34) jeweils unabhängig voneinander eine Bindungsposition mit einem anderen Atom oder einer anderen Struktur im Molekül der dritten Verbindung darstellt.

**11.** Die organische Elektrolumineszenzvorrichtung gemäß Anspruch 10, wobei
$X_{30}$ in der Formel (32) ein Stickstoffatom oder ein Sauerstoffatom ist.

**12.** Die organische Elektrolumineszenzvorrichtung gemäß Anspruch 10 oder 11, wobei
eine Singulett-Energie $S_1(M1)$ der ersten Verbindung und eine Singulett-Energie $S_1(M3)$ der dritten Verbindung eine Beziehung der folgenden numerischen Formel 2 erfüllen,

$$S_1(M3) > S_1(M1) \text{ (Numerische Formel 2).}$$

**13.** Eine elektronische Vorrichtung, die die organische Elektrolumineszenzvorrichtung gemäß einem der Ansprüche 1 bis 12 umfasst.

## Revendications

**1.** Dispositif d'électroluminescence organique, comprenant:

une anode;
une couche émettrice; et
une cathode, dans lequel
la couche émettrice comprend un premier composé et un second composé,
le premier composé est un composé à fluorescence retardée activé thermiquement,
le premier composé est un composé représenté par la formule (11D) suivante,
le second composé est représenté par la formule (2) suivante, et
une énergie singulet $S_1(M1)$ du premier composé et une énergie singulet S,(M2) du second composé satisfont la relation de la formule numérique 1 suivante,

$$S_1(M1) > S_1(M2) \text{ (formule numérique 1),}$$

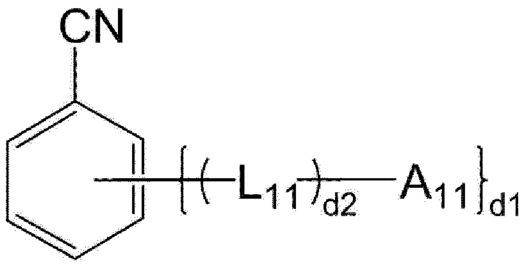

(11D)

dans laquelle, dans la formule (11D):

d1 est 5, d2 sont chacun indépendamment 0 ou 1;
$L_{11}$ sont chacun indépendamment une liaison simple ou un groupe de connexion;
$L_{11}$ utilisés comme substituants sont chacun indépendamment un groupe dérivé d'un groupe choisi dans le groupe constitué d'un groupe aryle substitué ou non substitué ayant 6 à 30 atomes de carbone de cycle, et d'un groupe hétéroaryle substitué ou non substitué ayant de 5 à 30 atomes de cycle;
$A_{11}$ sont chacun indépendamment un atome d'hydrogène ou un substituant; et
$A_{11}$ utilisés comme substituants sont chacun indépendamment un groupe choisi dans le groupe constitué d'un groupe cyano, d'un groupe aryle substitué ou non substitué ayant 6 à 30 atomes de carbone de cycle, et d'un groupe hétéroaryle substitué ou non substitué ayant 5 à 30 atomes de cycle,
sous réserve qu'au moins un des éléments $A_{11}$ est un groupe représenté par la formule (11a)

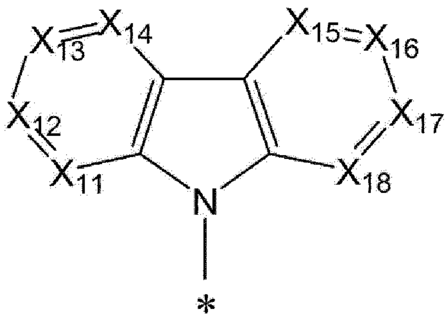

(11a)

dans laquelle, dans la formule (11a):

$X_{11}$ à $X_{18}$ sont chacun indépendamment un atome d'azote ou CRx (un atome de carbone ayant un substituant Rx);
Rx sont chacun indépendamment un atome d'hydrogène ou un substituant;
Rx utilisé comme substituant est choisi dans le groupe constitué d'un groupe aryle substitué ou non substitué ayant de 6 à 30 atomes de carbone de cycle, d'un groupe hétéroaryle substitué ou non substitué ayant de 5 à 30 atomes de cycle, d'un groupe alkyle substitué ou non substitué ayant de 1 à 30 atomes de carbone, d'un groupe fluoroalkyle substitué ou non substitué ayant de 1 à 30 atomes de carbone, d'un groupe cycloalkyle substitué ou non substitué ayant de 3 à 30 atomes de carbone de cycle, d'un groupe aralkyle substitué ou non substitué ayant de 7 à 30 atomes de carbone, d'un groupe phosphoryle substitué, d'un groupe silyle substitué, d'un groupe cyano, d'un groupe nitro et d'un groupe carboxyle ;
une pluralité de Rx sont mutuellement identiques ou différents;
lorsque plusieurs des éléments $X_{11}$ à $X_{18}$ sont CRx et que les Rx sont des substituants, les Rx sont liés entre eux pour former un anneau, ou ils ne sont pas liés pour ne pas former d'anneau; et
et
* représente une position de liaison avec un atome de carbone de la structure cyclique représentée par $L_{11}$ ou la partie benzonitrile dans la formule (11D),

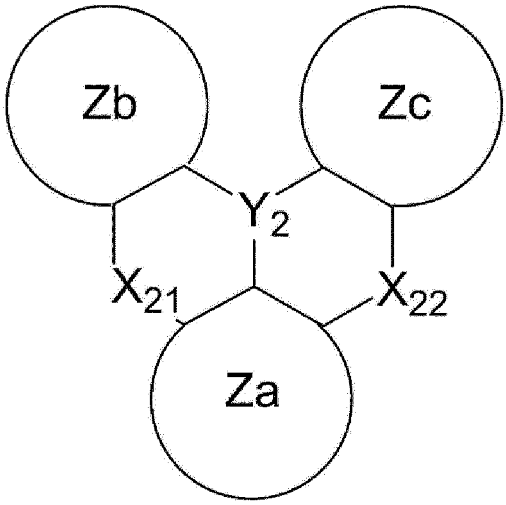

(2)

dans laquelle, dans la formule (2): les anneaux Za, Zb et Zc sont chacun indépendamment une structure cyclique choisie dans le groupe constitué d'un anneau aryle substitué ou non substitué ayant de 6 à 30 atomes de carbone de cycle, et d'un anneau hétéroaryle substitué ou non substitué ayant de 5 à 30 atomes de cycle;
$X_{21}$ et $X_{22}$ sont chacun indépendamment un atome d'oxygène, NRa ou un atome de soufre;

lorsque $X_{21}$ est NRa, Ra est lié à l'anneau Za ou à l'anneau Zb pour former un anneau ou n'est pas lié pour ne pas former d'anneau;
lorsque $X_{22}$ est NRa, Ra est lié à l'anneau Za ou à l'anneau Zc pour former un anneau ou n'est pas lié pour ne pas former d'anneau ;
Ra est indépendamment un groupe choisi dans le groupe constitué d'un groupe aryle substitué ou non substitué ayant de 6 à 30 atomes de carbone de cycle, d'un groupe hétéroaryle substitué ou non substitué ayant de 5 à 30 atomes de cycle, et d'un groupe alkyle substitué ou non substitué ayant de 1 à 30 atomes de carbone;
$Y_2$ est un atome de bore, un atome de phosphore, SiRb, P=O, ou P=S; et
Rb est indépendamment un groupe choisi dans le groupe constitué d'un groupe aryle substitué ou non substitué ayant de 6 à 30 atomes de carbone de cycle, d'un groupe hétéroaryle substitué ou non substitué ayant de 5 à 30 atomes de cycle, et d'un groupe alkyle substitué ou non substitué ayant de 1 à 30 atomes de carbone.

**2.** Le dispositif d'électroluminescence organique selon la revendication 1, dans lequel le second composé est un composé représenté par la formule (2A) suivante,

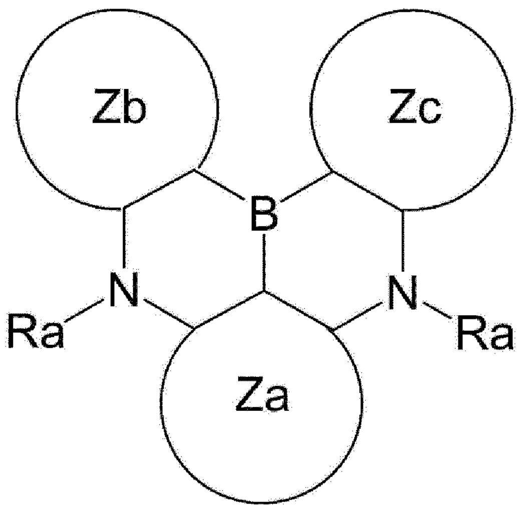

(2A)

dans laquelle, dans la formule (2A), l'anneau Za, l'anneau Zb, l'anneau Zc et Ra représentent les mêmes que l'anneau Za, l'anneau Zb, l'anneau Zc et Ra dans la formule (2), respectivement.

**3.** Le dispositif d'électroluminescence organique selon la revendication 1, dans lequel le second composé est un composé représenté par la formule (21) suivante,

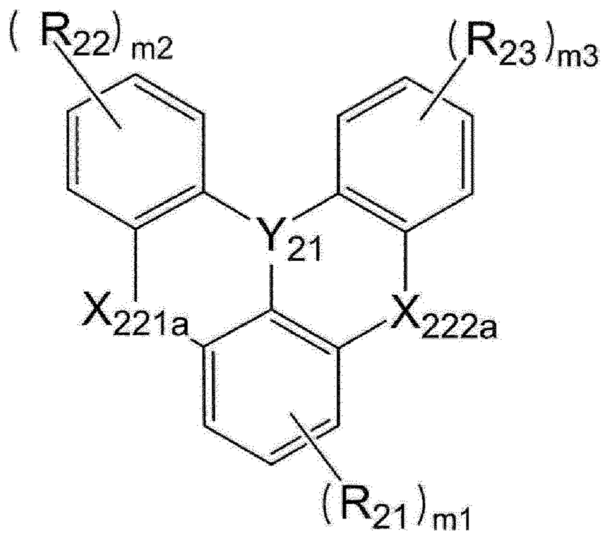

(21)

dans laquelle, dans la formule (21): $X_{221a}$ et $X_{222a}$, qui sont mutuellement identiques, représentent l'un des atomes d'oxygène, NRa, et atomes de soufre ;

m1 est égal à 3, et chacun de m2 et m3 est égal à 4;
$R_{21}$ à $R_{23}$ sont chacun indépendamment un atome d'hydrogène ou un substituant;
$R_{21}$ à $R_{23}$ utilisés comme substituants sont chacun indépendamment un groupe choisi dans le groupe constitué d'un groupe aryle substitué ou non substitué ayant 6 à 30 atomes de carbone de cycle, un groupe hétéroaryle substitué ou non substitué ayant 5 à 30 atomes de cycle, un groupe alkyle substitué ou non substitué ayant 1 à 30 atomes de carbone, un groupe aryloxy substitué ou non substitué ayant 6 à 30 atomes de carbone de cycle, un groupe amino substitué ou non substitué, et un groupe silyle substitué ; et
dans la formule (21), $Y_{21}$ représente la même chose que $Y_2$ dans la formule (2).

**4.** Le dispositif d'électroluminescence organique selon la revendication 3, dans lequel le second composé est un composé représenté par la formule (21A) suivante,

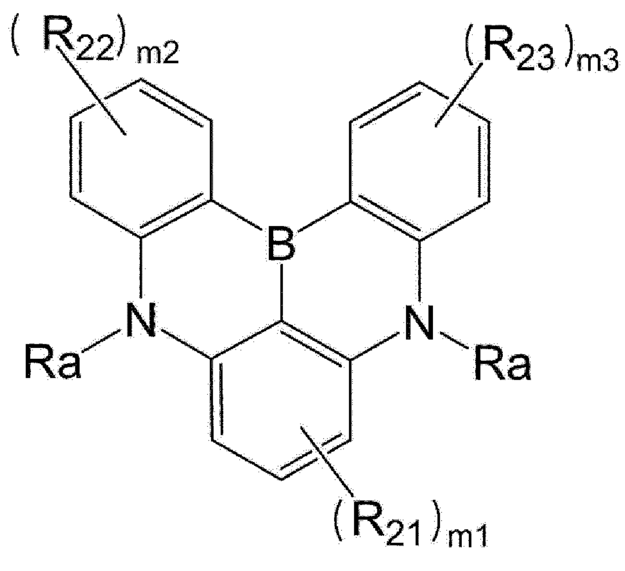

(21A)

dans laquelle Ra, m1 à m3, et $R_{21}$ à $R_{23}$ dans la formule (21A) représentent la même chose que Ra, m1 à m3, et $R_{21}$ à $R_{23}$ dans la formule (21), respectivement.

**5.** Le dispositif d'électroluminescence organique selon l'une des revendications 1 à 4, dans lequel Ra est un groupe aryle substitué ou non substitué ayant de 6 à 30 atomes de carbone de cycle.

**6.** Le dispositif d'électroluminescence organique selon l'une des revendications 1 à 5, dans lequel Ra est un groupe phényle substitué ou non substitué.

**7.** Le dispositif d'électroluminescence organique selon l'une des revendications 1 à 6, dans lequel Ra dans la formule (2) n'est pas lié à l'un des anneaux Za et Zb pour ne former aucun anneau, et Ra dans la formule (2) n'est pas lié à l'un des anneaux Za et Zc pour ne former aucun anneau.

**8.** Le dispositif d'électroluminescence organique selon l'une des revendications 1 à 7, dans lequel le second composé est un composé fluorescent retardé activé thermiquement.

**9.** Le dispositif d'électroluminescence organique selon l'une des revendications 1 à 8, dans lequel, lorsque le dispositif d'électroluminescence organique émet de la lumière, le second composé émet de la lumière dans la couche émettrice.

**10.** Le dispositif d'électroluminescence organique selon l'une des revendications 1 à 9, dans lequel

la couche émettrice comprend en outre un troisième composé, et
le troisième composé a au moins l'une des structures partielles représentées par la formule (31) suivante, une structure partielle représentée par la formule (32) suivante, une structure partielle représentée par la formule (33) suivante, ou une structure partielle représentée par la formule (34) suivante dans une molécule,

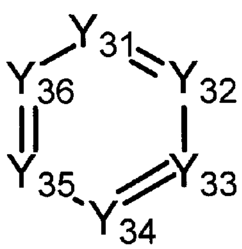
(31)

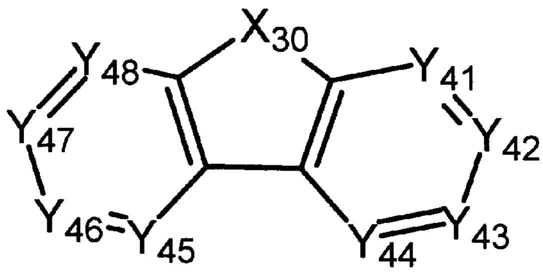
(32)

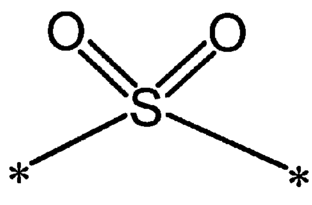
(33)

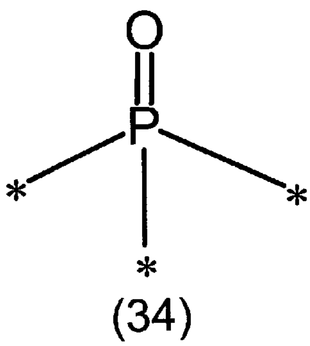
(34)

dans lesquelles, dans la formule (31): $Y_{31}$ à $Y_{36}$ représentent chacun indépendamment un atome d'azote ou un atome de carbone lié à un autre atome dans la molécule du troisième composé, au moins un des $Y_{31}$ à $Y_{36}$ étant l'atome de carbone lié à un autre atome dans la molécule du troisième composé,
dans la formule (32): $Y_{41}$ à $Y_{48}$ représentent chacun indépendamment un atome d'azote ou un atome de carbone lié à un autre atome dans la molécule du troisième composé, au moins un de $Y_{41}$ à $Y_{48}$ étant l'atome de carbone lié à un autre atome dans la molécule du troisième composé; et

$X_{30}$ est un atome d'azote lié à un autre atome dans la molécule du troisième composé, ou un atome d'oxygène ou un atome de soufre, et

* dans les formules (33) à (34), chacun représente indépendamment une position de liaison avec un autre atome ou une autre structure dans la molécule du troisième composé.

**11.** Le dispositif d'électroluminescence organique selon la revendication 10, dans lequel $X_{30}$ dans la formule (32) est un atome d'azote ou un atome d'oxygène.

**12.** Le dispositif d'électroluminescence organique selon la revendication 10 ou 11, dans lequel une énergie singulet $S_1$(M1) du premier composé et une énergie singulet S,(M3) du troisième composé satisfont la relation de la formule numérique 2 suivante,

$$S_1(M3) > S_1(M1) \text{ (formule numérique 2).}$$

**13.** Un dispositif électronique comprenant le dispositif d'électroluminescence organique selon l'une des revendications 1 à 12.

FIG.1

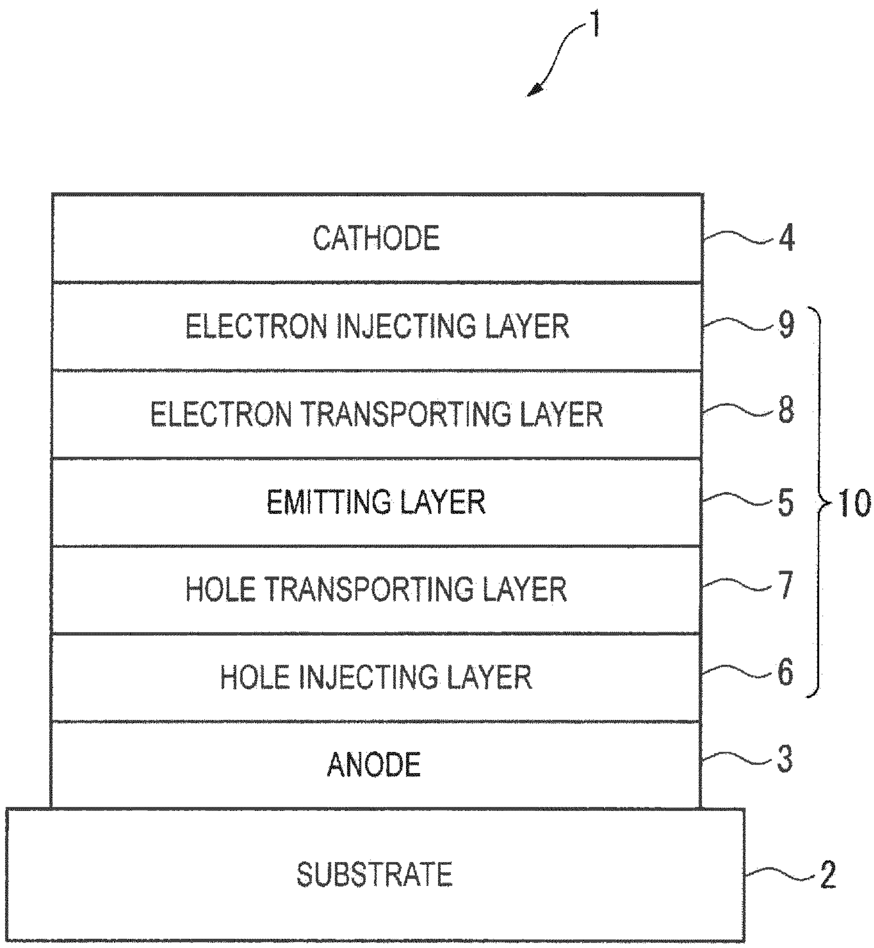
1
CATHODE
4
ELECTRON INJECTING LAYER
9
ELECTRON TRANSPORTING LAYER
8
EMITTING LAYER
5
10
HOLE TRANSPORTING LAYER
7
HOLE INJECTING LAYER
6
ANODE
3
SUBSTRATE
2

FIG.2

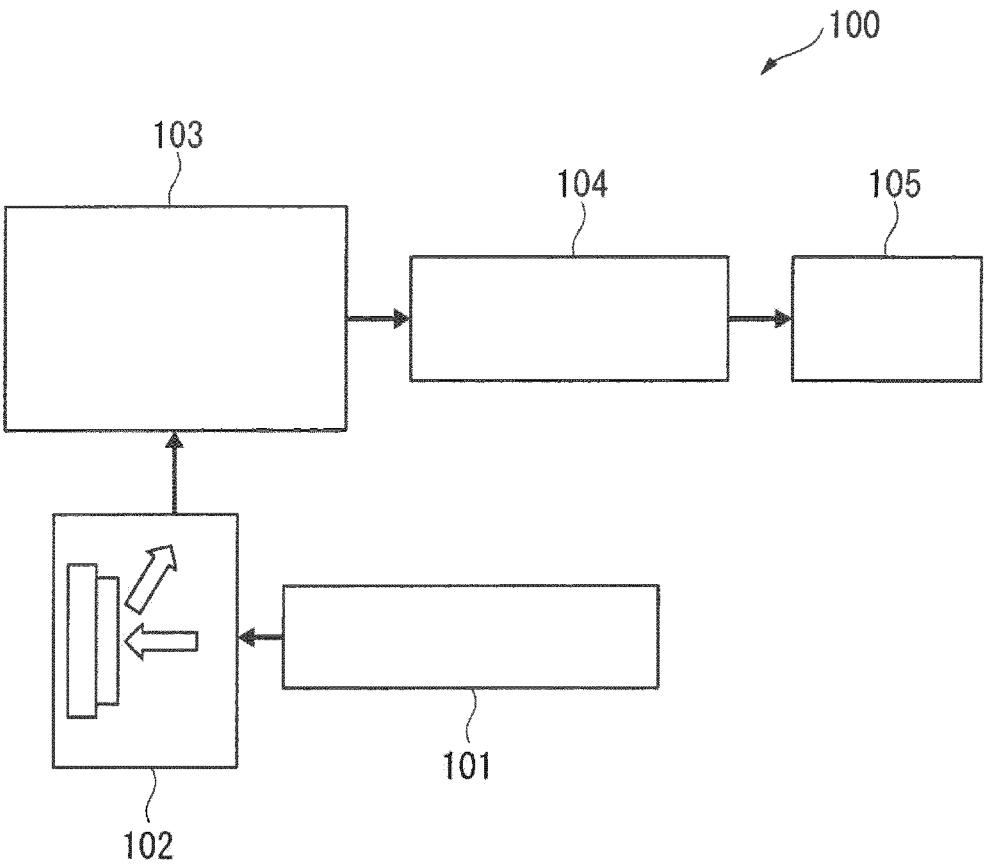

FIG. 3

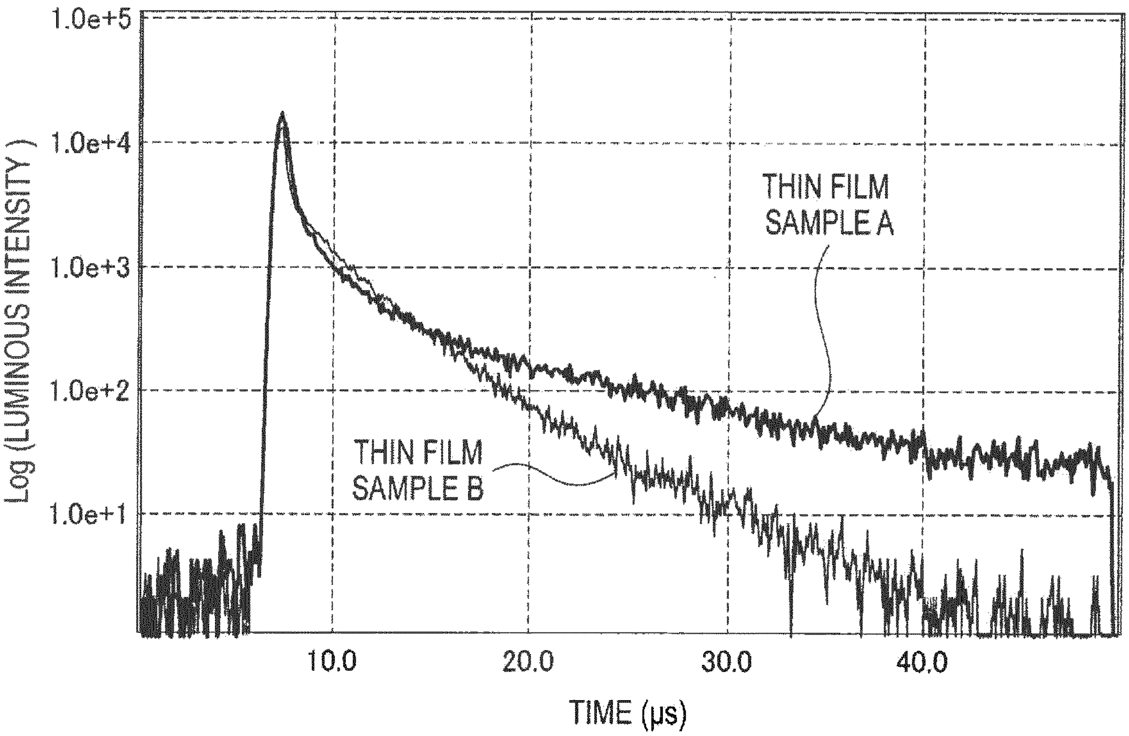
1.0e+5
1.0e+4
1.0e+3
1.0e+2
1.0e+1
Log (LUMINOUS INTENSITY)
THIN FILM SAMPLE A
THIN FILM SAMPLE B
10.0
20.0
30.0
40.0
TIME (μs)

FIG.4

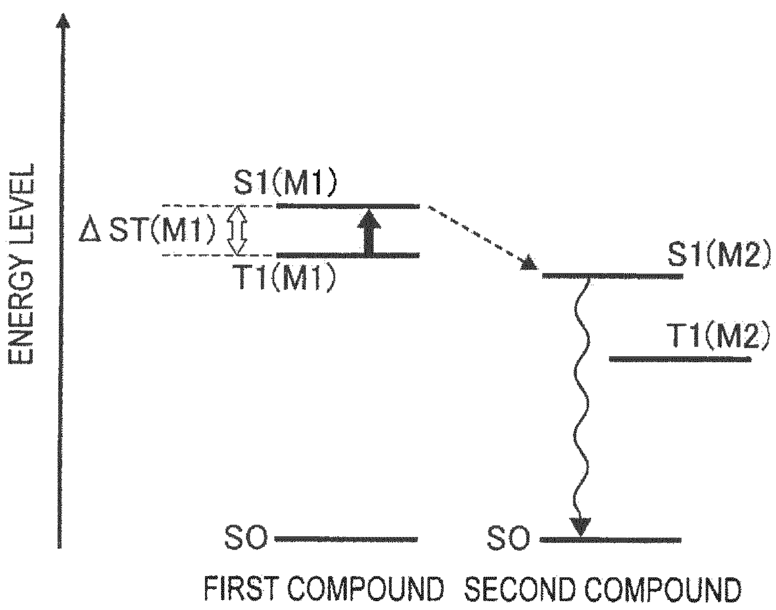
ENERGY LEVEL
S1(M1)
ΔST(M1)
T1(M1)
S1(M2)
T1(M2)
SO
SO
FIRST COMPOUND
SECOND COMPOUND

FIG.5

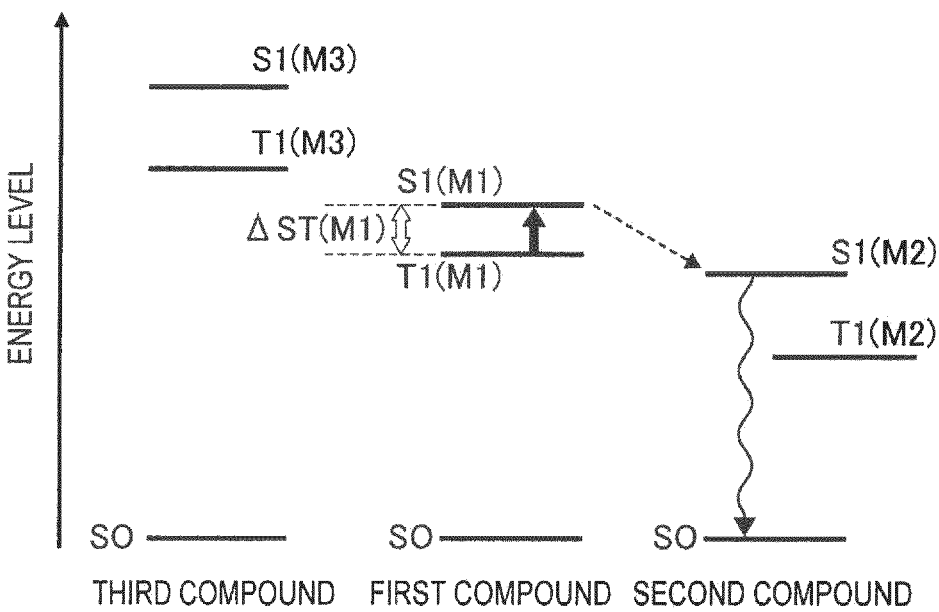
ENERGY LEVEL
S1(M3)
T1(M3)
S1(M1)
ΔST(M1)
T1(M1)
S1(M2)
T1(M2)
SO
SO
SO
THIRD COMPOUND
FIRST COMPOUND
SECOND COMPOUND

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2016152544 A
- WO 2016152418 A
- WO 2015102118 A
- US 2016172601 A1
- WO 2017018326 A1
- WO 2013180241 A
- WO 2014092083 A
- WO 2014104346 A
- WO 2012153780 A
- WO 2013038650 A


### Non-patent literature cited in the description


- Yuki Hando-tai no Debaisu Bussei (Device Physics of Organic Semiconductors). ADACHI, 01 April 2012, 261-262
- Ultrapure Blue Thermally Activated Delayed Fluorescence Molecules: Efficient HOMO-LUMO Separation by the Multiple Resonance Effect. *Adv. Mater.,* 2016, vol. 28, 2777-2781
- **TAKUJI HATAKEYAMA et al.** Ultrapure Blue Thermally Activated Delayed Fluorescence Molecules: Efficient HOMO-LUMO Separation by the Multiple Resonance Effect. *ADVANCED MATERIALS,* 11 February 2016, vol. 28 (14), 2777-2781
- Yuki Hando-tai no Debaisu Bussei (Device Physics of Organic Semiconductors). ADACHI, 261-268
- *Nature,* 2012, vol. 492, 234-238
- *Chemical Communications,* 2013, 10385-10387
- *NATURE Photonics,* 2014, 326-332